(19) Europäisches Patentamt
European Patent Office
Office européen des brevets

(11) **EP 4 130 879 A1**

(12) # EUROPEAN PATENT APPLICATION
published in accordance with Art. 153(4) EPC

(43) Date of publication:
**08.02.2023 Bulletin 2023/06**

(21) Application number: **21779704.2**

(22) Date of filing: **08.03.2021**

(51) International Patent Classification (IPC):
***G03F 7/039*** *(1990.01)* ***G03F 7/20*** *(1968.09)*

(52) Cooperative Patent Classification (CPC):
**G03F 7/039; G03F 7/20**

(86) International application number:
**PCT/JP2021/009032**

(87) International publication number:
**WO 2021/199940 (07.10.2021 Gazette 2021/40)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **31.03.2020 JP 2020062773**

(71) Applicant: **FUJIFILM Corporation**
**Tokyo 106-8620 (JP)**

(72) Inventors:
- **TANGO Naohiro**
  **Haibara-gun, Shizuoka 421-0396 (JP)**
- **SHIRAKAWA Michihiro**
  **Haibara-gun, Shizuoka 421-0396 (JP)**
- **SAKITA Kyohei**
  **Haibara-gun, Shizuoka 421-0396 (JP)**
- **GOTO Akiyoshi**
  **Haibara-gun, Shizuoka 421-0396 (JP)**
- **YAGI Kazunari**
  **Haibara-gun, Shizuoka 421-0396 (JP)**
- **FUJITA Mitsuhiro**
  **Haibara-gun, Shizuoka 421-0396 (JP)**

(74) Representative: **HGF**
**HGF Limited**
**1 City Walk**
**Leeds LS11 9DX (GB)**

(54) **MANUFACTURING METHOD FOR RESIST COMPOSITION AND PATTERN FORMING METHOD**

(57) Provided are a production method capable of easily producing a resist composition with good production reproducibility; and a pattern forming method. The method for producing a resist composition includes a setting step of setting parameter, an acquisition step of acquiring a pattern size for a regression analysis, an analysis step of performing a regression analysis, a calculation step of calculating a pattern size of a target resist composition based on the regression analysis, a comparison step of comparing the pattern size of the target resist composition and the target pattern size, a determination step of determining a formulating amount of the resist composition in a case where a difference between the pattern size of the target resist composition and the target pattern size is within an allowable range, and a producing step of producing a resist composition based on the determined formulating amount, in which, in a case where the difference is out of the allowable range, the method further includes a change step of changing at least the content of components in the target resist composition, and the formulating amount of the resist composition is determined based on the changed physical quantity to produce the resist composition.

FIG. 1

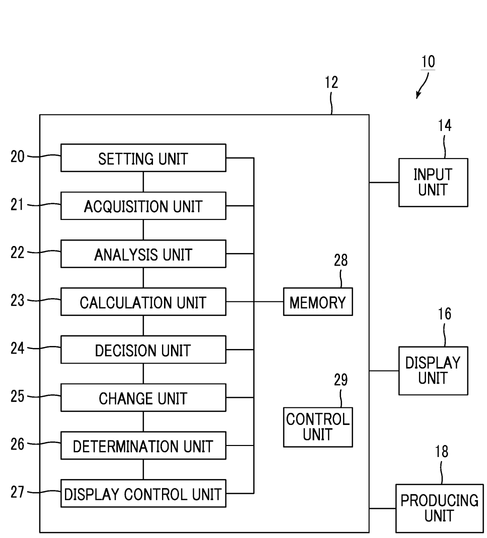


EP 4 130 879 A1

## Description

## BACKGROUND OF THE INVENTION

1. Field of the Invention

The present invention relates to a method for producing a resist composition and a pattern forming method.

2. Description of the Related Art

In processes for manufacturing semiconductor devices such as an integrated circuit (IC) and a large scale integrated circuit (LSI) in the related art, microfabrication by lithography using a resist composition (hereinafter, also referred to as an "actinic ray-sensitive or radiation-sensitive resin composition") has been performed. In recent years, along with the high integration of integrated circuits, the formation of ultrafine patterns in a submicron region or quarter micron region has been required. With such a demand, a tendency that an exposure wavelength has been shifted from g-rays to i-rays, and further, as with KrF excimer laser light, the exposure wavelength is shortened is observed. Moreover, developments in lithography with electron beams or extreme ultraviolet (EUV) rays, in addition to the excimer laser light, have also been currently proceeding.

For example, JP2019-211531A discloses a positive tone resist composition for EUV lithography, which has a predetermined composition.

## SUMMARY OF THE INVENTION

Generally, in a case of producing a resist composition, it is desirable that there is little difference in performance between lots. On the other hand, for example, in a case where a lot of the raw material itself of the resist composition such as an acid-decomposable resin changes, even in a case where the resist composition is produced with the same raw material compositional ratio as before, the performance may be different from that of the previous resist composition due to a slight structural difference in raw material itself (for example, a difference in content of a repeating unit of the acid-decomposable resin), a slight difference in formulating amount during production, and the like. In particular, this tendency is remarkable in a case where the lot of the acid-decomposable resin changes.

Therefore, in the related art, each time a resist composition is prepared, a size of a pattern formed by performing an exposure treatment and a development treatment using the resist composition is evaluated, and in a case where there is a deviation from the desired size, the composition of the resist composition is appropriately readjusted, and a size of a pattern obtained by using the readjusted resist composition is repeatedly evaluated.

However, it is not always easy to adjust the performance by the method for adjusting the composition of the resist composition as described above. In particular, with regard to a resist composition for EUV, in addition to the above-described problem, the exposure treatment using an EUV exposure device with EUV is very expensive, so that from the viewpoint of cost, it has been difficult to repeatedly evaluate the performance of the resist composition in which the composition is readjusted as in the related art.

Therefore, a production method capable of producing a resist composition more easily and with good production reproducibility has been desired.

In view of the above-descried circumstances, an object of the present invention is to provide a production method capable of easily producing a resist composition with good production reproducibility.

Another object of the present invention is to provide a pattern forming method.

The present inventors have found that the above-described objects can be achieved by the following configurations.

(1) A method for producing a resist composition, the resist composition including an acid-decomposable resin which has a group decomposed by an action of acid to generate a polar group and a photoacid generator, the method comprising:

a setting step of setting each of a content of a repeating unit included in the acid-decomposable resin with respect to all repeating units and a physical quantity including at least a content of components in the resist composition as parameters;

an acquisition step of producing a plurality of resist compositions for a regression analysis, which include at least the acid-decomposable resin and the photoacid generator, with at least one of the parameters as a variable, and acquiring a pattern size for a regression analysis by performing a pattern forming treatment including an exposure treatment and a development treatment so that a target pattern size can be obtained by using each

of the produced resist compositions for a regression analysis;

an analysis step of performing a regression analysis on the pattern size for a regression analysis, which is obtained by the acquisition step, using the parameter as the variable as an explanatory variable and using a target pattern size as an objective variable;

a calculation step of measuring a content of a repeating unit included in the acid-decomposable resin which is a component in a target resist composition including the same types of components as components in the resist composition for a regression analysis with respect to all repeating units by a nuclear magnetic resonance spectroscopy, and calculating, based on the regression analysis in the analysis step, a pattern size of the target resist composition using the obtained content of the repeating unit included in the acid-decomposable resin with respect to all repeating units and the physical quantity of the explanatory variables of the target resist composition;

a comparison step of comparing the pattern size of the target resist composition, which is obtained by the calculation step, with the target pattern size;

a determination step of determining a formulating amount of the target resist composition based on the regression analysis of the analysis step in a case where, in the comparison step, a difference between the pattern size of the target resist composition and the target pattern size is within an allowable range; and

a producing step of producing a resist composition based on the formulating amount determined in the determination step,

in which, in the comparison step, in a case where the difference between the pattern size of the target resist composition and the target pattern size is out of the allowable range, the method further includes a change step of changing the formulating amount of the target resist composition such that the difference between the pattern size of the target resist composition and the target pattern size is within the allowable range.

(2) The method for producing a resist composition according to (1),
in which the number of times of integration in the nuclear magnetic resonance spectroscopy is 5000 or more.
(3) The method for producing a resist composition according to (1) or (2),
in which the number of times of integration in the nuclear magnetic resonance spectroscopy is 10000 or more.
(4) The method for producing a resist composition according to any one of (1) to (3),
in which the number of times of integration in the nuclear magnetic resonance spectroscopy is 20000 or more.
(5) The method for producing a resist composition according to any one of (1) to (4),
in which the physical quantity is a content of the acid-decomposable resin with respect to a total solid content mass in the resist composition.
(6) The method for producing a resist composition according to any one of (1) to (5),
in which the physical quantity is a content of the photoacid generator with respect to a total solid content mass in the resist composition.
(7) The method for producing a resist composition according to any one of (1) to (6),
in which the physical quantity is a weight-average molecular weight of the acid-decomposable resin.
(8) The method for producing a resist composition according to any one of (1) to (7),
in which the regression analysis is a multivariate analysis.
(9) The method for producing a resist composition according to any one of (1) to (8),
in which the resist composition produced in the producing step is used for exposure with extreme ultraviolet rays.
(10) A pattern forming method comprising:

a step of forming a resist film using the resist composition produced by the production method according to any one of (1) to (9);

a step of exposing the resist film; and

a step of developing the exposed resist film using a developer to form a pattern.

According to the present invention, it is possible to provide a production method capable of easily producing a resist composition with good production reproducibility.

In addition, according to the present invention, it is possible to provide a pattern forming method.

**BRIEF DESCRIPTION OF THE DRAWINGS**

Fig. 1 is a schematic diagram showing an example of a processing apparatus used in the method for producing a resist composition according to an embodiment of the present invention.

Fig. 2 is a flowchart showing the method for producing a resist composition according to the embodiment of the present invention.

## DESCRIPTION OF THE PREFERRED EMBODIMENTS

Hereinafter, a method for producing a resist composition and a pattern forming method according to the embodiment of the present invention will be described in detail based on suitable embodiments shown in the attached drawings.

The drawings illustrated below are exemplary for explaining the present invention, and the present invention is not limited to the drawings illustrated below.

In the following, "to" indicating the numerical range includes numerical values described on both sides. For example, in a case where $\varepsilon$ is a numerical value $\alpha$ to a numerical value $\beta$, the range of $\varepsilon$ is a range including the numerical value $\alpha$ and the numerical value $\beta$, and it is expressed as $\alpha \leq \varepsilon \leq \beta$ in mathematical symbols.

In addition, various numerical values represented by specific numerical values include an error range generally acceptable in the relevant technical field, unless otherwise specified.

In citations for a group (atomic group) in the present specification, in a case where the group is cited without specifying whether it is substituted or unsubstituted, the group includes both a group having no substituent and a group having a substituent. For example, an "alkyl group" includes not only an alkyl group having no substituent (unsubstituted alkyl group), but also an alkyl group having a substituent (substituted alkyl group).

A bonding direction of a divalent group cited in the present specification is not limited unless otherwise specified. For example, in a compound represented by the General Formula "L-M-N", in a case where M is -OCO-C(CN)=CH-, and the position bonded to the L side is defined as *1 and the position bonded to the N side is defined as *2, M may be *1-OCO-C(CN)=CH-*2 or *1-CH=C(CN)-COO-*2.

"(Meth)acryl" in the present specification is a generic term encompassing acryl and methacryl, and means "at least one of acryl or methacryl". In the same way, "(meth)acrylic acid" is a generic term encompassing acrylic acid and methacrylic acid, and means "at least one of acrylic acid or methacrylic acid".

Unless otherwise specified, "exposure" in the present specification encompasses not only exposure by a bright line spectrum of a mercury lamp, far ultraviolet rays typified by an excimer laser, X-rays, EUV, or the like, but also drawing by particle beams such as electron beams and ion beams.

In the present specification, an acid dissociation constant (pKa) represents a pKa in an aqueous solution, and is specifically a value determined by computation from a value based on a Hammett's substituent constant and database of publicly known literature values, using the following software package 1. Any of the pKa values described in the present specification indicates values determined by computation using the software package.

Software Package 1: Advanced Chemistry Development (ACD/Labs) Software V 8.14 for Solaris (1994 - 2007 ACD/Labs).

On the other hand, the pKa can also be determined by a molecular orbital computation method. Examples of a specific method therefor include a method for performing calculation by computing $H^+$ dissociation free energy in an aqueous solution based on a thermodynamic cycle. With regard to a computation method for $H^+$ dissociation free energy, the $H^+$ dissociation free energy can be computed by, for example, density functional theory (DFT), but various other methods have been reported in literature and the like, and are not limited thereto. There are a plurality of software applications capable of performing DFT, and examples thereof include Gaussian 16.

As described above, the pKa in the present specification refers to a value determined by computation from a value based on a Hammett's substituent constant and database of publicly known literature values, using the software package 1, but in a case where the pKa cannot be calculated by the method, a value obtained by Gaussian 16 based on density functional theory (DFT) shall be adopted.

In addition, the pKa in the present specification refers to a "pKa in an aqueous solution" as described above, but in a case where the pKa in an aqueous solution cannot be calculated, a "pKa in a dimethyl sulfoxide (DMSO) solution" shall be adopted.

As described above, in a case of a resist composition adopted to light of extreme ultraviolet rays (EUV), the EUV exposure device is very expensive, and it is very difficult to perform exposure with EUV

On the other hand, in the method for producing a resist composition according to the embodiment of the present invention, by using a content of a repeating unit included in an acid-decomposable resin with respect to all repeating units and a predetermined physical quantity described later as parameters for a regression analysis, among the parameters, it is possible to identify the parameters which have a large effect on a pattern dimension. As a result, it is possible to confirm whether a predetermined formulating amount of the resist composition can achieve a predetermined target pattern size even in a case where raw materials of different lots are used. Even in a case where the above-described predetermined amount cannot be achieved, results of the regression analysis can be used to appropriately readjust the formulating amount of the resist composition. In particular, the production method according to the embodiment of the

present invention can be adopted to a resist composition for EUV As a result, the resist composition can be produced with stable quality.

As will be described later, as the number of parameters which are explanatory variables for the regression analysis increases, the effects of the present invention (a resist composition can be produced easily and with good production reproducibility) are more excellent. That is, as the number of parameters increases, in many cases, the target resist composition in which the difference between the pattern size of the target resist composition and the target pattern size is within an allowable range in a determination step described later actually shows the target pattern size, and even for the target resist composition in which the difference is out of the allowable range, the resist composition in which composition is readjusted actually shows the target pattern size. That is, as the number of parameters increases, the resist composition can be produced with better reproducibility.

[Processing apparatus]

Fig. 1 is a schematic diagram showing an example of a processing apparatus used in the method for producing a resist composition according to the embodiment of the present invention.

A processing apparatus 10 used for determining a formulating amount of the resist composition and used in the method for producing a resist composition based on the formulating amount is configured by using hardware such as a computer. However, in a case where the method for producing a resist composition can be executed using hardware such as a computer and software, the method is not limited to the processing apparatus 10, and the method may be a program for causing a computer or the like to execute each step of the method for producing a resist composition as a procedure.

The processing apparatus 10 is used in the method for producing a resist composition as described above. In the processing apparatus 10, the formulating amount of the resist composition is determined, and the resist composition is produced based on the formulating amount. The resist composition is used in a photography method. For example, a resist film is formed from the resist composition on a silicon wafer. By subjecting the resist film to an exposure treatment and a development treatment, the resist film is processed into a specific pattern shape, and the silicon wafer is subjected to processing such as etching using the resist film as a mask.

The processing apparatus 10 includes a processing unit 12, an input unit 14, a display unit 16, and a producing unit 18. The processing unit 12 includes a setting unit 20, an acquisition unit 21, an analysis unit 22, a calculation unit 23, a decision unit 24, a change unit 25, a determination unit 26, a display control unit 27, a memory 28, and a control unit 29. The processing apparatus 10 also includes Read Only Memory (ROM) and the like (not shown).

The processing unit 12 is controlled by the control unit 29. In addition, in the processing unit 12, the setting unit 20, the acquisition unit 21, the analysis unit 22, the calculation unit 23, the decision unit 24, the change unit 25, the determination unit 26, and the display control unit 27 are connected to the memory 28, and data of the setting unit 20, the acquisition unit 21, the analysis unit 22, the calculation unit 23, the decision unit 24, the change unit 25, the determination unit 26, and the display control unit 27 can be stored in the memory 28.

By executing program stored in the ROM or the like with the control unit 29, the processing apparatus 10 functionally forms each unit of the setting unit 20, the analysis unit 22, the calculation unit 23, the decision unit 24, the change unit 25, and the determination unit 26. As described above, the processing apparatus 10 may be configured by a computer in which each unit functions by executing a program, or may be a dedicated apparatus in which each unit is configured of a dedicated circuit. The program is supplied, for example, in a form of computer software. Hereinafter, each unit of the processing apparatus 10 will be described.

The input unit 14 is various input devices for inputting various information according to an instruction of operator, such as a mouse and a keyboard. The display unit 16 displays, for example, various results, and various known displays are used. In addition, the display unit 16 also includes a device for displaying various information on an output medium, such as a printer.

The resist composition includes an acid-decomposable resin which has a group decomposed by an action of acid to generate a polar group (hereinafter, also simply referred to as an "acid-decomposable resin") and a photoacid generator. The setting unit 20 sets a content of a repeating unit included in the acid-decomposable resin with respect to all repeating units in the resist composition and a physical quantity including at least a content of components in the resist composition as parameters.

The acquisition unit 21 acquires a pattern size for a regression analysis by producing a plurality of resist compositions for a regression analysis with at least one of the parameters of the content of the repeating unit included in the acid-decomposable with respect to all repeating units and the above-described physical quantity, which are set in the setting unit, as a variable, producing a resist film using each of the produced resist compositions for a regression analysis, and performing a pattern forming treatment including an exposure treatment and a development treatment so that a target pattern size can be obtained by using each of the produced resist compositions for a regression analysis. The target pattern size indicates a performance required for the resist composition, and is a set value of the pattern size.

As the set value of the pattern size, for example, a line width of a line-shaped pattern and a diameter of a hole of a pattern having holes are used.

The target pattern size and the pattern size for a regression analysis are the same type, and for example, the line width of the pattern or the diameter of the hole is used.

The pattern size for a regression analysis obtained by performing the pattern forming treatment including the exposure treatment and the development treatment so as to obtain the target pattern size is an actually measured value of a size of the pattern obtained from the resist film produced from the resist composition.

The analysis unit 22 performs a regression analysis on the pattern size for a regression analysis of the resist compositions for a regression analysis, which is obtained by the acquisition unit 21, using the parameter as the variable as an explanatory variable and using a target pattern size as an objective variable.

In the calculation unit 23, a content of a repeating unit included in the acid-decomposable resin that is a component in a target resist composition which is a determining target of a formulating amount and includes the same types of components as components in the resist composition for a regression analysis (hereinafter, also simply referred to as a "target resist composition") with respect to all repeating units is measured by a nuclear magnetic resonance spectroscopy, and based on the regression analysis in the analysis unit 22, a pattern size of the target resist composition is calculated using the obtained content of the repeating unit included in the acid-decomposable resin with respect to all repeating units and the physical quantity used as the explanatory variables of the target resist composition.

The physical quantity used as the explanatory variable is a physical quantity used as the parameter in the regression analysis, and is a physical quantity including at least the content of the components in the resist composition.

The decision unit 24 compares the pattern size of the target resist composition, which is obtained by the calculation unit 23, with the target pattern size.

In the change unit 25, in a case where, in the decision unit 24, the difference between the pattern size of the target resist composition and the target pattern size is out of the allowable range, at least the content of the component in the target resist composition among the physical quantities used as the explanatory variables in the target resist composition is changed such that the difference between the pattern size of the target resist composition and the target pattern size is within the allowable range. The change unit 25 adjusts the formulating amount of the target resist composition.

In a case where the difference between the above-described pattern size of the target resist composition and the above-described target pattern size is out of the allowable range, using the measured content of the repeating unit included in the acid-decomposable resin with respect to all repeating units and the physical quantity changed by the change unit 25, the pattern size of the changed target resist composition can be calculated based on the regression analysis.

In the determination unit 26, in a case where, in the decision unit 24, the difference between the above-described pattern size of the target resist composition and the above-described target pattern size is out of the allowable range, the formulating amount of the resist composition is determined based on the regression analysis of the analysis unit 22.

The display control unit 27 causes the display unit 16 to display the parameters related to the resist composition for a regression analysis used in the regression analysis.

In addition, the display control unit 27 caused the display unit 16 to display the content of the repeating unit included in the acid-decomposable resin with respect to all repeating units, which is obtained by the measurement by the nuclear magnetic resonance spectroscopy, the pattern size of the target resist composition obtained from the regression analysis, the target pattern size, the comparison result between the pattern size of the target resist composition and the target pattern size, the formulating amount of the resist composition, and the like.

In a case where the display control unit 27 causes the display unit 16 to display the information, various information may be read out from the memory 28 and displayed. In addition, the display control unit 27 can also cause the display unit 16 to display various information and the like input through the input unit 14.

In the producing unit 18, a resist composition is produced based on the formulating amount determined by the determination unit 26. As long as a resist composition can be produced based on the formulating amount of the resist composition determined by the determination unit 26, a configuration of the producing unit 18 is not particularly limited, and a known one can be appropriately used.

In addition, the producing unit 18 may have a configuration different from that of the processing apparatus 10, and for example, the resist composition can also be produced by another production device based on the formulating amount of the resist composition determined by the determination unit 26.

[Method for producing resist composition]

Fig. 2 is a flowchart showing the method for producing a resist composition according to the embodiment of the present invention. As a method for determining a resist formulating amount, for example, the processing apparatus 10 shown in Fig. 1 is used.

In the method for producing a resist composition described below, although not particularly described, various processes are performed in each unit of the processing unit 12 of the processing apparatus 10 and the producing unit 18. In addition, in the following description, the description that various processes are performed by the control unit 29 in each unit of the processing unit 12 is omitted, but a series of processes of each unit is controlled by the control unit 29.

First, with regard to a resist composition including an acid-decomposable resin and a photoacid generator, a content of a repeating unit included in the acid-decomposable resin with respect to all repeating units and a physical quantity including at least a content of components in the resist composition are set as parameters (step S10).

The content of the above-described repeating unit with respect to all repeating units may be a mass proportion (% by mass) with respect to all repeating units, or may be a molar proportion (% by mole) with respect to all repeating units.

In a case where there are multiple types of repeating units included in the acid-decomposable resin, only the content of some types of repeating units included in the acid-decomposable resin with respect to all repeating units may be set as the parameter, or the content of all types of repeating units included in the acid-decomposable resin with respect to all repeating units may be set as the parameter. That is, it is sufficient that the content of at least a part of repeating units included in the acid-decomposable resin with respect to all repeating units is set as the parameter. For example, in a case where the acid-decomposable resin includes three types of repeating units of a unit A, a unit B, and a unit C, only the content of the unit A with respect to all repeating units may be set as the parameter, or the content of the unit A with respect to all repeating units, the content of the unit B with respect to all repeating units, and the content of the unit C with respect to all repeating units may be set as the parameter.

The content of the repeating unit included in the acid-decomposable resin with respect to all repeating units, which is used in the calculation step described later, may be calculated from a preparation ratio of monomers used in the production of the acid-decomposable resin, or may be obtained by a known method such as a nuclear magnetic resonance spectroscopy.

Measurement conditions of the nuclear magnetic resonance spectroscopy are not particularly limited, and examples thereof include measurement conditions of the nuclear magnetic resonance spectroscopy performed in the calculation step (step S16) described later.

In addition, in a case where the acid-decomposable resin is a commercially available product, a catalog value may be used.

The physical quantity includes at least the content of components in the resist composition.

The components in the resist composition are intended to be components in the resist composition, such as the acid-decomposable resin and the photoacid generator. Examples of the components in the resist composition include, as described later, an acid diffusion control agent, a surfactant, and a hydrophobic resin, in addition to the acid-decomposable resin and the photoacid generator.

In addition, the content of the above-described components may be a mass proportion (% by mass) of the components with respect to the total mass of the resist composition, or may be a mass proportion (% by mass) of the components with respect to the total solid content in the resist composition. Examples thereof include a content (% by mass) of the acid-decomposable resin with respect to the total solid content mass in the resist composition, a content (% by mass) of the photoacid generator with respect to the total solid content mass in the resist composition, and a content (% by mass) of the acid diffusion control agent with respect to the total solid content mass in the resist composition.

In a case where the resist composition includes a plurality of components, as the content of the components in the resist composition, which is selected as the physical quantity, only the content of a part of the plurality of components included in the resist composition may be used, or each content of all the components included in the resist composition may be used. That is, it is sufficient that the content of at least a part of the plurality of components included in the resist composition is used. For example, in a resist composition including an acid-decomposable resin, a photoacid generator, and an acid diffusion control agent, only the content of the acid-decomposable resin with respect to the total solid content mass in the resist composition may be selected as the physical quantity, or three values of the content of the acid-decomposable resin with respect to the total solid content mass in the resist composition, the content of the photoacid generator with respect to the total solid content mass in the resist composition, and the content of the acid diffusion control agent with respect to the total solid content mass in the resist composition may be selected as the physical quantity.

The above-described total solid content means components in the resist composition, excluding a solvent, and even in a case where a component is liquid, the component is treated as the solid content.

The above-described physical quantity includes at least the content of components in the resist composition, and may include a physical quantity other than the content of components in the resist composition.

Examples of other physical quantities include a weight-average molecular weight of the acid-decomposable resin, a refractive index of the acid-decomposable resin, and a molecular weight distribution of the acid-decomposable resin.

A method for measuring method the weight-average molecular weight of the acid-decomposable resin is not particularly limited, and the weight-average molecular weight can be measured by a gel permeation chromatography (GPC) analysis method.

A known device can be used in the GPC analysis method.

An installation location of the device used in the GPC analysis method is not particularly limited, and a location provided with air conditioning equipment is preferable.

From the viewpoint of stable liquid feed rate, a pump part included in the device used in the GPC analysis method preferably has a high liquid feeding accuracy, and also preferably has a temperature control function.

A column part included in the device used in the GPC analysis method preferably has a temperature control function.

Examples of a detector included in the device used in the GPC analysis method include a differential refractometer (RI) or an ultraviolet-visible spectrophotometer. In a case where the acid-decomposable resin is a polymer consisting only of monomers having no aromatic ring, it is preferable to perform the measurement by RI.

As a column included in the device used in the GPC analysis method, a commercially available column can be used. Examples of a filler include silica-based particles, polymethacrylate-based resin particles, and crosslinked polystyrene-based resin particles. In addition, in order to obtain a required separation ability, a plurality of columns may be connected and used. Further, in order to obtain a high separation ability, a filler having a small particle size may be used.

An eluent used in the GPC analysis method is not particularly limited, and examples thereof include various organic solvents and water. A flow rate of the eluent is not particularly limited, but is preferably in a range of 0.5 to 2.0 mL/min.

A sample concentration in the GPC analysis method is not particularly limited, but is preferably adjusted in a range of 0.1% to 10% by mass.

A sample injection amount in the GPC analysis method is not particularly limited, but is preferably in a range of 1 to 100 $\mu$L.

To reduce a daily difference, the measurement of the standard sample for generating a calibration curve is preferably performed within 24 hours of the sample measurement. In addition, an internal standard method may be used in which an internal standard sample is added to the sample to correct the holding time thereof.

The number of measurements in the GPC analysis method is not particularly limited, but a plurality of measurements may be performed and an average value thereof may be used in order to improve the measurement accuracy.

The number of parameters set in the step S10 is not particularly limited, and examples thereof include multiple values including at least the content of the repeating unit included in the acid-decomposable resin with respect to all repeating units and the physical quantity including at least the content of components in the above-described resist composition.

Among these, from the viewpoint that the effects of the present invention are more excellent, the number of physical quantities is preferably 2 or more, more preferably 3 or more, and still more preferably 4 or more. The upper limit is not particularly limited, and is preferably 10 or less.

Next, a plurality of resist compositions for a regression analysis, which include at least the acid-decomposable resin and the photoacid generator, is produced with at least one of the parameters of the content of the repeating unit included in the acid-decomposable resin with respect to all repeating units and the above-described physical quantity, which are set in the setting step (step S10), as a variable. Using each of the produced resist compositions for a regression analysis, a pattern size for a regression analysis is acquired by performing a pattern forming treatment including an exposure treatment and a development treatment so that a target pattern size is obtained (step S12).

In the above-described acquisition step of the step S12, first, a plurality of resist compositions for a regression analysis, which include at least the acid-decomposable resin and the photoacid generator, is produced with at least one of the parameters set in the setting step as a variable. As an example, in a case where the content of the repeating unit included in the acid-decomposable resin with respect to all repeating units and the content of components in the resist composition are selected as parameters, and the content of components in the resist composition is selected as a variable, a plurality of resist compositions for a regression analysis is produced by fixing the content of the repeating unit included in the acid-decomposable resin with respect to all repeating units and changing content of components in the resist composition. That is, a plurality of resist compositions for a regression analysis, in which the content of the repeating unit included in the acid-decomposable resin with respect to all repeating units is constant and the content of components in the resist composition is different, is produced.

In addition, in the above-described example, for example, in a case where the content of the repeating unit included in the acid-decomposable resin with respect to all repeating units is selected as a variable, a plurality of resist compositions for a regression analysis may be produced by fixing the content of components in the resist composition and changing the content of the repeating unit included in the acid-decomposable resin with respect to all repeating units.

In addition to the above, in a case where both of the content of the repeating unit included in the acid-decomposable resin with respect to all repeating units and the content of components in the resist composition are selected as variables, a plurality of resist compositions for a regression analysis may be produced by changing the both.

In a case of producing a plurality of the above-described resist compositions for a regression analysis, the type of repeating units in the acid-decomposable resin is not changed.

Next, as described above, using each of the produced resist compositions for a regression analysis, a pattern size for a regression analysis is acquired by performing a pattern forming treatment including an exposure treatment and a development treatment so that a target pattern size is obtained. That is, by performing a pattern forming treatment using each of the resist compositions for a regression analysis so as to obtain a target pattern size, a predetermined pattern is formed and a size of the pattern (pattern size for a regression analysis) is acquired.

The pattern forming treatment for obtaining the target pattern size is a pattern forming treatment performed for obtaining the target pattern size, and is a treatment including a series of operations in which a resist film is produced using the resist composition for regression analysis, and the produced resist film is exposed and developed. That is, the above-described pattern forming treatment includes at least a film forming treatment for producing a resist film using the resist composition for a regression analysis, an exposure treatment, and a development treatment. Conditions are appropriately set for each treatment so that the target pattern size is obtained.

For example, in the film forming treatment, the type of a base material used, a film thickness of the resist film to be formed, and the like are appropriately set. In addition, in the exposure treatment, the type of exposure light, the type of mask, the exposure amount, and the like are appropriately set. In the development treatment, the type of a developer used and development conditions (for example, the temperature of the developer, the contact time with the developer, and the presence or absence of a drying treatment) are appropriately set.

The pattern forming treatment may include a treatment (for example, a rinsing treatment) other than the film forming treatment, the exposure treatment, and the development treatment.

That is, in order to obtain the target pattern size, the same pattern forming treatment is applied to the plurality of resist films.

For example, in a case where a target pattern size is set to 25 nm in a line width of a line-shaped pattern, as a pattern forming treatment for obtaining the target pattern size through a series of set treatments including a film forming treatment in which a film thickness of the resist film is set to 45 nm, an exposure treatment in which the resist film is exposed with EUV at an exposure amount of 30 ($mJ/cm^2$) using a mask having a line/space = 25 nm/25 nm, and a development treatment in which the resist film is developed for 30 seconds using an aqueous solution of tetramethylammonium hydroxide (2.38% by mass) as a developer, the same exposure treatment and development treatment are performed on a plurality of resist films to form a pattern, thereby obtaining a predetermined pattern size (pattern size for a regression analysis).

In the acquisition step of the step S12, the pattern size for a regression analysis obtained by exposing the resist film is measured using, for example, a transmission electron microscope (TEM).

Next, a regression analysis is performed on the pattern size for a regression analysis, which is obtained in the acquisition step (step S12), using the parameter as the variable as an explanatory variable and using the target pattern size as an objective variable (step S14).

The regression analysis in the analysis step of the step S14 is not particularly limited, and is appropriately determined according to the number of parameters and the like. In addition, the regression analysis may be a multivariate analysis, and is preferably a multiple regression analysis.

A method of the multiple regression analysis is well known. Examples thereof include a method described in "Yukihiro Ozaki, Akihumi Uda, Toshio Akai, "Multivariate Analysis for Chemist (Introduction Chemometrix)", Kodansha Co., Ltd.".

In a case of performing the above-described multiple regression analysis, a multiple regression equation used in the calculation step (step S16) described later can be created in advance by carrying out this step. In a case where the content of the repeating unit included in the acid-decomposable resin with respect to all repeating units and the content of components in the resist composition are selected as parameters, examples of the multiple regression equation include a multiple regression equation in which the content of the repeating unit included in the acid-decomposable resin with respect to all repeating units and the content of components in the resist composition are selected as variables.

The following multiple regression equation is an example, and the present invention is not limited to the following multiple regression equation.

$$Y = b1X1 + b2X2 + ... + bmXm + b0 \text{ (multiple regression equation)}$$

In the multiple regression equation, b 1 to bm and b0 represent a constant obtained by the multiple regression analysis, X1 to Xm represent m types of parameters, and Y represents a pattern size (for example, a line width of the line-shaped pattern or a diameter of the hole). For example, as described above, in a case where the content of the repeating unit included in the acid-decomposable resin with respect to all repeating units, the content (% by mass) of the photoacid generator with respect to the total solid content mass in the resist composition, and the weight-average molecular weight of the acid-decomposable resin are set as parameters, the following multiple regression equation is obtained. In the following equation, a case where the acid-decomposable resin includes three kinds of a repeating unit

A, a repeating unit B, and a repeating unit C is shown.

$$Y = b1X1 + b2X2 + b3X3 + b4X4 + b5X5 + b0$$

In the above-described multiple regression equation, b 1 to b5 and b0 represent a constant obtained by the multiple regression analysis, X1 represents the content (% by mass) of the repeating unit A included in the acid-decomposable resin with respect to all repeating units, X2 represents the content (% by mass) of the repeating unit B included in the acid-decomposable resin with respect to all repeating units, X3 represents the content (% by mass) of the repeating unit C included in the acid-decomposable resin with respect to all repeating units, X4 represents the content (% by mass) of the photoacid generator with respect to the total solid content mass in the resist composition, X5 represents the weight-average molecular weight of the acid-decomposable resin, and Y represents a pattern size (for example, a line width of the line-shaped pattern or a diameter of the hole).

As will be described later, by substituting predetermined parameters of the target resist composition into the above-described multiple regression equation, it is possible to obtain a pattern size obtained by performing the exposure treatment and the development treatment so as to obtain the above-described target pattern size using the target resist composition, that is, to obtain an expected value.

Next, the content of the repeating unit included in the acid-decomposable resin, which is a component in the target resist composition, with respect to all repeating units is measured by a nuclear magnetic resonance spectroscopy, and based on the regression analysis in the analysis step, a pattern size of the target resist composition is calculated using the obtained content of the repeating unit included in the acid-decomposable resin with respect to all repeating units and the physical quantity used as the explanatory variables of the target resist composition which is a determining target of a formulating amount (step S 16).

As described above, the target resist composition includes the same types of components as the components in the resist composition for a regression analysis, and is a composition for determining the formulating amount of each component in a case of producing a resist composition in a producing step described later.

In addition, in the target resist composition, each component is formulated based on the formulating amount of each component expected to achieve the target pattern size. That is, the formulating amount of each component in the target resist composition is an expected formulation showing predetermined performance.

The target resist composition may be any composition in which the components used and the formulating amount thereof are determined in order to calculate the pattern size described later, and in this step, it is not necessary that the target resist composition itself is actually produced.

As described above, the above-described target resist composition includes the same types of components as the components in the resist composition for a regression analysis. For example, in a case where the resist composition for a regression analysis includes, as components, an acid-decomposable resin X including a specific repeating unit A and a specific repeating unit B, a photoacid generator Y, and a solvent X, the above-described target resist composition also includes the acid-decomposable resin X, the photoacid generator Y, and the solvent X.

Lot numbers may be different in the same type of components included in the target resist composition and the resist composition for a regression analysis. For example, the acid-decomposable resin included in the target resist composition and the acid-decomposable resin included in the resist composition for a regression analysis may have different lot numbers at different production times.

As described above, in a case where a lot of the raw material itself of the resist composition such as the acid-decomposable resin changes, even in a case where the resist composition is produced with the same raw material compositional ratio as before, the performance may be different from that of the previous resist composition. On the other hand, for example, by performing the procedure of the present invention using components of different lots as components in the target resist composition, it is possible to produce a resist composition with good reproducibility even in a case where the components of a new lot are used.

In the step S16, the pattern size (expected value) in a case where the pattern is formed of the target resist composition is calculated. In the step S 16, first, the content of the repeating unit included in the acid-decomposable resin which is a component in the target resist composition with respect to all repeating units is measured by a nuclear magnetic resonance spectroscopy. The measurement by the nuclear magnetic resonance spectroscopy is usually carried out by dissolving the acid-decomposable resin in a predetermined measurement solvent.

Examples of the nuclear magnetic resonance (NMR) spectroscopy include $^{1}H$ NMR method and $^{13}C$ NMR method. In a case of using the $^{13}C$ NMR method, since the sensitivity is much lower than that of the $^{1}H$ NMR method, it is preferable to use measurement conditions as shown below.

A frequency of an equipment used in the nuclear magnetic resonance spectroscopy is not particularly limited, but from the viewpoint of improving the sensitivity, is preferably 400 MHz or more and more preferably 500 MHz or more.

From the viewpoint of improving the sensitivity, a probe in the nuclear magnetic resonance spectroscopy

preferably has a large probe diameter or an extremely low temperature probe. In addition, a coil preferably has a coil corresponding to various measurements installed inside.

From the viewpoint of improving the sensitivity, a sample tube in the nuclear magnetic resonance spectroscopy preferably has a thin tube thickness and a high thickness uniformity.

In nuclear magnetic resonance spectroscopy, various deuterated solvents (acetone, tetrahydrofuran, methanol, dimethyl sulfoxide, and the like) can be used as a measurement solvent.

From the viewpoint that the effects of the present invention are more excellent, the number of times of integration in the nuclear magnetic resonance spectroscopy is preferably 5000 or more, more preferably 10000 or more, and still more preferably 20000 or more. As the number of times of integration is larger, the accuracy of the measured value is higher but the measurement times is longer, so that the number of times of integration may be 50000 or less.

In addition, it is also preferable to perform multiple measurements in the nuclear magnetic resonance spectroscopy and use a calculated average value of the compositional ratio.

In the nuclear magnetic resonance spectroscopy, a relaxation agent may be used in order to shorten the relaxation time and improve the quantitativeness of the compositional ratio. Examples of the relaxation agent include various metal salts (chromium acetylacetone complex, iron acetylacetone complex, and the like).

From the viewpoint of improving the sensitivity, a sample concentration in the nuclear magnetic resonance spectroscopy is preferably 20% by mass or more, and more preferably 25% by mass or more.

From the viewpoint of shortening the relaxation time, a measured temperature in the nuclear magnetic resonance spectroscopy is preferably set high to an extent that decomposition of the sample and volatilization of the solvent do not matter.

In this step, the physical quantity is used as the explanatory variable of the target resist composition.

Specifically, for example, in a case where the content (% by mass) of the photoacid generator with respect to the total solid content mass in the resist composition and the weight-average molecular weight of the acid-decomposable resin are used as the physical quantities as the explanatory variables, the content (% by mass) of the photoacid generator included in the target resist composition with respect to the total solid content mass in the resist composition and the weight-average molecular weight of the acid-decomposable resin included in the target resist composition are each obtained.

Based on the regression analysis in the analysis step, a pattern size of the target resist composition is calculated using the content of the repeating unit included in the acid-decomposable resin with respect to all repeating units, which is obtained by the nuclear magnetic resonance spectroscopy, and the physical quantity used as the explanatory variable of the resist composition which is a determining target of a formulating amount.

For example, as described above, in a case where the regression analysis in the analysis step is a multiple regression analysis, by substituting, into the multiple regression equation obtained in the analysis step, the content of the repeating unit included in the acid-decomposable resin with respect to all repeating units, which is obtained by the nuclear magnetic resonance spectroscopy, and the physical quantity used as the explanatory variable of the resist composition which is a determining target of a formulating amount, the pattern size of the pattern obtained by using the target resist composition can be predicted. That is, the predicted value of the pattern size obtained by using the target resist composition can be calculated as the calculated value.

Next, the pattern size of the target resist composition obtained in the calculation step (step S16) is compared with the target pattern size (step S18).

In the comparison step of the step S18, in a case where the difference between the above-described pattern size of the target resist composition and the above-described target pattern size is out of the allowable range, the formulating amount of the resist composition is determined based on the regression analysis of the analysis step (step S14) (step S20).

In the above-described determination step of the step S20, the formulating amount of the resist composition within the allowable range with respect to the above-described target pattern size is determined.

Thereafter, a resist composition is produced based on the formulating amount of the resist composition, which is determined in the determination step (step S20) (step S22). By the producing step of the step S22, a resist composition having the target pattern size is obtained.

The above-described resist composition includes the same components as those in the target resist composition. That is, the resist composition is produced using the same components as those planned to be used in the target resist composition. More specifically, as the components in the resist composition and the components in the target resist composition, those manufactured at the same time (same lot number) are used. In this case, as described above, the formulating amount of each component is based on the formulating amount determined in the step S20.

In addition, the allowable range of the above-described difference in the above-described comparison step can be appropriately set. For example, the allowable range may be that the difference from the target pattern size is within $\pm$ 0.5 nm, may be that the difference from the target pattern size is within $\pm$ 0.1 nm, or may be that the difference from the target pattern size is 0.

On the other hand, in the comparison step of the step S18, in a case where the difference between the above-described pattern size of the target resist composition and the above-described target pattern size is out of the allowable range, at least the content of the components in the target resist composition among the physical quantities used as the explanatory variables in the target resist composition is changed such that the difference between the pattern size of the target resist composition and the target pattern size is within the allowable range, thereby adjusting the formulating amount of the target resist composition (step S24).

For example, in a case where the content (% by mass) of the photoacid generator with respect to the total solid content mass in the resist composition is selected as one of the physical quantities used as the explanatory variables, the formulating amount of the target resist composition can be adjusted by changing the content (% by mass) of the photoacid generator with respect to the total solid content mass in the resist composition.

In the change step, the formulating amount of the target resist composition is changed, but at least the above-described content of components in the target resist composition may be changed, and other physical quantities may be changed at the same time.

In addition, in a case where the formulating amount of the target resist composition is adjusted by changing the physical quantity used as the explanatory variable in the target resist composition, the difference between the pattern size of the target resist composition and the target pattern size is adjusted to be within the allowable range, but in this case, it is preferable to adjust the formulating amount so that the difference is close to 0 (preferably, is 0).

Based on the physical quantity changed in the change step, the formulating amount of the target resist composition is determined in the determination step (step S20). Next, in the producing step (step S22), the resist composition is produced by the producing unit 18 (see Fig. 1) as described above based on the formulating amount determined in the determination step (step S20).

The method for producing a resist composition is not particularly limited.

In the production of the resist composition, for example, it is preferable to dissolve the various components, such as the acid-decomposable resin and the photoacid generator, in the solvent, and then perform a filtration (may be a circulatory filtration) using a plurality of filters having different materials. For example, it is preferable to connect a polyethylene-made filter having a pore diameter of 50 nm, a nylon-made filter having a pore diameter of 10 nm, and a polyethylene-made filter having a pore diameter of 3 to 5 nm in permuted connection, and then perform the filtration. As for the filtration, a method of performing circulatory filtration twice or more is also preferable. The above-described filtration step also has an effect of reducing the content of the metal atom in the resist composition. A smaller pressure difference between the filters is more preferable, and the pressure difference is preferably 0.1 MPa or less, more preferably 0.05 MPa or less, and still more preferably 0.01 MPa or less.

In addition, as a method for performing the circulatory filtration using a filter in the production of the resist composition, for example, a method of performing the circulatory filtration twice or more using a polytetrafluoroethylene-made filter having a pore diameter of 50 nm is also preferable.

In the resist composition, it is preferable that the content of the metal atom is reduced.

Examples of the method for reducing the content of the metal atom in the resist composition include a method for adjusting the content by filtration using a filter. As for a filter pore diameter, the pore size is preferably less than 100 nm, more preferably 10 nm or less, and still more preferably 5 nm or less. As a filter, a polytetrafluoroethylene-made filter, a polyethylene-made filter, or a nylon-made filter is preferable. The filter may be composed of a composite material in which the above-described filter material is combined with an ion exchange medium. As the filter, a filter which has been previously washed with an organic solvent may be used. In the step of filter filtration, plural kinds of filters connected in series or in parallel may be used. In a case of using the plural kinds of filters, a combination of filters having different pore diameters and/or materials may be used. In addition, various materials may be filtered plural times, and the step of filtering plural times may be a circulatory filtration step.

In addition, examples of the method for reducing the content of the metal atom in the resist composition include a method of selecting raw materials having a low content of metals as raw materials constituting the various materials in the resist composition, a method of subjecting raw materials constituting the various materials in the resist composition to filter filtration, and a method of performing distillation under the condition for suppressing the contamination as much as possible by, for example, lining the inside of a production device with TEFLON (registered trademark).

In addition, as the method for reducing the content of the metal atom in the resist composition, removal with an adsorbing material may be performed, in addition to the above-described filter filtration, and the filter filtration and the adsorbing material may be used in combination. As the adsorbing material, known adsorbing materials can be used, and for example, inorganic adsorbing materials such as silica gel and zeolite and organic adsorbing materials such as activated carbon can be used.

In addition, it is necessary to prevent the incorporation of metal impurities in the production process in order to reduce the content of the metal atom in the composition. Sufficient removal of the metal impurities from a production device can be confirmed by measuring the content of metal components included in a washing solution used to wash the production device.

In the resist composition produced as described above, typically, in a case where an alkali developer is adopted as the developer, a positive tone pattern is suitably formed, and in a case where an organic developer is adopted as the developer, a negative tone pattern is suitably formed. That is, the resist composition may be a negative tone resist composition or a positive tone resist composition.

<Resist film and pattern forming method>

A pattern can be formed by using the resist composition produced by the above-described production method according to the embodiment of the present invention.
A procedure of a pattern forming method using the resist composition produced by the above-described production method according to the embodiment of the present invention is not particularly limited, but preferably includes the following steps.
Step 1: step of forming a resist film using the resist composition
Step 2: step of exposing the resist film
Step 3: step of developing the exposed resist film using a developer to form a pattern
Hereinafter, the procedure of each of the above-described steps will be described in detail.

(Step 1: resist film forming step)

The step 1 is a step of forming a resist film on a substrate using the resist composition.
The resist composition includes at least an acid-decomposable resin and a photoacid generator, and details of the components in the resist composition will be described in detail later.
Examples of a method for forming a resist film using the resist composition include a method in which a resist composition is applied to a substrate.
The resist composition can be applied to a substrate (for example, silicon and silicon dioxide coating) as used in the manufacture of integrated circuit elements by a suitable application method such as an application using a spinner or a coater. The application method is preferably a spin application using a spinner. A rotation speed upon the spin application using a spinner is preferably 1000 to 3000 rpm.
After the application of the resist composition, the substrate may be dried to form a resist film. In addition, various underlying films (an inorganic film, an organic film, or an antireflection film) may be formed on an underlayer of the resist film as necessary.
Examples of the drying method include a method of heating and drying. The heating can be carried out using a unit included in an ordinary exposure machine and/or development machine, and may also be carried out using a hot plate or the like. A heating temperature is preferably 80°C to 150°C, more preferably 80°C to 140°C, and still more preferably 80°C to 130°C. A heating time is preferably 30 to 1000 seconds, more preferably 60 to 800 seconds, and still more preferably 60 to 600 seconds.
A film thickness of the resist film is not particularly limited, but from the viewpoint that a fine pattern having higher accuracy can be formed, is preferably 10 to 150 nm and more preferably 15 to 100 nm.
A topcoat may be formed on the upper layer of the resist film using a topcoat composition.
It is preferable that the topcoat composition is not mixed with the resist film and can be uniformly applied to the upper layer of the resist film.
In addition, it is preferable that the resist film is dried before forming the topcoat.
The film thickness of the topcoat is preferably 10 to 200 nm, and more preferably 20 to 100 nm.

(Step 2: exposure step)

The step 2 is a step of exposing the resist film.
Examples of an exposing method include a method in which the formed resist film is irradiated with actinic rays or radiation through a predetermined mask.
Examples of the actinic rays or radiation include infrared light, visible light, ultraviolet light, far ultraviolet light, extreme ultraviolet light, X-rays, and electron beams, preferably a far ultraviolet light having a wavelength of 250 nm or less, more preferably a far ultraviolet light having a wavelength of 220 nm or less, and particularly preferably a far ultraviolet light having a wavelength of 1 to 200 nm, specifically, KrF excimer laser (248 nm), ArF excimer laser (193 nm), $F_2$ excimer laser (157 nm), EUV (13 nm), X-rays, and electron beams. Among these, EUV (13 nm), X-rays, or electron beams is preferable, EUV (13 nm) or electron beams is more preferable, and EUV (13 nm) is still more preferable.
It is preferable to perform baking (heating) before performing development and after the exposure. The baking accelerates a reaction in the exposed portion, and the sensitivity and the pattern shape are improved.
A heating temperature is preferably 80°C to 150°C, more preferably 80°C to 140°C, and still more preferably

80°C to 130°C.

A heating time is preferably 10 to 1000 seconds, more preferably 10 to 180 seconds, and still more preferably 30 to 120 seconds.

The heating can be performed using a unit included in an ordinary exposure machine and/or development machine, or may also be performed using a hot plate or the like.

This step is also referred to as a post-exposure baking.

(Step 3: development step)

The step 3 is a step of developing the exposed resist film using a developer to form a pattern.

Examples of a developing method include a method in which the substrate is immersed in a tank filled with a developer for a certain period of time (a dipping method), a method in which a development is performed by heaping a developer up onto the surface of the substrate by surface tension, and then leaving it to stand for a certain period of time (a puddle method), a method in which a developer is sprayed on the surface of the substrate (a spraying method), and a method in which a developer is continuously jetted onto the substrate rotating at a constant rate while scanning a developer jetting nozzle at a constant rate (a dynamic dispensing method).

In addition, after the step of performing the development, a step of stopping the development may be carried out while replacing the solvent with another solvent.

A developing time is not particularly limited as long as it is a period of time where the non-exposed portion of the resin is sufficiently dissolved, and is preferably 10 to 300 seconds and more preferably 20 to 120 seconds.

A temperature of the developer is preferably 0°C to 50°C and more preferably 15°C to 35°C.

Examples of the developer include an alkali developer and an organic solvent developer.

As the alkali developer, it is preferable to use an alkali aqueous solution including an alkali. The type of the alkali aqueous solution is not particularly limited, and examples thereof include an alkali aqueous solution including a quaternary ammonium salt typified by tetramethylammonium hydroxide, an inorganic alkali, a primary amine, a secondary amine, a tertiary amine, an alcoholamine, a cyclic amine, or the like. Among these, the alkali developer is preferably aqueous solutions of the quaternary ammonium salts typified by tetramethylammonium hydroxide (TMAH). An appropriate amount of alcohols, a surfactant, or the like may be added to the alkali developer. An alkali concentration of the alkali developer is usually 0.1% to 20% by mass. In addition, a pH of the alkali developer is usually 10.0 to 15.0.

The organic solvent developer is a developer including an organic solvent.

A vapor pressure of the organic solvent included in the organic solvent developer (in a case of a mixed solvent, a vapor pressure as a whole) is preferably 5 kPa or less, more preferably 3 kPa or less, and still more preferably 2 kPa or less at 20°C. By setting the vapor pressure of the organic solvent to 5 kPa or less, evaporation of the developer on the substrate or in a development cup is suppressed, temperature uniformity in a wafer plane is improved, and as a result, dimensional uniformity in the wafer plane is improved.

Examples of the organic solvent used in the organic solvent developer include known organic solvents, and include an ester-based solvent, a ketone-based solvent, an alcohol-based solvent, an amide-based solvent, an ether-based solvent, and a hydrocarbon-based solvent.

It is preferable to use an ester-based solvent having 7 or more carbon atoms (preferably 7 to 14 carbon atoms, more preferably 7 to 12 carbon atoms, and still more preferably 7 to 10 carbon atoms), and 2 or less heteroatoms as the organic solvent included in the organic solvent developer, from the viewpoint that swelling of the resist film can be suppressed in a case where EUV and electron beams are used in the above-described exposure step.

The heteroatom of the ester-based solvent is an atom other than a carbon atom and a hydrogen atom, and examples thereof include an oxygen atom, a nitrogen atom, and a sulfur atom. The number of the heteroatoms is preferably 2 or less.

As the ester-based solvent having 7 or more carbon atoms and 2 or less heteroatoms, amyl acetate, isoamyl acetate, 2-methylbutyl acetate, 1-methylbutyl acetate, hexyl acetate, pentyl propionate, hexyl propionate, butyl propionate, isobutyl isobutyrate, heptyl propionate, or butyl butanoate is preferable, and isoamyl acetate is more preferable.

In a case where EUV and electron beams are used in the above-described exposure step, a mixed solvent of the ester-based solvent and the hydrocarbon-based solvent or a mixed solvent of the ketone-based solvent and the hydrocarbon-based solvent may be used instead of the ester-based solvent having 7 or more carbon atoms and having 2 or less heteroatoms as the organic solvent included in the organic solvent developer. Also in this case, it is effective in suppressing the swelling of the resist film.

In a case where the ester-based solvent and the hydrocarbon-based solvent are used in combination, it is preferable to use isoamyl acetate as the ester-based solvent. In addition, from the viewpoint of adjusting the solubility of the resist film, as the hydrocarbon-based solvent, a saturated hydrocarbon-based solvent (for example, octane, nonane, decane, dodecane, undecane, and hexadecane) is preferable.

In a case where the ketone-based solvent and the hydrocarbon-based solvent are used in combination, it is

preferable to use 2-heptanone as the ketone-based solvent. In addition, from the viewpoint of adjusting the solubility of the resist film, as the hydrocarbon-based solvent, a saturated hydrocarbon-based solvent (for example, octane, nonane, decane, dodecane, undecane, and hexadecane) is preferable.

In a case of using the above-described mixed solvent, since a content of the hydrocarbon-based solvent depends on the solubility of the resist film in a solvent, the content is not particularly limited, and the content may be appropriately prepared to determine a necessary amount of the hydrocarbon-based solvent.

A plurality of the above-described organic solvents may be mixed, or the organic solvent may also be used in admixture with a solvent other than those described above or water. However, in order to fully exert the effects of the present invention, a moisture content of the developer as a whole is preferably less than 10% by mass, and the developer is more preferably substantially free of the moisture. A concentration of the organic solvent (in a case of mixing a plurality of organic solvents, a total thereof) in the developer is preferably 50% by mass or more, more preferably 50% to 100% by mass, still more preferably 85% to 100% by mass, particularly preferably 90% to 100% by mass, and most preferably 95% to 100% by mass.

(Other steps)

It is preferable that the above-described pattern forming method includes a step of performing washing using a rinsing liquid after the step 3.

Examples of the rinsing liquid used in the rinsing step after the step of performing development using a developer include pure water. An appropriate amount of a surfactant may be added to the pure water.

An appropriate amount of a surfactant may be added to the rinsing liquid.

A method for the rinsing step is not particularly limited, and examples thereof include a method in which the rinsing liquid is continuously jetted onto the substrate rotated at a constant rate (a spin coating method), a method in which the substrate is immersed in a tank filled with the rinsing liquid for a certain period of time (a dipping method), and a method in which the rinsing liquid is sprayed on the surface of the substrate (a spraying method).

In addition, the pattern forming method according to the embodiment of the present invention may include a heating step (post bake) after the rinsing step. By this step, the developer and the rinsing liquid remaining between and inside the patterns are removed by baking. In addition, this step also has an effect that a resist pattern is annealed and the surface roughness of the pattern is improved. The heating step after the rinsing step is usually performed at 40°C to 250°C (preferably 90°C to 200°C) for usually 10 seconds to 3 minutes (preferably 30 to 120 seconds).

In addition, an etching treatment on the substrate may be carried out using the formed pattern as a mask. That is, the substrate (or the underlayer film and the substrate) may be processed using the pattern formed in the step 3 as a mask to form a pattern on the substrate.

A method for processing the substrate (or the underlayer film and the substrate) is not particularly limited, but a method in which a pattern is formed on a substrate by subjecting the substrate (or the underlayer film and the substrate) to dry etching using the pattern formed in the step 3 as a mask is preferable.

The dry etching may be one-stage etching or multi-stage etching. In a case where the etching is an etching including a plurality of stages, etchings at the respective stages may be the same treatment or different treatments.

For etching, any of known methods can be used, and various conditions and the like are appropriately determined according to the type of the substrate, usage, and the like. The etching can be carried out, for example, in accordance with Journal of The International Society for Optical Engineering (Proc. of SPIE), Vol. 6924, 692420 (2008), JP2009-267112A, and the like. In addition, the etching can also be carried out in accordance with "Chapter 4 Etching" in "Semiconductor Process Text Book, 4th Ed., published in 2007, publisher: SEMI Japan".

Among these, oxygen plasma etching is preferable as the dry etching.

Various materials (for example, a developer, a rinsing liquid, a composition for forming an antireflection film, and a composition for forming a topcoat) other than the resist composition used in the pattern forming method according to the embodiment of the present invention preferably have smaller amounts of impurities such as a metal (for example, Na, K, Ca, Fe, Cu, Mg, Al, Li, Cr, Ni, Sn, Ag, As, Au, Ba, Cd, Co, Pb, Ti, V, W, and Zn). A content of the impurities included in these materials is preferably, for example, 1 ppm by mass or less.

Examples of a method for reducing the impurities such as metals in the various materials other than the resist composition include filtration using a filter. As for a filter pore diameter, the pore size is preferably less than 100 nm, more preferably 10 nm or less, and still more preferably 5 nm or less. As a filter, a polytetrafluoroethylene-made filter, a polyethylene-made filter, or a nylon-made filter is preferable. The filter may be composed of a composite material in which the above-described filter material is combined with an ion exchange medium. As the filter, a filter which has been previously washed with an organic solvent may be used. In the step of filter filtration, plural kinds of filters connected in series or in parallel may be used. In a case of using the plural kinds of filters, a combination of filters having different pore diameters and/or materials may be used. In addition, various materials may be filtered plural times, and the step of filtering plural times may be a circulatory filtration step.

In addition, examples of a method for reducing the impurities such as metals in the various materials other than the resist composition include a method of selecting raw materials having a low content of metals as raw materials constituting the various materials, a method of subjecting raw materials constituting the various materials to filter filtration, and a method of performing distillation under the condition for suppressing the contamination as much as possible by, for example, lining the inside of a device with TEFLON (registered trademark).

In addition, as the method for reducing impurities such as a metal in the various materials other than the composition, removal of impurities with an adsorbing material may be performed, in addition to the above-described filter filtration, and the filter filtration and the adsorbing material may be used in combination. As the adsorbing material, known adsorbing materials can be used, and for example, inorganic adsorbing materials such as silica gel and zeolite and organic adsorbing materials such as activated carbon can be used. It is necessary to prevent the incorporation of metal impurities in the production process in order to reduce the impurities such as metals included in the various materials other than the above-described composition. Sufficient removal of the metal impurities from a production device can be confirmed by measuring the content of metal components included in a washing solution used to wash the production device.

A conductive compound may be added to an organic treatment liquid such as the rinsing liquid in order to prevent breakdown of chemical liquid pipes and various parts (a filter, an O-ring, a tube, or the like) due to electrostatic charging, and subsequently generated electrostatic discharging. The conductive compound is not particularly limited, and examples thereof include methanol. An addition amount is not particularly limited, but from the viewpoint that preferred development characteristics or rinsing characteristics are maintained, the addition amount is preferably 10% by mass or less and more preferably 5% by mass or less.

For members of the chemical liquid pipe, various pipes coated with stainless steel (SUS), or a polyethylene, polypropylene, or a fluororesin (polytetrafluoroethylene, a perfluoroalkoxy resin, or the like) that has been subjected to an antistatic treatment can be used. In the same manner, for the filter or the O-ring, polyethylene, polypropylene, or a fluororesin (polytetrafluoroethylene, a perfluoroalkoxy resin, and the like) that has been subjected to an antistatic treatment can be used.

A method for improving the surface roughness of the pattern may be adopted to the pattern formed by the method according to the embodiment of the present invention. Examples of the method for improving the surface roughness of the pattern include the method of treating a pattern by a plasma of a hydrogen-containing gas described in WO2014/002808A. Additional examples of the method include known methods as described in JP2004-235468A, US2010/0020297A, JP2008-083384A, and Proc. of SPIE Vol. 8328 83280N-1 "EUV Resist Curing Technique for LWR Reduction and Etch Selectivity Enhancement".

In a case where the formed pattern is in a form of a line, an aspect ratio determined by dividing a height of the pattern with a line width of the pattern is preferably 2.5 or less, more preferably 2.1 or less, and still more preferably 1.7 or less.

In a case where the formed pattern is in a form of a trench (groove) pattern or a contact hole pattern, an aspect ratio determined by dividing a height of the pattern with a trench width or hole diameter of the pattern is preferably 4.0 or less, more preferably 3.5 or less, and still more preferably 3.0 or less.

The pattern forming method according to the embodiment of the present invention can also be used for forming a guide pattern in a directed self-assembly (DSA) (see, for example, ACS Nano Vol. 4, No. 8, Pages 4815-4823).

In addition, a pattern formed by the above-described method can be used as a core material (core) of the spacer process described in, for example, JP1991-270227A (JP-H3-270227A) and JP2013-164509A.

<Method for manufacturing electronic device>

In addition, the present invention further relates to a method for manufacturing an electronic device, including the above-described pattern forming method, and an electronic device manufactured by this manufacturing method.

The electronic device according to the embodiment of the present invention is suitably mounted on electric and electronic apparatus (for example, home appliances, office automation (OA)-related equipment, media-related equipment, optical equipment, telecommunication equipment, and the like).

<Resist composition>

Hereinafter, each component included in the resist composition produced by the producing step will be described in detail.

The resist composition includes an acid-decomposable resin (hereinafter, also referred as a "resin (A)") and a photoacid generator. As will be described later, the resist composition may include a component other than the above-described components.

Examples of each component which can be included in the resist compositions for a regression analysis used

in the above-described acquisition step and the target resist composition used in the calculation step include each component described later.

In the resist composition, an A value determined by Expression (1) is preferably 0.130 or more.

In a case where the A value is high, the absorption efficiency for EUV and electron beams of a resist film formed from the resist composition increases. The A value represents the absorption efficiency of EUV and electron beams of the resist film in terms of a mass proportion.

$$\text{Expression (1): } A = ([H] \times 0.04 + [C] \times 1.0 + [N] \times 2.1 + [O] \times 3.6 + [F] \times 5.6 + [S] \times 1.5 + [I] \times 39.5)/([H] \times 1 + [C] \times 12 + [N] \times 14 + [O] \times 16 + [F] \times 19 + [S] \times 32 + [I] \times 127)$$

As described above, the A value is 0.130 or more, but from the viewpoint that at least one of a point that the resolution of the resist film is even more excellent or a point that the LWR performance of a pattern thus formed is even more excellent can be obtained, it is preferable that the A value is 0.135 or more. An upper limit thereof is not particularly limited, but in a case where the A value is extremely high, the transmittance of EUV and electron beams of the resist film is lowered and the optical image profile in the resist film is deteriorated, which results in difficulty in obtaining a good pattern shape, and therefore, the upper limit is preferably 0.240 or less, and more preferably 0.220 or less.

In Expression (1), [H] represents a molar ratio of hydrogen atoms derived from a total solid content with respect to all atoms of the total solid content in the resist composition, [C] represents a molar ratio of carbon atoms derived from the total solid content with respect to all the atoms of the total solid content in the resist composition, [N] represents a molar ratio of nitrogen atoms derived from the total solid content with respect to all the atoms of the total solid content in the resist composition, [O] represents a molar ratio of oxygen atoms derived from the total solid content with respect to all the atoms of the total solid content in the resist composition, [F] represents a molar ratio of fluorine atoms derived from the total solid content with respect to all the atoms of the total solid content in the resist composition, [S] represents a molar ratio of sulfur atoms derived from the total solid content with respect to all the atoms of the total solid content in the resist composition, and [I] represents a molar ratio of iodine atoms derived from the total solid content with respect to all the atoms of the total solid content in the resist composition.

For example, in a case where the resist composition includes a resin (acid-decomposable resin) having polarity that increases by the action of acid, a photoacid generator, an acid diffusion control agent, and a solvent, the resin, the photoacid generator, and the acid diffusion control agent correspond to the solid content. That is, all the atoms of the total solid content correspond to a sum of all the atoms derived from the resin, all the atoms derived from the photoacid generator, and all the atoms derived from the acid diffusion control agent. For example, [H] represents a molar ratio of hydrogen atoms derived from the total solid content with respect to all the atoms in the total solid content, and by way of description based on the example above, [H] represents a molar ratio of a sum of the hydrogen atoms derived from the resin, the hydrogen atoms derived from the photoacid generator, and the hydrogen atoms derived from the acid diffusion control agent with respect to a sum of all the atoms derived from the resin, all the atoms derived from the photoacid generator, and all the atoms derived from the acid diffusion control agent.

The A value can be calculated by computation of the structure of constituent components of the total solid content in the resist composition, and the ratio of the number of atoms contained in a case where the content is already known. In addition, even in a case where the constituent component is not known yet, it is possible to calculate a ratio of the number of constituent atoms by subjecting a resist film obtained after evaporating the solvent components of the resist composition to computation according to an analytic approach such as elemental analysis.

In the present specification, the "A value" shall be specified with three significant figures by rounding off the 4th significant figure digit.

The resin (A) usually includes a repeating unit having a group having a polarity that increases through decomposition by the action of acid (hereinafter, also referred to as an "acid-decomposable group"), and preferably includes a repeating unit having an acid-decomposable group.

(Repeating unit having acid-decomposable group)

The acid-decomposable group is a group which is decomposed by the action of acid to form a polar group. The acid-decomposable group preferably has a structure in which a polar group is protected by a leaving group which is eliminated by the action of acid. That is, the resin (A) has a repeating unit having a group which is decomposed by the action of acid to generate a polar group. The resin having this repeating unit has an increased polarity by the action of acid, an increased solubility in an alkali developer, and a decreased solubility in an organic solvent.

As the polar group, an alkali-soluble group is preferable, and examples thereof include an acidic group, such as a carboxyl group, a phenolic hydroxyl group, a fluorinated alcohol group, a sulfonic acid group, a phosphoric acid

group, a sulfonamide group, a sulfonylimide group, an (alkylsulfonyl)(alkylcarbonyl)methylene group, an (alkylsulfonyl)(alkylcarbonyl)imide group, a bis(alkylcarbonyl)methylene group, a bis(alkylcarbonyl)imide group, a bis(alkylsulfonyl)methylene group, a bis(alkylsulfonyl)imide group, a tris(alkylcarbonyl)methylene group, and a tris(alkylsulfonyl)methylene group; and an alcoholic hydroxyl group.

Among these, as the polar group, a carboxyl group, a phenolic hydroxyl group, a fluorinated alcohol group (preferably, a hexafluoroisopropanol group), or a sulfonic acid group is preferable.

Examples of the leaving group which leaves by the action of acid include groups represented by Formulae (Y1) to (Y4).

Formula (Y1): $-C(Rx_1)(Rx_2)(Rx_3)$
Formula (Y2): $-C(=O)OC(Rx_1)(Rx_2)(Rx_3)$
Formula (Y3): $-C(R_{36})(R_{37})(OR_{38})$
Formula (Y4): -C(Rn)(H)(Ar)

In Formula (Y1) and Formula (Y2), Rxi to $Rx_3$ each independently represent a (linear or branched) alkyl group, a (monocyclic or polycyclic) cycloalkyl group, an (linear or branched) alkenyl group, or a (monocyclic or polycyclic) aryl group. In a case where all of Rxi to $Rx_3$ are (linear or branched) alkyl groups, it is preferable that at least two of $Rx_1$, $Rx_2$, or $Rx_3$ are methyl groups.

Among these, it is preferable that Rxi to $Rx_3$ each independently represent a linear or branched alkyl group, and it is more preferable that Rxi to $Rx_3$ each independently represent a linear alkyl group.

Two of Rxi to $Rx_3$ may be bonded to each other to form a monocycle or a polycycle.

As the alkyl group of Rxi to $Rx_3$, an alkyl group having 1 to 5 carbon atoms, such as a methyl group, an ethyl group, an n-propyl group, an isopropyl group, an n-butyl group, an isobutyl group, and a t-butyl group is preferable.

As the cycloalkyl group of Rxi to $Rx_3$, a monocyclic cycloalkyl group such as a cyclopentyl group and a cyclohexyl group, or a polycyclic cycloalkyl group such as a norbornyl group, a tetracyclodecanyl group, a tetracyclododecanyl group, and an adamantyl group is preferable.

As the aryl group of Rxi to $Rx_3$, an aryl group having 6 to 10 carbon atoms is preferable, and examples thereof include a phenyl group, a naphthyl group, and an anthryl group.

As the alkenyl group of Rxi to $Rx_3$, a vinyl group is preferable.

A cycloalkyl group is preferable as the ring formed by the bonding of two of Rxi to $Rx_3$. As a cycloalkyl group formed by the bonding of two of Rxi to $Rx_3$, a monocyclic cycloalkyl group such as a cyclopentyl group and a cyclohexyl group, or a polycyclic cycloalkyl group such as a norbornyl group, a tetracyclodecanyl group, a tetracyclododecanyl group, and an adamantyl group is preferable, and a monocyclic cycloalkyl group having 5 or 6 carbon atoms is more preferable.

In the cycloalkyl group formed by the bonding of two of Rxi to $Rx_3$, for example, one of methylene groups constituting the ring may be replaced with a heteroatom such as an oxygen atom, with a group having a heteroatom, such as a carbonyl group, or with a vinylidene group. In addition, in the cycloalkyl group, one or more of the ethylene groups constituting the cycloalkane ring may be substituted with a vinylene group.

With regard to the group represented by Formula (Y1) or Formula (Y2), for example, an aspect in which Rxi is a methyl group or an ethyl group and $Rx_2$ and $Rx_3$ are bonded to each other to form the above-described cycloalkyl group is preferable.

In Formula (Y3), $R_{36}$ to $R_{38}$ each independently represent a hydrogen atom or a monovalent organic group. $R_{37}$ and $R_{38}$ may be bonded to each other to form a ring. Examples of the monovalent organic group include an alkyl group, a cycloalkyl group, an aryl group, an aralkyl group, and an alkenyl group. It is also preferable that $R_{36}$ is a hydrogen atom.

The alkyl group, the cycloalkyl group, the aryl group, and the aralkyl group may include a heteroatom such as an oxygen atom, and/or a group having a heteroatom, such as a carbonyl group. For example, in the above-described alkyl group, cycloalkyl group, aryl group, and aralkyl group, one or more of methylene groups may be substituted with a heteroatom such as an oxygen atom and/or with a group having a heteroatom, such as a carbonyl group.

In addition, $R_{38}$ and another substituent included in the main chain of the repeating unit may be bonded to each other to form a ring. A group formed by the mutual bonding of $R_{38}$ and another substituent on the main chain of the repeating unit is preferably an alkylene group such as a methylene group.

As Formula (Y3), a group represented by Formula (Y3-1) is preferable.

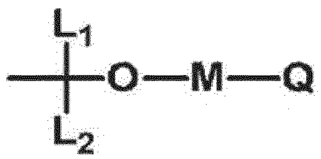

(Y3-1)

Here, $L_1$ and $L_2$ each independently represent a hydrogen atom, an alkyl group, a cycloalkyl group, an aryl group, or a group formed by a combination thereof (for example, a group formed by a combination of an alkyl group and an aryl group).

M represents a single bond or a divalent linking group.

Q represents an alkyl group which may include a heteroatom, a cycloalkyl group which may include a heteroatom, an aryl group which may include a heteroatom, an amino group, an ammonium group, a mercapto group, a cyano group, an aldehyde group, or a group formed by a combination thereof (for example, a group formed by a combination of an alkyl group and a cycloalkyl group).

In the alkyl group and the cycloalkyl group, for example, one of methylene groups may be replaced with a heteroatom such as an oxygen atom or with a group having a heteroatom, such as a carbonyl group.

It is preferable that one of $L_1$ or $L_2$ is a hydrogen atom, and the other is an alkyl group, a cycloalkyl group, an aryl group, or a group formed by a combination of an alkylene group and an aryl group.

At least two of Q, M, or $L_1$ may be bonded to each other to form a ring (preferably a 5- or 6-membered ring).

From the viewpoint of pattern miniaturization, $L_2$ is preferably a secondary or tertiary alkyl group, and more preferably a tertiary alkyl group. Examples of the secondary alkyl group include an isopropyl group, a cyclohexyl group, and a norbornyl group, and examples of the tertiary alkyl group include a tert-butyl group and an adamantane group. In these aspects, since a glass transition temperature (Tg) and an activation energy are increased, it is possible to suppress fogging in addition to ensuring a film hardness.

In Formula (Y4), Ar represents an aromatic ring group. Rn represents an alkyl group, a cycloalkyl group, or an aryl group. Rn and Ar may be bonded to each other to form a non-aromatic ring. Ar is preferably an aryl group.

From the viewpoint that the acid decomposability of the repeating unit is excellent, in a case where a non-aromatic ring is directly bonded to a polar group (or a residue thereof) in a leaving group which protects the polar group, it is also preferable that a ring member atom adjacent to the ring member atom directly bonded to the polar group (or a residue thereof) in the non-aromatic ring has no halogen atom such as a fluorine atom as a substituent.

In addition, the leaving group which leaves by the action of acid may be a 2-cyclopentenyl group having a substituent (an alkyl group and the like), such as a 3-methyl-2-cyclopentenyl group, and a cyclohexyl group having a substituent (an alkyl group and the like), such as a 1,1,4,4-tetramethylcyclohexyl group.

As the repeating unit having an acid-decomposable group, a repeating unit represented by Formula (A) is also preferable.

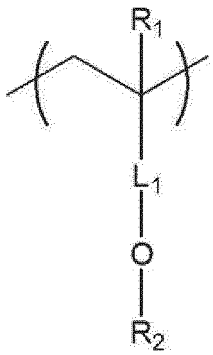

(A)

$L_1$ represents a divalent linking group which may have a fluorine atom or an iodine atom, $R_1$ represents a hydrogen atom, a fluorine atom, an iodine atom, a fluorine atom, an alkyl group which may have an iodine atom, or an aryl group which may have a fluorine atom or an iodine atom, and $R_2$ represents a leaving group which leaves by the action of acid and may have a fluorine atom or an iodine atom. However, at least one of $L_1$, $R_1$, or $R_2$ has a fluorine atom or an iodine atom.

$L_1$ represents a divalent linking group which may have a fluorine atom or an iodine atom. Examples of the divalent linking group which may have a fluorine atom or an iodine atom include -CO-, -O-, -S-, -SO-, $-SO_2-$, a hydrocarbon group which may have a fluorine atom or an iodine atom (for example, an alkylene group, a cycloalkylene group, an alkenylene group, and an arylene group), and a linking group formed by the linking of a plurality of these groups. Among

these, as Li, -CO- or -arylene group-alkylene group having a fluorine atom or an iodine atom- is preferable.

As the arylene group, a phenylene group is preferable.

The alkylene group may be linear or branched. The number of carbon atoms in the alkylene group is not particularly limited, but is preferably 1 to 10 and more preferably 1 to 3.

The total number of fluorine atoms and iodine atoms included in the alkylene group having a fluorine atom or an iodine atom is not particularly limited, but is preferably 2 or more, more preferably 2 to 10, and still more preferably 3 to 6.

$R_1$ represents a hydrogen atom, a fluorine atom, an iodine atom, an alkyl group which may have a fluorine atom or an iodine atom, or an aryl group which may have a fluorine atom or an iodine atom.

The alkyl group may be linear or branched. The number of carbon atoms in the alkyl group is not particularly limited, but is preferably 1 to 10 and more preferably 1 to 3.

The total number of fluorine atoms and iodine atoms included in the alkyl group having a fluorine atom or an iodine atom is not particularly limited, but is preferably 1 or more, more preferably 1 to 5, and still more preferably 1 to 3.

The above-described alkyl group may include a heteroatom such as an oxygen atom other than a halogen atom.

$R_2$ represents a leaving group which leaves by the action of acid and may have a fluorine atom or an iodine atom.

Among these, examples of the leaving group include groups represented by Formulae (Z1) to (Z4).

Formula (Z1): $-C(Rx_{11})(Rx_{12})(Rx_{13})$ Formula (Z2): $-C(=O)OC(Rx_{11})(Rx_{12})(Rx_{13})$ Formula (Z3): $-C(R_{136})(R_{137})(OR_{138})$ Formula (Z4): -C(Rm)(H)(Ari)

In Formulae (Z1) and (Z2), Rxn to $Rx_{13}$ each independently represent an (linear or branched) alkyl group which may have a fluorine atom or an iodine atom, a (monocyclic or polycyclic) cycloalkyl group which may have a fluorine atom or an iodine atom, an (linear or branched) alkenyl group which may have a fluorine atom or an iodine atom, or an (monocyclic or polycyclic) aryl group which may have a fluorine atom or an iodine atom. In a case where all of Rxn to $Rx_{13}$ are (linear or branched) alkyl groups, it is preferable that at least two of Rxn, $Rx_{12}$, or $Rx_{13}$ are methyl groups.

$Rx_{11}$ to $Rx_{13}$ are the same as Rxi to $Rx_3$ in (Y1) and (Y2) described above, respectively, except that they may have a fluorine atom or an iodine atom, and have the same definitions and suitable ranges as those of the alkyl group, the cycloalkyl group, the alkenyl group, and the aryl group.

In Formula (Z3), $R_{136}$ to $R_{138}$ each independently represent a hydrogen atom, or a monovalent organic group which may have a fluorine atom or an iodine atom. $R_{137}$ and $R_{138}$ may be bonded to each other to form a ring. Examples of the monovalent organic group which may have a fluorine atom or an iodine atom include an alkyl group which may have a fluorine atom or an iodine atom, a cycloalkyl group which may have a fluorine atom or an iodine atom, an aryl group which may have a fluorine atom or an iodine atom, an aralkyl group which may have a fluorine atom or an iodine atom, and a group formed by a combination thereof (for example, a group formed by a combination of an alkyl group and a cycloalkyl group).

In addition, a heteroatom such as an oxygen atom, in addition to the fluorine atom and the iodine atom, may be included in the alkyl group, the cycloalkyl group, the aryl group, and the aralkyl group. That is, in the above-described alkyl group, cycloalkyl group, aryl group, and aralkyl group, one of methylene groups may be substituted with a heteroatom such as an oxygen atom or with a group having a heteroatom, such as a carbonyl group.

In addition, $R_{138}$ and another substituent included in the main chain of the repeating unit may be bonded to each other to form a ring. In this case, a group formed by the mutual bonding of $R_{138}$ and another substituent on the main chain of the repeating unit is preferably an alkylene group such as a methylene group.

As Formula (Z3), a group represented by Formula (Z3-1) is preferable.

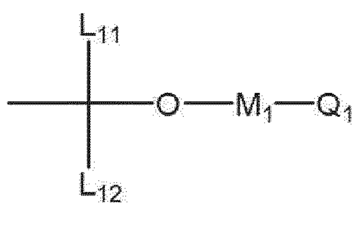

(Z3-1)

Here, $L_{11}$ and $L_{12}$ each independently represent a hydrogen atom; an alkyl group which may have a heteroatom selected from the group consisting of a fluorine atom, an iodine atom, and an oxygen atom; a cycloalkyl group which may have a heteroatom selected from the group consisting of a fluorine atom, an iodine atom, and an oxygen atom; an aryl group which may have a heteroatom selected from the group consisting of a fluorine atom, an iodine atom, and an oxygen atom; or a group formed by a combination thereof (for example, a group formed by a combination of an alkyl group and a cycloalkyl group, each of which may have a heteroatom selected from the group consisting of a fluorine atom, an iodine atom, and an oxygen atom).

Mi represents a single bond or a divalent linking group.

Qi represents an alkyl group which may have a heteroatom selected from the group consisting of a fluorine

atom, an iodine atom, and an oxygen atom; a cycloalkyl group which may have a heteroatom selected from the group consisting of a fluorine atom, an iodine atom, and an oxygen atom; an aryl group which may have a heteroatom selected from the group consisting of a fluorine atom, an iodine atom, and an oxygen atom; an amino group; an ammonium group; a mercapto group; a cyano group; an aldehyde group; a group formed by a combination thereof (for example, a group formed by a combination of the alkyl group and the cycloalkyl group, each of which may have a heteroatom selected from the group consisting of a fluorine atom, an iodine atom, and an oxygen atom).

In Formula (Z4), $Ar_1$ represents an aromatic ring group which may have a fluorine atom or an iodine atom. $Rn_1$ represents an alkyl group which may have a fluorine atom or an iodine atom, a cycloalkyl group which may have a fluorine atom or an iodine atom, or an aryl group which may have a fluorine atom or an iodine atom. $Rn_1$ and An may be bonded to each other to form a non-aromatic ring.

As the repeating unit having an acid-decomposable group, a repeating unit represented by General Formula (AI) is also preferable.

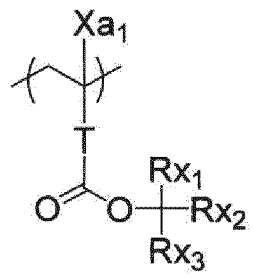

(A I)

In General Formula (AI),

Xai represents a hydrogen atom, or an alkyl group which may have a substituent.
T represents a single bond or a divalent linking group.
Rxi to $Rx_3$ each independently represent a (linear or branched) alkyl group, a (monocyclic or polycyclic) cycloalkyl group, an (linear or branched) alkenyl group, or a (monocyclic or polycyclic) aryl group. However, in a case where all of Rxi to $Rx_3$ are (linear or branched) alkyl groups, it is preferable that at least two of $Rx_1$, $Rx_2$, or $Rx_3$ are methyl groups.
Two of Rxi to $Rx_3$ may be bonded to each other to form a monocyclic ring or a polycyclic ring (a monocyclic or polycyclic cycloalkyl group and the like).

Examples of the alkyl group which may have a substituent, represented by Xai, include a methyl group and a group represented by $-CH_2-R_{11}$. Rn represents a halogen atom (a fluorine atom or the like), a hydroxyl group, or a monovalent organic group, examples thereof include an alkyl group having 5 or less carbon atoms, which may be substituted with a halogen atom, an acyl group having 5 or less carbon atoms, which may be substituted with a halogen atom, and an alkoxy group having 5 or less carbon atoms, which may be substituted with a halogen atom; and an alkyl group having 3 or less carbon atoms is preferable, and a methyl group is more preferable. Xai is preferably a hydrogen atom, a methyl group, a trifluoromethyl group, or a hydroxymethyl group.

Examples of the divalent linking group of T include an alkylene group, an aromatic ring group, a -COO-Rt- group, and an -O-Rt- group. In the formulae, Rt represents an alkylene group or a cycloalkylene group.

T is preferably a single bond or a -COO-Rt- group. In a case where T represents a -COO-Rt-group, Rt is preferably an alkylene group having 1 to 5 carbon atoms, and more preferably a $-CH_2-$ group, a $-(CH_2)_2-$ group, or a $-(CH_2)_3-$ group.

As the alkyl group of Rxi to $Rx_3$, an alkyl group having 1 to 4 carbon atoms, such as a methyl group, an ethyl group, an n-propyl group, an isopropyl group, an n-butyl group, an isobutyl group, and a t-butyl group is preferable.

As the cycloalkyl group of Rxi to $Rx_3$, a monocyclic cycloalkyl group such as a cyclopentyl group and a cyclohexyl group, or a polycyclic cycloalkyl group such as a norbornyl group, a tetracyclodecanyl group, a tetracyclododecanyl group, and an adamantyl group is preferable.

As the aryl group of Rxi to $Rx_3$, an aryl group having 6 to 10 carbon atoms is preferable, and examples thereof include a phenyl group, a naphthyl group, and an anthryl group.

As the alkenyl group of Rxi to $Rx_3$, a vinyl group is preferable.

As the cycloalkyl group formed by the bonding of two of Rxi to $Rx_3$, a monocyclic cycloalkyl group such as a cyclopentyl group and a cyclohexyl group is preferable, and in addition, a polycyclic cycloalkyl group such as a norbornyl

group, a tetracyclodecanyl group, a tetracyclododecanyl group, and an adamantyl group is also preferable. Among these, a monocyclic cycloalkyl group having 5 or 6 carbon atoms is preferable.

In the cycloalkyl group formed by the bonding of two of Rxi to $Rx_3$, for example, one of methylene groups constituting the ring may be replaced with a heteroatom such as an oxygen atom, with a group having a heteroatom, such as a carbonyl group, or with a vinylidene group. In addition, in the cycloalkyl group, one or more of the ethylene groups constituting the cycloalkane ring may be substituted with a vinylene group.

With regard to the repeating unit represented by General Formula (AI), for example, an aspect in which Rxi is a methyl group or an ethyl group and $Rx_2$ and $Rx_3$ are bonded to each other to form the above-described cycloalkyl group is preferable.

In a case where each of the above-described groups has a substituent, examples of the substituent include an alkyl group (having 1 to 4 carbon atoms), a halogen atom, a hydroxyl group, an alkoxy group (having 1 to 4 carbon atoms), a carboxyl group, and an alkoxycarbonyl group (having 2 to 6 carbon atoms). The substituent preferably has 8 or less carbon atoms.

The repeating unit represented by General Formula (AI) is preferably an acid-decomposable tertiary alkyl (meth)acrylate ester-based repeating unit (a repeating unit in which Xai represents a hydrogen atom or a methyl group and T represents a single bond).

A content of the repeating unit having an acid-decomposable group is preferably 15% by mole or more, more preferably 20% by mole or more, still more preferably 25% by mole or more, and particularly preferably 30% by mole or more with respect to all the repeating units in the resin (A). In addition, the upper limit thereof is not particularly limited, but is preferably 90% by mole or less, more preferably 80% by mole or less, and still more preferably 70% by mole or less.

Specific examples of the repeating unit having an acid-decomposable group will be shown below, but the present invention is not limited thereto. In the formulae, $Xa_1$ represents H, $CH_3$, $CF_3$, or $CH_2OH$, and Rxa and Rxb each represent a linear or branched alkyl group having 1 to 5 carbon atoms.

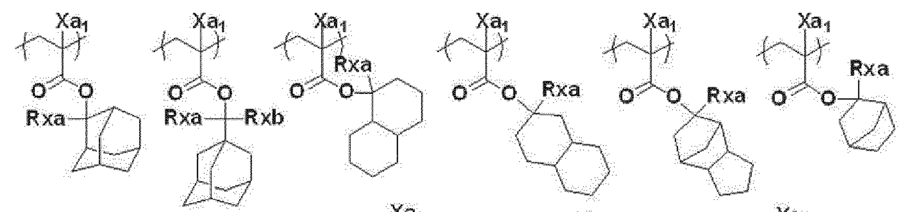

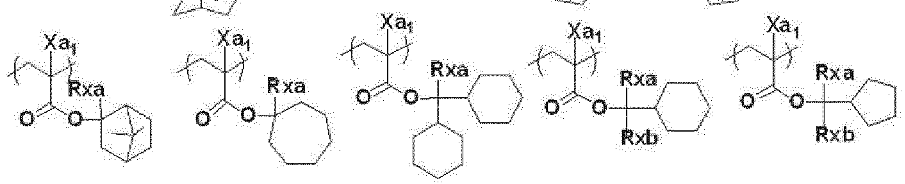

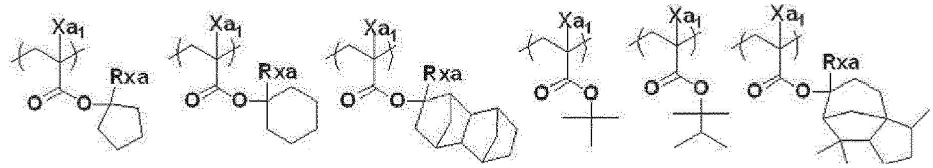

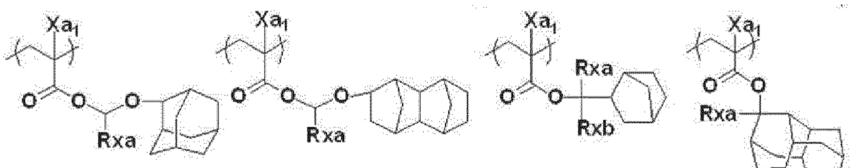

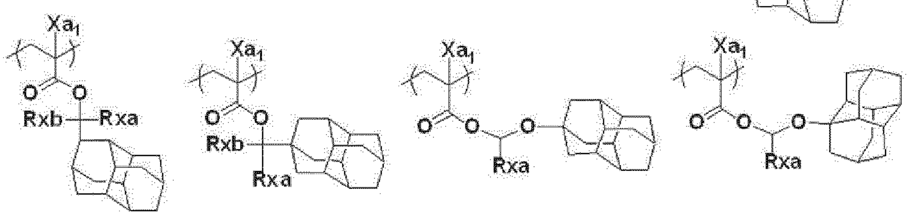

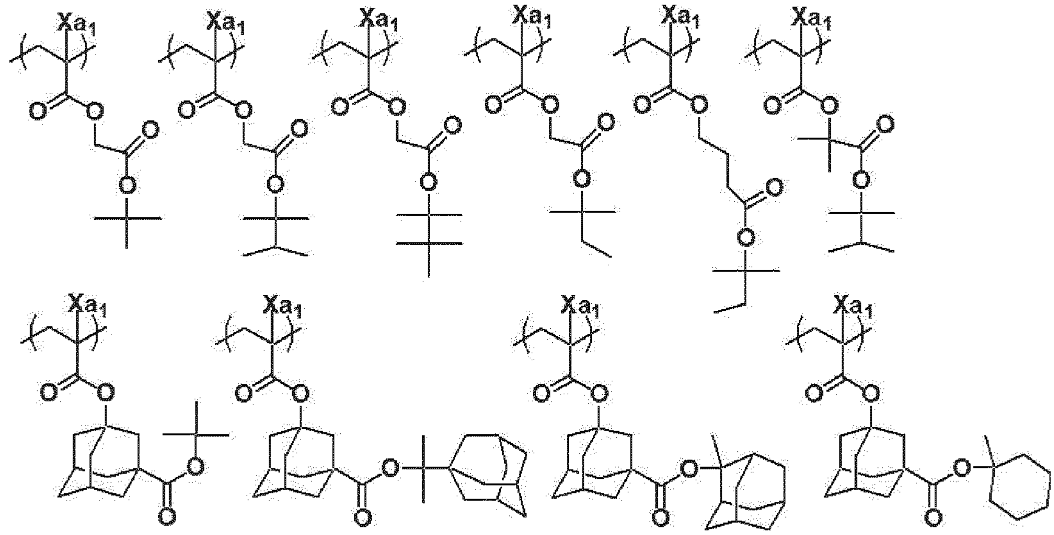

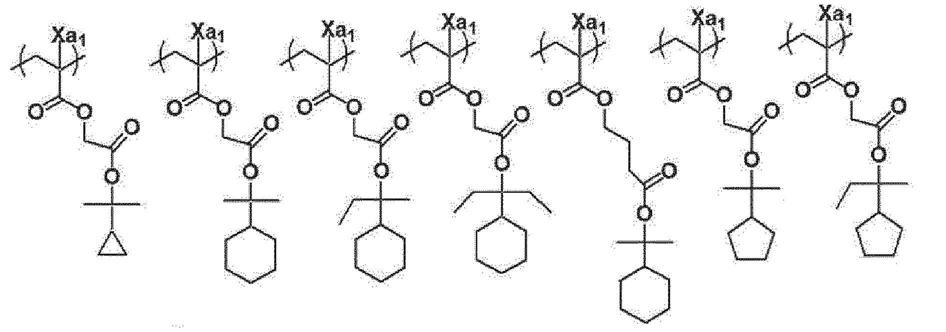

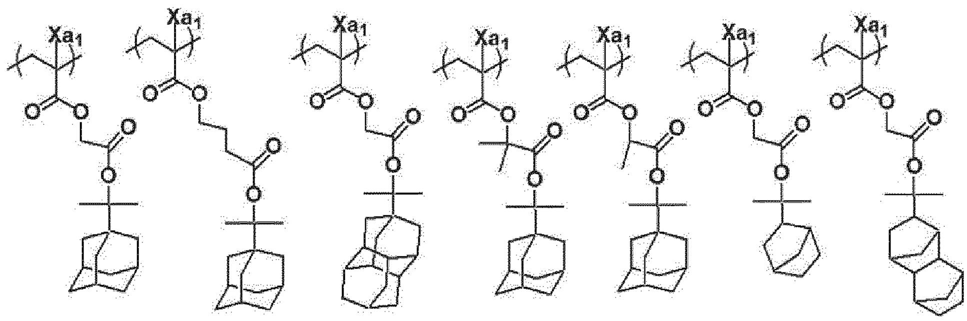

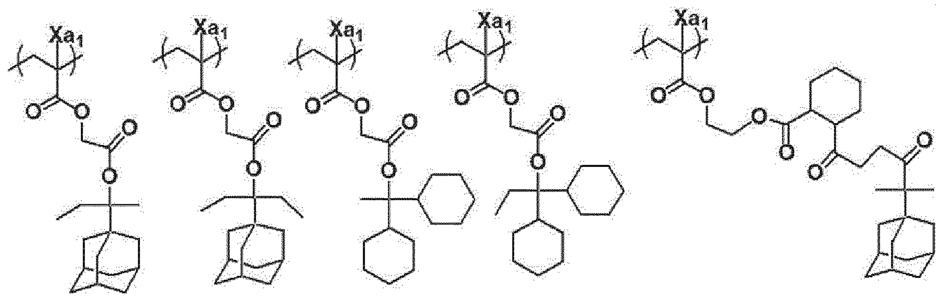

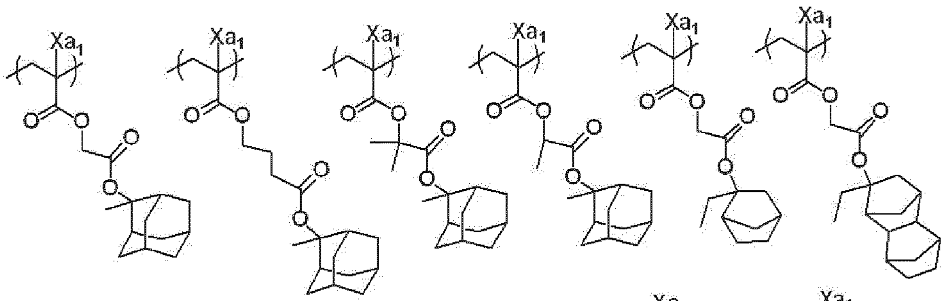

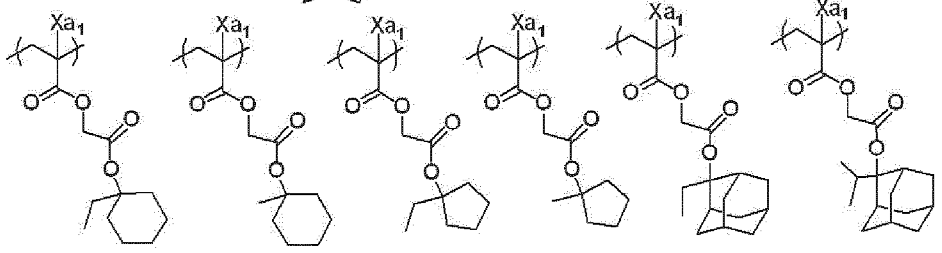

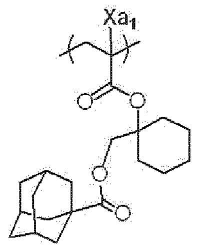

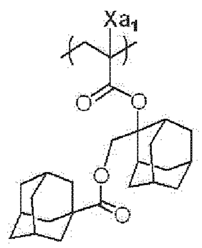

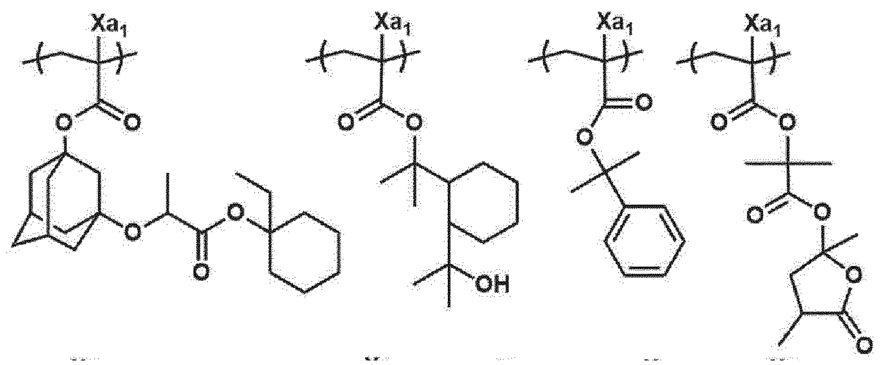

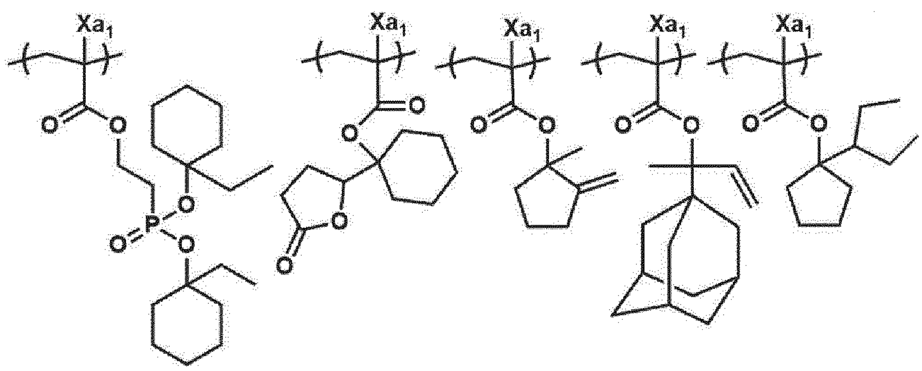

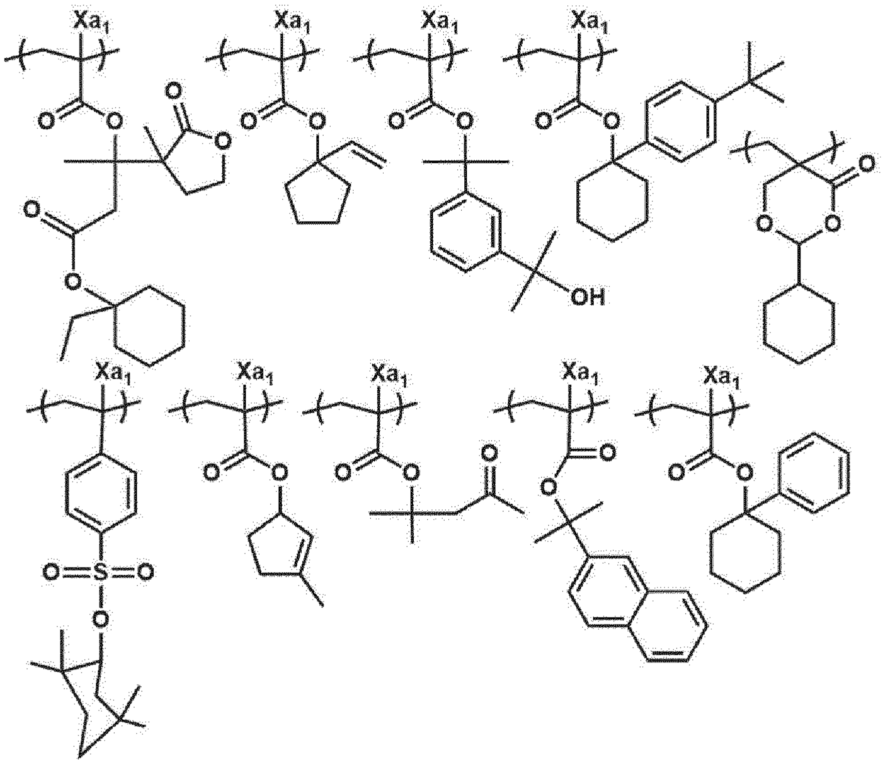

The resin (A) may include a repeating unit other than the above-described repeating units.

For example, the resin (A) may include at least one repeating unit selected from the group consisting of the following group A and/or at least one repeating unit selected from the group consisting of the following group B.

Group A: group consisting of the following repeating units (20) to (29)

(20) repeating unit having an acid group, which will be described later
(21) repeating unit having a fluorine atom or an iodine atom, which will be described later
(22) repeating unit having a lactone group, a sultone group, or a carbonate group, which will be described later
(23) repeating unit having a photoacid generating group, which will be described later
(24) repeating unit represented by General Formula (V-1) or General Formula (V-2), which will be described later
(25) repeating unit represented by Formula (A), which will be described later
(26) repeating unit represented by Formula (B), which will be described later.
(27) repeating unit represented by Formula (C), which will be described later.
(28) repeating unit represented by Formula (D), which will be described later
(29) repeating unit represented by Formula (E), which will be described later

Group B: group consisting of the following repeating units (30) to (32)

(30) repeating unit having at least one group selected from a lactone group, a sultone group, a carbonate group, a hydroxyl group, a cyano group, or an alkali-soluble group, which will be described later
(31) repeating unit having an alicyclic hydrocarbon structure and not exhibiting acid decomposability, which will be described later
(32) repeating unit represented by General Formula (III) having neither a hydroxyl group nor a cyano group, which will be described later

In a case where the resist composition is used for EUV exposure or electron beam exposure, the resin (A) preferably has at least one repeating unit selected from the group consisting of the above-described group A.

In addition, in a case where the resist composition is used for EUV exposure or electron beam exposure, the resin (A) also preferably includes at least one of a fluorine atom or an iodine atom. In a case where the resin (A) includes both a fluorine atom and an iodine atom, the resin (A) may have one repeating unit including both a fluorine atom and an iodine atom, and the resin (A) may include two kinds of repeating units, that is, a repeating unit having a fluorine atom and a repeating unit having an iodine atom.

In addition, in a case where the resist composition is used for EUV exposure or electron beam exposure, the resin (A) also preferably has a repeating unit having an aromatic group.

In a case where the resist composition is used for ArF exposure, the resin (A) preferably has at least one repeating unit selected from the group consisting of the above-described group B.

In addition, in a case where the resist composition is used for ArF exposure, the resin (A) preferably includes neither a fluorine atom nor a silicon atom.

In addition, in a case where the composition is used for ArF applications, the resin (A) preferably has no aromatic group.

(Repeating unit having acid group)

The resin (A) may have a repeating unit having an acid group.

As the acid group, an acid group having a pKa of 13 or less is preferable.

As the acid group, for example, a carboxyl group, a phenolic hydroxyl group, a fluorinated alcohol group (preferably, a hexafluoroisopropanol group), a sulfonic acid group, a sulfonamide group, an isopropanol group, or the like is preferable.

In addition, in the above-described hexafluoroisopropanol group, one or more (preferably one or two) fluorine atoms may be substituted with a group (an alkoxycarbonyl group and the like) other than a fluorine atom. $-C(CF_3)(OH)-CF_2-$ formed as above is also preferable as the acid group. In addition, one or more fluorine atoms may be substituted with a group other than a fluorine atom to form a ring including $-C(CF_3)(OH)-CF_2-$.

The repeating unit having an acid group is preferably a repeating unit different from the repeating unit having the structure in which a polar group is protected by the leaving group which is eliminated by the action of acid as described above, and the repeating unit having a lactone group, a sultone group, or a carbonate group, which will be described later.

The repeating unit having an acid group may have a fluorine atom or an iodine atom.

As the repeating unit having an acid group, a repeating unit represented by Formula (B) is preferable.

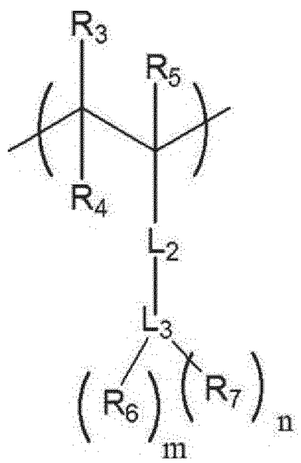

(B)

$R_3$ represents a hydrogen atom or a monovalent organic group which may have a fluorine atom or an iodine atom.

As the monovalent organic group which may have a fluorine atom or an iodine atom, a group represented by $-L_4-R_8$ is preferable. $L_4$ represents a single bond or an ester group. $R_8$ is an alkyl group which may have a fluorine atom or an iodine atom, a cycloalkyl group which may have a fluorine atom or an iodine atom, an aryl group which may have a fluorine atom or an iodine atom, or a group formed by a combination thereof.

$R_4$ and $R_5$ each independently represent a hydrogen atom, a fluorine atom, an iodine atom, or an alkyl group which may have a fluorine atom or an iodine atom.

$L_2$ represents a single bond or an ester group.

$L_3$ represents an (n+m+1)-valent aromatic hydrocarbon ring group or an (n+m+1)-valent alicyclic hydrocarbon ring group. Examples of the aromatic hydrocarbon ring group include a benzene ring group and a naphthalene ring group. The alicyclic hydrocarbon ring group may be monocyclic or polycyclic, and examples thereof include a cycloalkyl

ring group.

$R_6$ represents a hydroxyl group, or a fluorinated alcohol group (preferably, a hexafluoroisopropanol group). In a case where $R_6$ is a hydroxyl group, $L_3$ is preferably the (n+m+1)-valent aromatic hydrocarbon ring group.

$R_7$ represents a halogen atom. Examples of the halogen atom include a fluorine atom, a chlorine atom, a bromine atom, and an iodine atom.

m represents an integer of 1 or more. m is preferably an integer of 1 to 3 and more preferably an integer of 1 or 2.

n represents 0 or an integer of 1 or more. n is preferably an integer of 1 to 4.

(n+m+1) is preferably an integer of 1 to 5.

As the repeating unit having an acid group, a repeating unit represented by General Formula (I) is also preferable.

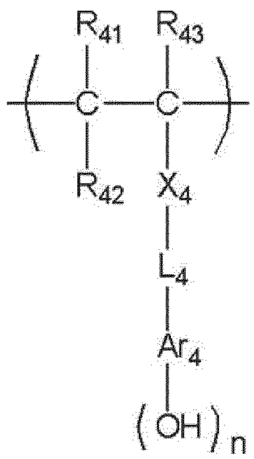

(I)

In General Formula (I),

$R_{41}$, $R_{42}$, and $R_{43}$ each independently represent a hydrogen atom, an alkyl group, a cycloalkyl group, a halogen atom, a cyano group, or an alkoxycarbonyl group. However, $R_{42}$ may be bonded to $Ar_4$ to form a ring, and in this case, $R_{42}$ represents a single bond or an alkylene group.

$X_4$ represents a single bond, -COO-, or -CONR$_{64}$-, and $R_{64}$ represents a hydrogen atom or an alkyl group.

$L_4$ represents a single bond or an alkylene group.

$Ar_4$ represents an (n+1)-valent aromatic ring group, and in a case where $Ar_4$ is bonded to $R_{42}$ to form a ring, $Ar_4$ represents an (n+2)-valent aromatic ring group.

n represents an integer of 1 to 5.

As the alkyl group represented by each of $R_{41}$, $R_{42}$, and $R_{43}$ in General Formula (I), an alkyl group having 20 or less carbon atoms, such as a methyl group, an ethyl group, a propyl group, an isopropyl group, an n-butyl group, a sec-butyl group, a hexyl group, a 2-ethylhexyl group, an octyl group, and a dodecyl group is preferable, an alkyl group having 8 or less carbon atoms is more preferable, and an alkyl group having 3 or less carbon atoms is still more preferable.

The cycloalkyl group of $R_{41}$, $R_{42}$, and $R_{43}$ in General Formula (I) may be monocyclic or polycyclic. Among these, a monocyclic cycloalkyl group having 3 to 8 carbon atoms, such as a cyclopropyl group, a cyclopentyl group, and a cyclohexyl group, is preferable.

Examples of the halogen atom of $R_{41}$, $R_{42}$, and $R_{43}$ in General Formula (I) include a fluorine atom, a chlorine atom, a bromine atom, and an iodine atom, and a fluorine atom is preferable. As the alkyl group included in the alkoxycarbonyl group of $R_{41}$, $R_{42}$, and $R_{43}$ in General Formula (I), the same as the alkyl group in $R_{41}$, $R_{42}$, and $R_{43}$ described above is preferable.

Preferred examples of the substituent in each of the groups include an alkyl group, a cycloalkyl group, an aryl group, an amino group, an amide group, a ureido group, a urethane group, a hydroxyl group, a carboxyl group, a halogen atom, an alkoxy group, a thioether group, an acyl group, an acyloxy group, an alkoxycarbonyl group, a cyano group, and a nitro group. The number of carbon atoms in the substituent is preferably 8 or less.

$Ar_4$ represents an (n+1)-valent aromatic ring group. The divalent aromatic ring group in a case where n is 1 is preferably, for example, an arylene group having 6 to 18 carbon atoms, such as a phenylene group, a tolylene group, a naphthylene group, and an anthracenylene group, or a divalent aromatic ring group including a heterocycle such as a thiophene ring, a furan ring, a pyrrole ring, a benzothiophene ring, a benzofuran ring, a benzopyrrole ring, a triazine ring, an imidazole ring, a benzimidazole ring, a triazole ring, a thiadiazole ring, and a thiazole ring. The above-described aromatic ring group may have a substituent.

Specific examples of the (n+1)-valent aromatic ring group in a case where n is an integer of 2 or more include groups formed by removing any (n-1) hydrogen atoms from the above-described specific examples of the divalent aromatic ring group.

The (n+1)-valent aromatic ring group may further have a substituent.

Examples of the substituent which may be included in the above-described alkyl group, cycloalkyl group, alkoxycarbonyl group, alkylene group, and (n+1)-valent aromatic ring group include alkyl groups mentioned as $R_{41}$, $R_{42}$, and $R_{43}$ in General Formula (I); alkoxy groups such as a methoxy group, an ethoxy group, a hydroxyethoxy group, a propoxy group, a hydroxypropoxy group, and a butoxy group; and aryl groups such as a phenyl group.

Examples of the alkyl group of $R_{64}$ in -CONR$_{64}$- represented by $X_4$ ($R_{64}$ represents a hydrogen atom or an alkyl group) include an alkyl group having 20 or less carbon atoms, such as a methyl group, an ethyl group, a propyl group, an isopropyl group, an n-butyl group, a sec-butyl group, a hexyl group, a 2-ethylhexyl group, an octyl group, and a dodecyl group, and an alkyl group having 8 or less carbon atoms, is preferable.

$X_4$ is preferably a single bond, -COO-, or -CONH-, and more preferably a single bond or -COO-.

As the alkylene group in $L_4$, an alkylene group having 1 to 8 carbon atoms, such as a methylene group, an ethylene group, a propylene group, a butylene group, a hexylene group, and an octylene group, is preferable.

As $Ar_4$, an aromatic ring group having 6 to 18 carbon atoms is preferable, and a benzene ring group, a naphthalene ring group, and a biphenylene ring group are more preferable.

The repeating unit represented by General Formula (I) preferably includes a hydroxystyrene structure. $Ar_4$ is preferably a benzene ring group.

The repeating unit represented by General Formula (I) is preferably a repeating unit represented by General Formula (1).

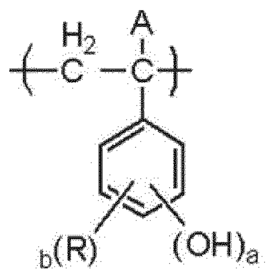

(1)

In General Formula (1),

A represents a hydrogen atom, an alkyl group, a cycloalkyl group, a halogen atom, or a cyano group.
R represents a halogen atom, an alkyl group, a cycloalkyl group, an aryl group, an alkenyl group, an aralkyl group, an alkoxy group, an alkylcarbonyloxy group, an alkylsulfonyloxy group, an alkyloxycarbonyl group, or an aryloxycarbonyl group, and in a case of a plurality of R's, the plurality of R's may be the same or different from each other. In a case where a plurality of R's are included, the plurality of R's may be combined with each other to form a ring. R is preferably a hydrogen atom.
a represents an integer of 1 to 3.
b represents an integer of 0 to (5-a).

Among these, the resin included in the resist composition preferably has a hydroxystyrene-based repeating unit.

Examples of the hydroxystyrene-based repeating unit include a repeating unit in which A in General Formula (1) represents a hydrogen atom.

The repeating unit having an acid group will be exemplified below. In the formulae, a represents 1 or 2.

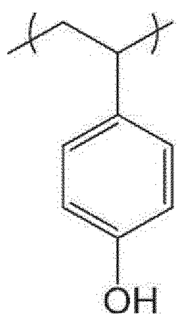

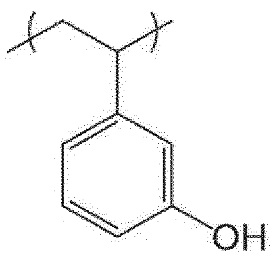

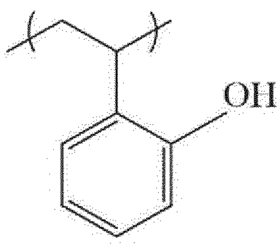

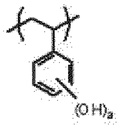
(B-1)

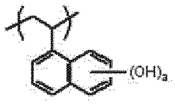
(B-2)

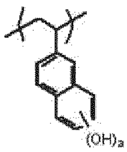
(B-3)

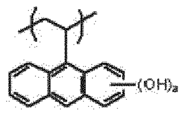
(B-4)

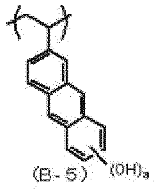
(B-5)

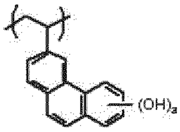
(B-6)

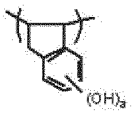
(B-7)

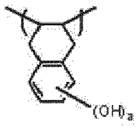
(B-8)

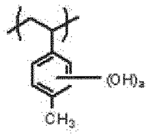
(B-9)

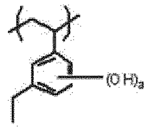
(B-10)

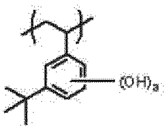
(B-11)

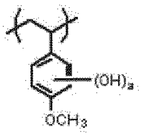
(B-12)

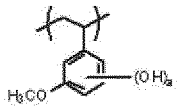
(B-13)

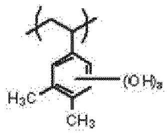
(B-14)

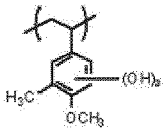
(B-15)

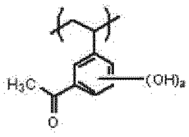
(B-16)

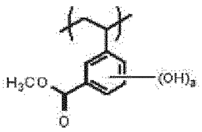
(B-17)

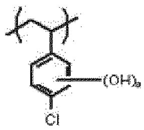
(B-18)

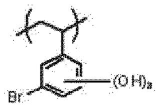
(B-19)

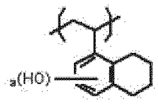
(B-20)

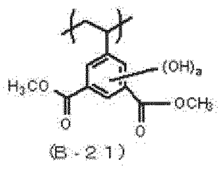
(B-21)

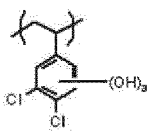
(B-22)

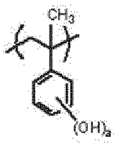
(B-23)

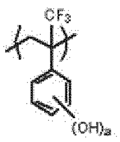
(B-24)

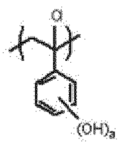
(B-25)

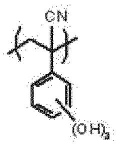
(B-26)

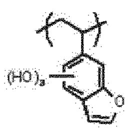
(B-27)

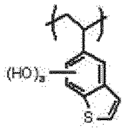
(B-28)

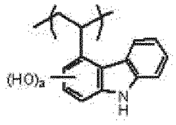
(B-29)

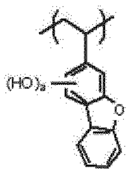
(B-30)

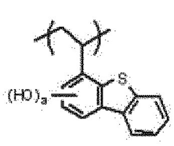
(B-31)

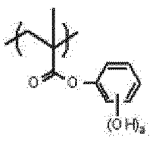
(B-32)

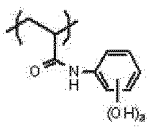
(B-33)

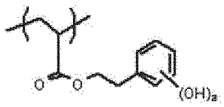
(B-34)

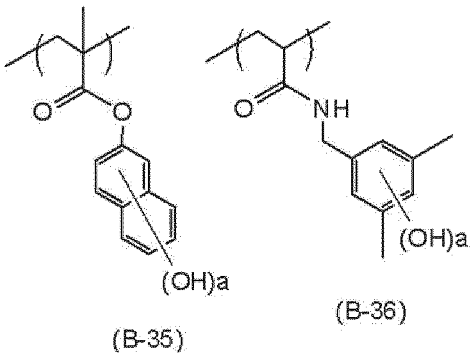

(B-35) (B-36)

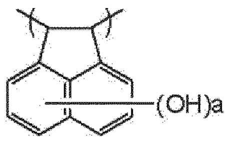

(B-37)

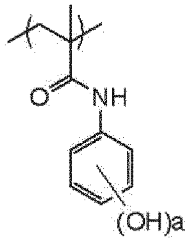

(B-38)

Among the above-described repeating units, repeating units specifically shown below are preferable. In the formulae, R represents a hydrogen atom or a methyl group, and a represents 2 or 3.

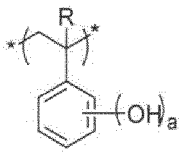

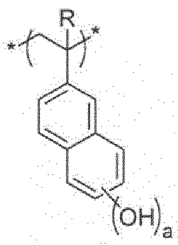

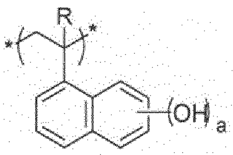

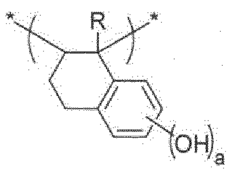

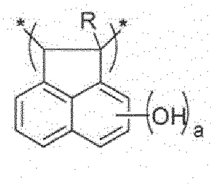

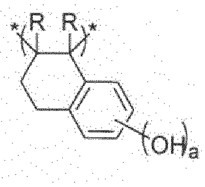

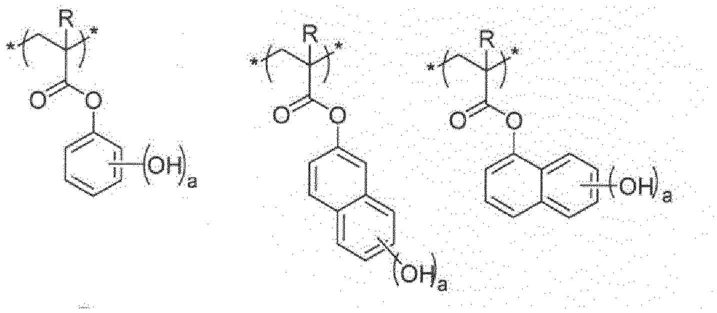

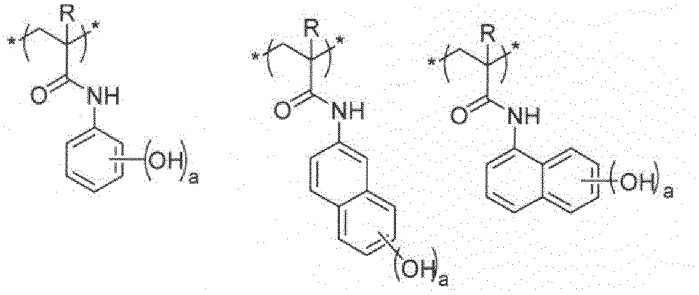

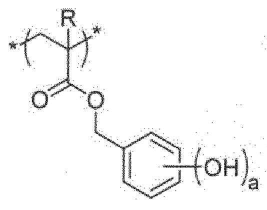
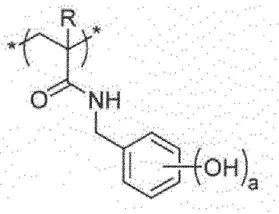

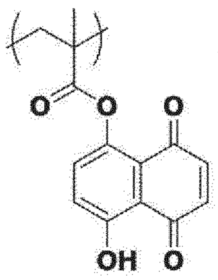
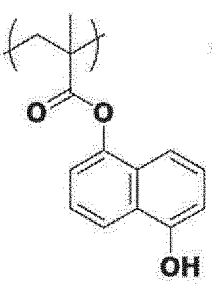
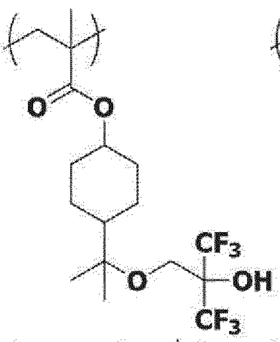
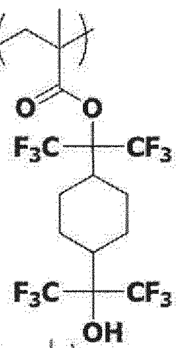

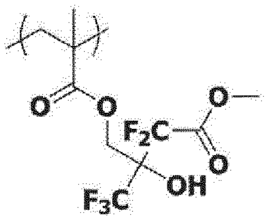
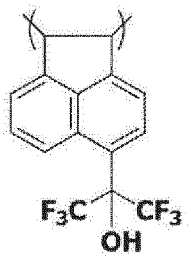
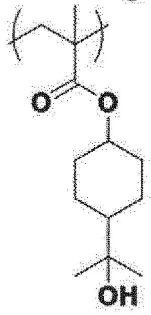
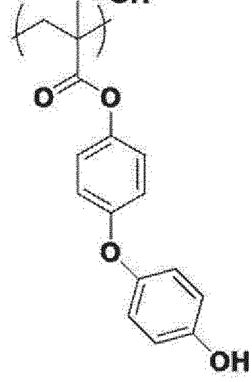

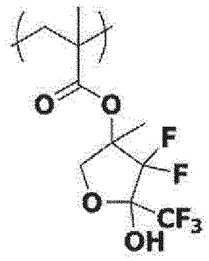
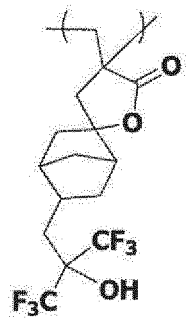
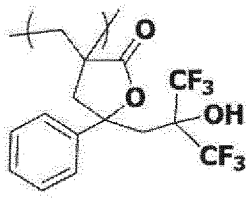
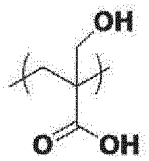
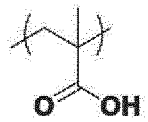

A content of the repeating unit having an acid group (preferably, the hydroxystyrene-based repeating unit) is preferably 5% by mole or more, and more preferably 10% by mole or more with respect to all the repeating units in the resin (A). In addition, the upper limit thereof is not particularly limited, but is preferably 50% by mole or less, more preferably 45% by mole or less, and still more preferably 40% by mole or less.

(Repeating unit having fluorine atom or iodine atom)

The resin (A) may have a repeating unit having a fluorine atom or an iodine atom in addition to (Repeating unit having acid-decomposable group) and (Repeating unit having acid group) described above. In addition, the (Repeating unit having fluorine atom or iodine atom) herein is preferably different from other kinds of repeating units belonging to the group A, such as (Repeating unit having lactone group, sultone group, or carbonate group) and (Repeating unit having photoacid generating group), which will be described later.

As the repeating unit having a fluorine atom or an iodine atom, a repeating unit represented by Formula (C) is preferable.

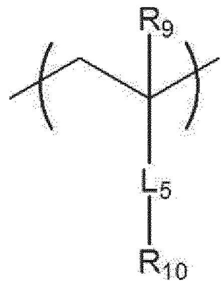

(C)

$L_5$ represents a single bond or an ester group.

$R_9$ represents a hydrogen atom or an alkyl group which may have a fluorine atom or an iodine atom.

$R_{10}$ represents a hydrogen atom, an alkyl group which may have a fluorine atom or an iodine atom, a cycloalkyl group which may have a fluorine atom or an iodine atom, an aryl group which may have a fluorine atom or an iodine atom, or a group formed by a combination thereof.

The repeating unit having a fluorine atom or an iodine atom will be exemplified below.

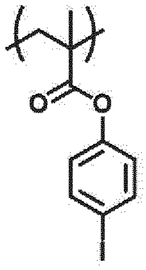
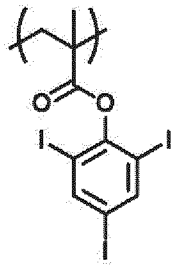
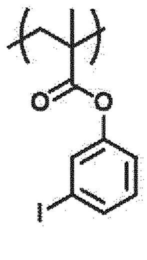
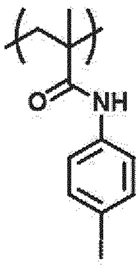
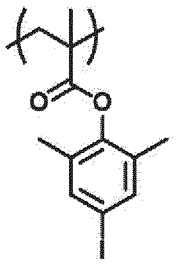
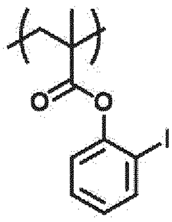

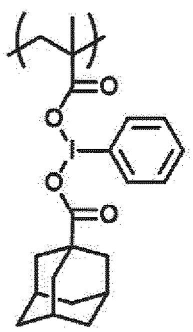
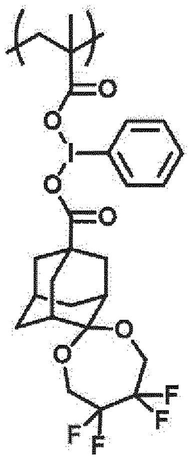
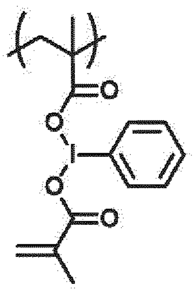

A content of the repeating unit having a fluorine atom or an iodine atom is preferably 0% by mole or more, more preferably 5% by mole or more, and still more preferably 10% by mole or more with respect to all the repeating units in the resin (A). In addition, the upper limit value thereof is preferably 50% by mole or less, more preferably 45% by mole or less, and still more preferably 40% by mole or less.

Since the repeating unit having a fluorine atom or an iodine atom does not include (Repeating unit having acid-decomposable group) and (Repeating unit having acid group) as described above, the above-described content of the repeating unit having a fluorine atom or an iodine atom is also intended to mean a content of the repeating unit having a fluorine atom or an iodine atom, excluding (Repeating unit having acid-decomposable group) and (Repeating unit having acid group).

The total content of the repeating units including at least one of a fluorine atom or an iodine atom in the repeating units of the resin (A) is preferably 20% by mole or more, more preferably 30% by mole or more, and still more preferably 40% by mole or more with respect to all the repeating units of the resin (A). An upper limit value thereof is not particularly limited, but is, for example, 100% by mole or less.

Examples of the repeating unit including at least one of a fluorine atom or an iodine atom include a repeating

unit which has a fluorine atom or an iodine atom, and has an acid-decomposable group, a repeating unit which has a fluorine atom or an iodine atom, and has an acid group, and a repeating unit having a fluorine atom or an iodine atom.

(Repeating unit having lactone group, sultone group, or carbonate group)

The resin (A) may have a repeating unit having at least one selected from the group consisting of a lactone group, a sultone group, and a carbonate group (hereinafter, also collectively referred to as a "repeating unit having a lactone group, a sultone group, or a carbonate group").

It is also preferable that the repeating unit having a lactone group, a sultone group, or a carbonate group has no acid group such as a hexafluoropropanol group.

The lactone group or the sultone group may have a lactone structure or a sultone structure. The lactone structure or the sultone structure is preferably a 5- to 7-membered ring lactone structure or a 5- to 7-membered ring sultone structure. Among these, the structure is more preferably a 5- to 7-membered ring lactone structure with which another ring structure is fused so as to form a bicyclo structure or a spiro structure or a 5- to 7-membered ring sultone structure with which another ring structure is fused so as to form a bicyclo structure or a spiro structure.

The resin (A) preferably has a repeating unit having a lactone group or a sultone group, formed by extracting one or more hydrogen atoms from a ring member atom of a lactone structure represented by any of General Formulae (LC1-1) to (LC1-21) or a sultone structure represented by any of General Formulae (SL1-1) to (SL1-3).

In addition, the lactone group or the sultone group may be bonded directly to the main chain. For example, a ring member atom of the lactone group or the sultone group may constitute the main chain of the resin (A).

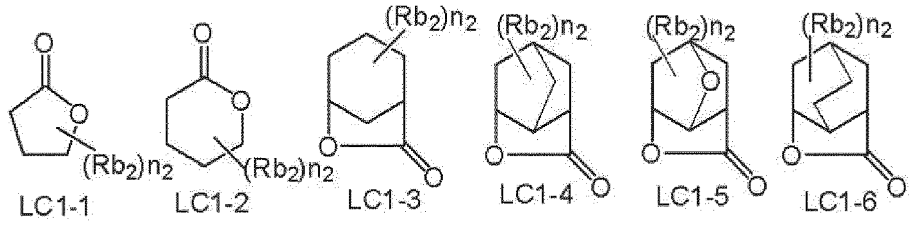

LC1-1 LC1-2 LC1-3 LC1-4 LC1-5 LC1-6

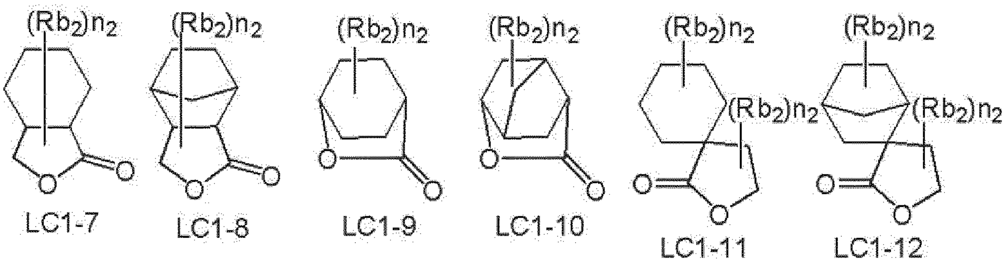

LC1-7 LC1-8 LC1-9 LC1-10 LC1-11 LC1-12

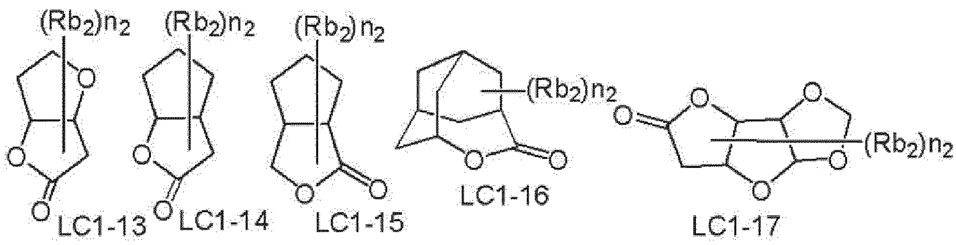

LC1-13 LC1-14 LC1-15 LC1-16 LC1-17

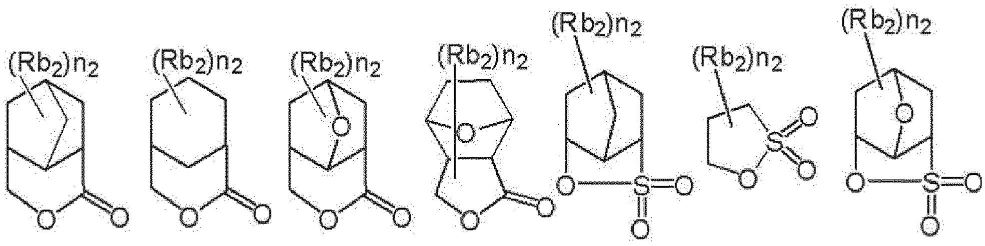

LC1-18 LC1-19 LC1-20 LC1-21 SL1-1 SL1-2 SL1-3

The above-described portion of lactone structure or sultone structure may have a substituent ($Rb_2$). Preferred examples of the substituent ($Rb_2$) include an alkyl group having 1 to 8 carbon atoms, a cycloalkyl group having 4 to 7 carbon atoms, an alkoxy group having 1 to 8 carbon atoms, an alkoxycarbonyl group having 1 to 8 carbon atoms, a carboxyl group, a halogen atom, a hydroxyl group, a cyano group, and an acid-decomposable group. n2 represents an integer of 0 to 4. In a case where n2 is 2 or more, $Rb_2$'s which are present in a plural number may be different from each other, and $Rb_2$'s which are present in a plural number may be bonded to each other to form a ring.

Examples of the repeating unit having a group having the lactone structure represented by any of General Formulae (LC1-1) to (LC1-21) or the sultone structure represented by any of General Formulae (SL1-1) to (SL1-3) include a repeating unit represented by General Formula (AI).

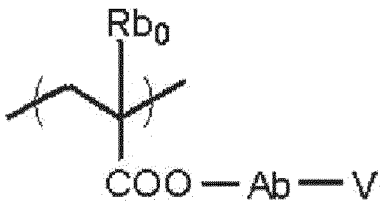

(AI)

In General Formula (AI), $Rb_0$ represents a hydrogen atom, a halogen atom, or an alkyl group having 1 to 4 carbon atoms.

Preferred examples of the substituent which may be contained in the alkyl group of $Rb_0$ include a hydroxyl group and a halogen atom.

Examples of the halogen atom of $Rb_0$ include a fluorine atom, a chlorine atom, a bromine atom, and an iodine atom. $Rb_0$ is preferably a hydrogen atom or a methyl group.

Ab represents a single bond, an alkylene group, a divalent linking group having a monocyclic or polycyclic alicyclic hydrocarbon structure, an ether group, an ester group, a carbonyl group, a carboxyl group, or a divalent group formed by a combination thereof. Among these, a single bond or a linking group represented by $-Ab_1-CO_2-$ is preferable. Abi is a linear or branched alkylene group, or a monocyclic or polycyclic cycloalkylene group, and is preferably a methylene group, an ethylene group, a cyclohexylene group, an adamantylene group, or a norbomylene group.

V represents a group formed by extracting one hydrogen atom from a ring member atom of the lactone structure represented by any of General Formulae (LC1-1) to (LC1-21) or a group formed by extracting one hydrogen atom from a ring member atom of the sultone structure represented by any of General Formulae (SL1-1) to (SL1-3).

In a case where an optical isomer is present in the repeating unit having a lactone group or a sultone group, any of optical isomers may be used. In addition, one optical isomer may be used alone or a mixture of a plurality of the optical isomers may be used. In a case where one kind of optical isomers is mainly used, an optical purity (ee) thereof is preferably 90 or more, and more preferably 95 or more.

As the carbonate group, a cyclic carbonate ester group is preferable.

As the repeating unit having a cyclic carbonate ester group, a repeating unit represented by General Formula (A-1) is preferable.

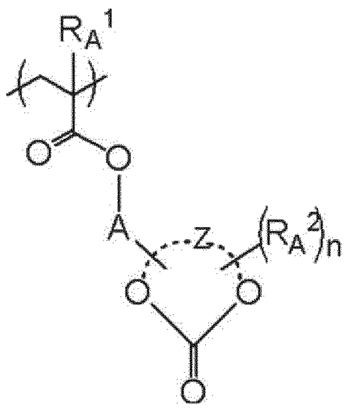

(A-1)

In General Formula (A-1), $R_A^1$ represents a hydrogen atom, a halogen atom, or a monovalent organic group (preferably a methyl group).

n represents an integer of 0 or more.

$R_A^2$ represents a substituent. In a case where n is 2 or more, $R_A^2$ which are present in a plural number may be the same or different from each other.

A represents a single bond or a divalent linking group. As the above-described divalent linking group, an alkylene group, a divalent linking group having a monocyclic or polycyclic alicyclic hydrocarbon structure, an ether group, an ester group, a carbonyl group, a carboxyl group, or a divalent group formed by a combination thereof is preferable.

Z represents an atomic group which forms a monocycle or polycycle with a group represented by -O-CO-O- in the formula.

The repeating unit having a lactone group, a sultone group, or a carbonate group will be exemplified below.

(in the formulae, Rx is H, $CH_3$, $CH_2OH$, or $CF_3$)

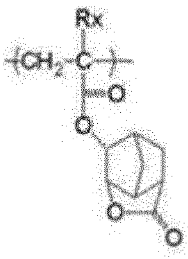
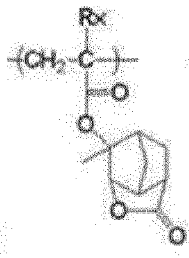
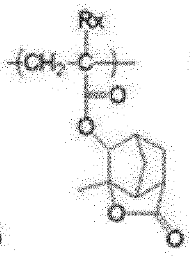
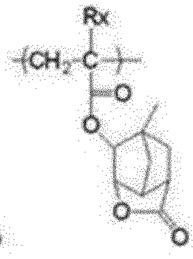
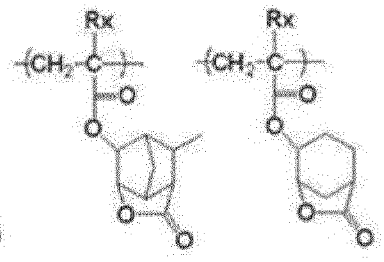

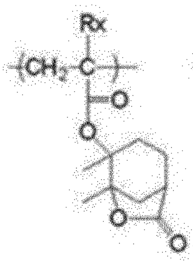
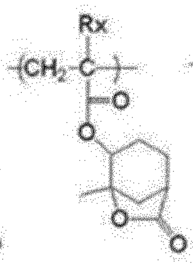
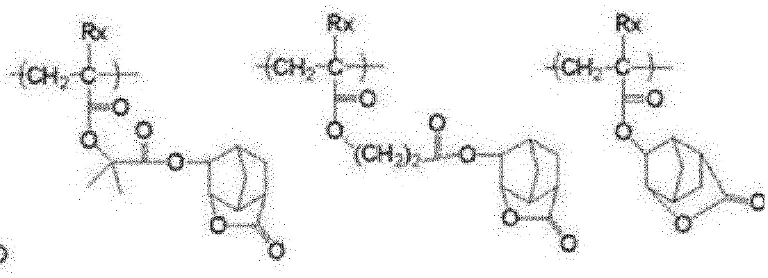

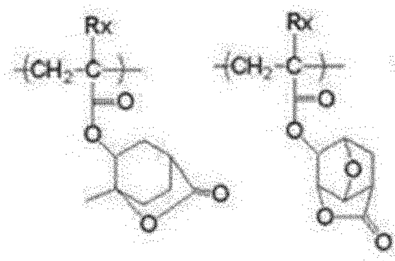
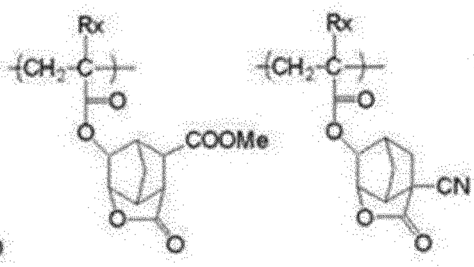
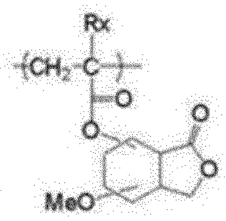

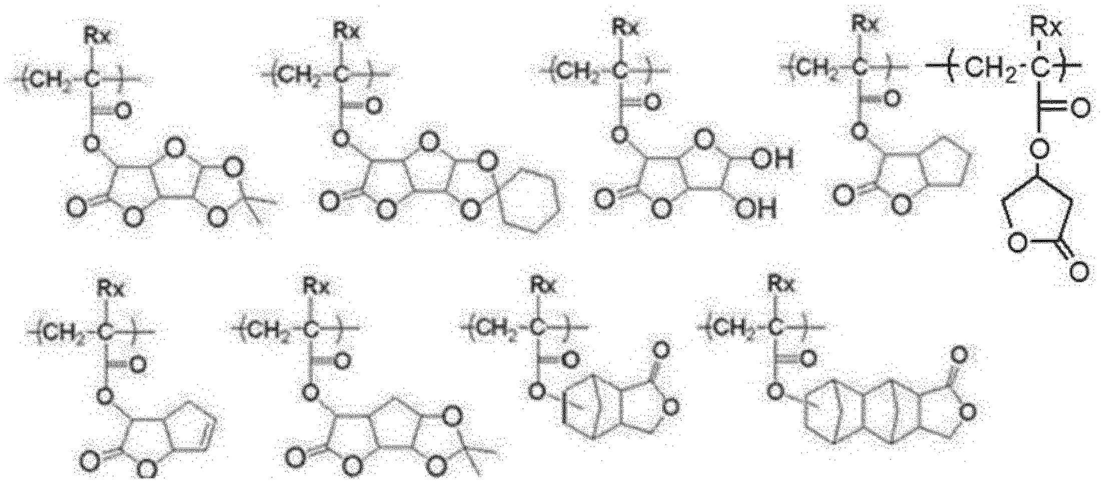

(in the formulae, Rx is H, $CH_3$, $CH_2OH$, or $CF_3$)

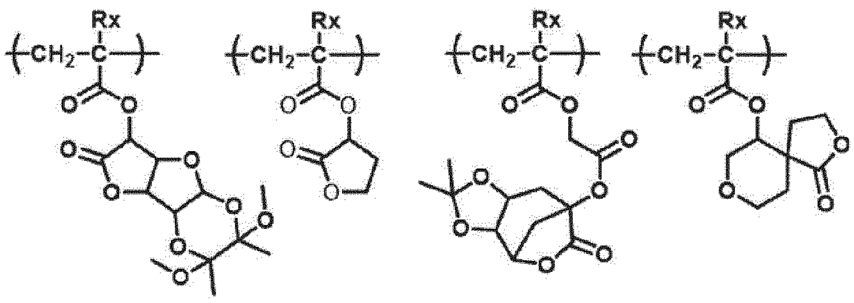

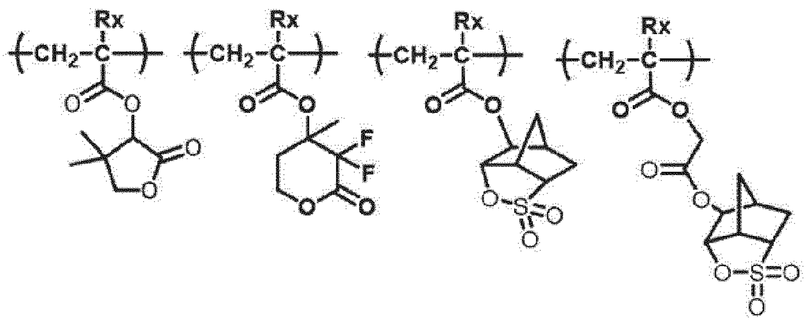

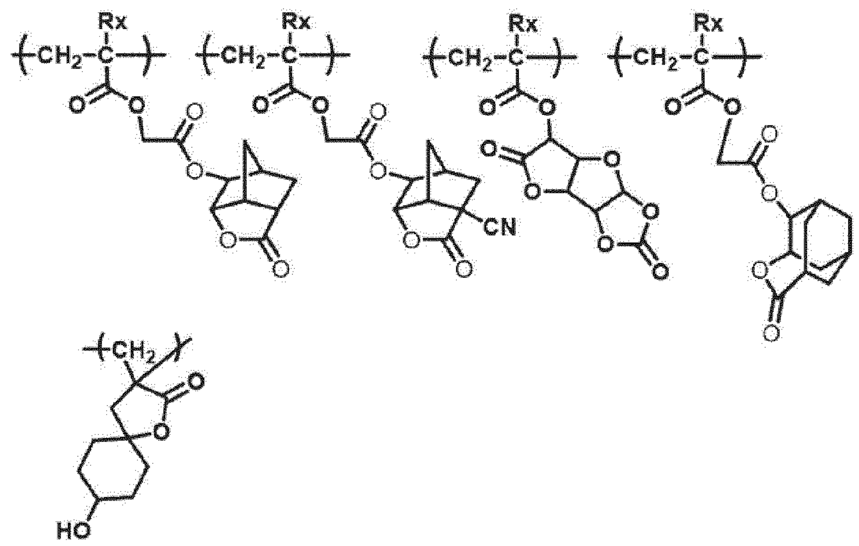

(in the formulae, Rx is H, $CH_3$, $CH_2OH$, or $CF_3$)

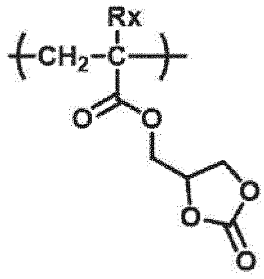
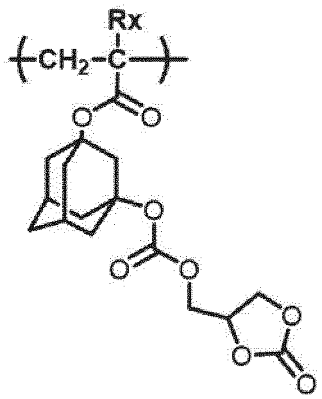

A content of the repeating unit having a lactone group, a sultone group, or a carbonate group is preferably 1% by mole or more, and more preferably 5% by mole or more with respect to all the repeating units in the resin (A). In addition, the upper limit thereof is not particularly limited, but is preferably 65% by mole or less, more preferably 30% by mole or less, still more preferably 25% by mole or less, and particularly preferably 20% by mole or less.

(Repeating unit having photoacid generating group)

The resin (A) may have, as a repeating unit other than those described above, a repeating unit having a group which generates an acid by irradiation with actinic rays or radiation (hereinafter, also referred to as a "photoacid generating group").

In this case, it can be considered that the repeating unit having a photoacid generating group corresponds to a compound which generates an acid by irradiation with actinic rays or radiation, which will be described later (hereinafter, also referred to as a "photoacid generator").

Examples of such a repeating unit include a repeating unit represented by General Formula (4).

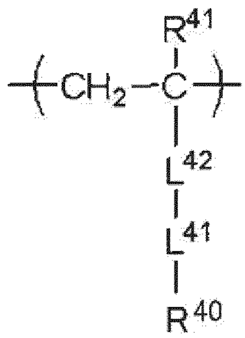

(4)

$R^{41}$ represents a hydrogen atom or a methyl group. $L^{41}$ represents a single bond or a divalent linking group. $L^{42}$ represents a divalent linking group. $R^{40}$ represents a structural moiety which is decomposed by irradiation with actinic rays or radiation to generate an acid in a side chain.

The repeating unit having a photoacid generating group is exemplified below.

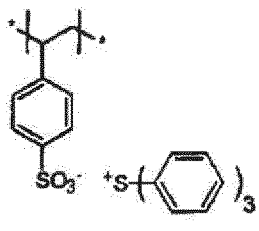

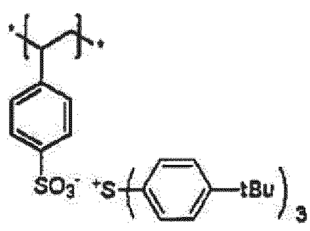

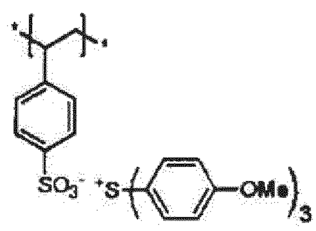

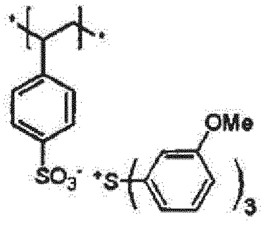

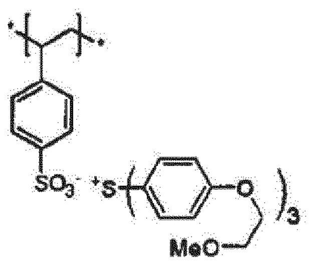

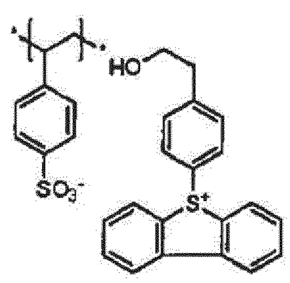

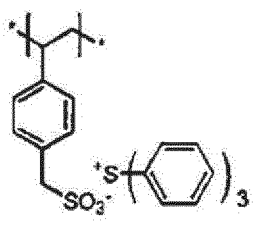
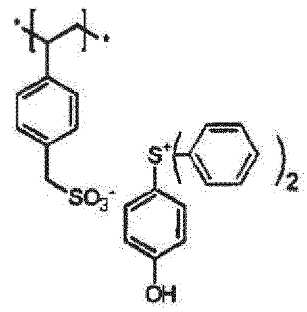
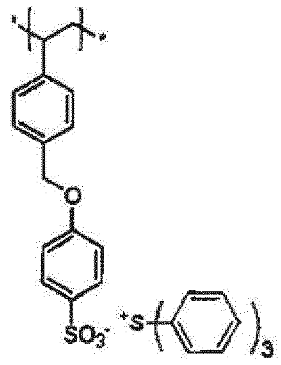
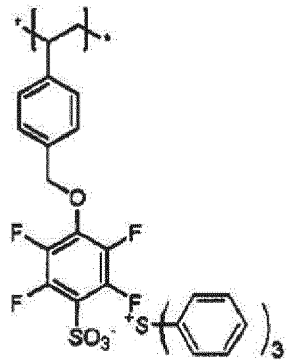
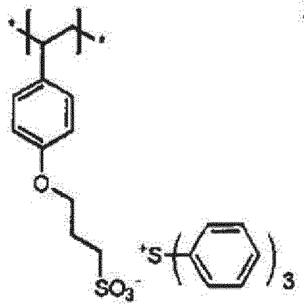
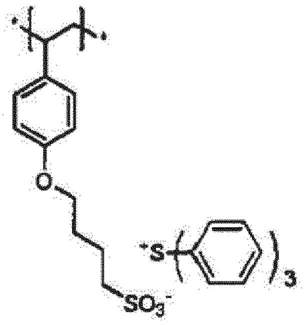
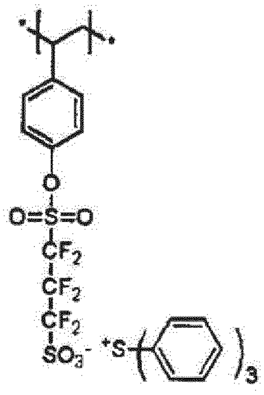
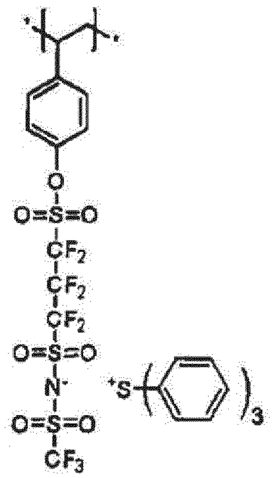
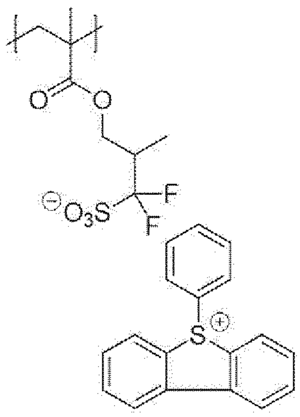
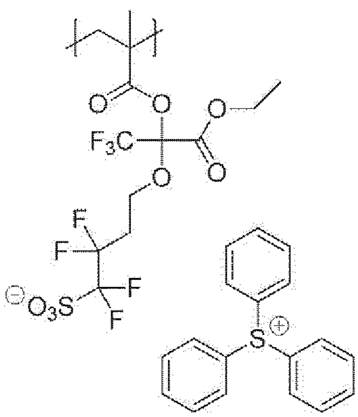

In addition, examples of the repeating unit represented by General Formula (4) include repeating units described in paragraphs [0094] to [0105] of JP2014-041327A.

A content of the repeating unit having a photoacid generating group is preferably 1% by mole or more, and more preferably 5% by mole or more with respect to all the repeating units in the resin (A). In addition, the upper limit

value thereof is preferably 40% by mole or less, more preferably 35% by mole or less, and still more preferably 30% by mole or less.

(Repeating unit represented by General Formula (V-1) or General Formula (V-2))

The resin (A) may have a repeating unit represented by General Formula (V-1) or General Formula (V-2).
The repeating unit represented by General Formula (V-1) and General Formula (V-2) is preferably a repeating unit different from the above-described repeating units.

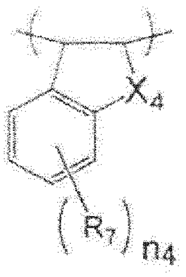

(V-1)

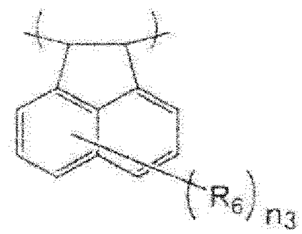

(V-2)

In the formula,

$R_6$ and $R_7$ each independently represent a hydrogen atom, a hydroxyl group, an alkyl group, an alkoxy group, an acyloxy group, a cyano group, a nitro group, an amino group, a halogen atom, an ester group (-OCOR or -COOR; R is an alkyl group or fluorinated alkyl group having 1 to 6 carbon atoms), or a carboxyl group. As the alkyl group, a linear, branched, or cyclic alkyl group having 1 to 10 carbon atoms is preferable.

$n_3$ represents an integer of 0 to 6.
$n_4$ represents an integer of 0 to 4.
$X^4$ is a methylene group, an oxygen atom, or a sulfur atom.

The repeating unit represented by General Formula (V-1) or General Formula (V-2) will be exemplified below.

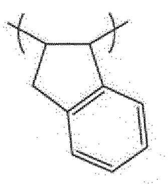
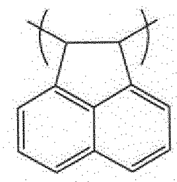
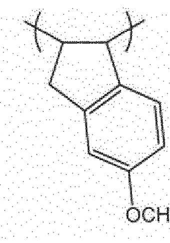
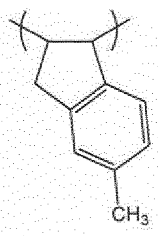
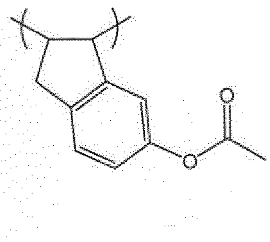

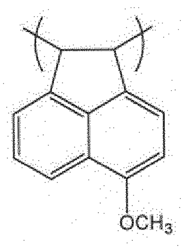
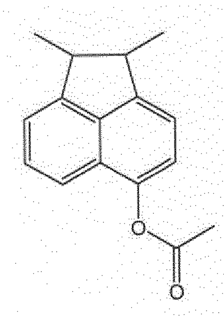
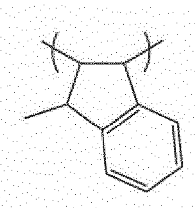

(Repeating unit for reducing mobility of main chain)

From the viewpoint that excessive diffusion of a generated acid or pattern collapse during development can

be suppressed, the resin (A) preferably has a high glass transition temperature (Tg). The Tg is preferably higher than 90°C, more preferably higher than 100°C, still more preferably higher than 110°C, and particularly preferably higher than 125°C. Since an excessively high Tg causes a decrease in dissolution rate in a developer, the Tg is preferably 400°C or lower and more preferably 350°C or lower.

In the present specification, the glass transition temperature (Tg) of a polymer such as the resin (A) is calculated by the following method. First, each Tg of homopolymers consisting of only the respective repeating units included in the polymer is calculated by the Bicerano method. Hereinafter, the Tg calculated is referred to as a "Tg of the repeating unit. Next, the mass proportion (%) of each repeating unit to all the repeating units in the polymer is calculated. Next, the Tg at each mass proportion is calculated using a Fox's equation (described in Materials Letters 62 (2008) 3152, and the like), and these are summed to obtain the Tg (°C) of the polymer.

The Bicerano method is described in Prediction of polymer properties, Marcel Dekker Inc., New York (1993), and the like. The calculation of a Tg by the Bicerano method can be carried out using MDL Polymer (MDL Information Systems, Inc.), which is software for estimating physical properties of a polymer.

In order to raise the Tg of the resin (A) (preferably to raise the Tg to higher than 90°C), it is preferable to reduce the mobility of the main chain of the resin (A). Examples of a method for lowering the mobility of the main chain of the resin (A) include the following (a) to (e) methods.

(a) introduction of a bulky substituent into the main chain
(b) introduction of a plurality of substituents into the main chain
(c) introduction of a substituent causing an interaction between the resins (A) into the vicinity of the main chain
(d) formation of the main chain in a cyclic structure
(e) linking of a cyclic structure to the main chain

The resin (A) preferably has a repeating unit in which the homopolymer exhibits a Tg of 130°C or higher.

The type of the repeating unit in which the homopolymer exhibits a Tg of 130°C or higher is not particularly limited, and may be any of repeating units in which the homopolymer exhibits a Tg of 130°C or higher, as calculated by a Bicerano method. It corresponds to a repeating unit having a Tg of a homopolymer exhibiting 130°C or higher, depending on the type of a functional group in the repeating units represented by Formulae (A) to (E) which will be described later.

(Repeating unit represented by Formula (A))

As an example of a specific unit for accomplishing (a) above, a method of introducing a repeating unit represented by Formula (A) into the resin (A) may be mentioned.

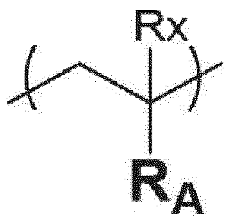

(A)

In Formula (A), $R_A$ represents a group having a polycyclic structure. $R_x$ represents a hydrogen atom, a methyl group, or an ethyl group. The group having a polycyclic structure is a group having a plurality of ring structures, and the plurality of ring structures may or may not be fused.

Specific examples of the repeating unit represented by Formula (A) include the following repeating units.

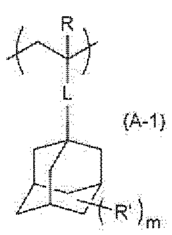

(A-1)

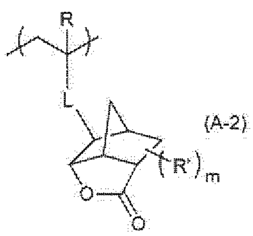

(A-2)

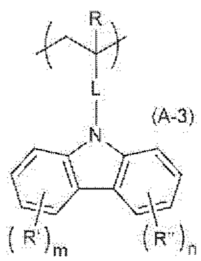

(A-3)

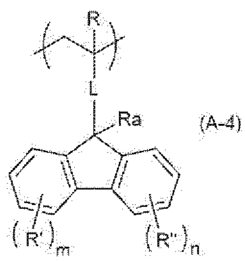

(A-4)

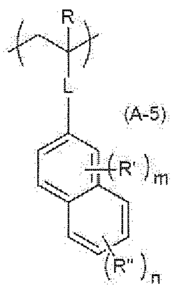
(A-5)

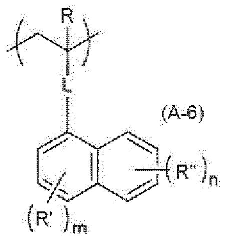
(A-6)

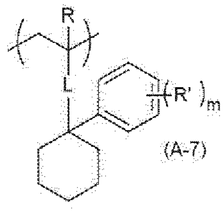
(A-7)

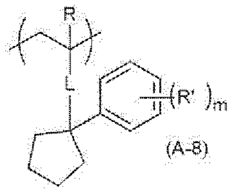
(A-8)

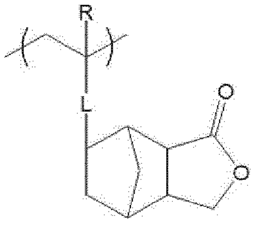
(A-9)

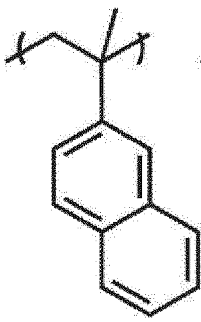

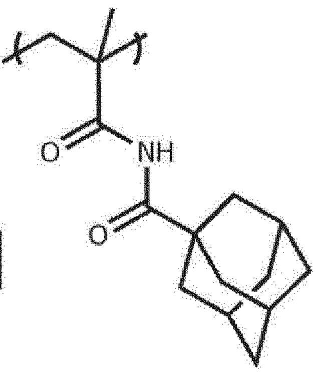

In the formula, R represents a hydrogen atom, a methyl group, or an ethyl group.

Ra represents a hydrogen atom, an alkyl group, a cycloalkyl group, an aryl group, an aralkyl group, an alkenyl group, a hydroxyl group, an alkoxy group, an acyloxy group, a cyano group, a nitro group, an amino group, a halogen atom, an ester group (-OCOR‴ or -COOR‴; R‴ is an alkyl group or fluorinated alkyl group having 1 to 20 carbon atoms), or a carboxyl group. The alkyl group, the cycloalkyl group, the aryl group, the aralkyl group, and the alkenyl group described above may each have a substituent. In addition, a hydrogen atom bonded to the carbon atom in the group represented by Ra may be substituted with a fluorine atom or an iodine atom.

In addition, R' and R" each independently represent an alkyl group, a cycloalkyl group, an aryl group, an aralkyl group, an alkenyl group, a hydroxyl group, an alkoxy group, an acyloxy group, a cyano group, a nitro group, an amino group, a halogen atom, an ester group (-OCOR‴ or -COOR‴; R‴ is an alkyl group or fluorinated alkyl group having 1 to 20 carbon atoms), or a carboxyl group. The alkyl group, the cycloalkyl group, the aryl group, the aralkyl group, and the alkenyl group described above may each have a substituent. In addition, a hydrogen atom bonded to the carbon atom in the group represented by R' and R" may be substituted with a fluorine atom or an iodine atom.

L represents a single bond or a divalent linking group. Examples of the divalent linking group include -COO-, -CO-, -O-, -S-, -SO-, $-SO_2-$, an alkylene group, a cycloalkylene group, an alkenylene group, a linking group consisting of a plurality of these groups linked to each other, and the like.

m and n each independently represent an integer of 0 or more. The upper limit of m and n is not particularly limited, but is 2 or less in many cases and 1 or less in more cases.

(Repeating unit represented by Formula (B))

As an example of a specific unit for accomplishing (b) above, a method of introducing a repeating unit represented by Formula (B) into the resin (A) may be mentioned.

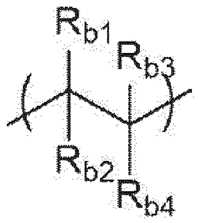

(B)

In Formula (B), $R_{b1}$ to $R_{b4}$ each independently represent a hydrogen atom or an organic group, and at least two or more of $R_{b1}$, ..., or $R_{b4}$ represent an organic group.

In addition, in a case where at least one of the organic groups is a group in which a ring structure is directly linked to the main chain in the repeating unit, the types of the other organic groups are not particularly limited.

In addition, in a case where none of the organic groups is a group in which a ring structure is directly linked to the main chain in the repeating unit, at least two or more of the organic groups are substituents having three or more constituent atoms excluding hydrogen atoms.

Specific examples of the repeating unit represented by Formula (B) include the following repeating units.

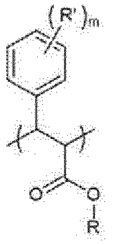

(B-1)

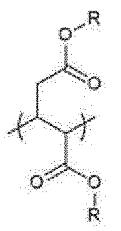

(B-2)

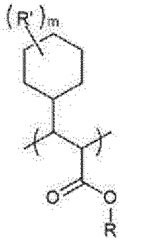

(B-3)

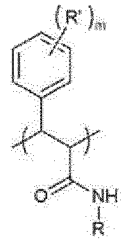

(B-4)

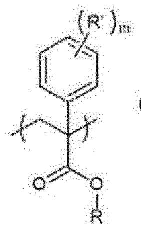

(B-5)

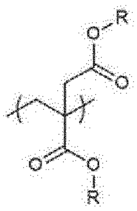

(B-6)

In the formula, R's each independently represent a hydrogen atom or an organic group. Examples of the organic group include organic groups such as an alkyl group, a cycloalkyl group, an aryl group, an aralkyl group, and an alkenyl group, which may have a substituent.

R"s each independently represent an alkyl group, a cycloalkyl group, an aryl group, an aralkyl group, an alkenyl group, a hydroxyl group, an alkoxy group, an acyloxy group, a cyano group, a nitro group, an amino group, a halogen atom, an ester group (-OCOR" or -COOR"; R" is an alkyl group or fluorinated alkyl group having 1 to 20 carbon atoms), or a carboxyl group. The alkyl group, the cycloalkyl group, the aryl group, the aralkyl group, and the alkenyl group described above may each have a substituent. In addition, a hydrogen atom bonded to the carbon atom in the group represented by R' may be substituted with a fluorine atom or an iodine atom.

m represents an integer of 0 or more. An upper limit of m is not particularly limited, but is 2 or less in many cases and 1 or less in more cases.

(Repeating unit represented by Formula (C))

As an example of a specific unit for accomplishing (c) above, a method of introducing a repeating unit represented by Formula (C) into the resin (A) may be mentioned.

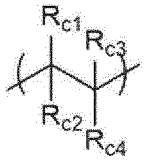

(C)

In Formula (C), $R_{c1}$ to $R_{c4}$ each independently represent a hydrogen atom or an organic group, and at least one of $R_{c1}$, ..., or $R_{c4}$ is a group having a hydrogen-bonding hydrogen atom with the number of atoms of 3 or less from the main chain carbon. Among these, it is preferable that the group has hydrogen-bonding hydrogen atoms with the number of atoms of 2 or less (on a side closer to the vicinity of the main chain) to cause an interaction between the main chains of the resin (A).

Specific examples of the repeating unit represented by Formula (C) include the following repeating units.

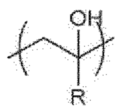 (C-1) 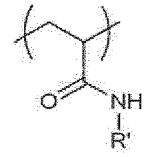 (C-2) 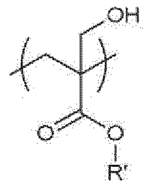 (C-3)

In the formula, R represents an organic group. Examples of the organic group include an alkyl group, a cycloalkyl group, an aryl group, an aralkyl group, an alkenyl group, and an ester group (-OCOR or -COOR: R represents an alkyl group or fluorinated alkyl group having 1 to 20 carbon atoms), each of which may have a substituent.

R' represents a hydrogen atom or an organic group. Examples of the organic group include an alkyl group, a cycloalkyl group, an aryl group, an aralkyl group, and an alkenyl group. A hydrogen atom in the organic group may be substituted with a fluorine atom or an iodine atom.

(Repeating unit represented by Formula (D))

As an example of a specific unit for accomplishing (d) above, a method of introducing a repeating unit represented by Formula (D) into the resin (A) may be mentioned.

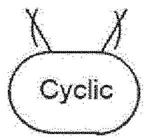

(D)

In Formula (D), "cyclic" is a group which forms a main chain as a cyclic structure. The number of ring-constituting atoms is not particularly limited.

Specific examples of the repeating unit represented by Formula (D) include the following repeating units.

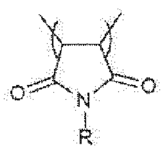 (D-1) 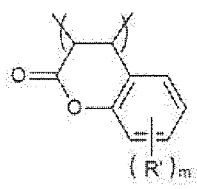 (D-2) 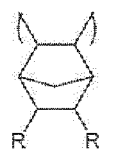 (D-3) 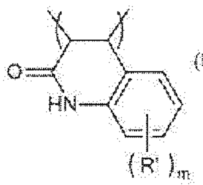 (D-4)

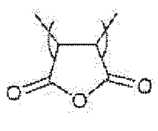 (D-5) 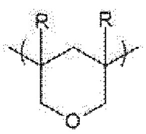 (D-6) 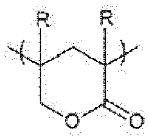 (D-7) 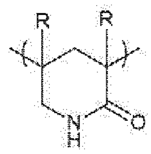 (D-8)

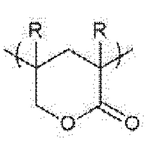 (D-9) 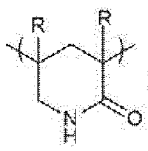 (D-10) 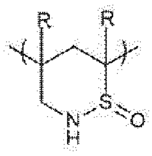 (D-11) 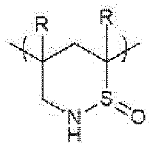 (D-12)

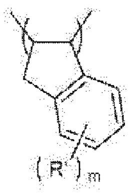 (D-13) 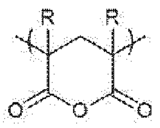 (D-14) 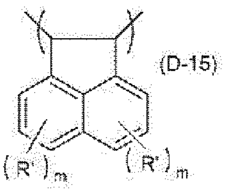 (D-15) 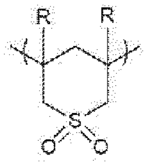 (D-16)

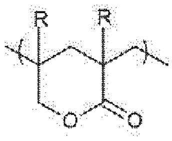 (D-17) 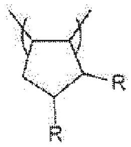 (D-18) 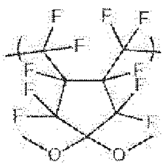 (D-19)

In the formula, R's each independently represent a hydrogen atom, an alkyl group, a cycloalkyl group, an aryl group, an aralkyl group, an alkenyl group, a hydroxyl group, an alkoxy group, an acyloxy group, a cyano group, a nitro group, an amino group, a halogen atom, an ester group (-OCOR" or -COOR"; R" is an alkyl group or fluorinated alkyl group having 1 to 20 carbon atoms), or a carboxyl group. The alkyl group, the cycloalkyl group, the aryl group, the aralkyl group, and the alkenyl group described above may each have a substituent. In addition, the hydrogen atom bonded to the carbon atom in the group represented by R may be substituted with a fluorine atom or an iodine atom.

In the formula, R"s each independently represent an alkyl group, a cycloalkyl group, an aryl group, an aralkyl group, an alkenyl group, a hydroxyl group, an alkoxy group, an acyloxy group, a cyano group, a nitro group, an amino group, a halogen atom, an ester group (-OCOR" or -COOR"; R" is an alkyl group or fluorinated alkyl group having 1 to 20 carbon atoms), or a carboxyl group. The alkyl group, the cycloalkyl group, the aryl group, the aralkyl group, and the alkenyl group described above may each have a substituent. In addition, a hydrogen atom bonded to the carbon atom in the group represented by R' may be substituted with a fluorine atom or an iodine atom.

m represents an integer of 0 or more. An upper limit of m is not particularly limited, but is 2 or less in many cases and 1 or less in more cases.

(Repeating unit represented by Formula (E))

As an example of a specific unit for accomplishing (e) above, a method of introducing a repeating unit represented by Formula (E) into the resin (A) may be mentioned.

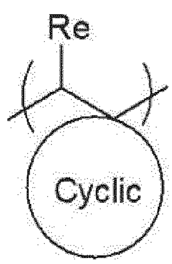 (E)

In Formula (E), Re's each independently represent a hydrogen atom or an organic group. Examples of the organic group include an alkyl group, a cycloalkyl group, an aryl group, an aralkyl group, and an alkenyl group, which may have a substituent.

"cyclic" is a cyclic group including a carbon atom of a main chain. The number of atoms included in the cyclic group is not particularly limited.

Specific examples of the repeating unit represented by Formula (E) include the following repeating units.

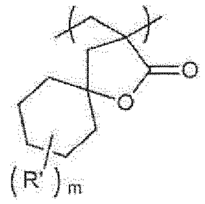 (E-1) 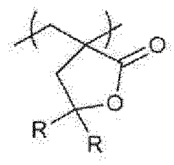 (E-2) 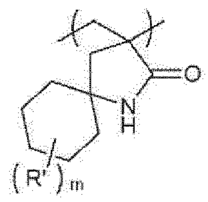 (E-3) 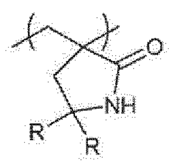 (E-4)

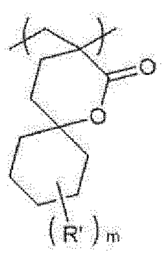 (E-5) 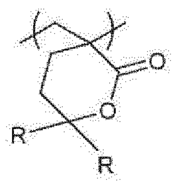 (E-6) 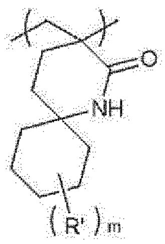 (E-7) 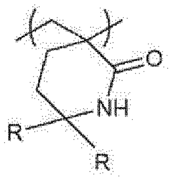 (E-8)

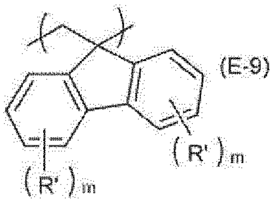 (E-9) 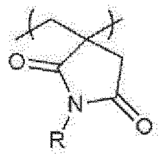 (E-10) 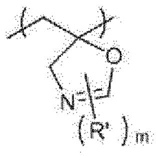 (E-11) 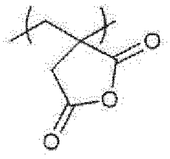 (E-12)

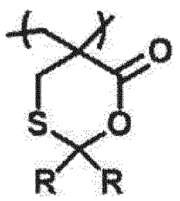 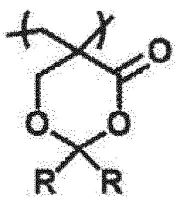 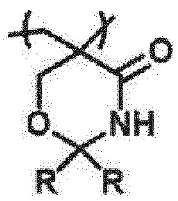

In the formula, R's each independently represent a hydrogen atom, an alkyl group, a cycloalkyl group, an aryl group, an aralkyl group, an alkenyl group, a hydroxyl group, an alkoxy group, an acyloxy group, a cyano group, a nitro group, an amino group, a halogen atom, an ester group (-OCOR" or -COOR"; R" is an alkyl group or fluorinated alkyl group having 1 to 20 carbon atoms), or a carboxyl group. The alkyl group, the cycloalkyl group, the aryl group, the aralkyl group, and the alkenyl group described above may each have a substituent. In addition, the hydrogen atom bonded to the carbon atom in the group represented by R may be substituted with a fluorine atom or an iodine atom.

R"s each independently represent a hydrogen atom, an alkyl group, a cycloalkyl group, an aryl group, an aralkyl group, an alkenyl group, a hydroxyl group, an alkoxy group, an acyloxy group, a cyano group, a nitro group, an amino group, a halogen atom, an ester group (-OCOR" or -COOR"; R" is an alkyl group or fluorinated alkyl group having 1 to 20 carbon atoms), or a carboxyl group. The alkyl group, the cycloalkyl group, the aryl group, the aralkyl group, and the alkenyl group described above may each have a substituent. In addition, a hydrogen atom bonded to the carbon atom in the group represented by R' may be substituted with a fluorine atom or an iodine atom.

m represents an integer of 0 or more. An upper limit of m is not particularly limited, but is 2 or less in many cases and 1 or less in more cases.

In addition, in Formula (E-2), Formula (E-4), Formula (E-6), and Formula (E-8), two R's may be bonded to each other to form a ring.

A content of the repeating unit represented by Formula (E) is preferably 5% by mole or more, and more preferably 10% by mole or more with respect to all the repeating units in the resin (A). In addition, the upper limit value thereof is preferably 60% by mole or less, and more preferably 55% by mole or less.

(Repeating unit having at least one group selected from lactone group, sultone group, carbonate group, hydroxyl group, cyano group, or alkali-soluble group)

The resin (A) may have a repeating unit having at least one group selected from a lactone group, a sultone

group, a carbonate group, a hydroxyl group, a cyano group, or an alkali-soluble group.

Examples of the repeating unit having a lactone group, a sultone group, or a carbonate group included in the resin (A) include the repeating units described in (Repeating unit having lactone group, sultone group, or carbonate group) described above. A preferred content thereof is also the same as described in (Repeating unit having lactone group, sultone group, or carbonate group) described above.

The resin (A) may have a repeating unit having a hydroxyl group or a cyano group. As a result, adhesiveness to the substrate and affinity for a developer are improved.

The repeating unit having a hydroxyl group or a cyano group is preferably a repeating unit having an alicyclic hydrocarbon structure substituted with a hydroxyl group or a cyano group.

It is preferable that the repeating unit having a hydroxyl group or a cyano group does not have the acid-decomposable group.

Examples of the repeating unit having a hydroxyl group or a cyano group include a repeating unit represented by General Formulae (AIIa) to (AIId).

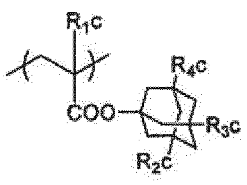
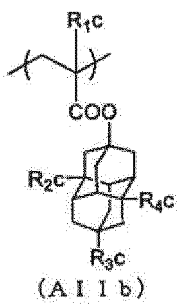
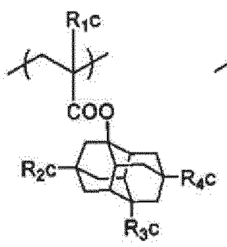
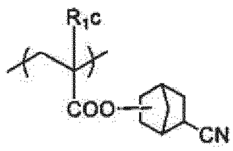

(A I I a) (A I I b) (A I I c) (A I I d)

In General Formulae (AIIa) to (AIId),

$R_{1c}$ represents a hydrogen atom, a methyl group, a trifluoromethyl group, or a hydroxymethyl group.

$R_{2c}$ to $R_{4c}$ each independently represent a hydrogen atom, a hydroxyl group, or a cyano group. However, at least one of $R_{2c}$, $R_{3c}$, or $R_{4c}$ represents a hydroxyl group or a cyano group. It is preferable that one or two of $R_{2c}$ to $R_{4c}$ are hydroxyl groups and the rest are hydrogen atoms. It is more preferable that two of $R_{2c}$ to $R_{4c}$ are hydroxyl groups and the rest are hydrogen atoms.

A content of the repeating unit having a hydroxyl group or a cyano group is preferably 5% by mole or more, and more preferably 10% by mole or more with respect to all the repeating units in the resin (A). In addition, the upper limit value thereof is preferably 40% by mole or less, more preferably 35% by mole or less, and still more preferably 30% by mole or less.

Specific examples of the repeating unit having a hydroxyl group or a cyano group are shown below, but the present invention is not limited thereto.

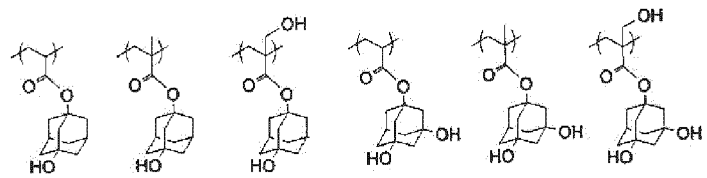

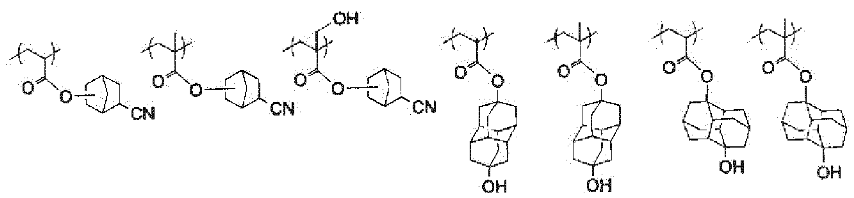

The resin (A) may have a repeating unit having an alkali-soluble group.

Examples of the alkali-soluble group include a carboxyl group, a sulfonamide group, a sulfonylimide group, a bissulfonylimide group, and an aliphatic alcohol group (for example, a hexafluoroisopropanol group) in which the α-position is substituted with an electron withdrawing group, and a carboxyl group is preferable. In a case where the resin (A) includes a repeating unit having an alkali-soluble group, the resolution for use in contact holes is increased.

Examples of the repeating unit having an alkali-soluble group include a repeating unit having an alkali-soluble group that is directly bonded to the main chain of the resin, such as a repeating unit composed of an acrylic acid or a methacrylic acid, and a repeating unit having an alkali-soluble group that is bonded to the main chain of the resin through a linking group. The linking group may have a monocyclic or polycyclic hydrocarbon structure.

The repeating unit having an alkali-soluble group is preferably a repeating unit with acrylic acid or methacrylic acid.

A content of the repeating unit having an alkali-soluble group is preferably 0% by mole or more, more preferably 3% by mole or more, and still more preferably 5% by mole or more with respect to all the repeating units in the resin (A). The upper limit value thereof is preferably 20% by mole or less, more preferably 15% by mole or less, and still more preferably 10% by mole or less.

Specific examples of the repeating unit having an alkali-soluble group will be shown below, but the present invention is not limited thereto. In the specific examples, Rx represents H, $CH_3$, CHzOH, or $CF_3$.

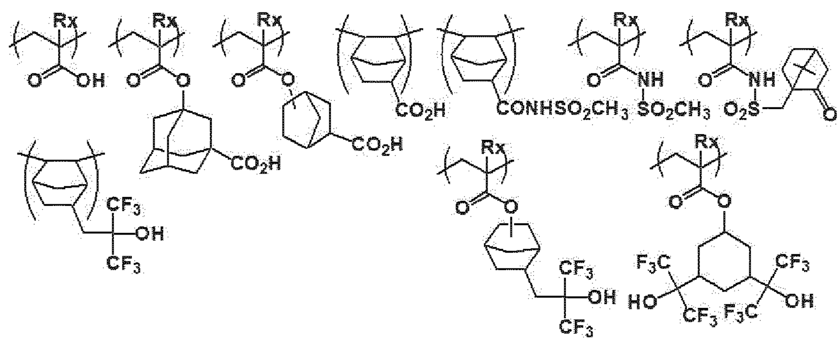

As the repeating unit having at least one group selected from a lactone group, a hydroxyl group, a cyano group, or an alkali-soluble group, a repeating unit having at least two selected from a lactone group, a hydroxyl group, a cyano group, or an alkali-soluble group is preferable, a repeating unit having a cyano group and a lactone group is more preferable, and a repeating unit having a structure in which a cyano group is substituted in the lactone structure represented by General Formula (LC1-4) is still more preferable.

(Repeating unit having alicyclic hydrocarbon structure and not exhibiting acid decomposability)

The resin (A) may have a repeating unit having an alicyclic hydrocarbon structure and not exhibiting acid decomposability. As a result, it is possible to reduce the elution of low-molecular-weight components from the resist film into an immersion liquid during liquid immersion exposure. Examples of such a repeating unit include a repeating unit derived from 1-adamantyl (meth)acrylate, a repeating unit derived from diamanthyl (meth)acrylate, a repeating unit derived from tricyclodecanyl (meth)acrylate, and a repeating unit derived from cyclohexyl (meth)acrylate.

(Repeating unit represented by General Formula (III) having neither hydroxyl group nor cyano group)

The resin (A) may have a repeating unit represented by General Formula (III), which has neither a hydroxyl group nor a cyano group.

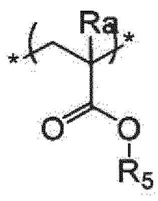

(III)

In General Formula (III), $R_5$ represents a hydrocarbon group having at least one cyclic structure and having neither a hydroxyl group nor a cyano group.

Ra represents a hydrogen atom, an alkyl group, or a -CHz-O-Raz group. In the formula, $Ra_2$ represents a hydrogen atom, an alkyl group, or an acyl group.

The cyclic structure included in $R_5$ includes a monocyclic hydrocarbon group and a polycyclic hydrocarbon group.

Examples of the monocyclic hydrocarbon group include a cycloalkyl group having 3 to 12 carbon atoms (more preferably having 3 to 7 carbon atoms) and a cycloalkenyl group having 3 to 12 carbon atoms.

Examples of the polycyclic hydrocarbon group include a ring assembly hydrocarbon group and a crosslinked cyclic hydrocarbon group.

Examples of the crosslinked cyclic hydrocarbon ring include a bicyclic hydrocarbon ring, a tricyclic hydrocarbon ring, and a tetracyclic hydrocarbon ring. In addition, as the crosslinked cyclic hydrocarbon ring, a fused ring in which a plurality of 5- to 8-membered cycloalkane rings are fused is also included.

As the crosslinked cyclic hydrocarbon group, a norbornyl group, an adamantyl group, a bicyclooctanyl group, or a tricyclo[5,2,1,$0^{2,6}$]decanyl group is preferable, and a norbornyl group or an adamantyl group is more preferable.

The alicyclic hydrocarbon group may have a substituent, and examples of the substituent include a halogen atom, an alkyl group, a hydroxyl group protected by a protective group, and an amino group protected by a protective group.

The halogen atom is preferably a bromine atom, a chlorine atom, or a fluorine atom.

As the alkyl group, a methyl group, an ethyl group, a butyl group, or a t-butyl group is preferable. The alkyl group may further have a substituent, and examples of the substituent include a halogen atom, an alkyl group, a hydroxyl group protected by a protective group, and an amino group protected by a protective group.

Examples of the protective group include an alkyl group, a cycloalkyl group, an aralkyl group, a substituted methyl group, a substituted ethyl group, an alkoxycarbonyl group, and an aralkyloxycarbonyl group.

As the alkyl group, an alkyl group having 1 to 4 carbon atoms is preferable.

As the substituted methyl group, a methoxymethyl group, a methoxythiomethyl group, a benzyloxymethyl group, a t-butoxymethyl group, or a 2-methoxyethoxymethyl group is preferable.

The substituted ethyl group is preferably a 1-ethoxyethyl group or a 1-methyl-1-methoxyethyl group.

As the acyl group, an aliphatic acyl group having 1 to 6 carbon atoms, such as a formyl group, an acetyl group, a propionyl group, a butyryl group, an isobutyryl group, a valeryl group, and a pivaloyl group, is preferable.

As the alkoxycarbonyl group, an alkoxycarbonyl group having 1 to 4 carbon atoms is preferable.

A content of the repeating unit represented by General Formula (III), which has neither a hydroxyl group nor a cyano group, is preferably 0% to 40% by mole, and more preferably 0% to 20% by mole with respect to all repeating units in the resin (A).

Specific examples of the repeating unit represented by General Formula (III) are shown below, but the present invention is not limited thereto. In the formula, Ra represents H, $CH_3$, CHzOH, or $CF_3$.

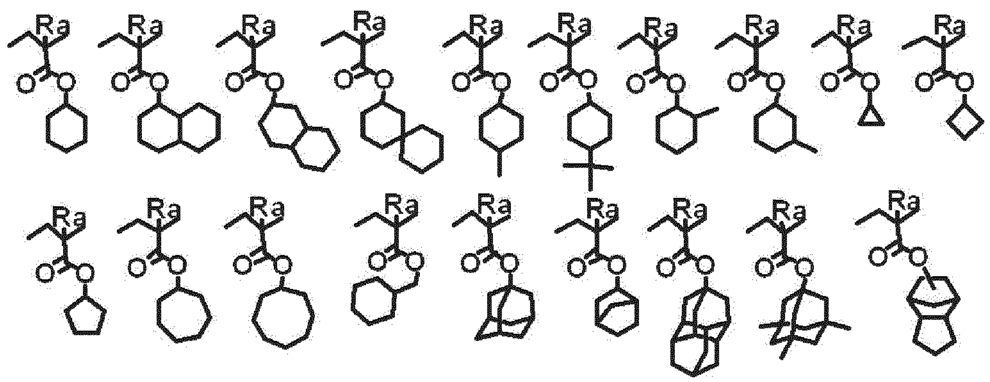

(Other Repeating Units)

Further, the resin (A) may have a repeating unit other than the above-described repeating units.

For example, the resin (A) may have a repeating unit selected from the group consisting of a repeating unit having an oxathiane ring group, a repeating unit having an oxazolone ring group, a repeating unit having a dioxane ring group, and a repeating unit having a hydantoin ring group.

Such repeating units will be exemplified below.

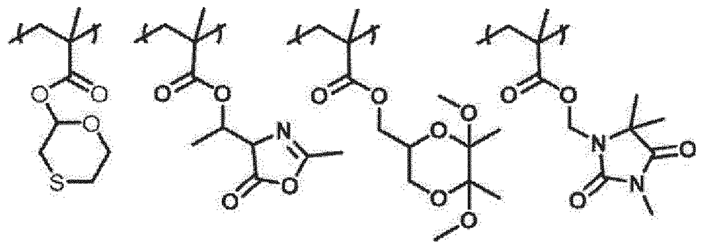

For the purpose of controlling dry etching resistance, suitability for a standard developer, substrate adhesiveness, resist profile, resolution, heat resistance, sensitivity, and the like, the resin (A) may have various repeating structural units in addition to the repeating structural units described above.

As the resin (A), all the repeating units also preferably include (meth)acrylate-based repeating units (particularly, in a case where the composition is used for ArF applications). In this case, any resin of a resin in which all repeating units are methacrylate-based repeating units, a resin in which all repeating units are acrylate-based repeating units, or a resin with all repeating units consisting of a methacrylate-based repeating unit and an acrylate-based repeating unit can be used. In addition, the acrylate-based repeating unit is preferably 50% by mole or less of all the repeating units.

The resin (A) can be synthesized in accordance with an ordinary method (for example, a radical polymerization).

A weight-average molecular weight of the resin (A) as a value expressed in terms of polystyrene by a GPC method is preferably 1000 to 200000, more preferably 3000 to 20000, and still more preferably 5000 to 15000. By setting the weight-average molecular weight of the resin (A) to 1000 to 200000, deterioration of heat resistance and dry etching resistance can be further suppressed. In addition, deterioration of developability and deterioration of film-forming properties due to high viscosity can also be further suppressed.

A dispersity (molecular weight distribution) of the resin (A) is usually 1 to 5, preferably 1 to 3, more preferably 1.2 to 3.0, and still more preferably 1.2 to 2.0. As the dispersity is smaller, resolution and resist shape are more excellent, and a side wall of a resist pattern is smoother.

In the resist composition, a content of the resin (A) is preferably 50% to 99.9% by mass, and more preferably 60% to 99.0% by mass with respect to the total solid content of the composition.

In addition, the resin (A) may be used alone or in combination of two or more kinds thereof.

<Photoacid generator>

The photoacid generator may be in a form of a low-molecular-weight compound or a form incorporated into a part of a polymer. In addition, a combination of the form of a low-molecular-weight compound and the form incorporated into a part of a polymer may also be used.

In addition, in a case where the photoacid generator is in a form of a low-molecular-weight compound, a molecular weight of the photoacid generator is preferably 3000 or less, more preferably 2000 or less, and still more preferably 1000 or less.

In a case where the photoacid generator is in the form incorporated into a part of a polymer, it may be incorporated into the part of the resin (A) or into a resin which is different from the resin (A).

In the present invention, the photoacid generator is preferably in the form of a low-molecular-weight compound.

The photoacid generator is not particularly limited as long as it is a known one, but it is preferably a compound that generates at least any one of organic acids such as sulfonic acid, bis(alkylsulfonyl)imide, and tris(alkylsulfonyl)methide by irradiation with actinic rays or radiation, preferably electron beams or extreme ultraviolet rays.

More preferred examples thereof include a compound represented by General Formula (ZI), a compound represented by (ZII), and a compound represented by (ZIII).

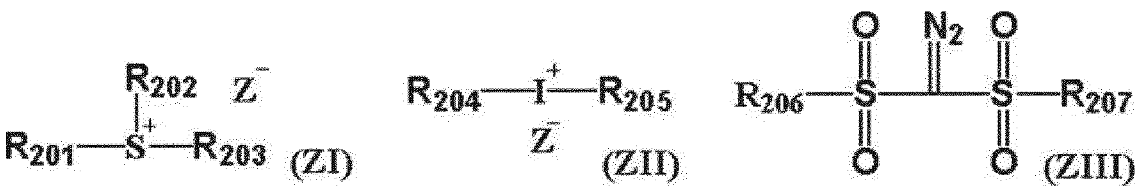

(ZI) (ZII) (ZIII)

In General Formula (ZI), $R_{201}$, $R_{202}$, and $R_{203}$ each independently represent an organic group.

The number of carbon atoms in the organic group of $R_{201}$, $R_{202}$, and $R_{203}$ is preferably 1 to 30 and more preferably 1 to 20.

In addition, two of $R_{201}$ to $R_{203}$ may be bonded to each other to form a ring structure, and the ring structure

may include an oxygen atom, a sulfur atom, an ester bond, an amide bond, or a carbonyl group in the ring. Examples of the group formed by the bonding of two of $R_{201}$ to $R_{203}$ include an alkylene group (for example, a butylene group and a pentylene group).

$Z^-$ represents a non-nucleophilic anion (anion having a remarkably low ability of causing a nucleophilic reaction).

Examples of the non-nucleophilic anion include a sulfonate anion (an aliphatic sulfonate anion, an aromatic sulfonate anion, a camphor sulfonate anion, and the like), a carboxylate anion (an aliphatic carboxylate anion, an aromatic carboxylate anion, an aralkyl carboxylate anion, and the like), a sulfonylimide anion, a bis(alkylsulfonyl)imide anion, and a tris(alkylsulfonyl)methide anion.

An aliphatic moiety in the aliphatic sulfonate anion and the aliphatic carboxylate anion may be an alkyl group or a cycloalkyl group, and preferred examples thereof include a linear or branched alkyl group having 1 to 30 carbon atoms and a cycloalkyl group having 3 to 30 carbon atoms.

As the aromatic group in the aromatic sulfonate anion and the aromatic carboxylate anion, an aryl group having 6 to 14 carbon atoms is preferable. Examples thereof include a phenyl group, a tolyl group, and a naphthyl group.

The above-described alkyl group, cycloalkyl group, and aryl group may have a substituent. Specific examples thereof include a nitro group, a halogen atom such as a fluorine atom, a carboxyl group, a hydroxyl group, an amino group, a cyano group, an alkoxy group (preferably having 1 to 15 carbon atoms), a cycloalkyl group (preferably having 3 to 15 carbon atoms), an aryl group (preferably having 6 to 14 carbon atoms), an alkoxycarbonyl group (preferably having 2 to 7 carbon atoms), an acyl group (preferably having 2 to 12 carbon atoms), an alkoxycarbonyloxy group (preferably having 2 to 7 carbon atoms), an alkylthio group (preferably having 1 to 15 carbon atoms), an alkylsulfonyl group (preferably having 1 to 15 carbon atoms), an alkyliminosulfonyl group (preferably having 1 to 15 carbon atoms), an aryloxysulfonyl group (preferably having 6 to 20 carbon atoms), an alkylaryloxysulfonyl group (preferably having 7 to 20 carbon atoms), a cycloalkylaryloxysulfonyl group (preferably having 10 to 20 carbon atoms), an alkyloxyalkyloxy group (preferably having 5 to 20 carbon atoms), and a cycloalkylalkyloxyalkyloxy group (preferably having 8 to 20 carbon atoms).

Examples of the further substituent for the aryl group and ring structure of each group include an alkyl group (preferably having 1 to 15 carbon atoms).

As the aralkyl group in the aralkyl carboxylate anion, an aralkyl group having 7 to 12 carbon atoms is preferable. Examples thereof include a benzyl group, a phenethyl group, a naphthylmethyl group, a naphthylethyl group, and a naphthylbutyl group.

Examples of the sulfonylimide anion include a saccharin anion.

As the alkyl group in the bis(alkylsulfonyl)imide anion or the tris(alkylsulfonyl)methide anion, an alkyl group having 1 to 5 carbon atoms is preferable. Examples of a substituent of these alkyl group include a halogen atom, an alkyl group substituted with a halogen atom, an alkoxy group, an alkylthio group, an alkyloxysulfonyl group, an aryloxysulfonyl group, and a cycloalkylaryloxysulfonyl group, and a fluorine atom or an alkyl group substituted with a fluorine atom is preferable.

In addition, the alkyl groups in the bis(alkylsulfonyl)imide anion may be bonded to each other to form a ring structure. As a result, the acid strength is increased.

Examples of other non-nucleophilic anions include fluorinated phosphorus (for example, $PF_6^-$), fluorinated boron (for example, $BF_4^-$), and fluorinated antimony (for example, $SbF_6^-$).

As the non-nucleophilic anion, an aliphatic sulfonate anion in which at least an $\alpha$-position of the sulfonic acid is substituted with a fluorine atom, an aromatic sulfonate anion substituted with a fluorine atom or a group having a fluorine atom, a bis(alkylsulfonyl)imide anion in which an alkyl group is substituted with a fluorine atom, or a tris(alkylsulfonyl)methide anion in which an alkyl group is substituted with a fluorine atom is preferable. As the non-nucleophilic anion, a perfluoroaliphatic sulfonate anion (preferably having 4 to 8 carbon atoms) or benzenesulfonate anion having a fluorine atom is more preferable, and a nonafluorobutanesulfonate anion, a perfluorooctanesulfonate anion, a pentafluorobenzenesulfonate anion, or a 3,5-bis(trifluoromethyl)benzenesulfonate anion is still more preferable.

From the viewpoint of acid strength and sensitivity, a pKa of the generated acid is preferably -1 or less.

In addition, examples of a preferred aspect of the non-nucleophilic anion include an anion represented by General Formula (AN1).

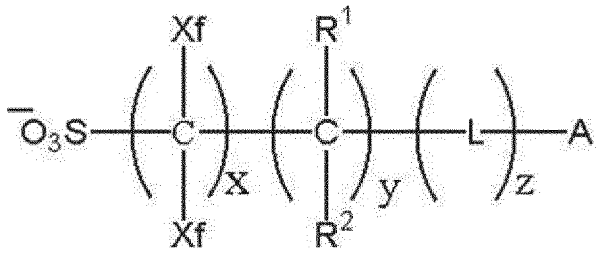

(AN1)

In the formula, Xf's each independently represent a fluorine atom or an alkyl group substituted with at least one fluorine atom.

$R^1$ and $R^2$ each independently represent a hydrogen atom, a fluorine atom, or an alkyl group. In a case where a plurality of $R^1$'s and $R^2$'s are present, $R^1$'s and $R^2$'s may each be the same or different from each other.

L represents a divalent linking group, and in a case where a plurality of L's are present, L's may be the same or different from each other.

A represents a cyclic organic group.

x represents an integer of 1 to 20, y represents an integer of 0 to 10, and z represents an integer of 0 to 10.

General Formula (AN1) will be described in more detail.

The number of carbon atoms in the alkyl group as the alkyl group substituted with a fluorine atom of Xf is preferably 1 to 10 and more preferably 1 to 4. In addition, the alkyl group as the alkyl group substituted with a fluorine atom of Xf is preferably a perfluoroalkyl group.

Xf is preferably a fluorine atom or a perfluoroalkyl group having 1 to 4 carbon atoms. Specific examples of Xf include a fluorine atom, $CF_3$, $C_2F_5$, $C_3F_7$, $C_4F_9$, $CH_2CF_3$, $CH_2CH_2CF_3$, $CH_2C_2F_5$, $CH_2CH_2C_2F_5$, $CH_2C_3F_7$, $CH_2CH_2C_3F_7$, $CH_2C_4F_9$, and $CH_2CH_2C_4F_9$. Among these, a fluorine atom or $CF_3$ is preferable.

In particular, it is preferable that both Xf's are fluorine atoms.

The alkyl group of $R^1$ and $R^2$ may have a substituent (preferably a fluorine atom), and the number of carbon atoms is preferably 1 to 4. Among these, the alkyl group of $R^1$ and $R^2$ is preferably a perfluoroalkyl group having 1 to 4 carbon atoms. Specific examples of the alkyl group of $R^1$ and $R^2$, which has the substituent, include $CF_3$, $C_2F_5$, $C_3F_7$, $C_4F_9$, $C_5F_{11}$, $C_6F_{13}$, $C_7F_{15}$, $C_8F_{17}$, $CH_2CF_3$, $CH_2CH_2CF_3$, $CH_2C_2F_5$, $CH_2CH_2C_2F_5$, $CH_2C_3F_7$, $CH_2CH_2C_3F_7$, $CH_2C_4F_9$, and $CH_2CH_2C_4F_9$. Among these, $CF_3$ is preferable.

$R^1$ and $R^2$ are preferably a fluorine atom or $CF_3$.

x is preferably 1 to 10 and more preferably 1 to 5.

y is preferably 0 to 4 and more preferably 0.

z is preferably 0 to 5 and more preferably 0 to 3.

The divalent linking group of L is not particularly limited, and examples thereof include -COO-, -OCO-, -CO-, -O-, -S-, -SO-, -SOz-, an alkylene group, a cycloalkylene group, an alkenylene group, a linking group consisting of a plurality of these groups linked to each other, and the like. Among these, a linking group having a total number of carbon atoms of 12 or less is preferable. In addition, -COO-, -OCO-, -CO-, or -O- is preferable, and -COO- or -OCO- is more preferable.

In General Formula (AN1), as a combination of partial structures other than A, $SO^3$-$CF_2$-$CH_2$-OCO-, $SO^3$-$CF_2$-CHF-$CH_2$-OCO-, $SO^{3-}$-$CF_2$-COO-, $SO^{3-}$-$CF_2$-$CF_2$-$CH_2$-, or $SO^{3-}$-$CF_2$-CH($CF_3$)-OCO- is preferable.

The cyclic organic group of A is not particularly limited as long as it has a cyclic structure, and examples thereof include an alicyclic group, an aryl group, and a heterocyclic group (including not only an aromatic heterocyclic group but also a non-aromatic heterocyclic group).

The alicyclic group may be a monocycle or a polycycle, and is preferably a monocyclic cycloalkyl group such as a cyclopentyl group, a cyclohexyl group, and a cyclooctyl group, or a polycyclic cycloalkyl group such as a norbornyl group, a tricyclodecanyl group, a tetracyclodecanyl group, a tetracyclododecanyl group, and an adamantyl group. Among these, from the viewpoint that diffusivity in the film in a post-exposure heating step can be suppressed and mask error enhancement factor (MEEF) is improved, an alicyclic group having a bulky structure and having 7 or more carbon atoms, such as a norbornyl group, a tricyclodecanyl group, a tetracyclodecanyl group, a tetracyclododecanyl group, and an adamantyl group is preferable.

Examples of the aryl group include a benzene ring, a naphthalene ring, a phenanthrene ring, and an anthracene ring.

Examples of the heterocyclic group include groups derived from a furan ring, a thiophene ring, a benzofuran ring, a benzothiophene ring, a dibenzofuran ring, a dibenzothiophene ring, or a pyridine ring. Among these, groups derived from a furan ring, a thiophene ring, or a pyridine ring are preferable.

In addition, examples of the cyclic organic group also include a lactone structure, and specific examples thereof

include the lactone structures represented by General Formulae (LC1-1) to (LC1-17) described above.

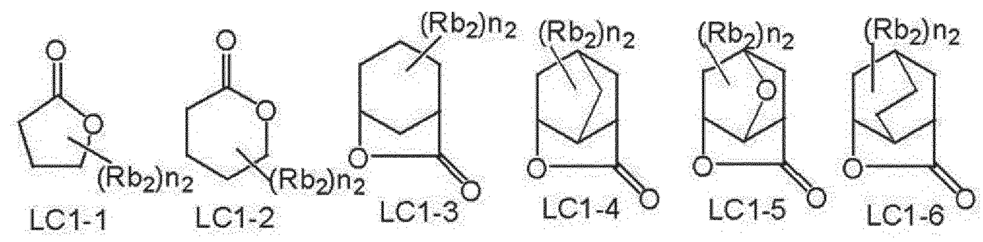

LC1-1 LC1-2 LC1-3 LC1-4 LC1-5 LC1-6

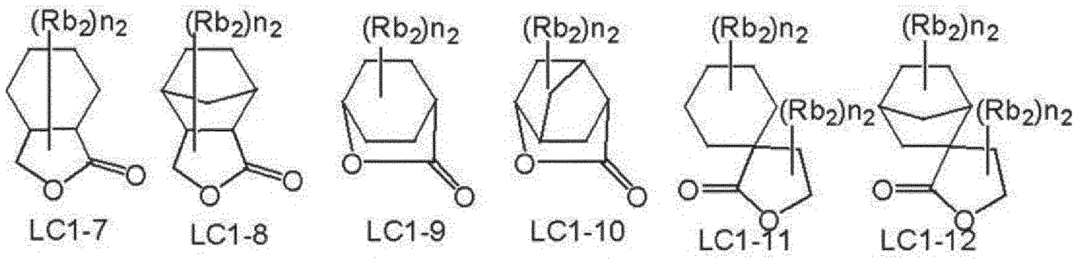

LC1-7 LC1-8 LC1-9 LC1-10 LC1-11 LC1-12

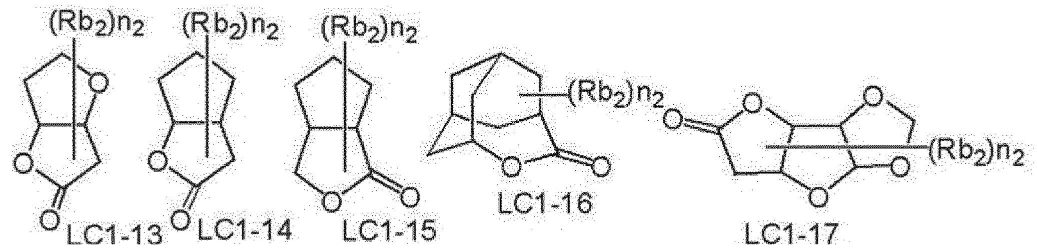

LC1-13 LC1-14 LC1-15 LC1-16 LC1-17

The above-described cyclic organic group may have a substituent, and examples of the substituent include an alkyl group (may be linear, branched, or cyclic; preferably having 1 to 12 carbon atoms), a cycloalkyl group (may be monocyclic, polycyclic, or spiro ring; preferably having 3 to 20 carbon atoms), an aryl group (preferably having 6 to 14 carbon atoms), a hydroxy group, an alkoxy group, an ester group, an amide group, a urethane group, a ureido group, a thioether group, a sulfonamide group, and a sulfonic acid ester group. A carbon constituting the cyclic organic group (carbon contributing to ring formation) may be a carbonyl carbon.

The above-described substituent corresponds to Rbz in General Formulae (LC1-1) to (LC1-17). In addition, in General Formulae (LC1-1) to (LC1-17), n2 represents an integer of 0 to 4. In a case where n2 is 2 or more, Rbz's which are present in a plural number may be the same or different from each other, and $Rb_2$'s which are present in a plural number may be bonded to each other to form a ring.

In General Formula (ZI), examples of the organic group of $R_{201}$, $R_{202}$, and $R_{203}$ include an aryl group, an alkyl group, and a cycloalkyl group.

It is preferable that at least one of $R_{201}$, $R_{202}$, or $R_{203}$ is an aryl group, and it is more preferable that all of $R_{201}$, $R_{202}$, and $R_{203}$ represent an aryl group. As the aryl group, in addition to a phenyl group, a naphthyl group, and the like, a heteroaryl group such as an indole residue and a pyrrole residue can also be used. As the alkyl group and cycloalkyl group of $R_{201}$ to $R_{203}$, a linear or branched alkyl group having 1 to 10 carbon atoms or a cycloalkyl group having 3 to 10 carbon atoms is preferable. As the alkyl group, a methyl group, an ethyl group, an n-propyl group, an isopropyl group, an n-butyl group, or the like is preferable. As the cycloalkyl group, a cyclopropyl group, a cyclobutyl group, a cyclopentyl group, a cyclohexyl group, a cycloheptyl group, or the like is preferable. These groups may further have a substituent. Examples of the substituent which may be further included include a nitro group, a halogen atom such as a fluorine atom, a carboxyl group, a hydroxyl group, an amino group, a cyano group, an alkoxy group (preferably having 1 to 15 carbon atoms), a cycloalkyl group (preferably having 3 to 15 carbon atoms), an aryl group (preferably having 6 to 14 carbon atoms), an alkoxycarbonyl group (preferably having 2 to 7 carbon atoms), an acyl group (preferably having 2 to 12 carbon atoms), and an alkoxycarbonyloxy group (preferably having 2 to 7 carbon atoms), but the present invention is not limited thereto.

Next, General Formulae (ZII) and (ZIII) will be described.

In General Formulae (ZII) and (ZIII), $R_{204}$ to $R_{207}$ each independently represent an aryl group, an alkyl group, or a cycloalkyl group.

The aryl group of $R_{204}$ to $R_{207}$ is preferably a phenyl group or a naphthyl group, and more preferably a phenyl group. The aryl group of $R_{204}$ to $R_{207}$ may be an aryl group which has a heterocyclic structure having an oxygen atom, a nitrogen atom, a sulfur atom, or the like. Examples of a skeleton of the aryl group having a heterocyclic structure include pyrrole, furan, thiophene, indole, benzofuran, and benzothiophene.

The alkyl group and cycloalkyl group of $R_{204}$ to $R_{207}$ are preferably a linear or branched alkyl group having 1 to 10 carbon atoms (for example, a methyl group, an ethyl group, a propyl group, a butyl group, and a pentyl group), or a cycloalkyl group having 3 to 10 carbon atoms (a cyclopentyl group, a cyclohexyl group, and a norbornyl group).

The aryl group, alkyl group, and cycloalkyl group of $R_{204}$ to $R_{207}$ may have a substituent. Examples of the substituent which may be included in each of the aryl group, the alkyl group, and the cycloalkyl group of $R_{204}$ to $R_{207}$ include an alkyl group (for example, having 1 to 15 carbon atoms), a cycloalkyl group (for example, having 3 to 15 carbon atoms), an aryl group (for example, having 6 to 15 carbon atoms), an alkoxy group (for example, having 1 to 15 carbon atoms), a halogen atom, a hydroxyl group, and a phenylthio group.

In addition, in General Formula (ZII), $Z^-$ represents a non-nucleophilic anion. Specifically, $Z^-$ is the same as that described as $Z^-$ in General Formula (ZI), and the preferred aspect thereof is also the same.

Hereinafter, specific examples of General Formulae (ZI) to (ZIII) are shown, but the present invention is not limited thereto.

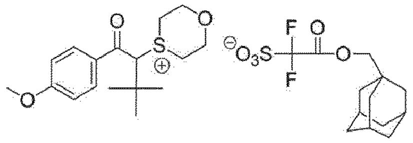

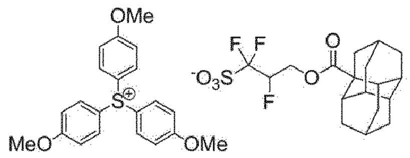

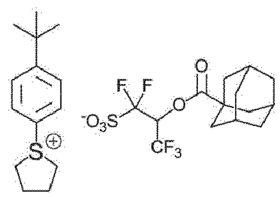

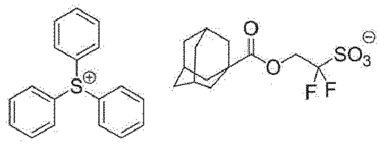

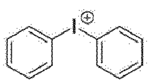

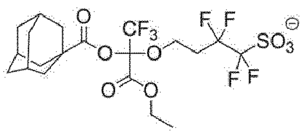

In the present invention, from the viewpoint of suppressing an acid generated by exposure from diffusing to an unexposed portion and improving the resolution, the above-described photoacid generator is a compound which generates an acid in a size with a volume of 130 $Å^3$ or more (more preferably, a sulfonic acid), more preferably a compound which generates an acid in a size with a volume of 190 $Å^3$ or more (more preferably, a sulfonic acid), still more preferably a compound which generates an acid in a size with a volume of 270 $Å^3$ or more (more preferably, sulfonic acid), and particularly preferably a compound which generates an acid in a size with a volume of 400 $Å^3$ or more (more preferably, sulfonic acid), by irradiation with electron beams or extreme ultraviolet rays. However, from the viewpoint of sensitivity or solubility in a coating solvent, the above-described volume is preferably 2,000 $Å^3$ or less, and more preferably 1,500 $Å^3$ or less. The value of the above-described volume is obtained using "WinMOPAC" manufactured by Fujitsu Limited. First, the chemical structure of an acid according to each example is input, next, using this structure as an initial structure, the most stable steric conformation of each acid is determined by molecular force field calculation using an MM3 method, and then, molecular orbital calculation using a PM3 method is performed with respect to the most stable steric conformation, whereby an "accessible volume" of each acid can be calculated. 1 Å means 0.1 nm.

In the present invention, a photoacid generator which generates acids exemplified below by irradiation with actinic rays or radiation is preferable. In some of the examples, the computed value of the volume is added (unit: $Å^3$). The calculated value obtained here is a volume value of an acid in a which a proton is bonded to the anionic moiety.

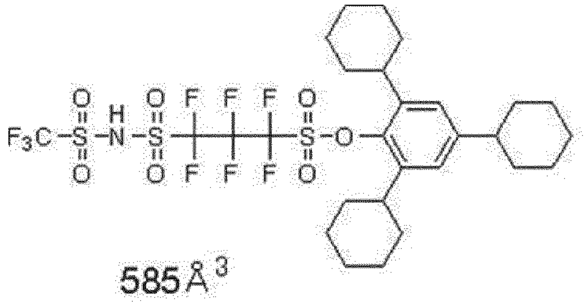

585 Å$^3$

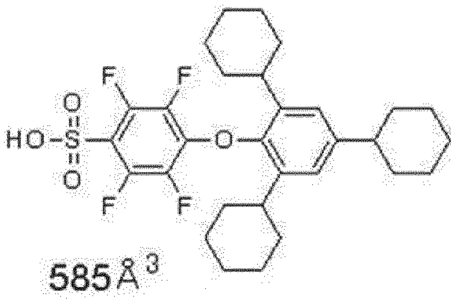

585 Å$^3$

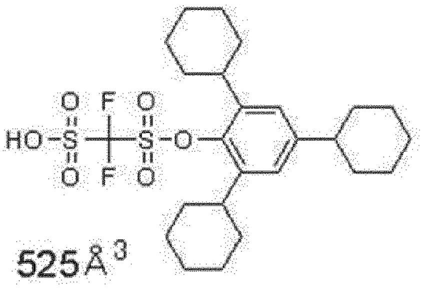

525 Å$^3$

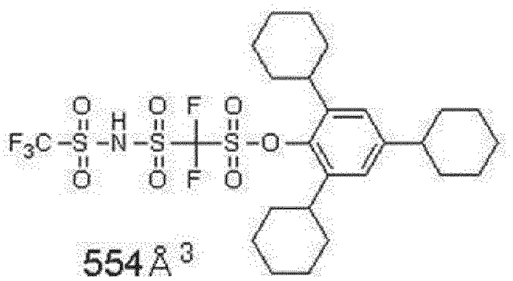

554 Å$^3$

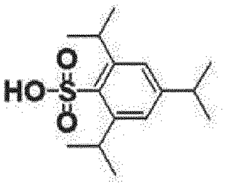

303 Å$^3$

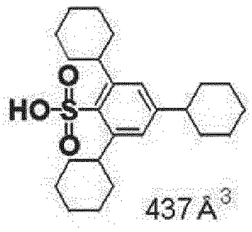

437 Å$^3$

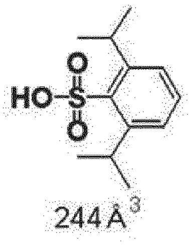

244 Å$^3$

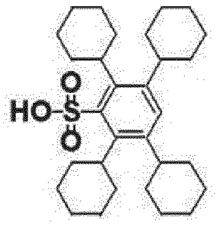

529 Å$^3$

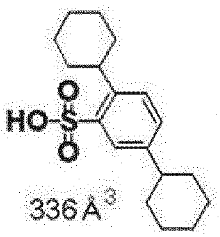

336 Å$^3$

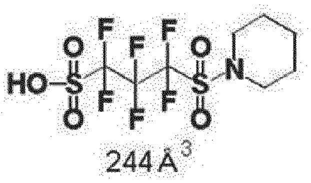

244 Å$^3$

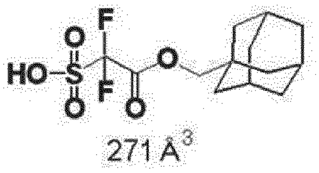

271 Å$^3$

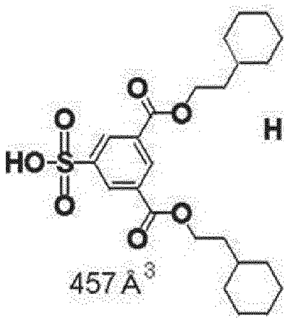

457 Å$^3$

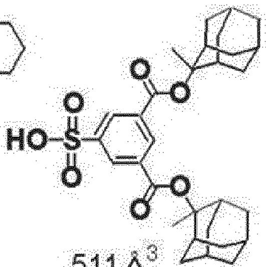

511 Å$^3$

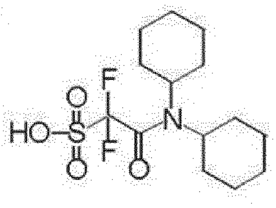

311 Å$^3$

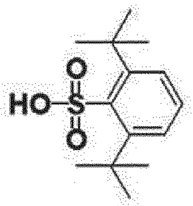

280 Å$^3$

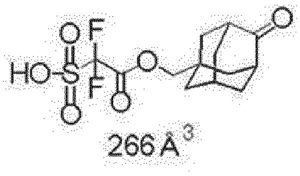

266 Å3

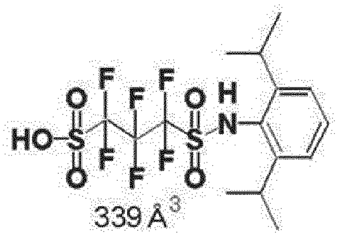

339 Å3

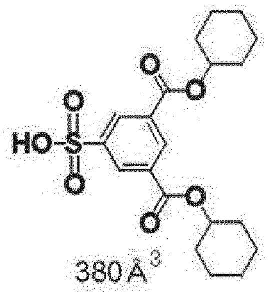

380 Å3

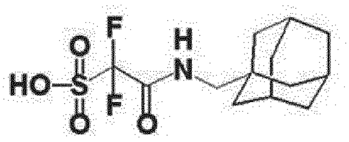

277 Å3

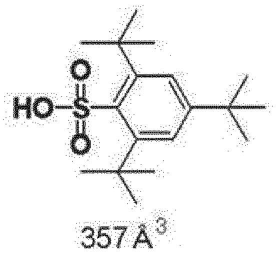

357 Å3

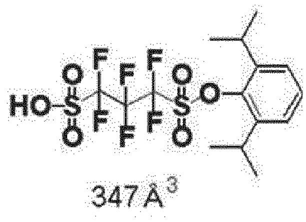

347 Å3

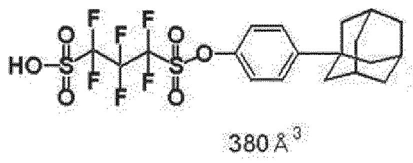

380 Å3

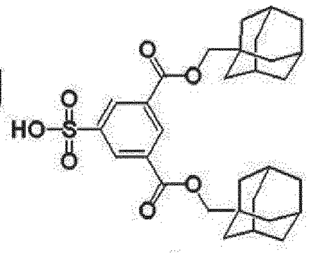

519 Å3

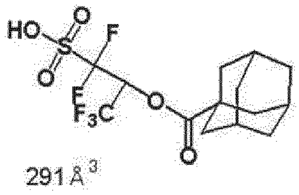

291 Å3

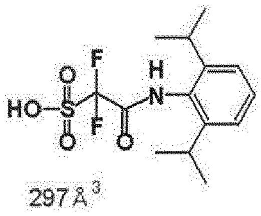

297 Å3

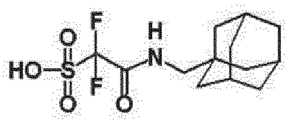

277 Å3

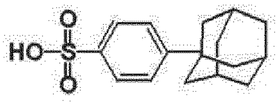

281 Å3

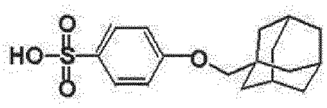

310 Å3

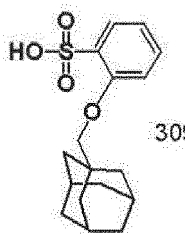

309 Å3

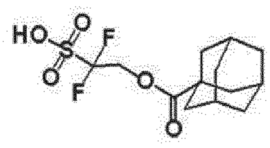

270 Å3

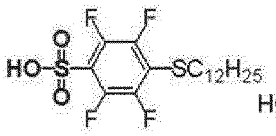

393 Å3

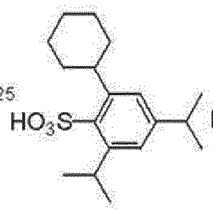

350 Å3

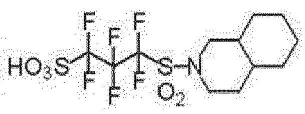

311 Å3

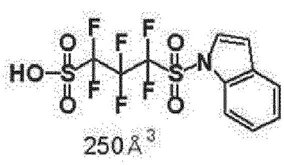

250 Å3

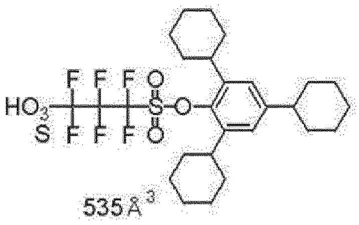
535 Å$^3$

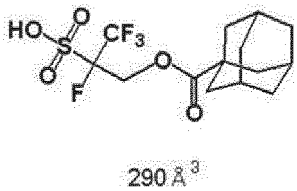
290 Å$^3$

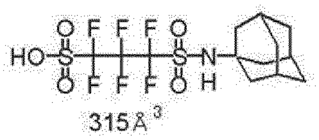
315 Å$^3$

With regard to the photoacid generator, reference can be made to paragraphs [0368] to [0377] of JP2014-41328A and paragraphs [0240] to [0262] of JP2013-228681A (corresponding to paragraph [0339] of US2015/004533A), the contents of which are incorporated herein by reference. In addition, preferred specific examples thereof include the following compounds, but the present invention is not limited thereto.

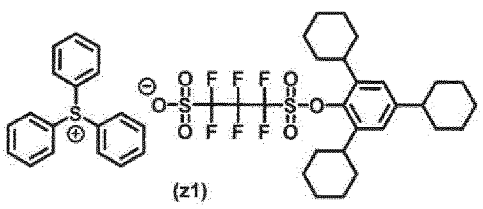
(z1)

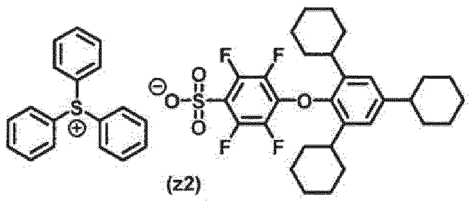
(z2)

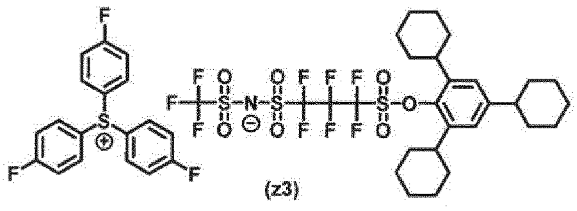
(z3)

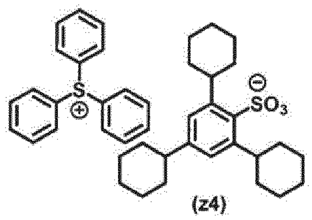
(z4)

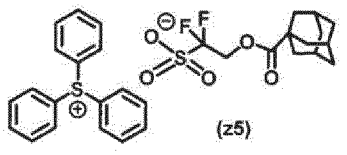
(z5)

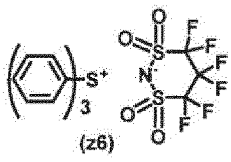
(z6)

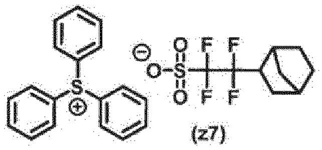
(z7)

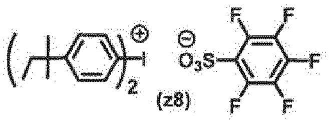
(z8)

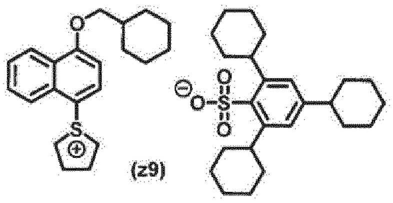
(z9)

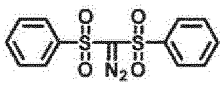
(z10)

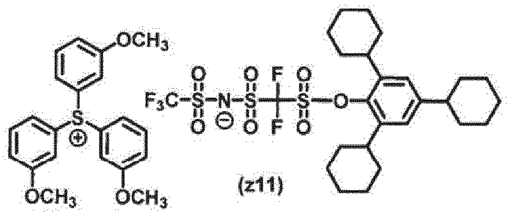
(z11)

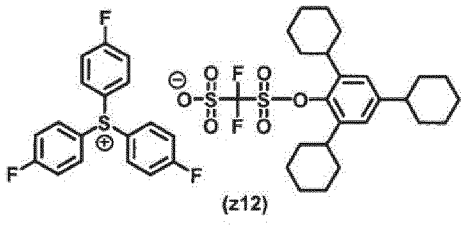
(z12)

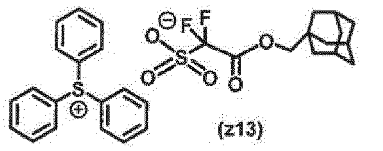
(z13)

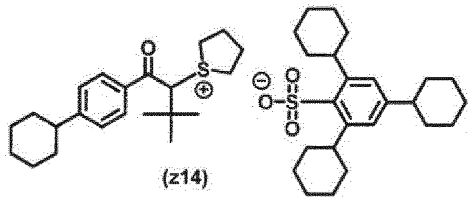
(z14)

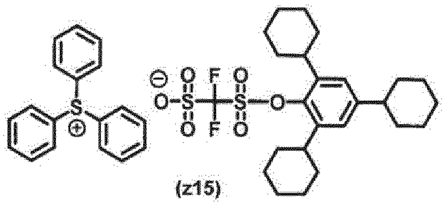
(z15)

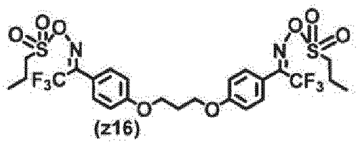
(z16)

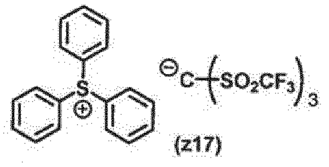
(z17)

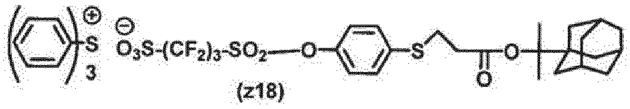
(z18)

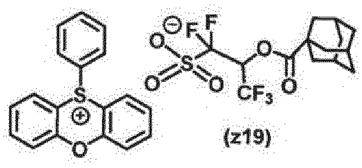
(z19)

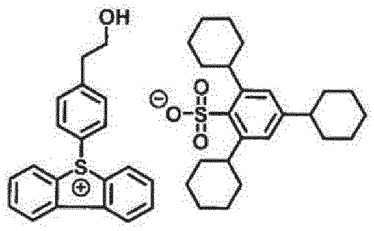
(z20)

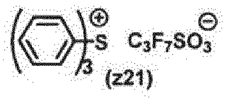
(z21)

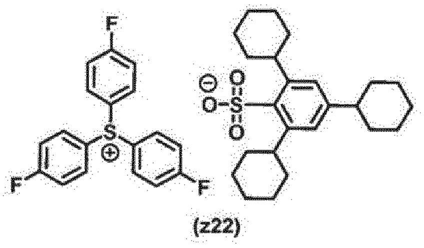
(z22)

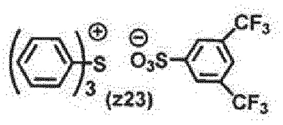
(z23)

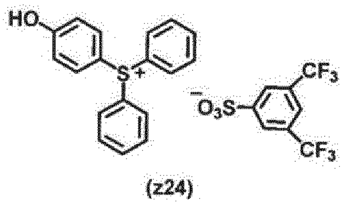
(z24)

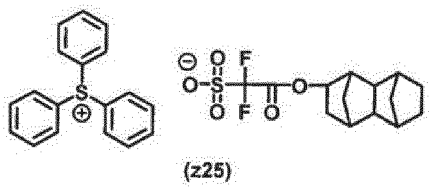
(z25)

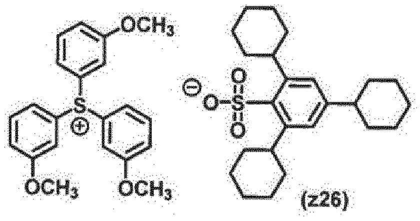
(z26)

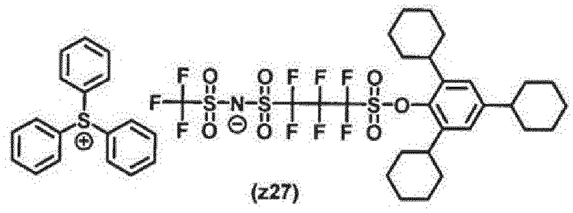
(z27)

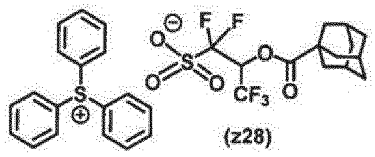

(z28)

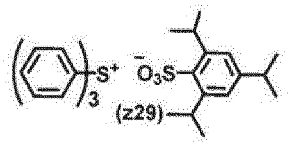

(z29)

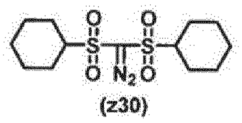

(z30)

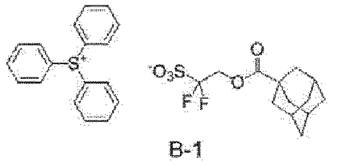

B-1

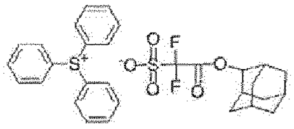

B-2

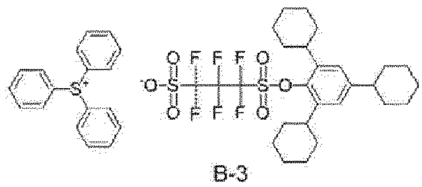

B-3

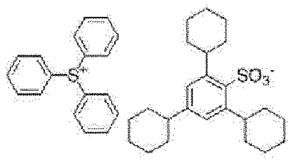

B-4

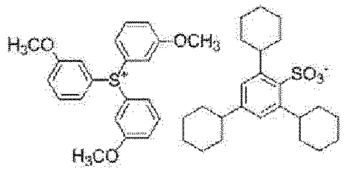

B-5

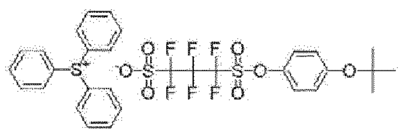

B-6

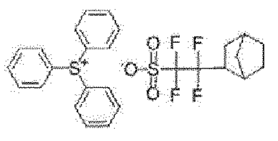

B-7

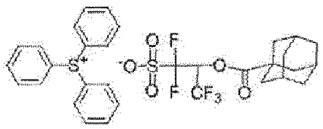

B-8

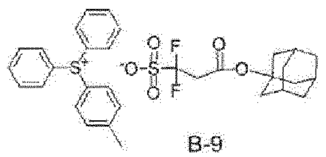

B-9

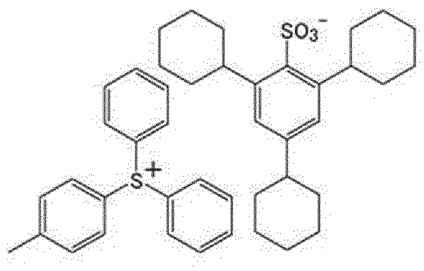

B-10

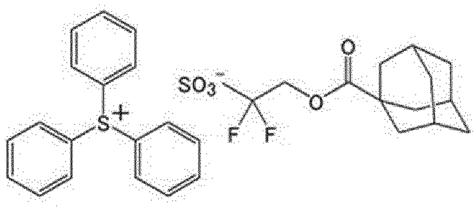

B-11

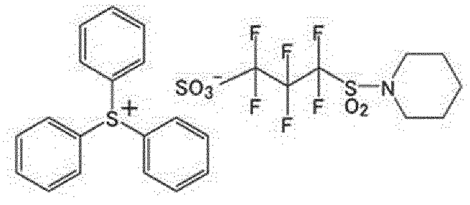

B-12

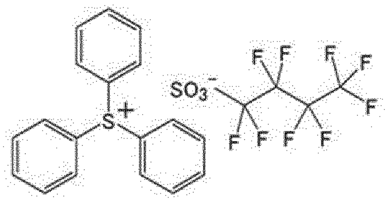

B-13

As the photoacid generator, a compound selected from the group consisting of compounds (I) to (III) described below is preferable.

(Compound (I))

The compound (I) will be described below.

Compound (I): compound having each one of the following structural moiety X and the following structural

moiety Y, in which the compound generates an acid including the following first acidic moiety derived from the following structural moiety X and the following second acidic moiety derived from the following structural moiety Y by irradiation with actinic rays or radiation

Structural moiety X: structural moiety which consists of an anionic moiety $A_1^-$ and a cationic moiety $M_1^+$, and forms a first acidic moiety represented by HAi by irradiation with actinic rays or radiation

Structural moiety Y: structural moiety which consists of an anionic moiety $A_2^-$ and a cationic moiety $M_2^+$, and forms a second acidic moiety represented by $HA_2$, having a structure different from that of the first acidic moiety formed in the structural moiety X, by irradiation with actinic rays or radiation

However, the compound (I) satisfies the following condition I.

Condition I: compound PI formed by substituting the cationic moiety $M_1^+$ in the structural moiety X and the cationic moiety $M_2^+$ in the structural moiety Y with $H^+$ in the compound (I) has an acid dissociation constant a1 derived from an acidic moiety represented by $HA_1$, formed by substituting the cationic moiety $M_1^+$ in the structural moiety X with $H^+$, and an acid dissociation constant a2 derived from an acidic moiety represented by $HA_2$, formed by substituting the cationic moiety $M_2^+$ in the structural moiety Y with $H^+$, and the acid dissociation constant a2 is larger than the acid dissociation constant a1

The acid dissociation constant a1 and the acid dissociation constant a2 are determined by the above-described method. More specifically, with regard to the acid dissociation constant a1 and the acid dissociation constant a2 of the compound PI, in a case where the acid dissociation constant of the compound PI is determined, the pKa with which the compound PI (in which the compound PI corresponds to a "compound having HAi and $HA_2$") serves as a "compound having $A_1^-$ and $HA_2$" is the acid dissociation constant a1, and the pKa with which "compound having $A_1^-$ and $HA_2$" serves as a "compound having $A_1^-$ and $A_2^-$" is the acid dissociation constant a2.

In addition, the above-described compound PI corresponds to an acid generated by irradiating the compound (I) with actinic rays or radiation.

From the viewpoint that the LWR performance of a pattern to be formed is more excellent, the difference between the acid dissociation constant a1 and the acid dissociation constant a2 in the compound PI is preferably 2.0 or more, and more preferably 3.0 or more. The upper limit value of the difference between the acid dissociation constant a1 and the acid dissociation constant a2 is not particularly limited, but is, for example, 15.0 or less.

In addition, from the viewpoint that the stability of the cationic moiety of the compound (I) in the resist composition is more excellent, the acid dissociation constant a2 is, for example, 6.5 or less in the compound PI, and from the viewpoint that the stability of the cationic moiety of the compound (I) in the resist composition is more excellent, the acid dissociation constant a2 is preferably 2.0 or less, and more preferably 1.0 or less. The lower limit value of the acid dissociation constant a2 is, for example, -5.0 or more, preferably -3.5 or more, and preferably -2.0 or more.

In addition, from the viewpoint that the LWR performance of a pattern to be formed is more excellent, the acid dissociation constant a1 is preferably 2.0 or less, more preferably 0.5 or less, and still more preferably -0.1 or less in the compound PI. The lower limit value of the acid dissociation constant a1 is preferably -15.0 or more.

The compound (I) is not particularly limited, and examples thereof include a compound represented by General Formula (Ia).

$$M_{11}^+ \ A_{11}^- \text{-} L_1 \text{-} A_{12}^- \ M_{12}^+ \qquad \text{(Ia)}$$

In General Formula (Ia), "$M_{11}^+ A_{11}^-$" and "$A_{12}^- M_{12}^+$" correspond to the structural moiety X and the structural moiety Y, respectively. The compound (Ia) generates an acid represented by $HA_{11}$-$L_1$-$A_{21}H$ by irradiation with actinic rays or radiation. That is, "$M_{11}^+A_{11}^-$" forms a first acidic moiety represented by $HA_{11}$, and "$A_{12}^-M_{12}^+$" forms a second acidic moiety represented by $HA_{12}$, which has a structure different from that of the first acidic moiety.

In General Formula (Ia), $M_{11}^+$ and $M_{12}^+$ each independently represent an organic cation.

$A_{11}^-$ and $A_{12}^-$ each independently represent an anionic functional group. However, $A_{12}^-$ represents a structure different from that of the anionic functional group represented by $A_{11}^-$.

$L_1$ represents a divalent linking group.

However, in the compound PIa ($HA_{11}$-$L_1$-$A_{12}H$) formed by substituting organic cations represented by $M_{11}^+$ and $M_{12}^+$ with $H^+$ in General Formula (Ia), the acid dissociation constant a2 derived from the acidic moiety represented by $A_{12}H$ is larger than the acid dissociation constant a1 derived from the acidic moiety represented by $HA_{11}$. Suitable values of the acid dissociation constant a1 and the acid dissociation constant a2 are as described above.

The organic cations represented by $M_1^+$ and $M_2^+$ in General Formula (I) are as described later.

Examples of the anionic functional group represented by $A_{11}^-$ and $A_{12}^-$ include groups represented by General Formulae (B-1) to (B-13).

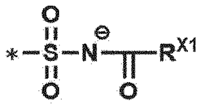 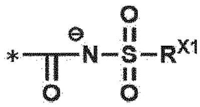 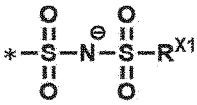 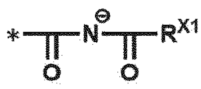

B-1 B-2 B-3 B-4

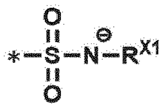 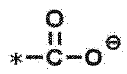 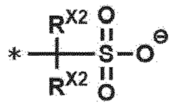 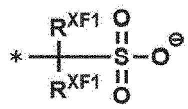

B-5 B-6 B-7 B-8

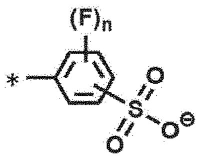 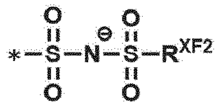 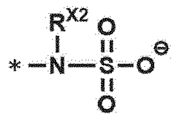

B-9 B-10 B-11

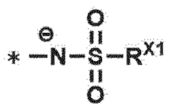 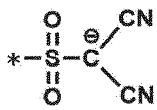

B-12 B-13

In General Formulae (B-1) to (B-13), * represents a bonding position.

It is also preferable that * in General Formula (B-12) is a bonding position to a group that is neither -CO- nor -SOz-.

In General Formulae (B-1) to (B-5) and General Formula (B-12), $R^{x1}$ represents an organic group.

As $R^{X1}$, a linear, branched, or cyclic alkyl group, or an aryl group is preferable.

The number of carbon atoms in the above-described alkyl group is preferably 1 to 15 and more preferably 1 to 10.

The above-described alkyl group may have a substituent. As the substituent, a fluorine atom or a cyano group is preferable. In a case where the alkyl group has a fluorine atom as the substituent, it may be a perfluoroalkyl group.

In addition, the above-described alkyl group may have a carbon atom substituted with a carbonyl group.

The above-described aryl group is preferably a phenyl group or a naphthyl group, and more preferably a phenyl group.

The above-described aryl group may have a substituent. As the substituent, a fluorine atom, a perfluoroalkyl group (for example, preferably having 1 to 10 carbon atoms, and more preferably having 1 to 6 carbon atoms), or a cyano group is preferable.

In General Formula (B-5), an atom directly bonded to $N^-$ in $R^{X1}$ is preferably neither a carbon atom in -CO- nor a sulfur atom in -SOz-.

Tt is preferable that $R^{X1}$ in General Formula (B-3) does not include a fluorine atom.

In General Formulae (B-7) and (B-11), $R^{X2}$ represents a hydrogen atom or a substituent other than a fluorine atom and a perfluoroalkyl group.

As the substituent other than a fluorine atom and a perfluoroalkyl group, represented by $R^{X2}$, an alkyl group (which may be linear, branched, or cyclic) other than the perfluoroalkyl group is preferable.

The number of carbon atoms in the above-described alkyl group is preferably 1 to 15 and more preferably 1 to 10.

The above-described alkyl group may have a substituent other than a fluorine atom.

In General Formula (B-8), $R^{XF1}$ represents a hydrogen atom, a fluorine atom, or a perfluoroalkyl group. However, at least one of a plurality of $R^{XF1}$'s represents a fluorine atom or a perfluoroalkyl group.

The number of carbon atoms in the perfluoroalkyl group represented by $R^{XF1}$ is preferably 1 to 15, more preferably 1 to 10, and still more preferably 1 to 6.

In General Formula (B-10), $R^{XF2}$ represents a fluorine atom or a perfluoroalkyl group.

The number of carbon atoms in the perfluoroalkyl group represented by $R^{XF2}$ is preferably 1 to 15, more preferably 1 to 10, and still more preferably 1 to 6.

In General Formula (B-9), n represents an integer of 0 to 4.

A combination of the anionic functional groups represented by $A_{11}^-$ and $A_{12}^-$ is not particularly limited, but for example, in a case where $A_{11}^-$ is a group represented by General Formula (B-8) or (B-10), examples of the anionic functional group represented by $A_{12}^-$ include a group represented by General Formula (B-1) to (B-7), (B-9), or (B-11) to (B-13); and in a case where $A_{11}^-$ is a group represented by General Formula (B-7), examples of the anionic functional group represented by $A_{12}^-$ includes a group represented by General Formula (B-6).

In General Formula (I), the divalent liking group represented by $L_1$ is not particularly limited, and examples thereof include -CO-, -NR-, -CO-, -O-, an alkylene group (preferably having 1 to 6 carbon atoms; may be linear or branched), a cycloalkylene group (preferably having 3 to 15 carbon atoms), an alkenylene group (preferably having 2 to 6 carbon atoms), a divalent aliphatic heterocyclic group (preferably a 5- to 10-membered ring, more preferably a 5- to 7-membered ring, and still more preferably a 5- or 6-membered ring; each having at least one of an N atom, an O atom, an S atom, or an Se atom in the ring structure), and a divalent aromatic heterocyclic group (preferably a 5- to 10-membered ring, more preferably a 5- to 7-membered ring, and still more preferably a 5- or 6-membered ring; each having at least one of an N atom, an O atom, an S atom, or an Se atom in the ring structure), a divalent aromatic hydrocarbon ring group (preferably a 6- to 10-membered ring, and more preferably a 6-membered ring), and a divalent linking group formed by a combination of a plurality of these groups. Examples of R include a hydrogen atom or a monovalent organic group. The monovalent organic group is not particularly limited, but is preferably, for example, an alkyl group (preferably having 1 to 6 carbon atoms).

These divalent linking groups may include a group selected from the group consisting of -S-, -SO-, and -SOz-.

In addition, the above-described alkylene group, the above-described cycloalkylene group, the above-described alkenylene group, and the above-described divalent aliphatic heterocyclic group may be substituted with a substituent. Examples of the substituent include a halogen atom (preferably, a fluorine atom).

In General Formula (I), preferred forms of the organic cations represented by $M_{11}^+$ and $M_{12}^+$ will be described in detail.

The organic cations represented by $M_1^+$ and $M_2^+$ each independently preferably an organic cation represented by General Formula (ZaI) (cation (ZaI)) or an organic cation represented by General Formula (ZaII) (cation (ZaII)).

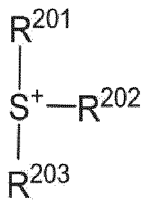

(ZaI)

$R^{204}$-$I^+$-$R^{205}$ (ZaII)

In General Formula (ZaI),

$R^{201}$, $R^{202}$, and $R^{203}$ each independently represent an organic group.

The number of carbon atoms in the organic group of $R^{201}$, $R^{202}$, and $R^{203}$ is usually 1 to 30, and preferably 1 to 20. In addition, two of $R^{201}$ to $R^{201}$ may be bonded to each other to form a ring structure, and the ring structure may include an oxygen atom, a sulfur atom, an ester group, an amide group, or a carbonyl group in the ring. Examples of the group formed by the bonding of two of $R^{201}$ to $R^{203}$ include an alkylene group (for example, a butylene group and a pentylene group) and -CHz-CHz-O-CHz-CHz-.

Examples of suitable aspects of the organic cation in General Formula (ZaI) include a cation (ZaI-1), a cation (ZaI-2), an organic cation (cation (ZaI-3b)) represented by General Formula (ZaI-3b), and an organic cation (cation (ZaI-4b)) represented by General Formula (ZaI-4b), each of which will be described later.

First, the cation (ZaI-1) will be described.

The cation (ZaI-1) is an arylsulfonium cation in which at least one of $R^{201}$, $R^{202}$, or $R^{203}$ of General Formula (ZaI) is an aryl group.

In the arylsulfonium cation, all of $R^{201}$ to $R^{203}$ may be aryl groups, or some of $R^{201}$ to $R^{203}$ may be an aryl group and the rest may be an alkyl group or a cycloalkyl group.

In addition, one of $R^{201}$ to $R^{203}$ may be an aryl group, the remaining two of $R^{201}$ to $R^{203}$ may be bonded to each other to form a ring structure, and an oxygen atom, a sulfur atom, an ester group, an amide group, or a carbonyl group may be included in the ring. Examples of the group formed by the bonding of two of $R^{201}$ to $R^{203}$ include an alkylene group (for example, a butylene group, a pentylene group, or -CHz-CHz-O-CHz-CHz-) in which one or more methylene groups may be substituted with an oxygen atom, a sulfur atom, an ester group, an amide group, and/or a carbonyl group.

Examples of the arylsulfonium cation include a triarylsulfonium cation, a diarylalkylsulfonium cation, an aryldialkylsulfonium cation, a diarylcycloalkylsulfonium cation, and an aryldicycloalkylsulfonium cation.

The aryl group included in the arylsulfonium cation is preferably a phenyl group or a naphthyl group, and more preferably a phenyl group. The aryl group may be an aryl group which has a heterocyclic structure having an oxygen atom, a nitrogen atom, a sulfur atom, or the like. Examples of the heterocyclic structure include a pyrrole residue, a furan residue, a thiophene residue, an indole residue, a benzofuran residue, and a benzothiophene residue. In a case where the arylsulfonium cation has two or more aryl groups, the two or more aryl groups may be the same or different from each other.

The alkyl group or the cycloalkyl group included in the arylsulfonium cation as necessary is preferably a linear alkyl group having 1 to 15 carbon atoms, a branched alkyl group having 3 to 15 carbon atoms, or a cycloalkyl group having 3 to 15 carbon atoms, and examples thereof include a methyl group, an ethyl group, a propyl group, an n-butyl group, a sec-butyl group, a t-butyl group, a cyclopropyl group, a cyclobutyl group, and a cyclohexyl group.

Examples of substituents which may be included in the aryl group, the alkyl group, and the cycloalkyl group of $R^{201}$ to $R^{203}$ each independently include an alkyl group (for example, having 1 to 15 carbon atoms), a cycloalkyl group (for example, having 3 to 15 carbon atoms), an aryl group (for example, having 6 to 14 carbon atoms), an alkoxy group (for example, having 1 to 15 carbon atoms), a cycloalkylalkoxy group (for example, having 1 to 15 carbon atoms), a halogen atom, a hydroxyl group, and a phenylthio group.

The substituent may further have a substituent if possible, and may be in a form of an alkyl halide group such as a trifluoromethyl group, for example, in which an alkyl group has a halogen atom as a substituent.

Next, the cation (ZaI-2) will be described.

The cation (ZaI-2) is a cation in which $R^{201}$ to $R^{203}$ in General Formula (ZaI) are each independently a cation representing an organic group having no aromatic ring. Here, the aromatic ring also encompasses an aromatic ring including a heteroatom.

The number of carbon atoms in the organic group as $R^{201}$ to $R^{203}$, which has no aromatic ring, is generally 1 to 30, and preferably 1 to 20.

$R^{201}$ to $R^{203}$ are each independently preferably an alkyl group, a cycloalkyl group, an allyl group, or a vinyl group, more preferably a linear or branched 2-oxoalkyl group, a 2-oxocycloalkyl group, or an alkoxycarbonylmethyl group, and still more preferably a linear or branched 2-oxoalkyl group.

Examples of the alkyl group and cycloalkyl group of $R^{201}$ to $R^{203}$ include a linear alkyl group having 1 to 10 carbon atoms or a branched alkyl group having 3 to 10 carbon atoms (for example, a methyl group, an ethyl group, a propyl group, a butyl group, and a pentyl group), and a cycloalkyl group having 3 to 10 carbon atoms (for example, a cyclopentyl group, a cyclohexyl group, and a norbornyl group).

$R^{201}$ to $R^{203}$ may further be substituted with a halogen atom, an alkoxy group (for example, having 1 to 5 carbon atoms), a hydroxyl group, a cyano group, or a nitro group.

Next, the cation (ZaI-3b) will be described.

The cation (Zal-3b) is a cation represented by General Formula (Zal-3b).

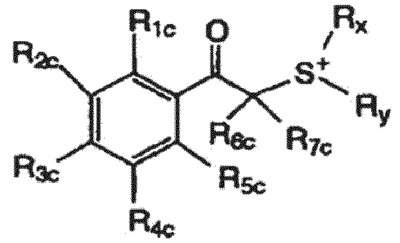

(ZaI-3b)

In General Formula (ZaI-3b),

$R_{1c}$ to $R_{5c}$ each independently represent a hydrogen atom, an alkyl group, a cycloalkyl group, an aryl group, an alkoxy group, an aryloxy group, an alkoxycarbonyl group, an alkylcarbonyloxy group, a cycloalkylcarbonyloxy group, a halogen atom, a hydroxyl group, a nitro group, an alkylthio group, or an arylthio group.

$R_{6c}$ and $R_{7c}$ each independently represent a hydrogen atom, an alkyl group (a t-butyl group and the like), a cycloalkyl group, a halogen atom, a cyano group, or an aryl group.

$R_x$ and $R_y$ each independently represent an alkyl group, a cycloalkyl group, a 2-oxoalkyl group, a 2-oxocycloalkyl group, an alkoxycarbonylalkyl group, an allyl group, or a vinyl group.

Any two or more of $R_{1c}$, ..., or $R_{5c}$, $R_{5c}$ and $R_{6c}$, $R_{6c}$ and $R_{7c}$, $R_{5c}$ and $R_x$, and $R_x$ and $R_y$ may each be bonded to each other to form a ring, and the rings may each independently include an oxygen atom, a sulfur atom, a ketone group, an ester bond, or an amide bond.

Examples of the above-described ring include an aromatic or non-aromatic hydrocarbon ring, an aromatic or non-aromatic heterocyclic ring, and a polycyclic fused ring formed by a combination of two or more of these rings.

Examples of the ring include a 3- to 10-membered ring, and the ring is preferably a 4- to 8-membered ring and more preferably a 5- or 6-membered ring.

Examples of the group formed by the bonding of any two or more of $R_{1c}$, ..., or $R_{5c}$, $R_{6c}$ and $R_{7c}$, and $R_x$ and $R_y$ include an alkylene group such as a butylene group and a pentylene group. A methylene group in this alkylene group may be substituted with a heteroatom such as an oxygen atom.

As the group formed by the bonding of $R_{5c}$ and $R_{6c}$, and $R_{5c}$ and $R_x$, a single bond or an alkylene group is preferable. Examples of the alkylene group include a methylene group and an ethylene group.

Next, the cation (ZaI-4b) will be described.

The cation (ZaI-4b) is a cation represented by General Formula (ZaI-4b).

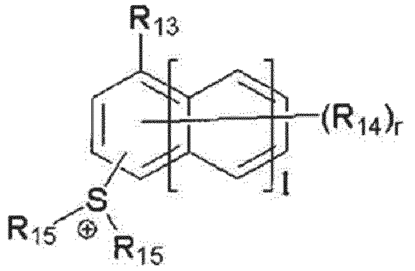

(ZaI-4b)

In General Formula (ZaI-4b),

1 represents an integer of 0 to 2.

r represents an integer of 0 to 8.

$R_{13}$ represents a hydrogen atom, a fluorine atom, a hydroxyl group, an alkyl group, an alkoxy group, an alkoxycarbonyl group, or a group having a cycloalkyl group (which may be the cycloalkyl group itself or a group including the cycloalkyl group in a part thereof). These groups may have a substituent.

$R_{14}$ represents a hydroxyl group, an alkyl group, an alkoxy group, an alkoxycarbonyl group, an alkylcarbonyl group, an alkylsulfonyl group, a cycloalkylsulfonyl group, or a group having a cycloalkyl group (which may be the cycloalkyl group itself or a group including the cycloalkyl group in a part thereof). These groups may have a substituent. In a case where $R_{14}$'s are present in a plural number, $R_{14}$'s each independently represent the above-described group such as a hydroxyl group.

$R_{15}$'s each independently represent an alkyl group, a cycloalkyl group, or a naphthyl group. These groups may have a substituent. Two $R_{15}$'s may be bonded to each other to form a ring. In a case where two Ris's are bonded to each other to form a ring, the ring skeleton may include a heteroatom such as an oxygen atom and a nitrogen atom. In one aspect, it is preferable that two $R_{15}$'s are alkylene groups and are bonded to each other to form a ring structure.

In General Formula (ZaI-4b), the alkyl group of $R_{13}$, $R_{14}$, and Ris is linear or branched. The number of carbon atoms in the alkyl group is preferably 1 to 10. The alkyl group is more preferably a methyl group, an ethyl group, an n-butyl group, a t-butyl group, or the like.

Next, General Formula (ZaII) will be described.

In General Formula (ZaII), $R^{204}$ and $R^{205}$ each independently represent an aryl group, an alkyl group, or a cycloalkyl group.

The aryl group of $R^{204}$ and $R^{205}$ is preferably a phenyl group or a naphthyl group, and more preferably a phenyl group. The aryl group of $R^{204}$ and $R^{205}$ may be an aryl group which has a heterocyclic ring having an oxygen atom, a nitrogen atom, a sulfur atom, or the like. Examples of a skeleton of the aryl group having a heterocyclic ring include pyrrole, furan, thiophene, indole, benzofuran, and benzothiophene.

The alkyl group and cycloalkyl group of $R^{204}$ and $R^{205}$ are preferably a linear alkyl group having 1 to 10 carbon atoms or a branched alkyl group having 3 to 10 carbon atoms (for example, a methyl group, an ethyl group, a propyl group, a butyl group, and a pentyl group), or a cycloalkyl group having 3 to 10 carbon atoms (for example, a cyclopentyl group, a cyclohexyl group, and a norbornyl group).

The aryl group, the alkyl group, and the cycloalkyl group of $R^{204}$ and $R^{205}$ may each independently have a substituent. Examples of the substituent which may be included in each of the aryl group, the alkyl group, and the cycloalkyl group of $R^{204}$ and $R^{205}$ include an alkyl group (for example, having 1 to 15 carbon atoms), a cycloalkyl group (for example, having 3 to 15 carbon atoms), an aryl group (for example, having 6 to 15 carbon atoms), an alkoxy group (for example, having 1 to 15 carbon atoms), a halogen atom, a hydroxyl group, and a phenylthio group.

(Compound (II))

Next, the compound (II) will be described.

Compound (II): compound having two or more of the structural moieties X and the structural moiety Y, in which the compound generates an acid including two or more of the first acidic moieties derived from the structural moiety X and the second acidic moiety derived from the structural moiety Y by irradiation with actinic rays or radiation

However, the compound (II) satisfies the following condition II.

Condition II: compound PII formed by substituting the cationic moiety $M_1^+$ in the structural moiety X and the cationic moiety $M_2^+$ in the structural moiety Y with $H^+$ in the compound (II) has an acid dissociation constant a1 derived from an acidic moiety represented by HAi, formed by substituting the cationic moiety $M_1^+$ in the structural moiety X with $H^+$ and an acid dissociation constant a2 derived from an acidic moiety represented by $HA_2$, formed by substituting the cationic moiety $M_2^+$ in the structural moiety Y with $H^+$, and the acid dissociation constant a2 is larger than the acid dissociation constant a1

The acid dissociation constant a1 and the acid dissociation constant a2 are determined by the above-described method.

Here, the acid dissociation constant a1 and the acid dissociation constant a2 of the compound PII will be more specifically described. In a case where the compound (II) is, for example, a compound that generates an acid having two of the first acidic moieties derived from the structural moiety X and one of the second acidic moieties derived from the structural moiety Y, the compound PII corresponds to a "compound having two HAi's and $HA_2$". In a case where the acid dissociation constant of the compound PII was determined, the pKa in a case where the compound PII serves as a "compound having one $A_1^-$, one $HA_1$, and $HA_2$" is the acid dissociation constant a1, and the pKa in a case where the compound having two A1-'s and $HA_2$ serves as a "compound having two $A_1^-$'s and $A_2^-$" is the acid dissociation constant a2. That is, in a case where the compound PII has a plurality of acid dissociation constants derived from the acidic moiety represented by HAi, formed by substituting the cationic moiety $M_1^+$ in the structural moiety X with $H^+$, the smallest value is considered as the acid dissociation constant a1.

In addition, the above-described compound PII corresponds to an acid generated by irradiating the compound (II) with actinic rays or radiation.

The compound (II) may have a plurality of the above-described structural moieties Y.

From the viewpoint that the LWR performance of a pattern to be formed is more excellent, the difference between the acid dissociation constant a1 and the acid dissociation constant a2 in the compound PII is preferably 2.0 or more, and more preferably 3.0 or more. The upper limit value of the difference between the acid dissociation constant a1 and the acid dissociation constant a2 is not particularly limited, but is, for example, 15.0 or less.

In addition, the acid dissociation constant a2 is, for example, 6.5 or less in the compound PII, and from the viewpoint that the stability of the cationic moiety of the compound (II) in the resist composition is more excellent, the acid dissociation constant a2 is preferably 2.0 or less, and more preferably 1.0 or less. The lower limit value of the acid dissociation constant a2 is preferably -2.0 or more.

In addition, from the viewpoint that the LWR performance of a pattern to be formed is more excellent, the acid dissociation constant a1 is preferably 2.0 or less, more preferably 0.5 or less, and still more preferably -0.1 or less in the compound PII. The lower limit value of the acid dissociation constant a1 is preferably -15.0 or more.

The compound (II) is not particularly limited, and examples thereof include a compound represented by General Formula (IIa).

$$\left( M_{21}^{\oplus} A_{21}^{\ominus} \right)_{n1} L_2 \left( A_{22}^{\ominus} M_{22}^{\oplus} \right)_{n2} \quad \text{(IIa)}$$

In General Formula (IIa), "$M_{21}^+A_{21}^-$" and "$A_{22}^-M_{22}^+$" correspond to the structural moiety X and the structural moiety Y, respectively. The compound (IIa) generates an acid represented by General Formula (IIa-1) by irradiation with actinic rays or radiation. That is, "$M_{21}^+A_{21}^-$" forms a first acidic moiety represented by $HA_{21}$, and "$A_{22}^-M_{22}^+$" forms a second acidic moiety represented by $HA_{22}$ having a structure different from that of the first acidic moiety.

$$\left( HA_{21} \right)_{n1} L_2 \left( A_{22}H \right)_{n2} \quad \text{(IIa-1)}$$

In General Formula (IIa), $M_{21}^+$ and $M_{22}^+$ each independently represent an organic cation.

$A_{21}^-$ and $A_{22}^-$ each independently represent an anionic functional group. However, $A_{22}^-$ represents a structure different from the anionic functional group represented by $A_{21}^-$.

$L_2$ represents an (n1+n2)-valent organic group.

n1 represents an integer of 2 or more.

n2 represents an integer of 1 or more.

However, in the compound PIIa (corresponding to a compound represented by General Formula (IIA-1)), formed by substituting organic cations represented by $M_{21}^+$ and $M_{22}^+$ with $H^+$ in General Formula (IIa), the acid dissociation constant a2 derived from the acidic moiety represented by $A_{22}H$ is larger than the acid dissociation constant a1 derived from the acidic moiety represented by $HA_{21}$. Suitable values of the acid dissociation constant a1 and the acid dissociation constant a2 are as described above.

In General Formula (IIa), $M_{21}^+$, $M_{22}^+$, $A_{21}^-$, and $A_{22}^-$ have the same definitions as $M_{11}^+$, $M_{12}^+$, $A_{11}^-$, and $A_{12}^-$ in General Formula (Ia), respectively, and suitable aspects thereof are also the same.

In General Formula (IIa), n1 pieces of $M_{21}^+$ and n1 pieces of $A_{21}^+$ represent the same group as each other.

In General Formula (IIa), the (n1 + n2)-valent organic group represented by $L_2$ is not particularly limited, and examples thereof include groups represented by (A1) and (A2) below. In (A1) and (A2) below, at least two of *'s represent bonding positions to $A_{21}^-$, and at least one of *'s represents a bonding position to $A_{22}^-$.

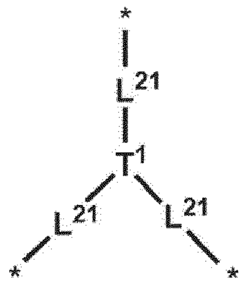

(A1)

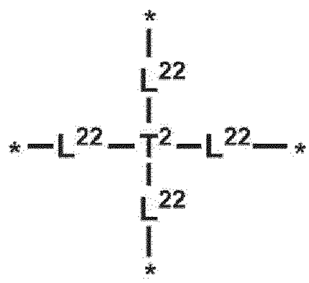

(A2)

In (A1) and (A2) above, $T^1$ represents a trivalent hydrocarbon ring group or a trivalent heterocyclic group, and $T^2$ represents a carbon atom, a tetravalent hydrocarbon ring group, or a tetravalent heterocyclic group.

The hydrocarbon ring group may be an aromatic hydrocarbon ring group or an aliphatic hydrocarbon ring group. The number of carbon atoms included in the hydrocarbon ring group is preferably 6 to 18, and more preferably 6 to 14.

The heterocyclic group may be an aromatic heterocyclic group or an aliphatic heterocyclic group. The heterocycle is preferably a 5- to 10-membered ring, more preferably a 5- to 7-membered ring, and still more preferably a 5- or 6-membered ring, each of which has at least one N atom, O atom, S atom, or Se atom in the ring structure.

In addition, in (A1) and (A2), $L^{21}$ and $L^{22}$ each independently represent a single bond or a divalent linking group.

The divalent linking group represented by each of $L^{21}$ and $L^{22}$ has the same definition as the divalent linking group represented by $L_1$ in General Formula (Ia), and a suitable aspect thereof is also the same.

n1 represents an integer of 2 or more. The upper limit thereof is not particularly limited, but is 6 or less, preferably 4 or less and more preferably 3 or less.

n2 represents an integer of 1 or more. The upper limit thereof is not particularly limited, but is, for example, 3 or less, preferably 2 or less.

In addition, examples of the compound (II) include a compound represented by General Formula (IIax).

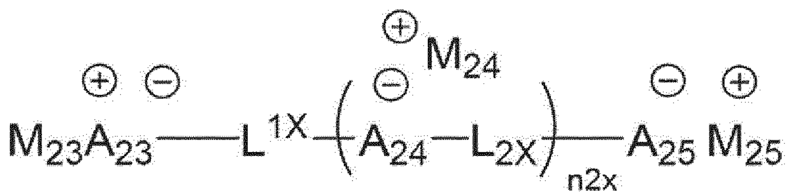

(IIax)

In General Formula (IIax), any two of "$M_{23}^+A_{23}^-$", "$A_{24}^-M_{24}^+$", or "$A_{25}^-M_{25}^+$" correspond to the structural moiety

X, and the other one corresponds to the structural moiety Y. The compound (IIax) generates an acid represented by General Formula (IIax-1) by irradiation with actinic rays or radiation. That is, "$M_{23}^+A_{23}^-$" forms a first acidic moiety represented by $HA_{23}$, "$A_{24}^-M_{24}^+$" forms a second acidic moiety represented by $HA_{24}$ having a structure different from that of the first acidic moiety, and "$A_{25}^-M_{25}^+$" forms a second acidic moiety represented by $HA_{25}$ having a structure different from that of the first acidic moiety.

$$HA_{23}-L_{1X}-\left(A_{24}H-L_{2X}\right)_{n2x}-A_{25}H \quad \text{(IIax-1)}$$

In General Formula (IIax), $M_{23}^+$, $M_{24}^+$, and $M_{25}^+$ each independently represent an organic cation.

$A_{23}^-$ and $A_{25}^-$ each represent a monovalent anionic functional group.

$A_{24}^-$ represents a divalent anionic functional group.

$L_{1x}$ and $L_{2x}$ each represent a divalent organic group.

n2x represents an integer of 1 or more.

However, in the compound PIIax (corresponding to the compound represented by General Formula (IIax-1)) in which the organic cation represented by each of $M_{23}^+$, $M_{24}^+$, and $M_{25}^+$ is substituted with $H^+$ in General Formula (IIax), the smallest acid dissociation constant and the largest acid dissociation constant out of the acid dissociation constant $a1^{ax}$ derived from the acidic moiety represented by $HA_{23}$, the acid dissociation constant $a2^{ax}$ derived from the acidic moiety represented by $A_{24}H$, and the acid dissociation constant $a3^{ax}$ derived from the acidic moiety represented by $A_{25}H$ correspond to the acid dissociation constant a1 and the acid dissociation constant a2, respectively. Suitable values of the acid dissociation constant a1 and the acid dissociation constant a2 are as described above. The acid dissociation constant derived from an acidic moiety that corresponds to neither the acid dissociation constant a1 nor the acid dissociation constant a2 is preferably within the acid dissociation constant a1 + 1.0, more preferably within the acid dissociation constant a1 + 0.7, and still more preferably within the acid dissociation constant a1 + 0.3.

In General Formula (IIa), $M_{23}^+$, $M_{24}^+$, $M_{25}^+$, $A_{23}^-$, and $A_{25}^-$ have the same definitions as $M_{11}^+$, $M_{12}^+$, $A_{11}^-$, and $A_{12}^-$ in General Formula (Ia) described above, respectively, and suitable aspects thereof are also the same.

In a case where $A_{23}^-$ or $A_{25}^-$ represents an acidic moiety corresponding to the acid dissociation constant a1 in a case where the organic cation is substituted with $H^+$, a group represented by either of General Formulae (B-8) and (B-10) is preferable as $A_{23}^-$ or $A_{25}^-$.

The divalent anionic functional group represented by $A_{24}^-$ is not particularly limited, but examples thereof include a linking group including $-N^-$-, and $*-SO_2-N^--CO-*$, $*-SO_2-N^--SO_2-$, $*-CO-N^--CO-*$, $*-SO_2-N^--*$, and the like are preferable. * represents a bonding position.

n2x is preferably 1 to 3, more preferably 1 or 2, and still more preferably 1.

In the compound represented by General Formula (IIax-1), it is preferable that the acid dissociation constant $a2^{ax}$ derived from the acidic moiety represented by $A_{24}H$ corresponds to the acid dissociation constant a2.

In General Formula (IIax), $M_{23}^+$ and $M_{25}^+$ each preferably represent the same group, and $A_{23}^-$ and $A_{25}^-$ each preferably represent the same group.

In General Formula (IIax), $M_{24}^+$'s and $A_{24}^+$'s may be the same as or different from each other.

The divalent organic group represented by each of $L_{1x}$ and $L_{2x}$ is not particularly limited, and examples thereof include -CO-, -NR-, -CO-, -O-, -S-, -SO-, -SOz-, an alkylene group (which preferably has 1 to 6 carbon atoms, and may be linear or branched), a cycloalkylene group (preferably having 3 to 15 carbon atoms), an alkenylene group (preferably having 2 to 6 carbon atoms), a divalent aliphatic heterocyclic group (preferably a 5- to 10-membered ring, more preferably a 5- to 7-membered ring, and still more preferably a 5- or 6-membered ring, each having at least one of an N atom, an O atom, an S atom, or an Se atom in the ring structure), and a divalent aromatic heterocyclic group (preferably a 5- to 10-membered ring, more preferably a 5- to 7-membered ring, and still more preferably a 5- or 6-membered ring, each having at least one of an N atom, an O atom, an S atom, or an Se atom in the ring structure), a divalent aromatic hydrocarbon ring group (preferably a 6- to 10-membered ring, and more preferably a 6-membered ring), and a divalent organic group formed by combination of a plurality of these groups. Examples of R include a hydrogen atom or a monovalent organic group. The monovalent organic group is not particularly limited, but is preferably, for example, an alkyl group (preferably having 1 to 6 carbon atoms).

In addition, the above-described alkylene group, the above-described cycloalkylene group, the above-described alkenylene group, and the above-described divalent aliphatic heterocyclic group may be substituted with a substituent. Examples of the substituent include a halogen atom (preferably, a fluorine atom).

In $L_{1x}$, the bonding position with $A_{23}^-$ and $A_{24}^-$ is preferably a carbon atom (excluding carbonyl carbon). In addition, in $L_{2x}$, the bonding position with $A_{24}^-$ and $A_{25}^-$ is preferably a carbon atom (excluding carbonyl carbon).

(Compound (III))

Next, the compound (III) will be described.

Compound (III): compound having two or more of the structural moieties X and the following structural moiety Z, in which the compound generates an acid including two or more of the first acidic moieties derived from the structural moiety X and the structural moiety Z by irradiation with actinic rays or radiation

Structural moiety Z: nonionic moiety capable of neutralizing an acid

The nonionic moiety capable of neutralizing an acid in the structural moiety Z is not particularly limited, and is preferably, for example, an organic moiety including a functional group having a group or an electron which is capable of electrostatically interacting with a proton.

Examples of the functional group having a group or electron capable of electrostatically interacting with a proton include a functional group with a macrocyclic structure, such as a cyclic polyether, or a functional group having a nitrogen atom having an unshared electron pair not contributing to $\pi$-conjugation. For example, the nitrogen atom having the unshared electron pair, which does not contribute to the $\pi$-conjugation, is a nitrogen atom having a partial structure represented by the following general formula.

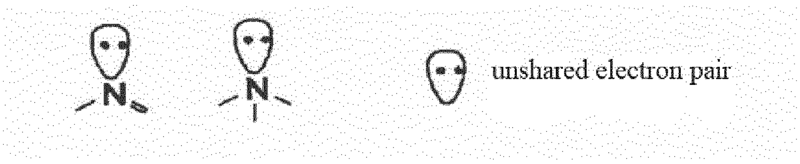


Examples of the partial structure of the functional group having a group or electron which is capable of electrostatically interacting with a proton include a crown ether structure, an azacrown ether structure, primary to tertiary amine structures, a pyridine structure, an imidazole structure, and a pyrazine structure, and among these, the primary to tertiary amine structures are preferable.

In the compound PIII formed by substituting the cationic moiety $M_1^+$ in the structural moiety X with $H^+$ in the compound (III), the acid dissociation constant a1 derived from the acidic moiety represented by HAi, formed by substituting the cationic moiety $M_1^+$ in the structural moiety X with $H^+$, is preferably 2.0 or less, more preferably 0.5 or less, still more preferably -0.1 or less, from the viewpoint that the LWR performance of a pattern to be formed is more excellent. The lower limit value of the acid dissociation constant a1 is preferably -15.0 or more.

In a case where the compound PIII has a plurality of acid dissociation constants derived from the acidic moiety represented by HAi, formed by substituting the cationic moiety $M_1^+$ in the structural moiety X with $H^+$, the smallest value is considered as the acid dissociation constant a1.

That is, in a case where the compound (III) is, for example, a compound that generates an acid having two of the first acidic moieties derived from the structural moiety X and the structural moiety Z, the compound PIII corresponds to a "compound having two of HAi". In a case where the acid dissociation constant of this compound PIII is determined, the pKa in a case where the compound PIII serves as a "compound having one of $A_1^-$ and one of HAi" is the acid dissociation constant a1. That is, in a case where the compound PIII has a plurality of acid dissociation constants derived from the acidic moiety represented by HAi, formed by substituting the cationic moiety $M_1^+$ in the structural moiety X with $H^+$, the smallest value is considered as the acid dissociation constant a1.

For example, in a case where the compound (III) is a compound represented by the compound (IIIa) which will be described later, the compound PIII obtained by substituting the cationic moiety $M_1^+$ in the structural moiety X with $H^+$ in the compound (III) corresponds to $HA_{31}$-$L_3$-$N(R^{2X})$-$L_4$-$A_{31}H$.

The compound (III) is not particularly limited, and examples thereof include a compound represented by General Formula (IIIa).

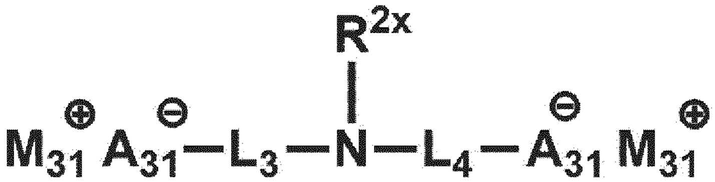

(IIIa)

In General Formula (IIIa), "$M_{31}^+A_{31}^-$" corresponds to the structural moiety X. The compound (IIIa) generates an acid represented by $HA_{31}$-$L_3$-$N(R^{2X})$-$L_4$-$A_{31}H$ by irradiation with actinic rays or radiation. That is, "$M_{31}^+A_{31}^-$" forms the first acidic moiety represented by $HA_{31}$.

In General Formula (IIIa), $M_{31}^+$ represents an organic cation.

$A_{31}^-$ represents an anionic functional group.

$L_3$ and $L_4$ each independently represent a divalent linking group.

$R^{2X}$ represents a monovalent organic group.

In General Formula (IIIa), $M_{31}^+$ and $A_{31}^-$ have the same definitions as $M_{11}^+$ and $A_{11}^-$ in General Formula (Ia), respectively, and suitable aspects thereof are also the same.

In General Formula (IIIa), $L_3$ and $L_4$ have the same definition as $L_1$ in General Formula (Ia), and suitable aspects thereof are also the same.

In General Formula (IIIa), two $M_{31}^+$'s and two $A_{31}^-$'s represent the same group as each other.

In General Formula (IIIa), the monovalent organic group represented by $R^{2X}$ is not particularly limited, and examples thereof include an alkyl group (which preferably has 1 to 10 carbon atoms, and may be linear or branched), a cycloalkyl group (preferably having 3 to 15 carbon atoms), and an alkenyl group (preferably having 2 to 6 carbon atoms), in which $-CH_2-$may be substituted with one or a combination of two or more selected from the group consisting of -CO-, -NH-, -O-, -S-, -SO-, and -SOz-.

In addition, the above-described alkylene group, the above-described cycloalkylene group, and the above-described alkenylene group may be substituted with a substituent.

A molecular weight of the compound represented by each of the compounds (I) to (III) is preferably 300 to 3000, more preferably 500 to 2000, and still more preferably 700 to 1500.

A content of the compound represented by each of the compounds (I) to (III) is preferably 0.1% to 40.0% by mass, more preferably 1.0% to 35.0% by mass, still more preferably 5.0% to 35.0% by mass, and particularly preferably 5.0% to 30.0% by mass with respect to the total solid content of the composition.

The compound represented by each of the compounds (I) to (III) may be used singly or in combination of two or more kinds thereof. In a case where two or more kinds of the compounds are used, a total content thereof is preferably within the suitable content range.

Preferred examples of the compounds represented by the compounds (I) to (III) are shown below.

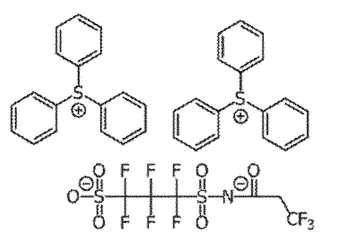

B-1

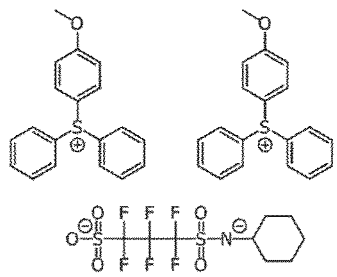

B-2

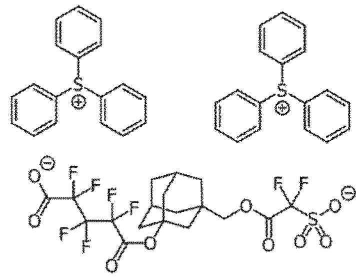

B-3

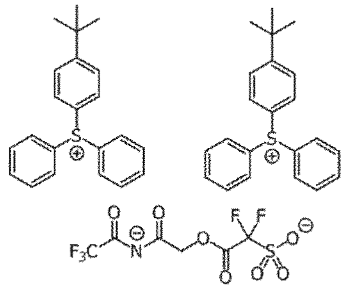

B-4

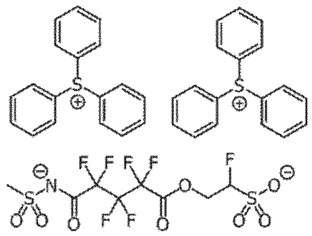

B-5

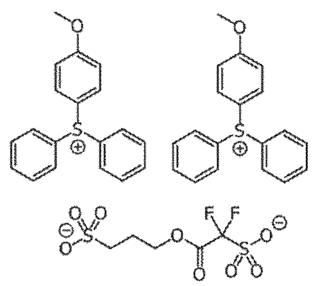

B-6

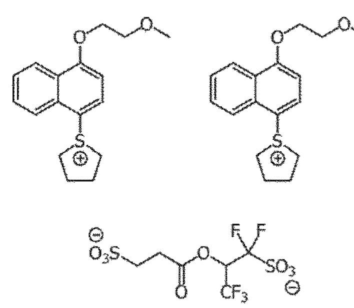

**B-7**

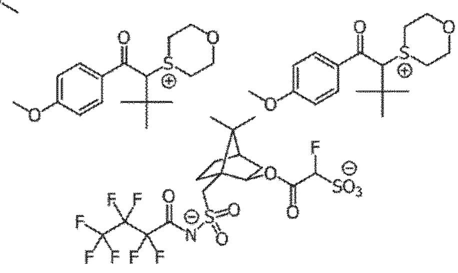

**B-8**

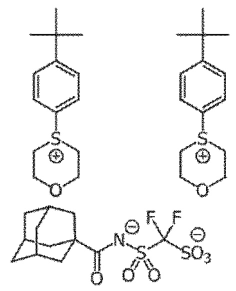

**B-9**

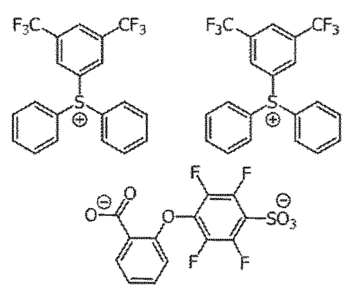

**B-10**

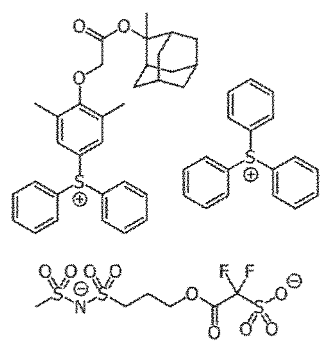

**B-11**

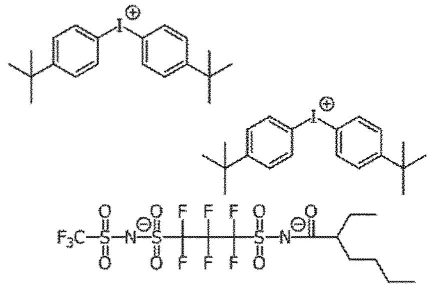

**B-12**

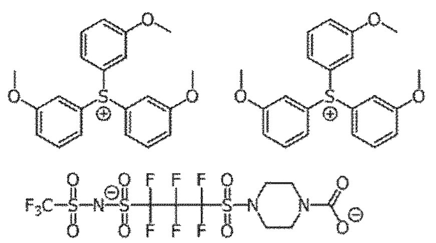

**B-13**

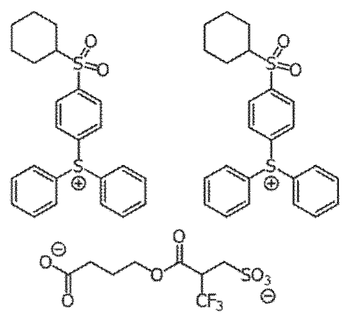

**B-14**

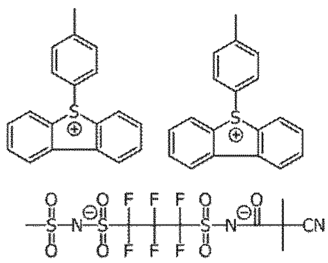

**B-15**

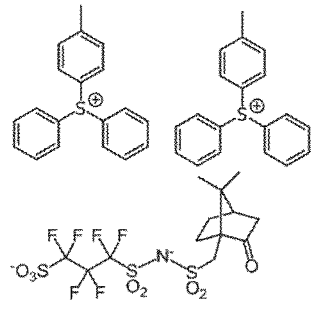

**B-16**

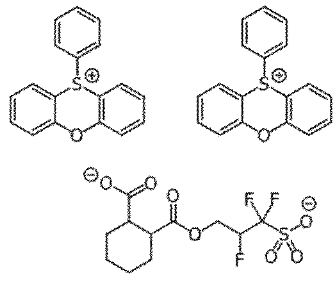

**B-17**

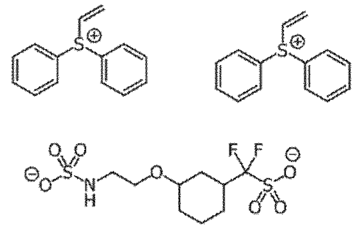

**B-18**

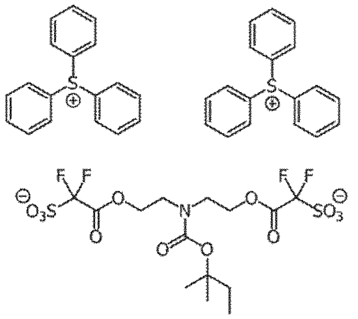

B-19

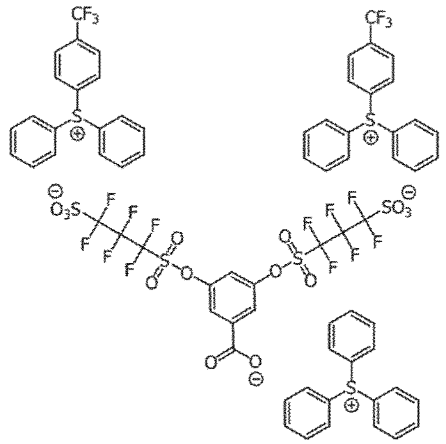

B-20

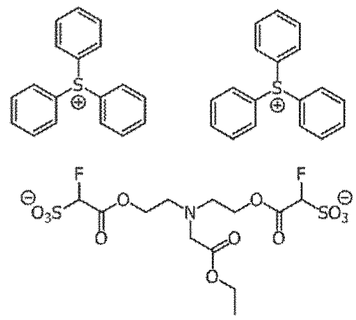

B-21

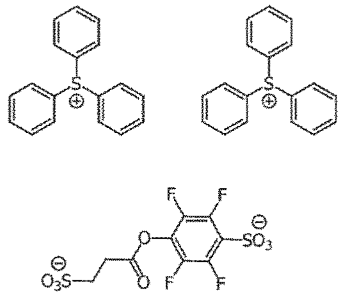

B-22

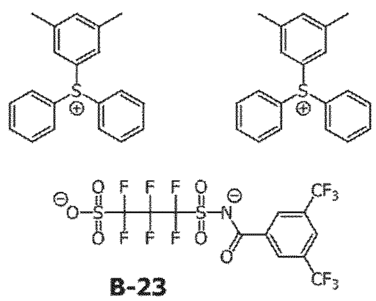

B-23

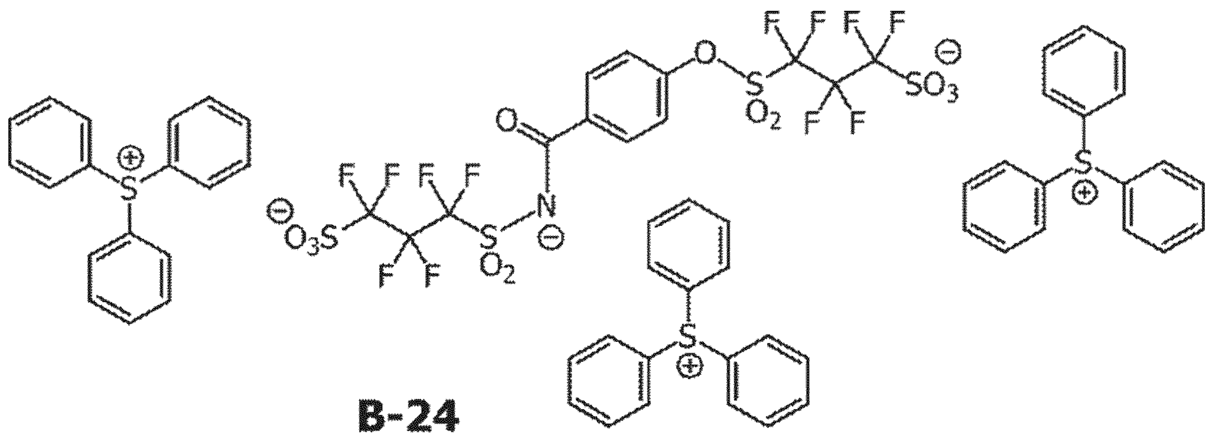

B-24

The photoacid generator may be used singly or in combination of two or more kinds thereof.

A content of the photoacid generator in the resist composition is preferably 0.1% to 50% by mass, more preferably 5% to 50% by mass, and still more preferably 8% to 40% by mass based on the total solid content of the composition. In particular, in order to achieve both high sensitivity and high resolution during exposure with electron beam or extreme ultraviolet rays, it is preferable that the content of the photoacid generator is high. From the above-described viewpoint, 10% to 40% by mass is preferable, and 10% to 35% by mass is more preferable.

<Solvent>

A solvent can be used in a case of preparing the resist composition by dissolving each of the above-described components. Examples of the solvent which can be used include organic solvents such as alkylene glycol monoalkyl ether carboxylate, alkylene glycol monoalkyl ether, alkyl lactate ester, alkyl alkoxypropionate, cyclic lactone having 4 to 10 carbon atoms, a monoketone compound having 4 to 10 carbon atoms, which may include a ring, alkylene carbonate,

alkyl alkoxyacetate, and alkyl pyruvate.

Examples of the alkylene glycol monoalkyl ether carboxylate include propylene glycol monomethyl ether acetate, propylene glycol monoethyl ether acetate, propylene glycol monopropyl ether acetate, propylene glycol monobutyl ether acetate, propylene glycol monomethyl ether propionate, propylene glycol monoethyl ether propionate, ethylene glycol monomethyl ether acetate, and ethylene glycol monoethyl ether acetate.

Examples of the alkylene glycol monoalkyl ether include propylene glycol monomethyl ether, propylene glycol monoethyl ether, propylene glycol monopropyl ether, propylene glycol monobutyl ether, ethylene glycol monomethyl ether, and ethylene glycol monoethyl ether.

Examples of the alkyl lactate ester include methyl lactate, ethyl lactate, propyl lactate, and butyl lactate.

Examples of the alkyl alkoxypropionate include ethyl 3-ethoxypropionate, methyl 3-methoxypropionate, methyl 3-ethoxypropionate, and ethyl 3-methoxypropionate.

Examples of the cyclic lactone having 4 to 10 carbon atoms include β-propiolactone, β-butyrolactone, γ-butyrolactone, α-methyl-γ-butyrolactone, β-methyl-γ-butyrolactone, γ-valerolactone, γ-caprolactone, γ-octanoic lactone, and α-hydroxy-γ-butyrolactone.

Examples of the monoketone compound having 4 to 10 carbon atoms, which may include a ring, include 2-butanone, 3-methylbutanone, pinacolone, 2-pentanone, 3-pentanone, 3-methyl-2-pentanone, 4-methyl-2-pentanone, 2-methyl-3-pentanone, 4,4-dimethyl-2-pentanone, 2,4-dimethyl-3-pentanone, 2,2,4,4-tetramethyl-3-pentanone, 2-hexanone, 3-hexanone, 5-methyl-3-hexanone, 2-heptanone, 3-heptanone, 4-heptanone, 2-methyl-3-heptanone, 5-methyl-3-heptanone, 2,6-dimethyl-4-heptanone, 2-octanone, 3-octanone, 2-nonanone, 3-nonanone, 5-nonanone, 2-decanone, 3-decanone, 4-decanone, 5-hexen-2-one, 3-penten-2-one, cyclopentanone, 2-methylcyclopentanone, 3-methylcyclopentanone, 2,2-dimethylcyclopentanone, 2,4,4-trimethylcyclopentanone, cyclohexanone, 3-methylcyclohexanone, 4-methylcyclohexanone, 4-ethylcyclohexanone, 2,2-dimethylcyclohexanone, 2,6-dimethylcyclohexanone, 2,2,6-trimethylcyclohexanone, cycloheptanone, 2-methylcycloheptanone, and 3-methylcycloheptanone.

Examples of the alkylene carbonate include propylene carbonate, vinylene carbonate, ethylene carbonate, and butylene carbonate.

Examples the alkyl alkoxyacetate include 2-methoxyethyl acetate, 2-ethoxyethyl acetate, 2-(2-ethoxyethoxy)ethyl acetate, 3-methoxy-3-methylbutyl acetate, and 1-methoxy-2-propyl acetate.

Examples of the alkyl pyruvate include methyl pyruvate, ethyl pyruvate, and propyl pyruvate.

Among these, as the solvent, a solvent having a boiling point of 130°C or higher at a normal temperature under a normal pressure is preferable. Specific examples thereof include cyclopentanone, γ-butyrolactone, cyclohexanone, ethyl lactate, ethylene glycol monoethyl ether acetate, propylene glycol monomethyl ether acetate, 3-ethyl ethoxypropionate, ethyl pyruvate, 2-ethoxyethyl acetate, 2-(2-ethoxyethoxy)ethyl acetate, and propylene carbonate.

The solvent may be used alone or in combination of two or more kinds thereof.

In the present invention, as the organic solvent, a mixed solvent in which a solvent including a hydroxyl group in the structure and a solvent not including a hydroxyl group are mixed may be used.

Examples of the solvent including a hydroxyl group include ethylene glycol, ethylene glycol monomethyl ether, ethylene glycol monoethyl ether, propylene glycol, propylene glycol monomethyl ether, propylene glycol monoethyl ether, and ethyl lactate. Among these, propylene glycol monomethyl ether or ethyl lactate is preferable.

Examples of the solvent not including a hydroxyl group include propylene glycol monomethyl ether acetate, ethyl ethoxypropionate, 2-heptanone, γ-butyrolactone, cyclohexanone, butyl acetate, N-methylpyrrolidone, N,N-dimethylacetamide, and dimethyl sulfoxide. Among these, propylene glycol monomethyl ether acetate, ethyl ethoxypropionate, 2-heptanone, γ-butyrolactone, cyclohexanone, or butyl acetate is preferable, and propylene glycol monomethyl ether acetate, ethyl ethoxypropionate, or 2-heptanone is more preferable.

A mass ratio of the content of the solvent including a hydroxyl group to the solvent not including a hydroxyl group [content mass of solvent including hydroxyl group/content mass of solvent not including hydroxyl group] is preferably 1/99 to 99/1, more preferably 10/90 to 90/10, and still more preferably 20/80 to 60/40. In addition, from the viewpoint of coating uniformity, it is preferable that the mass of the solvent not including a hydroxyl group in the mixed solvent is 50% by mass or more.

The above-described solvent is preferably a mixed solvent of two or more kinds including propylene glycol monomethyl ether acetate, and more preferably a combination of γ -butyrolactone and butyl acetate.

As the solvent, for example, solvents described in paragraphs [0013] to [0029] of JP2014-219664A can also be used.

<Acid diffusion control agent>

In order to reduce a change in performance over time from exposure to heating, the resist composition preferably includes an acid diffusion control agent.

Examples of the acid diffusion control agent include a basic compound.

Examples of the basic compound include a compound having a structure represented by Formulae (A1) to (E1).

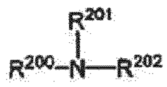
(A1)
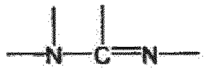
(B1)
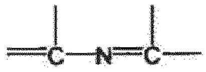
(C1)
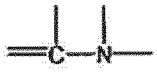
(D1)
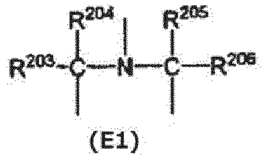
(E1)

In General Formula (A1) and General Formula (E1), $R^{200}$, $R^{201}$, and $R^{202}$ may be the same or different from each other, and each represent a hydrogen atom, an alkyl group (preferably having 1 to 20 carbon atoms), a cycloalkyl group (preferably having 3 to 20 carbon atoms), or an aryl group (preferably having 6 to 20 carbon atoms). $R^{201}$ and $R^{202}$ may be bonded to each other to form a ring.

The above-described alkyl group having a substituent is preferably an aminoalkyl group having 1 to 20 carbon atoms, a hydroxyalkyl group having 1 to 20 carbon atoms, or a cyanoalkyl group having 1 to 20 carbon atoms.

$R^{203}$, $R^{204}$, $R^{205}$, and $R^{206}$ may be the same or different from each other, and each represent an alkyl group having 1 to 20 carbon atoms.

The alkyl groups in General Formulae (A1) and (E1) are preferably unsubstituted.

Examples of the compound having a structure represented by General Formulae (A1) to (E1) include guanidine, aminopyrrolidine, pyrazole, pyrazoline, piperazine, aminomorpholine, aminoalkylmorpholin, and piperidine. In addition, examples thereof include a compound having an imidazole structure, a diazabicyclo structure, an onium hydroxide structure, an onium carboxylate structure, a trialkylamine structure, an aniline structure, or a pyridine structure; an alkylamine derivative having a hydroxyl group and/or an ether bond; and an aniline derivative having a hydroxyl group and/or an ether bond.

Examples of the compound having an imidazole structure include imidazole, 2,4,5-triphenylimidazole, and benzimidazole. Examples of the compound having a diazabicyclo structure include 1,4-diazabicyclo[2,2,2]octane, 1,5-diazabicyclo[4,3,0]non-5-ene, and 1,8-diazabicyclo[5,4,0]undec-7-ene. Examples of the compound having an onium hydroxide structure include triarylsulfonium hydroxide, phenacylsulfonium hydroxide, and sulfonium hydroxide having a 2-oxoalkyl group. Specific examples thereof include triphenylsulfonium hydroxide, tris(t-butylphenyl)sulfonium hydroxide, bis(t-butylphenyl)iodonium hydroxide, phenacylthiophenium hydroxide, and 2-oxopropylthiophenium hydroxide.

The compound having an onium carboxylate structure is formed by carboxylation of an anionic moiety of a compound having an onium hydroxide structure, and examples thereof include acetate, adamantane-1-carboxylate, and perfluoroalkyl carboxylate. Examples of the compound having a trialkylamine structure include tri(n-butyl)amine and tri(n-octyl)amine.

Examples of the aniline compound include 2,6-diisopropylaniline, N,N-dimethylaniline, N,N-dibutylaniline, and N,N-dihexylaniline.

Examples of the alkylamine derivative having a hydroxyl group and/or an ether bond include ethanolamine, diethanolamine, triethanolamine, and tris(methoxyethoxyethyl)amine.

Examples of the aniline derivative having a hydroxyl group and/or an ether bond include N,N-bis(hydroxyethyl)aniline.

Further, examples of the basic compound also include an amine compound having a phenoxy group and an ammonium salt compound having a phenoxy group.

As the amine compound, a primary, secondary, or tertiary amine compound can be used, and an amine compound in which at least one alkyl group is bonded to a nitrogen atom is preferable. The amine compound is more preferably a tertiary amine compound. As long as at least one alkyl group (preferably having 1 to 20 carbon atoms) is bonded to the nitrogen atom, the amine compound may have a cycloalkyl group (preferably having 3 to 20 carbon atoms) or an aryl group (preferably having 6 to 12 carbon atoms) bonded to the nitrogen atom in addition to the alkyl group.

In addition, it is preferable that the amine compound has an oxygen atom in the alkyl chain to form an oxyalkylene group. The number of oxyalkylene groups is 1 or more in the molecule, preferably 3 to 9 and more preferably 4 to 6.

Among these, as the oxyalkylene group, an oxyethylene group (-CHzCHzO-) or an oxypropylene group (-$CH(CH_3)CH_2O$- or -CHzCHzCHzO-) is preferable, and an oxyethylene group is more preferable.

As the ammonium salt compound, a primary, secondary, tertiary, and quaternary ammonium salt compound can be used, and an ammonium salt compound in which at least one alkyl group is bonded to a nitrogen atom is preferable. As long as at least one alkyl group (preferably having 1 to 20 carbon atoms) is bonded to the nitrogen atom, the ammonium salt compound may have a cycloalkyl group (preferably having 3 to 20 carbon atoms) or an aryl group (preferably having 6 to 12 carbon atoms) bonded to the nitrogen atom in addition to the alkyl group.

It is preferable that the ammonium salt compound has an oxygen atom in the alkyl chain to form an oxyalkylene group. The number of oxyalkylene groups is 1 or more in the molecule, preferably 3 to 9 and more preferably 4 to 6.

Among these, as the oxyalkylene group, an oxyethylene group (-CHzCHzO-) or an oxypropylene group (-$CH(CH_3)CH_2O$- or CHzCHzCHzO-) is preferable, and an oxyethylene group is more preferable.

Examples of the anion of the ammonium salt compound include a halogen atom, a sulfonate, a borate, and a phosphate. Among these, a halogen atom or a sulfonate is preferable. As the halogen atom, chloride, bromide, or iodide is preferable. The sulfonate is preferably an organic sulfonate having 1 to 20 carbon atoms. As the organic sulfonate, an alkyl sulfonate or an aryl sulfonate, which has 1 to 20 carbon atoms, is preferable. The alkyl group of the alkyl sulfonate may have a substituent, and examples of the substituent include fluorine, chlorine, bromine, an alkoxy group, an acyl group, and an aryl group. Examples of the alkyl sulfonate include methanesulfonate, ethanesulfonate, butanesulfonate, hexanesulfonate, octanesulfonate, benzyl sulfonate, trifluoromethanesulfonate, pentafluoroethanesulfonate, and nonafluorobutanesulfonate. Examples of an aryl group of the aryl sulfonate include a benzene ring, a naphthalene ring, and an anthracene ring. The benzene ring, the naphthalene ring, and the anthracene ring may have a substituent, and the substituent is preferably a linear or branched alkyl group having 1 to 6 carbon atoms or a cycloalkyl group having 3 to 6 carbon atoms. Specific examples of the linear or branched alkyl group and the cycloalkyl group include a methyl group, an ethyl group, an n-propyl group, an isopropyl group, an n-butyl group, an isobutyl group, a t-butyl group, an n-hexyl group, and a cyclohexyl group. Examples of other substituents include an alkoxy group having 1 to 6 carbon atoms, a halogen atom, a cyano group, a nitro group, an acyl group, and an acyloxy group.

The amine compound having a phenoxy group and the ammonium salt compound having a phenoxy group are each a compound having a phenoxy group at the terminal on the opposite side to the nitrogen atom of the alkyl group which is included in the amine compound or the ammonium salt compound. The phenoxy group may have a substituent. Examples of a substituent of the phenoxy group include an alkyl group, an alkoxy group, a halogen atom, a cyano group, a nitro group, a carboxyl group, a carboxylic acid ester group, a sulfonic acid ester group, an aryl group, an aralkyl group, an acyloxy group, and an aryloxy group. A substitution position of the substituent may be any of 2- to 6-positions. The number of substituents may be in a range of 1 to 5.

The compound preferably has at least one oxyalkylene group between the phenoxy group and the nitrogen atom. The number of oxyalkylene groups is 1 or more in the molecule, preferably 3 to 9 and more preferably 4 to 6. Among these, as the oxyalkylene group, an oxyethylene group (-CHzCHzO-) or an oxypropylene group (-$CH(CH_3)CH_2O$- or -CHzCHzCHzO-) is preferable, and an oxyethylene group is more preferable.

The amine compound having a phenoxy group is obtained by heating and reacting a primary or secondary amine having a phenoxy group with a haloalkyl ether, adding an aqueous solution of a strong base such as sodium hydroxide, potassium hydroxide, and tetraalkylammonium thereto, and extracting the mixture with an organic solvent such as ethyl acetate and chloroform. Alternatively, the amine compound having a phenoxy group is obtained by heating and reacting a primary or secondary amine with a haloalkyl ether having a phenoxy group at the terminal, adding an aqueous solution of a strong base such as sodium hydroxide, potassium hydroxide, and tetraalkylammonium thereto, and extracting the solution with an organic solvent such as ethyl acetate and chloroform.

(Compound (PA) that Has Proton-Accepting Functional Group and Generates Compound which is Decomposed by Irradiation with Actinic Ray or Radiation to Exhibit Deterioration in Proton-Accepting Properties, No Proton-Accepting Properties, or Change from Proton-Accepting Properties to Acidic Properties)

The composition according to the present invention may further include, as an acid diffusion control agent, a compound [hereinafter, also referred to as a "compound (PA)"] that has a proton-accepting functional group and generates a compound which is decomposed by an irradiation with actinic ray or radiation to exhibit deterioration in proton-accepting properties, no proton-accepting properties, or a change from the proton-accepting properties to acidic properties.

The proton-accepting functional group refers to a functional group having a group or electron capable of electrostatically interacting with a proton, and for example, means a functional group with a macrocyclic structure, such as a cyclic polyether, or a functional group having a nitrogen atom having an unshared electron pair not contributing to π-conjugation. For example, the nitrogen atom having the unshared electron pair, which does not contribute to the π-conjugation, is a nitrogen atom having a partial structure represented by the following general formula.

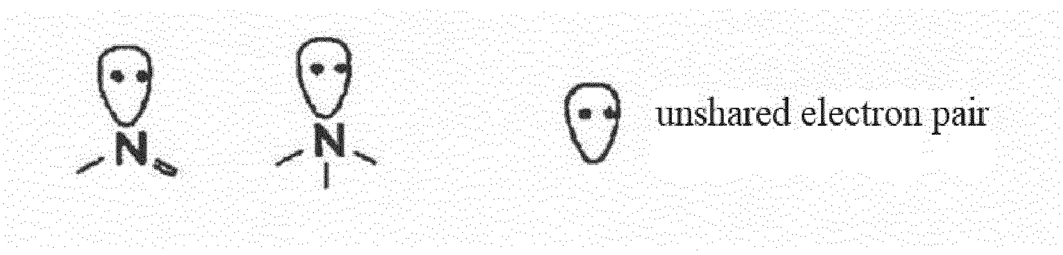

Preferred examples of the partial structure of the proton-accepting functional group include a crown ether structure, an azacrown ether structure, primary to tertiary amine structures, a pyridine structure, an imidazole structure, and a pyrazine structure.

The compound (PA) is decomposed by irradiation with actinic ray or radiation to generate a compound exhibiting deterioration in proton-accepting properties, no proton-accepting properties, or a change from the proton-accepting properties to acidic properties. Here, the decrease or disappearance of proton-accepting properties, or the change from proton-accepting properties to acid property is a change in proton-accepting properties due to the proton being added to the proton-accepting functional group, and specifically means that, in a case where a proton adduct is generated from the compound (PA) having the proton-accepting functional group and the proton, the equilibrium constant in chemical equilibrium thereof decreases.

Specific examples of the compound (PA) include the following compounds. Further, with regard to the specific examples of the compound (PA), reference can be made to those described in paragraphs [0421] to [0428] of JP2014-041328A or paragraphs [0108] to [0116] of JP2014-134686A, the contents of which are incorporated herein by reference.

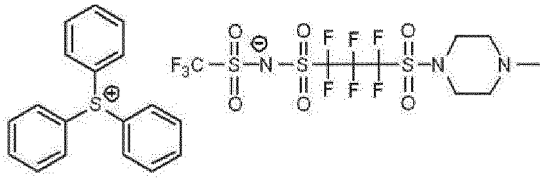
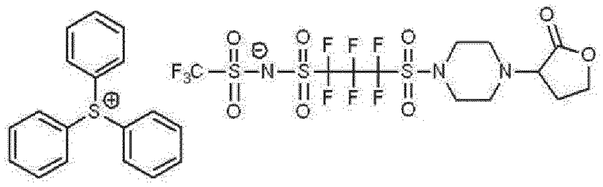

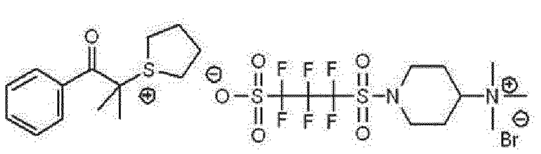
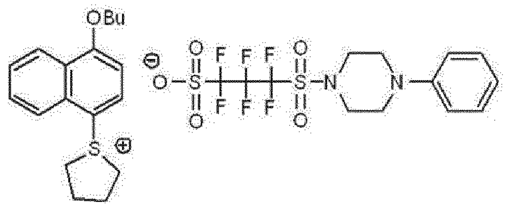

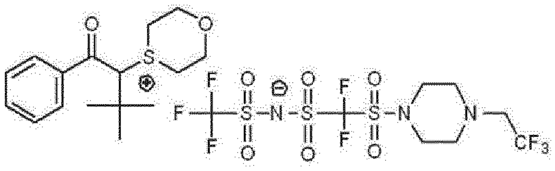
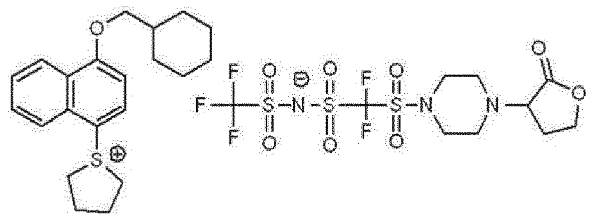

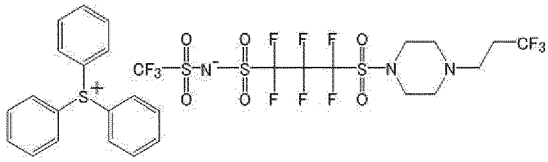
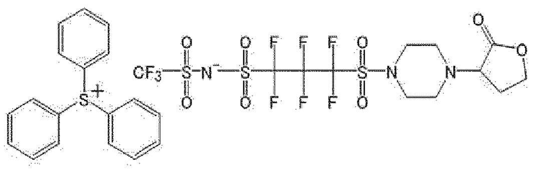

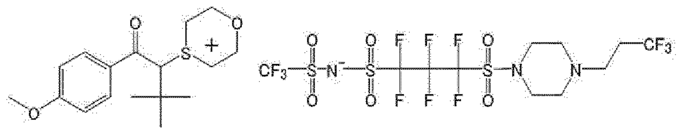

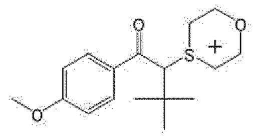

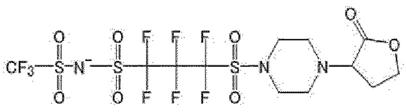

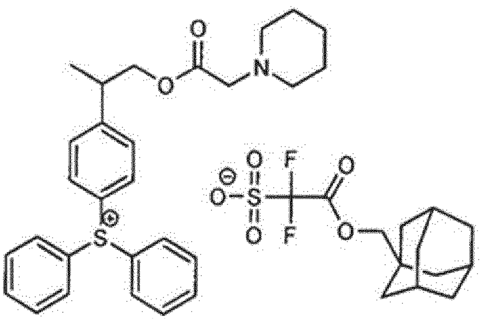

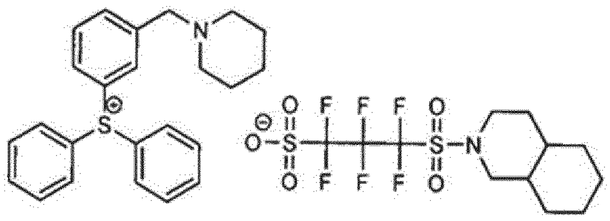

The acid diffusion control agent may be used alone or in combination of two or more kinds thereof.

A content of the acid diffusion control agent is preferably 0.001% to 10% by mass and more preferably 0.005% to 5% by mass with respect to the total solid content of the resist composition.

A used proportion of the photoacid generator and the acid diffusion control agent in the resist composition is preferably photoacid generator/acid diffusion control agent (molar ratio) = 2.5 to 300. From the viewpoint the effects of the present invention are more excellent, the molar ratio is preferably 2.5 or more, and from the viewpoint of suppressing the deterioration in resolution due to the thickening of a resist pattern with the passage of time from the exposure to the heat treatment, the molar ratio is preferably 300 or less. The photoacid generator/acid diffusion control agent (molar ratio) is more preferably 5.0 to 200 and still more preferably 7.0 to 150.

As the acid diffusion control agent, for example, compounds (amine compounds, amide group-containing compounds, urea compounds, nitrogen-containing heterocyclic compounds, and the like) described in paragraphs [0140] to [0144] of JP2013-011833A can be used.

<Hydrophobic resin>

The resist composition may include a hydrophobic resin in addition to the above-described resin (A).

Although it is preferable that the hydrophobic resin is designed to be unevenly distributed on a surface of the resist film, it is not necessary to have a hydrophilic group in the molecule as different from a surfactant, and may not contribute to uniform mixing of polar materials and non-polar materials.

Examples of an effect caused by the addition of the hydrophobic resin include a control of static and dynamic contact angles of a surface of the resist film with respect to water and suppression of outgas.

From the viewpoint of uneven distribution on the film surface layer, the hydrophobic resin preferably has any one or more of a fluorine atom, a silicon atom, and a $CH_3$ partial structure which is contained in a side chain moiety of a resin, and more preferably has two or more kinds thereof. In addition, the above-described hydrophobic resin preferably includes a hydrocarbon group having 5 or more carbon atoms. These groups may be included in the main chain of the resin or may be substituted in the side chain of the resin.

In a case where hydrophobic resin includes a fluorine atom and/or a silicon atom, the fluorine atom and/or the silicon atom in the hydrophobic resin may be included in the main chain or the side chain of the resin.

In a case where the hydrophobic resin includes a fluorine atom, as a partial structure having a fluorine atom, a resin which has an alkyl group having a fluorine atom, a cycloalkyl group having a fluorine atom, or an aryl group having a fluorine atom is preferable.

The alkyl group having a fluorine atom (preferably having 1 to 10 carbon atoms and more preferably having 1 to 4 carbon atoms) is a linear or branched alkyl group in which at least one hydrogen atom is substituted with a fluorine atom, and the alkyl group may further have a substituent other than the fluorine atom.

The cycloalkyl group having a fluorine atom is a monocyclic or polycyclic cycloalkyl group in which at least one hydrogen atom is substituted with a fluorine atom, and may further have a substituent other than the fluorine atom.

Examples of the aryl group having a fluorine atom include an aryl group such as a phenyl group and a naphthyl group, in which at least one hydrogen atom is substituted with a fluorine atom, and the aryl group may further have a substituent other than the fluorine atom.

Examples of the repeating unit having a fluorine atom or a silicon atom include repeating units exemplified in

paragraph [0519] of US2012/0251948A1.

In addition, as described above, it is also preferable that the hydrophobic resin includes a $CH_3$ partial structure in the side chain moiety.

Here, the $CH_3$ partial structure included in the side chain moiety of the hydrophobic resin includes a $CH_3$ partial structure included in an ethyl group, a propyl group, and the like.

On the other hand, since a methyl group directly bonded to the main chain of the hydrophobic resin (for example, an $\alpha$-methyl group in a repeating unit having a methacrylic acid structure) has only a small contribution of uneven distribution on the surface of the hydrophobic resin due to the effect of the main chain, the methyl group is not included in the $CH_3$ partial structure in the present invention.

With regard to the hydrophobic resin, reference can be made to the description in paragraphs [0348] to [0415] of JP2014-010245A, the contents of which are incorporated herein by reference.

As the hydrophobic resin, the resins described in JP2011-248019A, JP2010-175859A, and/or JP2012-032544A can also be preferably used, in addition to the resins described above.

<Surfactant>

The resist composition may further include a surfactant. By including the surfactant, in a case where an exposure light source at a wavelength of 250 nm or less, in particular, 220 nm or less is used, it is possible to form a pattern with good sensitivity and resolution and less adhesiveness and development defects.

It is particularly preferable to use a fluorine-based and/or silicon-based surfactant as the surfactant.

Examples of the fluorine-based and/or silicon-based surfactant include the surfactants described in paragraph [0276] of US2008/0248425A. In addition, EFTOP EF301 or EF303 (manufactured by Shin-Akita Chemical Co., Ltd.); FLUORAD FC430, 431, and 4430 (manufactured by Sumitomo 3M inc.); MEGAFACE F171, F173, F176, F189, F113, F110, F177, F120, and R08 (manufactured by DIC Corporation); SURFLON S-382, SC101, 102, 103, 104, 105, or 106 (manufactured by Asahi Glass Co., Ltd.); TROYSOL S-366 (manufactured by Troy Corporation); GF-300 or GF-150 (manufactured by Toagosei Co., Ltd.); SURFLON S-393 (manufactured by AGC Seimi Chemical Co., Ltd.); EFTOP EF121, EF122A, EF122B, RF122C, EF125M, EF135M, EF351, EF352, EF801, EF802, or EF601 (manufactured by JEMCO Inc.); PF636, PF656, PF6320, and PF6520 (manufactured by OMNOVA Solutions Inc.); or FTX-204G, 208G, 218G, 230G, 204D, 208D, 212D, 218D, and 222D (manufactured by NEOS COMPANY LIMITED) may be used. A polysiloxane polymer KP-341 (manufactured by Shin-Etsu Chemical Co., Ltd.) can also be used as the silicon-based surfactant.

Moreover, in addition to the known surfactants as described above, the surfactant may be synthesized using a fluoroaliphatic compound produced by a telomerization method (also referred to as a telomer method) or an oligomerization method (also referred to as an oligomer method). Specifically, a polymer including a fluoroaliphatic group derived from the fluoroaliphatic compound may be used as the surfactant. The fluoroaliphatic compound can be synthesized, for example, by the method described in JP2002-090991A.

In addition, a surfactant other than the fluorine-based and/or the silicon-based surfactants described in paragraph [0280] of US2008/0248425A may be used.

The surfactant may be used alone or in combination of two or more kinds thereof.

In a case where the resist composition includes a surfactant, a content thereof is preferably 0% to 2% by mass, more preferably 0.0001% to 2% by mass, and still more preferably 0.0005% to 1% by mass with respect to the total solid content of the composition.

<Other additives>

The resist composition may further include a dissolution inhibiting compound, a dye, a plasticizer, a photosensitizer, a light absorbing agent, and/or a compound promoting a solubility in a developer (for example, a phenol compound having a molecular weight of 1000 or less or an alicyclic or aliphatic compound including a carboxyl group), or the like.

The resist composition may further include a dissolution inhibiting compound.

Here, the "dissolution inhibiting compound" is intended to be a compound having a molecular weight of 3000 or less, in which solubility in an organic developer decreases by decomposition due to the action of acid.

The present invention is basically configured as described above. The method for producing a resist composition according to the embodiment of the present invention has been described in detail above, but the present invention is not limited to the above-described embodiments, and various improvements and changes can be made without departing from the spirit of the present invention.

Examples

Hereinbelow, the present invention will be described in more detail with reference to Examples. The materials, the amounts of materials used, the proportions, the treatment details, the treatment procedure, and the like shown in Examples below may be appropriately modified as long as the modifications do not depart from the spirit of the present invention. Accordingly, the scope of the present invention should not be construed as being limited to the following examples, "parts" and "%" are intended to mean values based on mass unless otherwise specified.

[Acid-decomposable resin]

The tables below shows an acid-decomposable resin used in the resist composition.

In the tables, the column of "Molar ratio of repeating unit" indicates a content (% by mole) of each repeating unit constituting each acid-decomposable resin with respect to all repeating units.

Resins A-1 to A-17 in Table 1-1 all have the respective repeating unit shown in the following chemical formulae, and the contents of the respective repeating units in the resins A-1 to A-17 correspond to the value shown in the column of "Molar ratio of repeating unit" in order from the left.

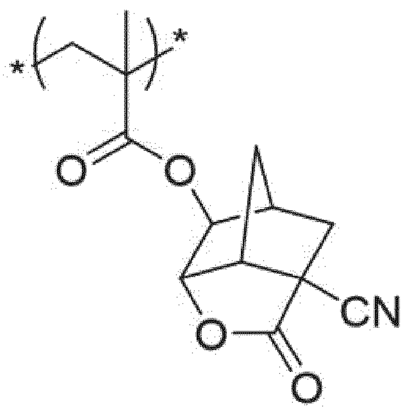
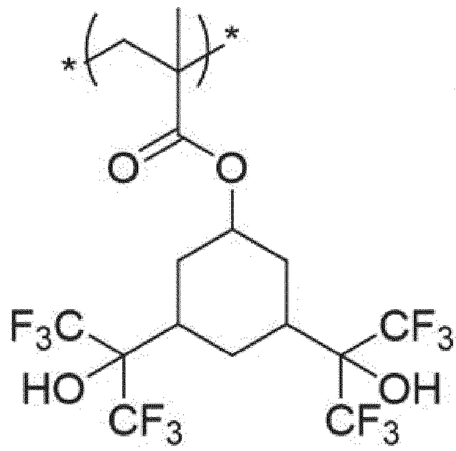
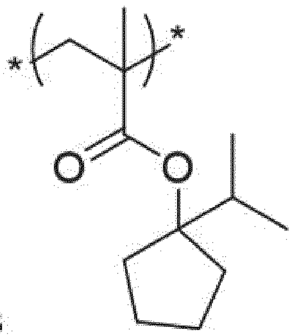

In addition, resins A-19 to A-35 in Table 1-2 all have the respective repeating unit shown in the following chemical formulae, and the contents of the respective repeating units in the resins A-19 to A-35 correspond to the value shown in the column of "Molar ratio of repeating unit" in order from the left.

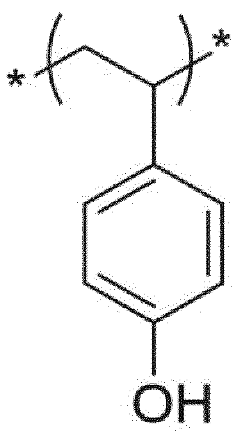
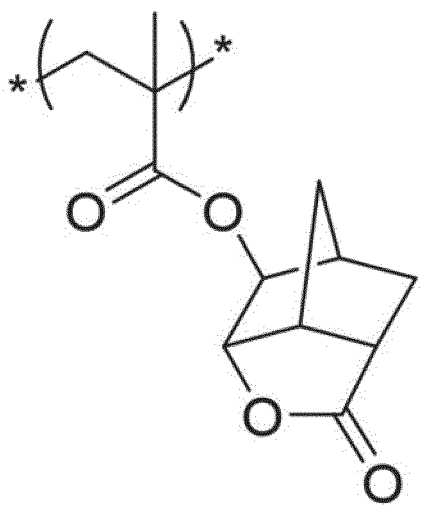
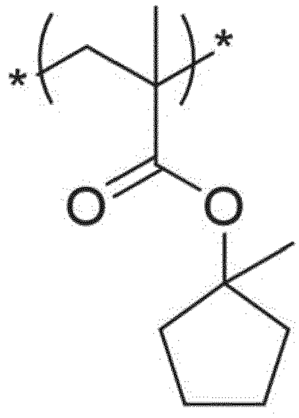

In addition, resins A-37 to A-57 in Table 1-3 all have the respective repeating unit shown in the following chemical formulae, and the contents of the respective repeating units in the resins A-37 to A-57 correspond to the value shown in the column of "Molar ratio of repeating unit" in order from the left.

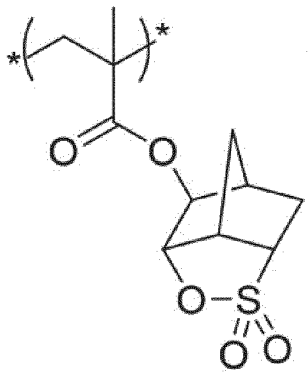
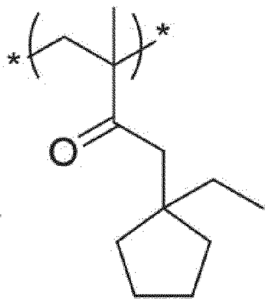
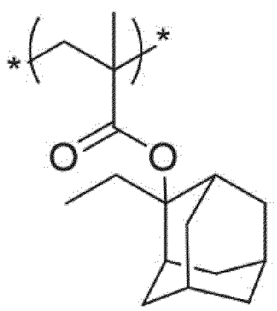
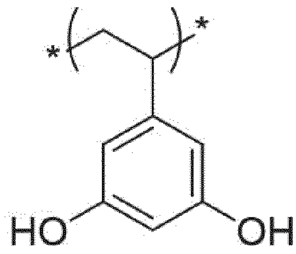

In addition, resins A-59 to A-75 in Table 1-4 all have the respective repeating unit shown in the following chemical formulae, and the contents of the respective repeating units in the resins A-59 to A-75 correspond to the value shown in the column of "Molar ratio of repeating unit" in order from the left.

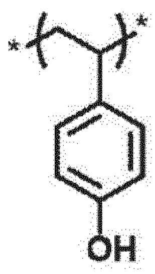
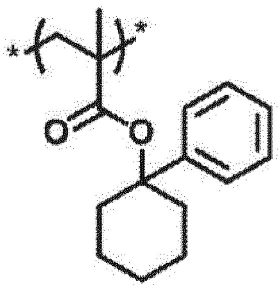
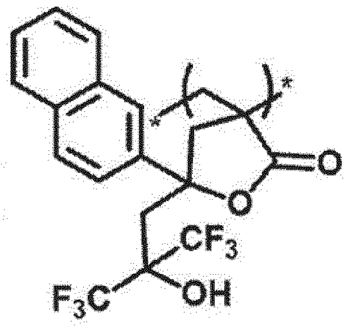

In addition, resins A-77 to A-93 in Table 1-5 all have the respective repeating unit shown in the following chemical formulae, and the contents of the respective repeating units in the resins A-77 to A-93 correspond to the value shown in the column of "Molar ratio of repeating unit" in order from the left.

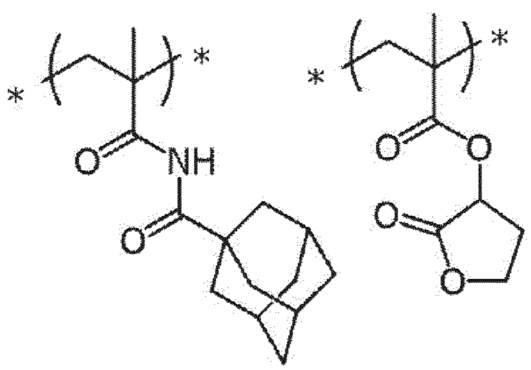
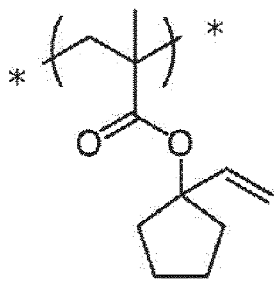

In addition, resins A-95 to A-119 in Table 1-6 all have the respective repeating unit shown in the following chemical formulae, and the contents of the respective repeating units in the resins A-95 to A-119 correspond to the value shown in the column of "Molar ratio of repeating unit" in order from the left.

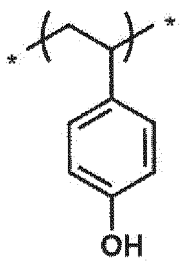 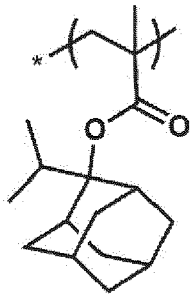 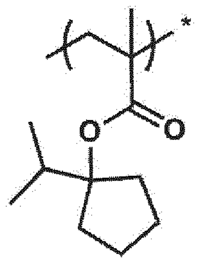 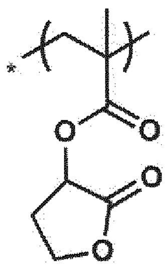 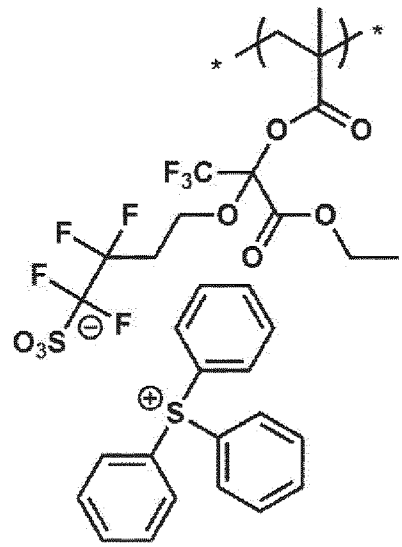

In addition, the content of each repeating unit constituting each acid-decomposable resin with respect to all repeating units was calculated from a value obtained by measuring with a measuring method described in <NMR measurement> described later and setting the number of times of integration of 5000 times.

A weight-average molecular weight and molecular weight distribution of the acid-decomposable resin are values measured by the measuring method described in <GPC measurement> described later.

Table 1]

| Table 1-1 | Molar ratio of repeating unit | | | Mw | Pd (Mw/Mn) |
|---|---|---|---|---|---|
| Resin A-1 | 27.9 | 15.1 | 57.0 | 6143 | 1.58 |
| Resin A-2 | 28.2 | 14.5 | 57.3 | 6352 | 1.63 |
| Resin A-3 | 27.2 | 15.5 | 57.3 | 5845 | 1.57 |
| Resin A-4 | 28.8 | 14.0 | 57.2 | 6580 | 1.60 |
| Resin A-5 | 27.8 | 15.4 | 56.8 | 5507 | 1.60 |
| Resin A-6 | 27.3 | 15.5 | 57.2 | 6150 | 1.63 |
| Resin A-7 | 27.5 | 16.9 | 55.6 | 6122 | 1.61 |
| Resin A-8 | 29.4 | 13.5 | 57.1 | 6205 | 1.62 |
| Resin A-9 | 27.6 | 12.7 | 59.7 | 6161 | 1.63 |
| Resin A-10 | 27.8 | 14.1 | 58.1 | 6221 | 1.59 |
| Resin A-11 | 26.0 | 14.5 | 59.5 | 6198 | 1.61 |
| Resin A-12 | 27.5 | 15.4 | 57.1 | 6199 | 1.54 |
| Resin A-13 | 29.3 | 15.2 | 55.5 | 6129 | 1.59 |
| Resin A-14 | 28.8 | 14.7 | 56.5 | 6173 | 1.59 |
| Resin A-15 | 30.2 | 14.1 | 55.7 | 6210 | 1.62 |
| Resin A-16 | 27.5 | 15.0 | 57.5 | 6168 | 1.57 |
| Resin A-17 | 25.9 | 14.9 | 59.2 | 6253 | 1.57 |

[Table 2]

| Table 1-2 | Molar ratio of repeating unit | | | Mw | Pd (Mw/Mn) |
|---|---|---|---|---|---|
| Resin A-19 | 41.2 | 10.5 | 48.3 | 7058 | 1.59 |
| Resin A-20 | 40.8 | 10.2 | 49.0 | 7312 | 1.64 |
| Resin A-21 | 41.4 | 10.6 | 48.0 | 6825 | 1.58 |
| Resin A-22 | 40.6 | 10.0 | 49.4 | 7581 | 1.61 |
| Resin A-23 | 41.6 | 10.3 | 48.1 | 6514 | 1.61 |
| Resin A-24 | 42.2 | 9.9 | 47.9 | 7065 | 1.64 |
| Resin A-25 | 45.0 | 11.8 | 43.2 | 7037 | 1.62 |
| Resin A-26 | 40.1 | 11.2 | 48.7 | 7120 | 1.63 |
| Resin A-27 | 38.5 | 12.0 | 49.5 | 7076 | 1.64 |
| Resin A-28 | 40.5 | 11.7 | 47.8 | 7136 | 1.60 |
| Resin A-29 | 39.9 | 13.8 | 46.3 | 7113 | 1.62 |
| Resin A-30 | 41.8 | 9.3 | 48.9 | 7114 | 1.55 |
| Resin A-31 | 43.0 | 7.2 | 49.8 | 7044 | 1.60 |
| Resin A-32 | 40.0 | 11.0 | 49.0 | 7088 | 1.60 |
| ResinA-33 | 39.4 | 8.3 | 52.3 | 7125 | 1.63 |
| Resin A-34 | 42.0 | 10.9 | 47.1 | 7083 | 1.58 |
| Resin A-35 | 43.4 | 11.4 | 45.2 | 7168 | 1.58 |

[Table 3]

| Table 1-3 | Molar ratio of repeating unit | | | | Mw | Pd (Mw/Mn) |
|---|---|---|---|---|---|---|
| Resin A-37 | 32.0 | 28.0 | 29.2 | 10.8 | 8123 | 1.64 |
| Resin A-38 | 31.2 | 28.2 | 28.9 | 11.7 | 8320 | 1.69 |
| Resin A-39 | 32.2 | 27.8 | 28.7 | 11.3 | 7954 | 1.63 |
| Resin A-40 | 31.5 | 28.5 | 29.3 | 10.7 | 8690 | 1.66 |
| Resin A-41 | 32.5 | 27.5 | 28.5 | 11.5 | 7495 | 1.66 |
| Resin A-42 | 33.4 | 27.7 | 28.5 | 10.4 | 8130 | 1.69 |
| Resin A-43 | 35.2 | 26.9 | 28.1 | 9.8 | 8102 | 1.67 |
| Resin A-44 | 31.2 | 28.3 | 29.4 | 11.1 | 8185 | 1.68 |
| Resin A-45 | 29.4 | 29.2 | 30.0 | 11.4 | 8141 | 1.69 |
| Resin A-46 | 31.8 | 28.5 | 29.0 | 10.7 | 8201 | 1.65 |
| Resin A-47 | 31.1 | 31.0 | 27.9 | 10.0 | 8178 | 1.67 |
| Resin A-48 | 32.3 | 26.8 | 29.5 | 11.4 | 8179 | 1.60 |
| Resin A-49 | 33.0 | 24.9 | 29.9 | 12.2 | 8109 | 1.65 |
| Resin A-50 | 31.8 | 27.7 | 30.0 | 10.5 | 8153 | 1.65 |
| Resin A-51 | 31.2 | 27.1 | 31.5 | 10.2 | 8190 | 1.68 |
| Resin A-52 | 32.3 | 28.4 | 27.9 | 11.4 | 8148 | 1.63 |
| Resin A-53 | 33.0 | 29.0 | 26.1 | 11.9 | 8233 | 1.63 |

(continued)

| Table 1-3 | Molar ratio of repeating unit | | | | Mw | Pd (Mw/Mn) |
|---|---|---|---|---|---|---|
| Resin A-54 | 31.8 | 27.7 | 28.9 | 11.6 | 8145 | 1.62 |
| Resin A-55 | 30.9 | 27.2 | 28.0 | 13.9 | 8206 | 1.64 |
| Resin A-56 | 32.4 | 28.4 | 29.4 | 9.8 | 8165 | 1.64 |
| Resin A-57 | 33.0 | 29.2 | 30.6 | 7.2 | 8230 | 1.61 |

[Table 4]

| Table 1-4 | Molar ratio of repeating unit | | | Mw | Pd (Mw/Mn) |
|---|---|---|---|---|---|
| Resin A-59 | 32.8 | 32.9 | 34.3 | 7150 | 1.65 |
| Resin A-60 | 33.1 | 32.3 | 34.6 | 7359 | 1.70 |
| Resin A-61 | 32.1 | 33.3 | 34.6 | 6852 | 1.64 |
| Resin A-62 | 33.7 | 31.8 | 34.5 | 7587 | 1.67 |
| Resin A-63 | 32.7 | 33.2 | 34.1 | 6514 | 1.67 |
| Resin A-64 | 32.2 | 33.3 | 34.5 | 7157 | 1.70 |
| Resin A-65 | 32.4 | 34.7 | 32.9 | 7129 | 1.68 |
| Resin A-66 | 34.3 | 31.3 | 34.4 | 7212 | 1.69 |
| Resin A-67 | 32.5 | 30.5 | 37.0 | 7168 | 1.70 |
| Resin A-68 | 32.7 | 31.9 | 35.4 | 7228 | 1.66 |
| Resin A-69 | 30.9 | 32.3 | 36.8 | 7205 | 1.68 |
| Resin A-70 | 32.4 | 33.2 | 34.4 | 7206 | 1.61 |
| Resin A-71 | 34.2 | 33.0 | 32.8 | 7136 | 1.66 |
| Resin A-72 | 33.7 | 32.5 | 33.8 | 7180 | 1.66 |
| Resin A-73 | 35.1 | 31.9 | 33.0 | 7217 | 1.69 |
| Resin A-74 | 32.4 | 32.8 | 34.8 | 7175 | 1.64 |
| Resin A-75 | 30.8 | 32.7 | 36.5 | 7260 | 1.64 |

[Table 5]

| Table 1-5 | Molar ratio of repeating unit | | | Mw | Pd (Mw/Mn) |
|---|---|---|---|---|---|
| Resin A-77 | 25.2 | 44.7 | 30.1 | 7520 | 1.78 |
| Resin A-78 | 25.5 | 44.1 | 30.4 | 7729 | 1.83 |
| Resin A-79 | 24.5 | 45.1 | 30.4 | 7222 | 1.77 |
| Resin A-80 | 26.1 | 43.6 | 30.3 | 7957 | 1.80 |
| Resin A-81 | 25.1 | 45.0 | 29.9 | 6884 | 1.80 |
| Resin A-82 | 24.6 | 45.1 | 30.3 | 7527 | 1.83 |
| Resin A-83 | 24.8 | 46.5 | 28.7 | 7499 | 1.81 |
| Resin A-84 | 26.7 | 43.1 | 30.2 | 7582 | 1.82 |
| Resin A-85 | 24.9 | 42.3 | 32.8 | 7538 | 1.83 |

(continued)

| Table 1-5 | Molar ratio of repeating unit | | | Mw | Pd (Mw/Mn) |
|---|---|---|---|---|---|
| Resin A-86 | 25.1 | 43.7 | 31.2 | 7598 | 1.79 |
| Resin A-87 | 23.3 | 44.1 | 32.6 | 7575 | 1.81 |
| Resin A-88 | 24.8 | 45.0 | 30.2 | 7576 | 1.74 |
| Resin A-89 | 26.6 | 44.8 | 28.6 | 7506 | 1.79 |
| Resin A-90 | 26.1 | 44.3 | 29.6 | 7550 | 1.79 |
| Resin A-91 | 27.5 | 43.7 | 28.8 | 7587 | 1.82 |
| Resin A-92 | 24.8 | 44.6 | 30.6 | 7545 | 1.77 |
| Resin A-93 | 23.2 | 44.5 | 32.3 | 7630 | 1.77 |

[Table 6]

| Table 1-6 | Molar ratio of repeating unit | | | | | Mw | Pd (Mw/Mn) |
|---|---|---|---|---|---|---|---|
| Resin A-95 | 35.4 | 24.4 | 34.2 | 2.9 | 3.1 | 4540 | 1.56 |
| Resin A-96 | 34.6 | 24.6 | 34.0 | 3.8 | 3.0 | 4737 | 1.61 |
| Resin A-97 | 35.6 | 24.2 | 33.6 | 3.4 | 3.2 | 4371 | 1.55 |
| Resin A-98 | 34.9 | 24.9 | 34.3 | 2.8 | 3.1 | 5107 | 1.58 |
| Resin A-99 | 35.9 | 23.9 | 33.5 | 3.6 | 3.1 | 3912 | 1.58 |
| Resin A-100 | 36.6 | 24.1 | 33.5 | 2.5 | 3.3 | 4547 | 1.61 |
| Resin A-101 | 38.4 | 23.3 | 33.1 | 1.9 | 3.3 | 4519 | 1.59 |
| Resin A-102 | 34.5 | 24.7 | 34.4 | 3.2 | 3.2 | 4602 | 1.60 |
| Resin A-103 | 32.7 | 25.6 | 35.0 | 3.5 | 3.2 | 4558 | 1.61 |
| Resin A-104 | 35.2 | 24.8 | 34.0 | 2.8 | 3.2 | 4618 | 1.57 |
| Resin A-105 | 34.5 | 27.3 | 32.9 | 2.1 | 3.2 | 4595 | 1.59 |
| Resin A-106 | 35.7 | 23.0 | 34.5 | 3.5 | 3.3 | 4596 | 1.52 |
| Resin A-107 | 36.4 | 21.1 | 34.9 | 4.3 | 3.3 | 4526 | 1.57 |
| Resin A-108 | 35.2 | 24.1 | 34.9 | 2.6 | 3.2 | 4570 | 1.57 |
| Resin A-109 | 34.6 | 23.5 | 36.4 | 2.3 | 3.2 | 4607 | 1.60 |
| Resin A-110 | 35.7 | 24.8 | 32.7 | 3.5 | 3.3 | 4565 | 1.55 |
| Resin A-111 | 36.4 | 25.4 | 30.9 | 4.0 | 3.3 | 4650 | 1.55 |
| Resin A-112 | 35.2 | 24.1 | 33.9 | 2.6 | 4.2 | 4562 | 1.54 |
| Resin A-113 | 34.3 | 23.6 | 33 | 5.9 | 3.2 | 4623 | 1.56 |
| Resin A-114 | 35.8 | 24.8 | 34.4 | 1.8 | 3.2 | 4582 | 1.56 |
| Resin A-115 | 36.4 | 25.6 | 35.6 | 0.9 | 1.5 | 4647 | 1.53 |
| Resin A-116 | 35.2 | 24 | 34 | 2.8 | 4.0 | 4624 | 1.61 |
| Resin A-117 | 33.9 | 23.8 | 33.9 | 2.4 | 6.0 | 4580 | 1.55 |
| Resin A-118 | 35.6 | 24.7 | 34.5 | 3.2 | 2.0 | 4601 | 1.57 |
| Resin A-119 | 36 | 24.9 | 34.7 | 3.4 | 1.0 | 4595 | 1.58 |

<Photoacid generator>

The following components were used as a photoacid generator.

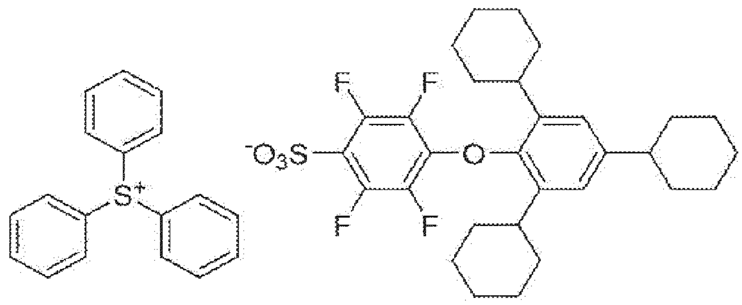

B - 1

B-2

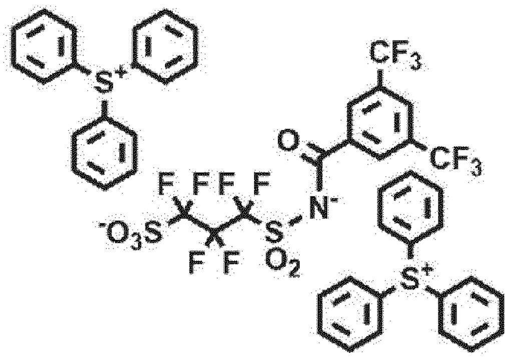

B-3

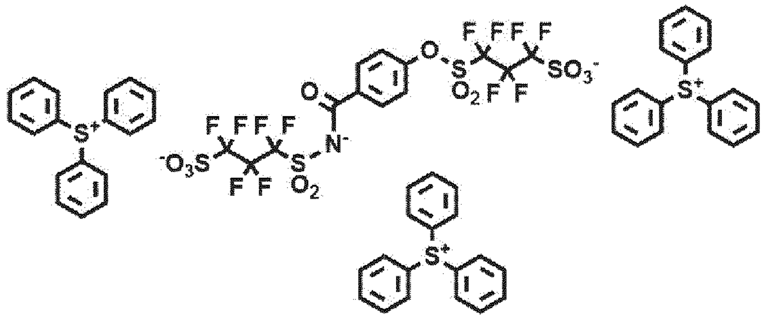

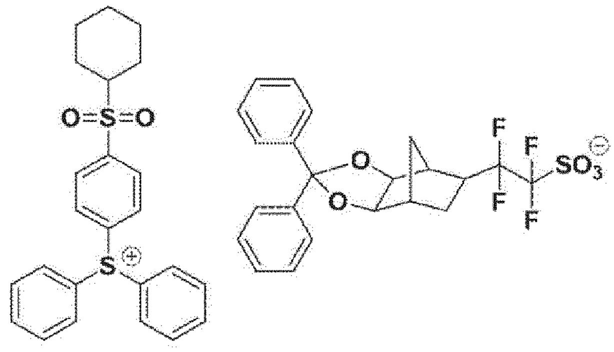

B-4

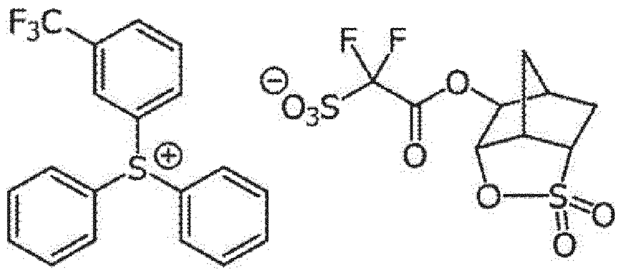

B-5

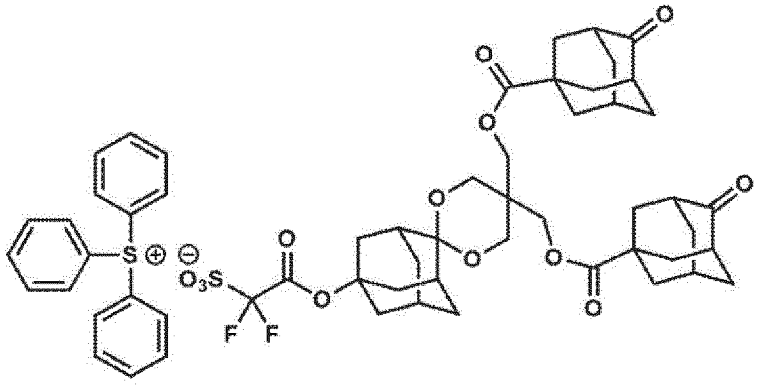

B-6

<Acid diffusion control agent>

The following components were used as an acid diffusion control agent.

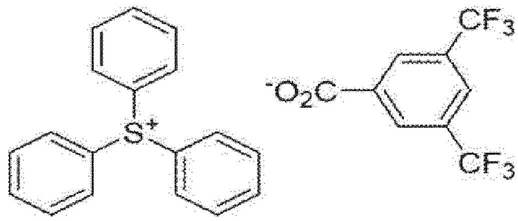

C-1

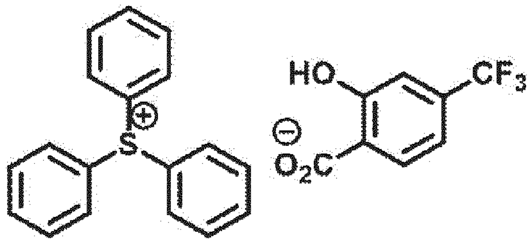

C-2

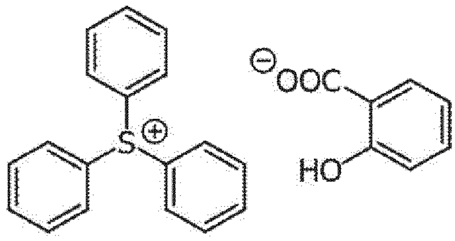

C-3

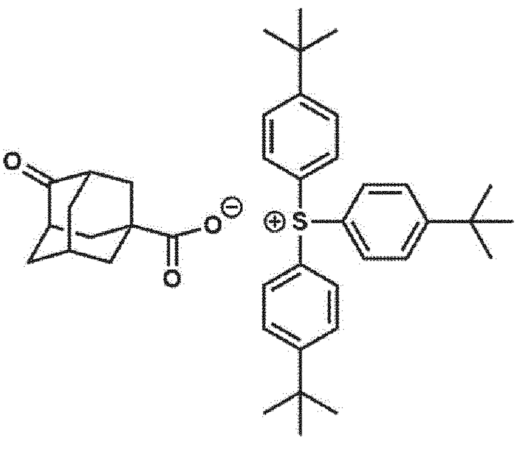

C-4

<Hydrophobic resin>

As a hydrophobic resin, a hydrophobic resin E-1 having the respective repeating units shown in the following chemical formulae was used. The contents of the respective repeating units in the hydrophobic resin correspond to the value shown in the column of "Molar ratio of repeating unit" in order from the left.

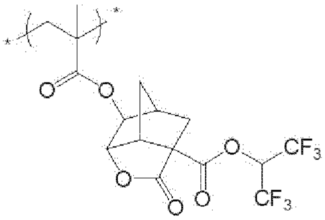 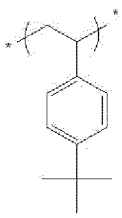 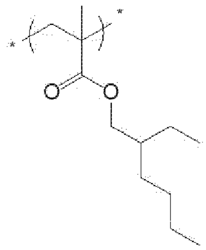

[Table 7]

| Table 2 | Molar ratio of repeating unit | | | | Mw | Pd (Mw/Mn) |
|---|---|---|---|---|---|---|
| Resin E-1 | 90 | 5 | 5 | - | 11000 | 1.55 |

<Solvent>

The following components were used as a solvent.

F-1: Propylene glycol monomethyl ether acetate (PGMEA)
F-2: Propylene glycol monomethyl ether (PGME)
F-3: γ-Butyrolactone
F-4: Ethyl lactate
F-5: Cyclohexanone
F-6: 2-Heptanone

<Preparation of resist composition (resist compositions for regression analysis)>

Respective components shown in Tables 3-1 to 3-6 were mixed such that a concentration of solid contents was 2% by mass. Next, the obtained mixed solution was filtered through firstly a polyethylene-made filter having a pore diameter of 50 nm, a nylon-made filter having a pore diameter of 10 nm, and lastly a polyethylene-made filter having a pore diameter of 5 nm in this order to prepare a resist composition.

As will be described later, resist compositions Re-1 to Re-17, Re-19 to Re-35, Re-37 to Re-57, Re-59 to Re-77, Re-79 to Re-93, and Re-95 to Re-119 were used as a resist compositions for a regression analysis.

In Tables 3-1 to 3-6, the content (% by mass) of each component other than the solvent means a content with respect to the total solid content. In addition, a mixing ratio in the column of "Solvent" indicates a mass ratio of each solvent.

[Table 8]

| Table 3-1 | Acid-decomposable resin | | Photoacid generator | | Acid diffusion control agent | | Solvent | |
|---|---|---|---|---|---|---|---|---|
| | Type | Content (% by mass) | Type | Content (% by mass) | Type | Content (% by mass) | Type | Mixed ratio |
| Re-1 | A-1 | 85.5 | B-1 | 11.0 | C-1 | 3.5 | F-1/F-2 | 80/20 |
| Re-2 | A-2 | 85.6 | B-1 | 11.0 | C-1 | 3.4 | F-1/F-2 | 80/20 |
| Re-3 | A-3 | 85.4 | B-1 | 11.0 | C-1 | 3.6 | F-1/F-2 | 80/20 |
| Re-4 | A-4 | 85.7 | B-1 | 11.0 | C-1 | 3.3 | F-1/F-2 | 80/20 |
| Re-5 | A-5 | 85.5 | B-1 | 11.0 | C-1 | 3.5 | F-1/F-2 | 80/20 |
| Re-6 | A-6 | 85.3 | B-1 | 11.0 | C-1 | 3.7 | F-1/F-2 | 80/20 |

(continued)

| Table 3-1 | Acid-decomposable resin | | Photoacid generator | | Acid diffusion control agent | | Solvent | |
|---|---|---|---|---|---|---|---|---|
| | Type | Content (% by mass) | Type | Content (% by mass) | Type | Content (% by mass) | Type | Mixed ratio |
| Re-7 | A-7 | 85.2 | B-1 | 11.0 | C-1 | 3.8 | F-1/F-2 | 80/20 |
| Re-8 | A-8 | 86.0 | B-1 | 11.0 | C-1 | 3.0 | F-1/F-2 | 80/20 |
| Re-9 | A-9 | 85.0 | B-1 | 11.0 | C-1 | 4.0 | F-1/F-2 | 80/20 |
| Re-10 | A-10 | 85.4 | B-1 | 11.0 | C-1 | 3.6 | F-1/F-2 | 80/20 |
| Re-11 | A-11 | 84.9 | B-1 | 11.0 | C-1 | 4.1 | F-1/F-2 | 80/20 |
| Re-12 | A-12 | 85.8 | B-1 | 11.0 | C-1 | 3.2 | F-1/F-2 | 80/20 |
| Re-13 | A-13 | 85.3 | B-1 | 11.0 | C-1 | 3.7 | F-1/F-2 | 80/20 |
| Re-14 | A-14 | 85.2 | B-1 | 11.0 | C-1 | 3.8 | F-1/F-2 | 80/20 |
| Re-15 | A-15 | 85.4 | B-1 | 11.0 | C-1 | 3.6 | F-1/F-2 | 80/20 |
| Re-16 | A-16 | 85.9 | B-1 | 11.0 | C-1 | 3.1 | F-1/F-2 | 80/20 |
| Re-17 | A-17 | 85.4 | B-1 | 11.0 | C-1 | 3.6 | F-1/F-2 | 80/20 |

Table 9]

| Table 3-2 | Acid-decomposable resin | | Photoacid generator | | Acid diffusion control agent | | Solvent | |
|---|---|---|---|---|---|---|---|---|
| | Type | Content (% by mass) | Type | Content (% by mass) | Type | Content (% by mass) | Type | Mixed ratio |
| Re-19 | A-19 | 78.5 | B-2 | 21.5 | - | - | F-1/F-2 | 40/60 |
| Re-20 | A-20 | 78.2 | B-2 | 21.8 | - | - | F-1/F-2 | 40/60 |
| Re-21 | A-21 | 79.1 | B-2 | 20.9 | - | - | F-1/F-2 | 40/60 |
| Re-22 | A-22 | 78.6 | B-2 | 21.4 | - | - | F-1/F-2 | 40/60 |
| Re-23 | A-23 | 78.5 | B-2 | 21.5 | - | - | F-1/F-2 | 40/60 |
| Re-24 | A-24 | 79.8 | B-2 | 20.2 | - | - | F-1/F-2 | 40/60 |

(continued)

| Table 3-2 | Acid-decomposable resin | | Photoacid generator | | Acid diffusion control agent | | Solvent | |
|---|---|---|---|---|---|---|---|---|
| | Type | Content (% by mass) | Type | Content (% by mass) | Type | Content (% by mass) | Type | Mixed ratio |
| Re-25 | A-25 | 78.0 | B-2 | 22.0 | - | - | F-1/F-2 | 40/60 |
| Re-26 | A-26 | 77.8 | B-2 | 22.2 | - | - | F-1/F-2 | 40/60 |
| Re-27 | A-27 | 80.1 | B-2 | 19.9 | - | - | F-1/F-2 | 40/60 |
| Re-28 | A-28 | 78.2 | B-2 | 21.8 | - | - | F-1/F-2 | 40/60 |
| Re-29 | A-29 | 77.1 | B-2 | 22.9 | - | - | F-1/F-2 | 40/60 |
| Re-30 | A-30 | 79.0 | B-2 | 21.0 | - | - | F-1/F-2 | 40/60 |
| Re-31 | A-31 | 78.3 | B-2 | 21.7 | - | - | F-1/F-2 | 40/60 |
| Re-32 | A-32 | 79.3 | B-2 | 20.7 | - | - | F-1/F-2 | 40/60 |
| Re-33 | A-33 | 78.6 | B-2 | 21.4 | - | - | F-1/F-2 | 40/60 |
| Re-34 | A-34 | 77.7 | B-2 | 22.3 | - | - | F-1/F-2 | 40/60 |
| Re-35 | A-35 | 77.6 | B-2 | 22.4 | - | - | F-1/F-2 | 40/60 |

[Table 10]

| Table 3-3 | Acid-decomposable resin | | Photoacid generator | | Acid diffusion control agent | | Hydrophobic resin | | Solvent | |
|---|---|---|---|---|---|---|---|---|---|---|
| | Type | Content (% by mass) | Type | Content (% by mass) | Type | Content (% by mass) | Typ e | Content (% by mass) | Type | Mixed ratio |
| Re-37 | A-37 | 76.2 | B-3 | 16.8 | C-1 | 1.0 | E-1 | 6.0 | F-1/F-3/ F-4 | 80/10/10 |
| Re-38 | A-38 | 76.6 | B-3 | 16.8 | C-1 | 0.6 | E-1 | 6.0 | F-1/F-3/ F-4 | 80/10/10 |
| Re-39 | A-39 | 75.8 | B-3 | 16.8 | C-1 | 1.4 | E-1 | 6.0 | F-1/F-3/F-4 | 80/10/10 |
| Re-40 | A-40 | 75.2 | B-3 | 16.8 | C-1 | 2.0 | E-1 | 6.0 | F-1/F-3/ F-4 | 80/10/10 |

(continued)

| Table 3-3 | Acid-decomposable resin | | Photoacid generator | | Acid diffusion control agent | | Hydrophobic resin | | Solvent | |
|---|---|---|---|---|---|---|---|---|---|---|
| | Type | Content (% by mass) | Type | Content (% by mass) | Type | Content (% by mass) | Typ e | Content (% by mass) | Type | Mixed ratio |
| Re-41 | A-41 | 76.0 | B-3 | 16.8 | C-1 | 1.2 | E-1 | 6.0 | F-1/F-3/ F-4 | 80/10/10 |
| Re-42 | A-42 | 76.4 | B-3 | 16.8 | C-1 | 0.8 | E-1 | 6.0 | F-1/F-3/ F-4 | 80/10/10 |
| Re-43 | A-43 | 76.8 | B-3 | 16.8 | C-1 | 0.4 | E-1 | 6.0 | F-1/F-3/ F-4 | 80/10/10 |
| Re-44 | A-44 | 75.0 | B-3 | 16.8 | C-1 | 2.2 | E-1 | 6.0 | F-1/F-3/ F-4 | 80/10/10 |
| Re-45 | A-45 | 75.6 | B-3 | 16.8 | C-1 | 1.6 | E-1 | 6.0 | F-1/F-3/ F-4 | 80/10/10 |
| Re-46 | A-46 | 75.7 | B-3 | 16.8 | C-1 | 1.5 | E-1 | 6.0 | F-1/F-3/ F-4 | 80/10/10 |
| Re-47 | A-47 | 76.1 | B-3 | 16.8 | C-1 | 1.1 | E-1 | 6.0 | F-1/F-3/F-4 | 80/10/10 |
| Re-48 | A-48 | 76.0 | B-3 | 16.8 | C-1 | 1.2 | E-1 | 6.0 | F-1/F-3/ F-4 | 80/10/10 |
| Re-49 | A-49 | 75.3 | B-3 | 16.8 | C-1 | 1.9 | E-1 | 6.0 | F-1/F-3/F-4 | 80/10/10 |
| Re-50 | A-50 | 75.5 | B-3 | 16.8 | C-1 | 1.7 | E-1 | 6.0 | F-1/F-3/ F-4 | 80/10/10 |
| Re-51 | A-51 | 75.1 | B-3 | 16.8 | C-1 | 2.1 | E-1 | 6.0 | F-1/F-3/ F-4 | 80/10/10 |
| Re-52 | A-52 | 76.0 | B-3 | 16.8 | C-1 | 1.2 | E-1 | 6.0 | F-1/F-3/F-4 | 80/10/10 |
| Re-53 | A-53 | 76.4 | B-3 | 16.8 | C-1 | 0.8 | E-1 | 6.0 | F-4 | 80/10/10 |
| Re-54 | A-54 | 76.2 | B-3 | 16.8 | C-1 | 1.0 | E-1 | 6.0 | F-1/F-3/ F-4 | 80/10/10 |
| Re-55 | A-55 | 76.1 | B-3 | 16.8 | C-1 | 1.1 | E-1 | 6.0 | F-1/F-3/ F-4 | 80/10/10 |

(continued)

| Table 3-3 | Acid-decomposable resin | | Photoacid generator | | Acid diffusion control agent | | Hydrophobic resin | | Solvent | |
|---|---|---|---|---|---|---|---|---|---|---|
| | Type | Content (% by mass) | Type | Content (% by mass) | Type | Content (% by mass) | Typ e | Content (% by mass) | Type | Mixed ratio |
| Re-56 | A-56 | 75.9 | B-3 | 16.8 | C-1 | 1.3 | E-1 | 6.0 | F-1/F-3/ F-4 | 80/10/10 |
| Re-57 | A-57 | 75.5 | B-3 | 16.8 | C-1 | 1.7 | E-1 | 6.0 | F-1/F-3/ F-4 | 80/10/10 |

Table 11]

| Table 3-4 | Acid-decomposable resin | | Photoacid generator | | Acid diffusion control agent | | Solvent | |
|---|---|---|---|---|---|---|---|---|
| | Type | Content (% by mass) | Type | Content (% by mass) | Type | Content (% by mass) | Type | Mixed ratio |
| Re-59 | A-59 | 81.9 | B-4 | 12.7 | C-2 | 5.4 | F-1/F-5 | 90/10 |
| Re-60 | A-60 | 81.7 | B-4 | 12.7 | C-2 | 5.6 | F-1/F-5 | 90/10 |
| Re-61 | A-61 | 82.5 | B-4 | 12.7 | C-2 | 4.8 | F-1/F-5 | 90/10 |
| Re-62 | A-62 | 82.9 | B-4 | 12.7 | C-2 | 4.4 | F-1/F-5 | 90/10 |
| Re-63 | A-63 | 81.1 | B-4 | 12.7 | C-2 | 6.2 | F-1/F-5 | 90/10 |
| Re-64 | A-64 | 81.8 | B-4 | 12.7 | C-2 | 5.5 | F-1/F-5 | 90/10 |
| Re-65 | A-65 | 83.1 | B-4 | 12.7 | C-2 | 4.2 | F-1/F-5 | 90/10 |
| Re-66 | A-66 | 80.9 | B-4 | 12.7 | C-2 | 6.4 | F-1/F-5 | 90/10 |
| Re-67 | A-67 | 81.3 | B-4 | 12.7 | C-2 | 6 | F-1/F-5 | 90/10 |
| Re-68 | A-68 | 82.0 | B-4 | 12.7 | C-2 | 5.3 | F-1/F-5 | 90/10 |
| Re-69 | A-69 | 82.4 | B-4 | 12.7 | C-2 | 4.9 | F-1/F-5 | 90/10 |
| Re-70 | A-70 | 82.3 | B-4 | 12.7 | C-2 | 5 | F-1/F-5 | 90/10 |
| Re-71 | A-71 | 82.1 | B-4 | 12.7 | C-2 | 5.2 | F-1/F-5 | 90/10 |
| Re-72 | A-72 | 83.3 | B-4 | 12.7 | C-2 | 4 | F-1/F-5 | 90/10 |

(continued)

| Table 3-4 | Acid-decomposable resin | | Photoacid generator | | Acid diffusion control agent | | Solvent | |
|---|---|---|---|---|---|---|---|---|
| | Type | Content (% by mass) | Type | Content (% by mass) | Type | Content (% by mass) | Type | Mixed ratio |
| Re-73 | A-73 | 81.0 | B-4 | 12.7 | C-2 | 6.3 | F-1/F-5 | 90/10 |
| Re-74 | A-74 | 83.0 | B-4 | 12.7 | C-2 | 4.3 | F-1/F-5 | 90/10 |
| Re-75 | A-75 | 82.2 | B-4 | 12.7 | C-2 | 5.1 | F-1/F-5 | 90/10 |

[Table 12]

| Table 3-5 | Acid-decomposable resin | | Photoacid generator | | Acid diffusion control agent | | Solvent | |
|---|---|---|---|---|---|---|---|---|
| | Type | Content (% by mass) | Type | Content (% by mass) | Type | Content (% by mass) | Type | Mixed ratio |
| Re-77 | A-77 | 76.8 | B-5 | 18.6 | C-3 | 4.6 | F-1/F-2 | 20/80 |
| Re-78 | A-78 | 75.3 | B-5 | 20.1 | C-3 | 4.6 | F-1/F-2 | 20/80 |
| Re-79 | A-79 | 77.4 | B-5 | 18.0 | C-3 | 4.6 | F-1/F-2 | 20/80 |
| Re-80 | A-80 | 75.9 | B-5 | 19.5 | C-3 | 4.6 | F-1/F-2 | 20/80 |
| Re-81 | A-81 | 74.0 | B-5 | 21.4 | C-3 | 4.6 | F-1/F-2 | 20/80 |
| Re-82 | A-82 | 75.6 | B-5 | 19.8 | C-3 | 4.6 | F-1/F-2 | 20/80 |
| Re-83 | A-83 | 77.0 | B-5 | 18.4 | C-3 | 4.6 | F-1/F-2 | 20/80 |
| Re-84 | A-84 | 77.4 | B-5 | 18.0 | C-3 | 4.6 | F-1/F-2 | 20/80 |
| Re-85 | A-85 | 77.6 | B-5 | 17.8 | C-3 | 4.6 | F-1/F-2 | 20/80 |
| Re-86 | A-86 | 76.4 | B-5 | 19.0 | C-3 | 4.6 | F-1/F-2 | 20/80 |
| Re-87 | A-87 | 77.4 | B-5 | 18.0 | C-3 | 4.6 | F-1/F-2 | 20/80 |
| Re-88 | A-88 | 75.0 | B-5 | 20.4 | C-3 | 4.6 | F-1/F-2 | 20/80 |
| Re-89 | A-89 | 75.4 | B-5 | 20.0 | C-3 | 4.6 | F-1/F-2 | 20/80 |
| Re-90 | A-90 | 74.7 | B-5 | 20.7 | C-3 | 4.6 | F-1/F-2 | 20/80 |

(continued)

| Table 3-5 | Acid-decomposable resin | | Photoacid generator | | Acid diffusion control agent | | Solvent | |
|---|---|---|---|---|---|---|---|---|
| | Type | Content (% by mass) | Type | Content (% by mass) | Type | Content (% by mass) | Type | Mixed ratio |
| Re-91 | A-91 | 76.6 | B-5 | 18.8 | C-3 | 4.6 | F-1/F-2 | 20/80 |
| Re-92 | A-92 | 76.2 | B-5 | 19.2 | C-3 | 4.6 | F-1/F-2 | 20/80 |
| Re-93 | A-93 | 76.3 | B-5 | 19.1 | C-3 | 4.6 | F-1/F-2 | 20/80 |

[Table 13]

| Table 3-6 | Acid-decomposable resin | | Photoacid generator | | Acid diffusion control agent | | Solvent | |
|---|---|---|---|---|---|---|---|---|
| | Type | Content (% by mass) | Type | Content (% by mass) | Type | Content (% by mass | Type | Mixed ratio |
| Re-95 | A-95 | 77.9 | B-6 | 19.4 | C-4 | 2.7 | F-1/F-2/F-6/F-3 | 85/7/7/1 |
| Re-96 | A-96 | 78.0 | B-6 | 19.4 | C-4 | 2.6 | F-1/F-2/F-6/F-3 | 85/7/7/1 |
| Re-97 | A-97 | 78.1 | B-6 | 19.4 | C-4 | 2.5 | F-1/F-2/F-6/F-3 | 85/7/7/1 |
| Re-98 | A-98 | 78.2 | B-6 | 19.4 | C-4 | 2.4 | F-1/F-2/F-6/F-3 | 85/7/7/1 |
| Re-99 | A-99 | 77.0 | B-6 | 19.4 | C-4 | 3.6 | F-1/F-2/F-6/F-3 | 85/7/7/1 |
| Re-100 | A-100 | 78.7 | B-6 | 19.4 | C-4 | 1.9 | F-1/F-2/F-6/F-3 | 85/7/7/1 |
| Re-101 | A-101 | 78.2 | B-6 | 19.4 | C-4 | 2.4 | F-1/F-2/F-6/F-3 | 85/7/7/1 |
| Re-102 | A-102 | 78.6 | B-6 | 19.4 | C-4 | 2 | F-1/F-2/F-6/F-3 | 85/7/7/1 |
| Re-103 | A-103 | 77.6 | B-6 | 19.4 | C-4 | 3 | F-1/F-2/F-6/F-3 | 85/7/7/1 |
| Re-104 | A-104 | 77.2 | B-6 | 19.4 | C-4 | 3.4 | F-1/F-2/F-6/F-3 | 85/7/7/1 |
| Re-105 | A-105 | 78.0 | B-6 | 19.4 | C-4 | 2.6 | F-1/F-2/F-6/F-3 | 85/7/7/1 |
| Re-106 | A-106 | 77.2 | B-6 | 19.4 | C-4 | 3.4 | F-1/F-2/F-6/F-3 | 85/7/7/1 |
| Re-107 | A-107 | 77.7 | B-6 | 19.4 | C-4 | 2.9 | F-1/F-2/F-6/F-3 | 85/7/7/1 |
| Re-108 | A-108 | 77.9 | B-6 | 19.4 | C-4 | 2.7 | F-1/F-2/F-6/F-3 | 85/7/7/1 |

(continued)

| Table 3-6 | Acid-decomposable resin | | Photoacid generator | | Acid diffusion control agent | | Solvent | |
|---|---|---|---|---|---|---|---|---|
| | Type | Content (% by mass) | Type | Content (% by mass) | Type | Content (% by mass | Type | Mixed ratio |
| Re-109 | A-109 | 77.8 | B-6 | 19.4 | C-4 | 2.8 | F-1/F-2/F-6/F-3 | 85/7/7/1 |
| Re-110 | A-110 | 77.4 | B-6 | 19.4 | C-4 | 3.2 | F-1/F-2/F-6/F-3 | 85/7/7/1 |
| Re-111 | A-111 | 78.0 | B-6 | 19.4 | C-4 | 2.6 | F-1/F-2/F-6/F-3 | 85/7/7/1 |
| Re-112 | A-112 | 77.9 | B-6 | 19.4 | C-4 | 2.7 | F-1/F-2/F-6/F-3 | 85/7/7/1 |
| Re-113 | A-113 | 77.2 | B-6 | 19.4 | C-4 | 3.4 | F-1/F-2/F-6/F-3 | 85/7/7/1 |
| Re-114 | A-114 | 77.4 | B-6 | 19.4 | C-4 | 3.2 | F-1/F-2/F-6/F-3 | 85/7/7/1 |
| Re-115 | A-115 | 7 7.3 | B-6 | 19.4 | C-4 | 3.3 | F-1/F-2/F-6/F-3 | 85/7/7/1 |
| Re-116 | A-116 | 77.1 | B-6 | 19.4 | C-4 | 3.5 | F-1/F-2/F-6/F-3 | 85/7/7/1 |
| Re-117 | A-117 | 77.6 | B-6 | 19.4 | C-4 | 3 | F-1/F-2/F-6/F-3 | 85/7/7/1 |
| Re-118 | A-118 | 77.8 | B-6 | 19.4 | C-4 | 2.8 | F-1/F-2/F-6/F-3 | 85/7/7/1 |
| Re-119 | A-119 | 78.4 | B-6 | 19.4 | C-4 | 2.2 | F-1/F-2/F-6/F-3 | 85/7/7/1 |

<Acquisition of pattern size for regression analysis>

A composition for forming an underlayer film, AL412 (manufactured by Brewer Science, Inc.), was applied to a silicon wafer and baked at 205°C for 60 seconds to form an underlayer film having a film thickness of 20 nm. Each of the resist compositions Re-1 to Re-17, Re-19 to Re-35, Re-37 to Re-57, Re-59 to Re-77, Re-79 to Re-93, and Re-95 to Re-119, which were the resist compositions for a regression analysis described in Tables 3-1 to 3-6, were applied thereon, and baked at 100°C for 60 seconds to form a resist film having a film thickness of 45 nm.

The silicon wafer having the obtained resist film was subjected to a pattern irradiation (exposure amount: 30 ($mJ/cm^2$)) using an EUV exposure device (manufactured by Exitech Ltd., Micro Exposure Tool, NA 0.3, Quadruple, outer sigma 0.885, inner sigma 0.381). As a reticle, a mask having a line size = 25 nm and a line:space =1:1 was used.

The resist film after the exposure was baked at 120°C for 60 seconds, developed with a tetramethylammonium hydroxide aqueous solution (2.38% by mass) for 30 seconds, and then rinsed with pure water for 30 seconds. Thereafter, the resist film was spin-dried to obtain a pattern for a regression analysis and acquire a pattern size for a regression analysis.

<Example 1>

First, with regard to the pattern size for a regression analysis obtained in <Acquisition of pattern size for regression analysis> using the resist compositions Re-1 to Re-17 which were the resist compositions for a regression analysis, a multiple regression analysis in which the content of the respective repeating units included in the acid-decomposable resin with respect to all repeating units and the content of the acid diffusion control agent with respect to the total solid content mass in the resist composition were used as explanatory variables and a target pattern size (25 nm) was used as an objective variable was carried out. By the multiple regression analysis, a multiple regression

equation represented by the following equation was obtained.

Multiple regression equation: CD (pattern size) = 0.3486 × [Content of unit A (% by mole)] - 0.8767 × [Content of unit B (% by mole)] + 0.4834 × [Content of unit C (% by mole)] + 1.2320 × [Content of acid diffusion control agent (% by mass)] - 2.262

In the above-described equation, the [Content of unit A (% by mole)] represents a content (% by mole) of the leftmost repeating unit in the following structural formula with respect to all repeating units, the [Content of unit B (% by mole)] represents a content (% by mole) of the middle repeating unit in the following structural formula with respect to all repeating units, the [Content of unit C (% by mole)] represents a content (% by mole) of the rightmost repeating unit in the following structural formula with respect to all repeating units, and the [Content of acid diffusion control agent (% by mass)] represents a content (% by mass) of the acid diffusion control agent in the resist composition with respect to the total solid content mass in the resist composition.

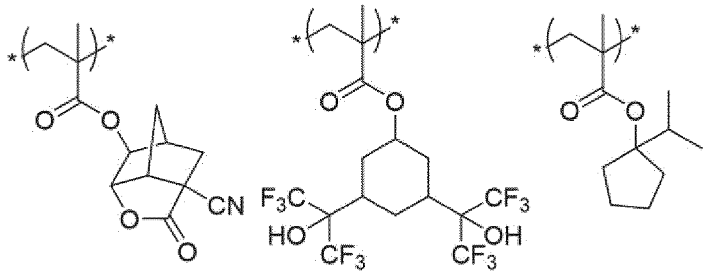

Next, under production conditions planned to produce an acid-decomposable resin in which the respective repeating units shown in the following chemical formulae were included, the contents of the respective repeating units were 26.0% by mole, 16.0% by mole, and 58.0% by mole in order from the left, the weight-average molecular weight was 6500, and the molecular weight distribution (Pd (Mw/Mn)) was 1.58, the acid-decomposable resins was produced a plurality of times, and a plurality of resins A-18 having different lot numbers were prepared.

In the obtained resins A-18 having different lot numbers, due to an error in the actual production conditions, the contents of the respective repeating units, the weight-average molecular weight, the molecular weight distribution, and the like differed from the above-described target values (contents for the respective repeating units: 26.0% by mole, 16.0% by mole, and 58.0% by mole, weight-average molecular weight: 6500, molecular weight distribution: 1.58). That is, the contents of the respective repeating units, the weight-average molecular weight, the molecular weight distribution, and the like in the resin A-18 of each lot number deviated from the target values.

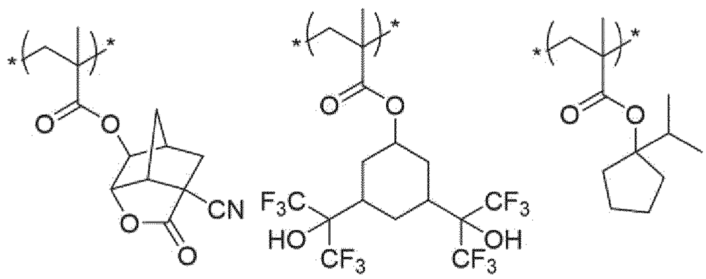

Next, one of the resins A-18 having different lot numbers was selected, and a composition including a predetermined amount of the following components (resist composition Re-18) was used as a target resist composition for determining a formulating amount. The concentration of solid contents of the target resist composition is 2% by mass, the content (% by mass) of each component other than the solvent means a content with respect to the total solid content, and "Solvent F-1/solvent F-2" represents a mixing ratio (mass ratio) of the solvent F-1 and the solvent F-2.

Resin A-18: 85.6% by mass
Photoacid generator B-1: 11.0% by mass
Acid diffusion control agent C-1: 3.4% by mass
Solvent F-1/solvent F-2: 80/20

Next, a content of each repeating unit included in the resin A-18 used for the target resist composition with respect to all repeating units was measured with a measuring method described in <NMR measurement> described later and the number of times of integration of 5000 times, and the content of each repeating unit included in the acid-decomposable resin with respect to all repeating units was calculated.

Next, the content of each repeating unit included in the resin A-18 used for the target resist composition with respect to all repeating units, which was calculated by <NMR measurement> described above, and the content of the acid diffusion control agent C-1 with respect to the total solid content mass in the target resist composition were substituted into the multiple regression equation to calculate a pattern size of the target resist composition.

The obtained pattern size of the target resist composition was compared with the target pattern size (25 nm), and in a case where the absolute value of the difference was more than 0.5 nm, the target resist composition was selected as a target resist composition for composition adjustment.

By repeating the above-described procedure using the resins A-18 having different lot numbers, 10 kinds of target resist compositions for composition adjustment (hereinafter, also simply referred to as a "target resist composition X1") were prepared.

In addition, by repeating the above-described procedure, 10 kinds of target resist compositions in which the absolute value of the difference between the pattern size of the target resist composition and the target pattern size (25 nm) was 0.5 nm or less (hereinafter, also referred to as a "target resist composition Y1") were prepared.

The content of the acid diffusion control agent with respect to the total solid content mass in the target resist composition X1 was changed such that a pattern size of the prepared target resist composition X1 (target resist composition for composition adjustment) was set to the target pattern size (25 nm), thereby determining a formulating amount.

Next, a resist composition was prepared using the resin A-18 of the lot number included in the target resist composition X1 based on the determined formulating amount. Using the resist composition prepared above instead of the resist composition for a regression analysis, the treatments described in <Acquisition of pattern size for regression analysis> above was carried out to form a pattern. Thereafter, in a case where the absolute value of the difference between a line width of the pattern and the target pattern size (25 nm) was within 0.5 nm, it was regarded as "pass", and in a case of being more than 0.5 nm, it was regarded as "fail".

The above-described treatment was carried out on the 10 kinds of the target resist compositions X1 and evaluated according to the following standard.

A: 10 kinds thereof were passed.
B: 8 or 9 kinds thereof were passed.
C: 6 or 7 kinds thereof were passed.
D: 4 or 5 kinds thereof were passed.
E: 2 or 3 kinds thereof were passed.
F: 1 or less kind thereof was passed.

In addition, using the target resist composition Y1 instead of the resist composition for a regression analysis, the treatments described in <Acquisition of pattern size for regression analysis> above was carried out to form a pattern. Thereafter, in a case where the absolute value of the difference between a line width of the pattern and the target pattern size (25 nm) was within 0.5 nm, it was regarded as "pass", and in a case of being more than 0.5 nm, it was regarded as "fail".

The above-described treatment was carried out on the 10 kinds of the target resist compositions Y1 and evaluated according to the following standard.

A: 10 kinds thereof were passed.
B: 8 or 9 kinds thereof were passed.
C: 6 or 7 kinds thereof were passed.
D: 4 or 5 kinds thereof were passed.
E: 2 or 3 kinds thereof were passed.
F: 1 or less kind thereof was passed.

<Example 2>

The evaluation was performed according to the same procedure as in Example 1, except that, as the explanatory variables for performing the multiple regression analysis, the content of each repeating unit included in the acid-decomposable resin with respect to all repeating units, the content of the acid diffusion control agent with respect to the total solid content mass in the resist composition, and the weight-average molecular weight of the acid-decomposable resin were selected, and the content of each repeating unit included in the resin A-18 used for the target resist composition with respect to all repeating units, the content of the acid diffusion control agent C-1 with respect to the total solid content mass in the target resist composition, and the weight-average molecular weight of the resin A-18 were substituted into the multiple regression equation to calculate the pattern size of the target resist composition.

<Example 3>

The evaluation was performed according to the same procedure as in Example 2, except that the number of times of integration of the NMR measurement in a case of measuring the content of each repeating unit included in the resin A-18 with respect to all repeating units was changed from 5000 times to 10000 times.

<Example 4>

The evaluation was performed according to the same procedure as in Example 2, except that the number of times of integration of the NMR measurement in a case of measuring the content of each repeating unit included in the resin A-18 with respect to all repeating units was changed from 5000 times to 20000 times.

<Example 5>

The evaluation was performed according to the same procedure as in Example 1, except that, as the explanatory variables for performing the multiple regression analysis, the content of each repeating unit included in the acid-decomposable resin with respect to all repeating units, the content of the acid diffusion control agent with respect to the total solid content mass in the resist composition, the weight-average molecular weight of the acid-decomposable resin, and the content of the acid-decomposable resin with respect to the total solid content mass in the resist composition were selected, and the content of each repeating unit included in the resin A-18 used for the target resist composition with respect to all repeating units, the content of the acid diffusion control agent C-1 with respect to the total solid content mass in the target resist composition, the weight-average molecular weight of the resin A-18, and the content of the resin A-18 with respect to the total solid content mass in the target resist composition were substituted into the multiple regression equation to calculate the pattern size of the target resist composition.

<Example 6>

The evaluation was performed according to the same procedure as in Example 1, except that, as the explanatory variables for performing the multiple regression analysis, the content of each repeating unit included in the acid-decomposable resin with respect to all repeating units, the content of the acid diffusion control agent with respect to the total solid content mass in the resist composition, the weight-average molecular weight of the acid-decomposable resin, the content of the acid-decomposable resin with respect to the total solid content mass in the resist composition, and the refractive index of the acid-decomposable resin were selected, and the content of each repeating unit included in the resin A-18 used for the target resist composition with respect to all repeating units, the content of the acid diffusion control agent C-1 with respect to the total solid content mass in the target resist composition, the weight-average molecular weight of the resin A-18, the content of the resin A-18 with respect to the total solid content mass in the target resist composition, and the refractive index of the resin A-18 were substituted into the multiple regression equation to calculate the pattern size of the target resist composition.

<Example 7>

The evaluation was performed according to the same procedure as in Example 1, except that, as the explanatory variables for performing the multiple regression analysis, the content of each repeating unit included in the acid-decomposable resin with respect to all repeating units, the content of the acid diffusion control agent with respect to the total solid content mass in the resist composition, the weight-average molecular weight of the acid-decomposable resin, the content of the acid-decomposable resin with respect to the total solid content mass in the resist composition, the refractive index of the acid-decomposable resin, and the content of the photoacid generator with respect to the total solid content mass in the resist composition were selected, and the content of each repeating unit included in the resin A-18 used for the target resist composition with respect to all repeating units, the content of the acid diffusion control agent C-1 with respect to the total solid content mass in the target resist composition, the weight-average molecular weight of the resin A-18, the content of the resin A-18 with respect to the total solid content mass in the target resist composition, the refractive index of the resin A-18, and the content of the photoacid generator B-1 with respect to the total solid content mass in the target resist composition were substituted into the multiple regression equation to calculate the pattern size of the target resist composition.

<Example 8>

The evaluation was performed according to the same procedure as in Example 7, except that the number of

times of integration of the NMR measurement in a case of measuring the content of each repeating unit included in the resin A-18 used for the target resist composition with respect to all repeating units was changed from 5000 times to 20000 times.

<Comparative Example 1>

The evaluation was performed according to the same procedure as in Example 1, except that, as the explanatory variables for performing the multiple regression analysis, the only content of each repeating unit included in the acid-decomposable resin with respect to all repeating units was selected, the content of each repeating unit included in the resin A-18 used for the target resist composition with respect to all repeating units was substituted into the multiple regression equation to calculate the pattern size of the target resist composition, a ratio of the pattern size to the target pattern size (pattern size/target pattern size) (for example, 1.1) was obtained, and the amount of the acid diffusion control agent C-1 was adjusted so as to be a value obtained by multiplying the content of the acid diffusion control agent in the target resist composition by the ratio.

<NMR spectroscopy>

A nuclear magnetic resonance ($^1$H NMR) spectroscopy of the acid-decomposable resin was performed under the following conditions.

Equipment: NMR device AVANCE III HD500 manufactured by Bruker Corporation
Probe: 10 mmBBO
Measurement method: 13C inverse gate mode
Measurement temperature: 25°C
Sample preparation: the acid-decomposable resin was dissolved in a solvent described later and transferred to a Φ 10 mm NMR sample tube.
Acid-decomposable resin: 1200 mg
Solvent: acetone-d6 (2.4 mL) with 10 mM iron(III) acetylacetone complex added
The number of times of integration was changed in each of Examples as shown in Table 4 described later.

<GPC measurement>

The weight-average molecular weight (Mw) of the resin was measured under the following conditions.

Equipment: HLC-8220GPC manufactured by Tosoh Corporation
Pump part: 40°C
Column part: 40°C
Flow rate (column line, reference line): 1.0 mL/min, 0.33 mL/min
Detection: differential refractometry (RI) detector
Column: 3 connected pieces of TSKgel Multipore HXL-M manufactured by Tosoh Corporation
Eluent: tetrahydrofuran (containing stabilizer)
Injection amount: 10 μL
Sample concentration: 5% by mass
Calibration standard sample: polystyrene

<Measurement of refractive index of acid-decomposable resin>

First, the acid-decomposable resin was dissolved in PGMEA to prepare a PGMEA solution having a concentration of the acid-decomposable resin of 10% by mass. Using 1 mL of the obtained PGMEA solution, the refractive index of the acid-decomposable resin was determined with an automatic refractometer (Abbemat 550 (manufactured by Anton Paar GmbH)). The measurement temperature was set to 20°C.

The "content of the acid-decomposable resin with respect to the total solid content mass in the resist composition", "content of the acid diffusion control agent with respect to the total solid content mass in the resist composition", and "content of the photoacid generator with respect to the total solid content mass in the resist composition", which are described in Examples, were obtained from the amount charged in each resist composition.

The results of Examples 1 to 8 and Comparative Example 1 are summarized in Table 4-1.

In Table 4-1, "Resin compositional ratio" means the "content of each repeating unit included in the acid-decomposable resin with respect to all repeating units", "Amount of acid diffusion control agent" means the "content of the

acid diffusion control agent with respect to the total solid content mass in the resist composition", "Resin Mw" means the "weight-average molecular weight of the acid-decomposable resin", "Amount of resin" means the "content of the acid-decomposable resin with respect to the total solid content mass in the resist composition", "Refractive index of resin" means the "refractive index of the acid-decomposable resin", and "PAG amount" means the "content of the photoacid generator with respect to the total solid content mass in the resist composition".

In each parameter, one used for the multiple regression analysis is indicated as "Implementation".

In Table 4-1, "Evaluation X" is the evaluation result in a case where the 10 kinds of target resist compositions X1 were used, and "Evaluation Y" is the evaluation result in a case where the 10 kinds of target resist compositions Y1 were used.

[Table 14]

| Table 4-1 | Resist composition | Parameter | | | | | | Number of times of integration in NMR measurement | Evaluation x | Evaluation Y |
|---|---|---|---|---|---|---|---|---|---|---|
| | | Resin compositional ratio | Amount of acid diffusion control agent | Resin Mw | Amount of resin | Refractive index of resin | PAG amount | | | |
| Example 1 | Re-18 | Implementation | Implementation | - | - | - | - | 5000 | E | E |
| Example 2 | Re-18 | Implementation | Implementation | Implementation | - | - | - | 5000 | D | D |
| Example 3 | Re-18 | Implementation | Implementation | Implementation | - | - | - | 10000 | C | C |
| Example 4 | Re-18 | Implementation | Implementation | Implementation | - | - | - | 20000 | A | A |
| Example 5 | Re-18 | Implementation | Implementation | Implementation | Implementation | - | - | 5000 | C | C |
| Example 6 | Re-18 | Implementation | Implementation | Implementation | Implementation | Implementation | - | 5000 | B | B |
| Example 7 | Re-18 | Implementation | Implementation | Implementation | Implementation | Implementation | Implementation | 5000 | B | B |
| Example 8 | Re-18 | Implementation | Implementation | Implementation | Implementation | Implementation | Implementation | 20000 | A | A |
| Comparative Example 1 | Re-18 | Implementation | - | - | - | - | - | 5000 | F | F |

As shown in Table 4-1, it was confirmed that the desired effect can be obtained by the method for producing a resist composition according to the embodiment of the present invention.

Among these, from the comparison of Examples 2 to 4, it was confirmed that, in a case where the number of times of integration was 10000 times or more (preferably, 20000 times or more), the effect was more excellent.

In addition, from the comparison of Examples 1 to 8, it was confirmed that, in a case where the number of parameters was 3 or more (preferably 4 or more and more preferably 5 or more), the effect was more excellent.

In the above, whether or not the absolute value of the difference between the pattern size of the target resist composition and the target pattern size (25 nm) was 0.5 nm or more was determined as an allowable range, but even in a case where the absolute value of the difference was smaller (for example, 0.1 nm or less), same as Examples 1 to 8 above, more excellent effect was obtained as the number of parameters increased.

<Example 9>

First, with regard to the pattern size for a regression analysis obtained in <Acquisition of pattern size for regression analysis> using the resist compositions Re-19 to Re-35 which were the resist compositions for a regression analysis, a multiple regression analysis in which the content of the respective repeating units included in the acid-decomposable resin with respect to all repeating units and the content of the photoacid generator with respect to the total solid content mass in the resist composition were used as explanatory variables and a target pattern size (25 nm) was used as an objective variable was carried out.

Next, under production conditions planned to produce an acid-decomposable resin in which the respective repeating units shown in the following chemical formulae were included, the contents of the respective repeating units were 41.5% by mole, 11.5% by mole, and 47.0% by mole in order from the left, the weight-average molecular weight was 7200, and the molecular weight distribution (Pd (Mw/Mn)) was 1.60, the acid-decomposable resins was produced a plurality of times, and a plurality of resins A-36 having different lot numbers were prepared.

In the obtained resins A-36 having different lot numbers, due to an error in the actual production conditions, the contents of the respective repeating units, the weight-average molecular weight, the molecular weight distribution, and the like differed from the above-described target values (contents for the respective repeating units: 41.5% by mole, 11.5% by mole, and 47.0% by mole, weight-average molecular weight: 7200, molecular weight distribution: 1.60). That is, the contents of the respective repeating units, the weight-average molecular weight, the molecular weight distribution, and the like in the resin A-36 of each lot number deviated from the target values.

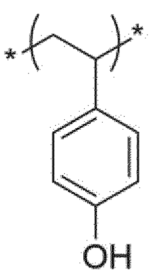
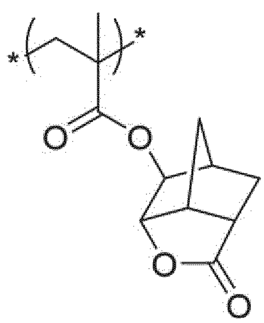
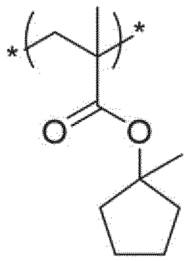

Next, one of the resins A-36 having different lot numbers was selected, and a composition including a predetermined amount of the following components (resist composition Re-36) was used as a target resist composition for determining a formulating amount. The concentration of solid contents of the target resist composition is 2% by mass, the content (% by mass) of each component other than the solvent means a content with respect to the total solid content, and "Solvent F-1/solvent F-2" represents a mixing ratio (mass ratio) of the solvent F-1 and the solvent F-2.

Resin A-36: 78.3% by mass
Photoacid generator B-2: 21.7% by mass
Solvent F-1/solvent F-2: 40/60

Next, a content of each repeating unit included in the resin A-36 used for the target resist composition with respect to all repeating units was measured with a measuring method described in <NMR measurement> described later and the number of times of integration of 5000 times, and the content of each repeating unit included in the acid-decomposable resin with respect to all repeating units was calculated.

Next, the content of each repeating unit included in the resin A-36 used for the target resist composition with

respect to all repeating units, which was calculated by <NMR measurement> described above, and the content of the photoacid generator B-2 with respect to the total solid content mass in the target resist composition were substituted into the multiple regression equation to calculate a pattern size of the target resist composition.

The obtained pattern size of the target resist composition was compared with the target pattern size (25 nm), and in a case where the absolute value of the difference was more than 0.5 nm, the target resist composition was selected as a target resist composition for composition adjustment.

By repeating the above-described procedure using the resins A-36 having different lot numbers, 10 kinds of target resist compositions for composition adjustment (hereinafter, also simply referred to as a "target resist composition X2") were prepared.

In addition, by repeating the above-described procedure, 10 kinds of target resist compositions in which the absolute value of the difference between the pattern size of the target resist composition and the target pattern size (25 nm) was 0.5 nm or less (hereinafter, also referred to as a "target resist composition Y2") were prepared.

The content of the photoacid generator with respect to the total solid content mass in the target resist composition X2 was changed such that a pattern size of the prepared target resist composition X2 (target resist composition for composition adjustment) was set to the target pattern size (25 nm), thereby determining a formulating amount.

Next, a resist composition was prepared using the resin A-36 of the lot number included in the target resist composition X2 based on the determined formulating amount. Using the resist composition prepared above instead of the resist composition for a regression analysis, the treatments described in <Acquisition of pattern size for regression analysis> above was carried out to form a pattern. Thereafter, in a case where the absolute value of the difference between a line width of the pattern and the target pattern size (25 nm) was within 0.5 nm, it was regarded as "pass", and in a case of being more than 0.5 nm, it was regarded as "fail".

The above-described treatment was carried out on the 10 kinds of the target resist compositions X2 and evaluated according to the following standard.

A: 10 kinds thereof were passed.
B: 8 or 9 kinds thereof were passed.
C: 6 or 7 kinds thereof were passed.
D: 4 or 5 kinds thereof were passed.
E: 2 or 3 kinds thereof were passed.
F: 1 or less kind thereof was passed.

In addition, using the target resist composition Y2 instead of the resist composition for a regression analysis, the treatments described in <Acquisition of pattern size for regression analysis> above was carried out to form a pattern. Thereafter, in a case where the absolute value of the difference between a line width of the pattern and the target pattern size (25 nm) was within 0.5 nm, it was regarded as "pass", and in a case of being more than 0.5 nm, it was regarded as "fail".

The above-described treatment was carried out on the 10 kinds of the target resist compositions Y2 and evaluated according to the following standard.

A: 10 kinds thereof were passed.
B: 8 or 9 kinds thereof were passed.
C: 6 or 7 kinds thereof were passed.
D: 4 or 5 kinds thereof were passed.
E: 2 or 3 kinds thereof were passed.
F: 1 or less kind thereof was passed.

<Example 10>

The evaluation was performed according to the same procedure as in Example 9, except that, as the explanatory variables for performing the multiple regression analysis, the content of each repeating unit included in the acid-decomposable resin with respect to all repeating units, the content of the photoacid generator with respect to the total solid content mass in the resist composition, and the weight-average molecular weight of the acid-decomposable resin were selected, and the content of each repeating unit included in the resin A-36 used for the target resist composition with respect to all repeating units, the content of the photoacid generator B-2 with respect to the total solid content mass in the target resist composition, and the weight-average molecular weight of the resin A-36 were substituted into the multiple regression equation to calculate the pattern size of the target resist composition.

<Example 11>

The evaluation was performed according to the same procedure as in Example 10, except that the number of times of integration of the NMR measurement in a case of measuring the content of each repeating unit included in the resin A-36 with respect to all repeating units was changed from 5000 times to 10000 times.

<Example 12>

The evaluation was performed according to the same procedure as in Example 10, except that the number of times of integration of the NMR measurement in a case of measuring the content of each repeating unit included in the resin A-36 with respect to all repeating units was changed from 5000 times to 20000 times.

<Example 13>

The evaluation was performed according to the same procedure as in Example 9, except that, as the explanatory variables for performing the multiple regression analysis, the content of each repeating unit included in the acid-decomposable resin with respect to all repeating units, the content of the photoacid generator with respect to the total solid content mass in the resist composition, the weight-average molecular weight of the acid-decomposable resin, and the content of the acid-decomposable resin with respect to the total solid content mass in the resist composition were selected, and the content of each repeating unit included in the resin A-36 used for the target resist composition with respect to all repeating units, the content of the photoacid generator B-2 with respect to the total solid content mass in the target resist composition, the weight-average molecular weight of the resin A-36, and the content of the resin A-36 with respect to the total solid content mass in the target resist composition were substituted into the multiple regression equation to calculate the pattern size of the target resist composition.

<Example 14>

The evaluation was performed according to the same procedure as in Example 9, except that, as the explanatory variables for performing the multiple regression analysis, the content of each repeating unit included in the acid-decomposable resin with respect to all repeating units, the content of the photoacid generator with respect to the total solid content mass in the resist composition, the weight-average molecular weight of the acid-decomposable resin, the content of the acid-decomposable resin with respect to the total solid content mass in the resist composition, and the refractive index of the acid-decomposable resin were selected, and the content of each repeating unit included in the resin A-36 used for the target resist composition with respect to all repeating units, the content of the photoacid generator B-2 with respect to the total solid content mass in the target resist composition, the weight-average molecular weight of the resin A-36, the content of the resin A-36 with respect to the total solid content mass in the target resist composition, and the refractive index of the resin A-36 were substituted into the multiple regression equation to calculate the pattern size of the target resist composition.

<Comparative Example 2>

The evaluation was performed according to the same procedure as in Example 9, except that, as the explanatory variables for performing the multiple regression analysis, the only content of each repeating unit included in the acid-decomposable resin with respect to all repeating units was selected, the content of each repeating unit included in the resin A-36 used for the target resist composition with respect to all repeating units was substituted into the multiple regression equation to calculate the pattern size of the target resist composition, a ratio of the pattern size to the target pattern size (pattern size/target pattern size) (for example, 1.1) was obtained, and the amount of the photoacid generator B-2 was adjusted so as to be a value obtained by multiplying the content of the photoacid generator in the target resist composition by the ratio.

The refractive index of the acid-decomposable resin was measured by <Measurement of refractive index of acid-decomposable resin> described above.

In addition, the "content of the acid-decomposable resin with respect to the total solid content mass in the resist composition" and "content of the photoacid generator with respect to the total solid content mass in the resist composition", which are described in Examples, were obtained from the amount charged in each resist composition.

The results of Examples 9 to 14 and Comparative Example 2 are summarized in Table 4-2.

In Table 4-2, "Resin compositional ratio" means the "content of each repeating unit included in the acid-decomposable resin with respect to all repeating units", "PAG amount" means the "content of the photoacid generator with respect to the total solid content mass in the resist composition", "Resin Mw" means the "weight-average molecular

weight of the acid-decomposable resin", "Amount of resin" means the "content of the acid-decomposable resin with respect to the total solid content mass in the resist composition", and "Refractive index of resin" means the "refractive index of the acid-decomposable resin".

In each parameter, one used for the multiple regression analysis is indicated as "Implementation".

In Table 4-2, "Evaluation X" is the evaluation result in a case where the 10 kinds of target resist compositions X2 were used, and "Evaluation Y" is the evaluation result in a case where the 10 kinds of target resist compositions Y2 were used.

[Table 15]

| Table 4-2 | Resist composition | Parameter | | | | | Number of times of integration in NMR measurement | Evaluation X | Evaluation Y |
|---|---|---|---|---|---|---|---|---|---|
| | | Resin compositional ratio | PAG amount | Resin Mw | Amount of resin | Refractive index of resin | | | |
| Example 9 | Re-36 | Implementation | Implementation | - | - | - | 5000 | E | E |
| Example 10 | Re-36 | Implementation | Implementation | Implementation | - | - | 5000 | D | D |
| Example 11 | Re-36 | Implementation | Implementation | Implementation | - | - | 10000 | C | C |
| Example 12 | Re-36 | Implementation | Implementation | Implementation | - | - | 20000 | A | A |
| Example 13 | Re-36 | Implementation | Implementation | Implementation | Implementation | - | 5000 | C | C |
| Example 14 | Re-36 | Implementation | Implementation | Implementation | Implementation | Implementation | 5000 | B | B |
| Comparative Example 2 | Re-36 | Implementation | - | - | - | - | 5000 | F | F |

As shown in Table 4-2, it was confirmed that the desired effect can be obtained by the method for producing a resist composition according to the embodiment of the present invention.

<Example 15>

First, with regard to the pattern size for a regression analysis obtained in <Acquisition of pattern size for regression analysis> using the resist compositions Re-37 to Re-57 which were the resist compositions for a regression analysis, a multiple regression analysis in which the content of the respective repeating units included in the acid-decomposable resin with respect to all repeating units and the content of the acid diffusion control agent with respect to the total solid content mass in the resist composition were used as explanatory variables and a target pattern size (25 nm) was used as an objective variable was carried out.

Next, under production conditions planned to produce an acid-decomposable resin in which the respective repeating units shown in the following chemical formulae were included, the contents of the respective repeating units were 31.2% by mole, 28.9% by mole, 29.6% by mole, and 10.3% by mole in order from the left, the weight-average molecular weight was 8200, and the molecular weight distribution (Pd (Mw/Mn)) was 1.65, the acid-decomposable resins was produced a plurality of times, and a plurality of resins A-58 having different lot numbers were prepared.

In the obtained resins A-58 having different lot numbers, due to an error in the actual production conditions, the contents of the respective repeating units, the weight-average molecular weight, the molecular weight distribution, and the like differed from the above-described target values (contents for the respective repeating units: 31.2% by mole, 28.9% by mole, 29.6% by mole, and 10.3% by mole, weight-average molecular weight: 8200, molecular weight distribution: 1.65). That is, the contents of the respective repeating units, the weight-average molecular weight, the molecular weight distribution, and the like in the resin A-58 of each lot number deviated from the target values.

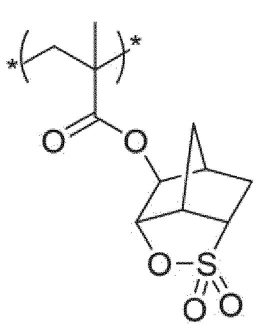
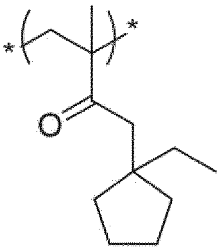
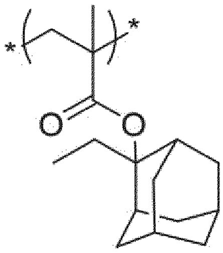
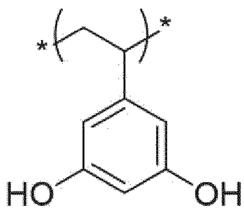

Next, one of the resins A-58 having different lot numbers was selected, and a composition including a predetermined amount of the following components (resist composition Re-58) was used as a target resist composition for determining a formulating amount. The concentration of solid contents of the target resist composition is 2% by mass, the content (% by mass) of each component other than the solvent means a content with respect to the total solid content, and "Solvent F-1/solvent F-3/solvent F-4" represents a mixing ratio (mass ratio) of the solvent F-1, the solvent F-3, and the solvent F-4.

Resin A-58: 76.1% by mass
Photoacid generator B-3: 16.8% by mass
Acid diffusion control agent C-1: 1.1% by mass
Hydrophobic resin E-1: 6.9% by mass
Solvent F-1/solvent F-3/solvent F-4: 80/10/10

Next, a content of each repeating unit included in the resin A-58 used for the target resist composition with respect to all repeating units was measured with a measuring method described in <NMR measurement> described later and the number of times of integration of 5000 times, and the content of each repeating unit included in the acid-decomposable resin with respect to all repeating units was calculated.

Next, the content of each repeating unit included in the resin A-58 used for the target resist composition with respect to all repeating units, which was calculated by <NMR measurement> described above, and the content of the acid diffusion control agent C-1 with respect to the total solid content mass in the target resist composition were substituted into the multiple regression equation to calculate a pattern size of the target resist composition.

The obtained pattern size of the target resist composition was compared with the target pattern size (25 nm), and in a case where the absolute value of the difference was more than 0.5 nm, the target resist composition was

selected as a target resist composition for composition adjustment.

By repeating the above-described procedure using the resins A-58 having different lot numbers, 10 kinds of target resist compositions for composition adjustment (hereinafter, also simply referred to as a "target resist composition X3") were prepared.

In addition, by repeating the above-described procedure, 10 kinds of target resist compositions in which the absolute value of the difference between the pattern size of the target resist composition and the target pattern size (25 nm) was 0.5 nm or less (hereinafter, also referred to as a "target resist composition Y3") were prepared.

The content of the acid diffusion control agent C-1 with respect to the total solid content mass in the target resist composition X3 was changed such that a pattern size of the prepared target resist composition X3 (target resist composition for composition adjustment) was set to the target pattern size (25 nm), thereby determining a formulating amount.

Next, a resist composition was prepared using the resin A-58 of the lot number included in the target resist composition X3 based on the determined formulating amount. Using the resist composition prepared above instead of the resist composition for a regression analysis, the treatments described in <Acquisition of pattern size for regression analysis> above was carried out to form a pattern. Thereafter, in a case where the absolute value of the difference between a line width of the pattern and the target pattern size (25 nm) was within 0.5 nm, it was regarded as "pass", and in a case of being more than 0.5 nm, it was regarded as "fail".

The above-described treatment was carried out on the 10 kinds of the target resist compositions X3 and evaluated according to the following standard.

A: 10 kinds thereof were passed.
B: 8 or 9 kinds thereof were passed.
C: 6 or 7 kinds thereof were passed.
D: 4 or 5 kinds thereof were passed.
E: 2 or 3 kinds thereof were passed.
F: 1 or less kind thereof was passed.

In addition, using the target resist composition Y3 instead of the resist composition for a regression analysis, the treatments described in <Acquisition of pattern size for regression analysis> above was carried out to form a pattern. Thereafter, in a case where the absolute value of the difference between a line width of the pattern and the target pattern size (25 nm) was within 0.5 nm, it was regarded as "pass", and in a case of being more than 0.5 nm, it was regarded as "fail".

The above-described treatment was carried out on the 10 kinds of the target resist compositions Y3 and evaluated according to the following standard.

A: 10 kinds thereof were passed.
B: 8 or 9 kinds thereof were passed.
C: 6 or 7 kinds thereof were passed.
D: 4 or 5 kinds thereof were passed.
E: 2 or 3 kinds thereof were passed.
F: 1 or less kind thereof was passed.

<Example 16>

The evaluation was performed according to the same procedure as in Example 15, except that, as the explanatory variables for performing the multiple regression analysis, the content of each repeating unit included in the acid-decomposable resin with respect to all repeating units, the content of the acid diffusion control agent with respect to the total solid content mass in the resist composition, and the weight-average molecular weight of the acid-decomposable resin were selected, and the content of each repeating unit included in the resin A-58 used for the target resist composition with respect to all repeating units, the content of the acid diffusion control agent C-1 with respect to the total solid content mass in the target resist composition, and the weight-average molecular weight of the resin A-58 were substituted into the multiple regression equation to calculate the pattern size of the target resist composition.

<Example 17>

The evaluation was performed according to the same procedure as in Example 16, except that the number of times of integration of the NMR measurement in a case of measuring the content of each repeating unit included in the resin A-58 with respect to all repeating units was changed from 5000 times to 10000 times.

<Example 18>

The evaluation was performed according to the same procedure as in Example 16, except that the number of times of integration of the NMR measurement in a case of measuring the content of each repeating unit included in the resin A-58 with respect to all repeating units was changed from 5000 times to 20000 times.

<Example 19>

The evaluation was performed according to the same procedure as in Example 15, except that, as the explanatory variables for performing the multiple regression analysis, the content of each repeating unit included in the acid-decomposable resin with respect to all repeating units, the content of the acid diffusion control agent with respect to the total solid content mass in the resist composition, the weight-average molecular weight of the acid-decomposable resin, and the content of the acid-decomposable resin with respect to the total solid content mass in the resist composition were selected, and the content of each repeating unit included in the resin A-58 used for the target resist composition with respect to all repeating units, the content of the acid diffusion control agent C-1 with respect to the total solid content mass in the target resist composition, the weight-average molecular weight of the resin A-58, and the content of the resin A-58 with respect to the total solid content mass in the target resist composition were substituted into the multiple regression equation to calculate the pattern size of the target resist composition.

<Example 20>

The evaluation was performed according to the same procedure as in Example 15, except that, as the explanatory variables for performing the multiple regression analysis, the content of each repeating unit included in the acid-decomposable resin with respect to all repeating units, the content of the acid diffusion control agent with respect to the total solid content mass in the resist composition, the weight-average molecular weight of the acid-decomposable resin, the content of the acid-decomposable resin with respect to the total solid content mass in the resist composition, and the refractive index of the acid-decomposable resin were selected, and the content of each repeating unit included in the resin A-58 used for the target resist composition with respect to all repeating units, the content of the acid diffusion control agent C-1 with respect to the total solid content mass in the target resist composition, the weight-average molecular weight of the resin A-58, the content of the resin A-58 with respect to the total solid content mass in the target resist composition, and the refractive index of the resin A-58 were substituted into the multiple regression equation to calculate the pattern size of the target resist composition.

<Example 21>

The evaluation was performed according to the same procedure as in Example 15, except that, as the explanatory variables for performing the multiple regression analysis, the content of each repeating unit included in the acid-decomposable resin with respect to all repeating units, the content of the acid diffusion control agent with respect to the total solid content mass in the resist composition, the weight-average molecular weight of the acid-decomposable resin, the content of the acid-decomposable resin with respect to the total solid content mass in the resist composition, the refractive index of the acid-decomposable resin, and the content of the photoacid generator with respect to the total solid content mass in the resist composition were selected, and the content of each repeating unit included in the resin A-58 used for the target resist composition with respect to all repeating units, the content of the acid diffusion control agent C-1 with respect to the total solid content mass in the target resist composition, the weight-average molecular weight of the resin A-58, the content of the resin A-58 with respect to the total solid content mass in the target resist composition, the refractive index of the resin A-58, and the content of the photoacid generator B-3 with respect to the total solid content mass in the target resist composition were substituted into the multiple regression equation to calculate the pattern size of the target resist composition.

<Example 22>

The evaluation was performed according to the same procedure as in Example 21, except that the number of times of integration of the NMR measurement in a case of measuring the content of each repeating unit included in the resin A-58 with respect to all repeating units was changed from 5000 times to 20000 times.

<Comparative Example 3>

The evaluation was performed according to the same procedure as in Example 15, except that, as the explanatory variables for performing the multiple regression analysis, the only content of each repeating unit included in the acid-decomposable resin with respect to all repeating units was selected, the content of each repeating unit included in the resin A-58 used for the target resist composition with respect to all repeating units was substituted into the multiple regression equation to calculate the pattern size of the target resist composition, a ratio of the pattern size to the target pattern size (pattern size/target pattern size) (for example, 1.1) was obtained, and the amount of the acid diffusion control agent C-1 was adjusted so as to be a value obtained by multiplying the content of the acid diffusion control agent in the target resist composition by the ratio.

The refractive index of the acid-decomposable resin was measured by <Measurement of refractive index of acid-decomposable resin> described above.

The "content of the acid-decomposable resin with respect to the total solid content mass in the resist composition", "content of the acid diffusion control agent with respect to the total solid content mass in the resist composition", and "content of the photoacid generator with respect to the total solid content mass in the resist composition", which are described in Examples, were obtained from the amount charged in each resist composition.

The results of Examples 15 to 22 and Comparative Example 3 are summarized in Table 4-3.

In Table 4-3, "Resin compositional ratio" means the "content of each repeating unit included in the acid-decomposable resin with respect to all repeating units", "Amount of acid diffusion control agent" means the "content of the acid diffusion control agent with respect to the total solid content mass in the resist composition", "Resin Mw" means the "weight-average molecular weight of the acid-decomposable resin", "Amount of resin" means the "content of the acid-decomposable resin with respect to the total solid content mass in the resist composition", "Refractive index of resin" means the "refractive index of the acid-decomposable resin", and "PAG amount" means the "content of the photoacid generator with respect to the total solid content mass in the resist composition".

In each parameter, one used for the multiple regression analysis is indicated as "Implementation".

In Table 4-3, "Evaluation X" is the evaluation result in a case where the 10 kinds of target resist compositions X3 were used, and "Evaluation Y" is the evaluation result in a case where the 10 kinds of target resist compositions Y3 were used.

[Table 16]

| Table 4-3 | Resist composition | Parameter | | | | | | Number of times of integration in NMR measurement | Evaluation X | Evaluation Y |
|---|---|---|---|---|---|---|---|---|---|---|
| | | Resin compositional ratio | Amount of acid diffusion control agent | Resin Mw | Amount of resin | Refractive index of resin | PAG amount | | | |
| Example 15 | Re-58 | Implementation | Implementation | - | - | - | - | 5000 | E | E |
| Example 16 | Re-58 | Implementation | Implementation | Implementation | - | - | - | 5000 | D | D |
| Example 17 | Re-58 | Implementation | Implementation | Implementation | - | - | - | 10000 | C | C |
| Example 18 | Re-58 | Implementation | Implementation | Implementation | - | - | - | 20000 | A | A |
| Example 19 | Re-58 | Implementation | Implementation | Implementation | Implementation | - | - | 5000 | C | C |
| Example 20 | Re-58 | Implementation | Implementation | Implementation | Implementation | Implementation | - | 5000 | B | B |
| Example 21 | Re-58 | Implementation | Implementation | Implementation | Implementation | Implementation | Implementation | 5000 | B | B |
| Example 22 | Rc-58 | Implementation | Implementation | Implementation | Implementation | Implementation | Implementation | 20000 | A | A |
| Comparative Example 3 | Rc-58 | Implementation | - | - | - | - | - | 5000 | F | F |

As shown in Table 4-3, it was confirmed that the desired effect can be obtained by the method for producing a resist composition according to the embodiment of the present invention.

<Example 23>

First, with regard to the pattern size for a regression analysis obtained in <Acquisition of pattern size for regression analysis> using the resist compositions Re-59 to Re-77 which were the resist compositions for a regression analysis, a multiple regression analysis in which the content of the respective repeating units included in the acid-decomposable resin with respect to all repeating units and the content of the acid diffusion control agent with respect to the total solid content mass in the resist composition were used as explanatory variables and a target pattern size (25 nm) was used as an objective variable was carried out.

Next, under production conditions planned to produce an acid-decomposable resin in which the respective repeating units shown in the following chemical formulae were included, the contents of the respective repeating units were 33.0% by mole, 33.0% by mole, and 34.0% by mole in order from the left, the weight-average molecular weight was 7100, and the molecular weight distribution (Pd (Mw/Mn)) was 1.64, the acid-decomposable resins was produced a plurality of times, and a plurality of resins A-78 having different lot numbers were prepared.

In the obtained resins A-78 having different lot numbers, due to an error in the actual production conditions, the contents of the respective repeating units, the weight-average molecular weight, the molecular weight distribution, and the like differed from the above-described target values (contents for the respective repeating units: 33.0% by mole, 33.0% by mole, and 34.0% by mole, weight-average molecular weight: 7100, molecular weight distribution: 1.64). That is, the contents of the respective repeating units, the weight-average molecular weight, the molecular weight distribution, and the like in the resin A-78 of each lot number deviated from the target values.

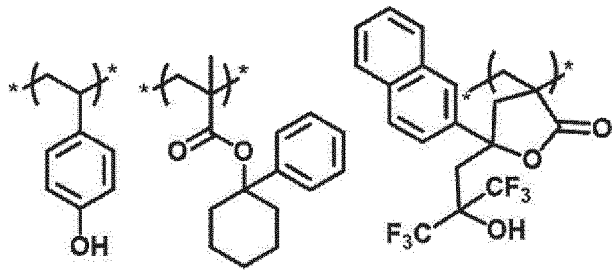

Next, one of the resins A-78 having different lot numbers was selected, and a composition including a predetermined amount of the following components (resist composition Re-76) was used as a target resist composition for determining a formulating amount. The concentration of solid contents of the target resist composition is 2% by mass, the content (% by mass) of each component other than the solvent means a content with respect to the total solid content, and "Solvent F-1/solvent F-5" represents a mixing ratio (mass ratio) of the solvent F-1 and the solvent F-5.

Resin A-78: 82.1% by mass
Photoacid generator B-4: 12.7% by mass
Acid diffusion control agent C-2: 5.2% by mass
Solvent F-1/solvent F-5: 90/10

Next, a content of each repeating unit included in the resin A-78 used for the target resist composition with respect to all repeating units was measured with a measuring method described in <NMR measurement> described later and the number of times of integration of 5000 times, and the content of each repeating unit included in the acid-decomposable resin with respect to all repeating units was calculated.

Next, the content of each repeating unit included in the resin A-78 used for the target resist composition with respect to all repeating units, which was calculated by <NMR measurement> described above, and the content of the acid diffusion control agent C-2 with respect to the total solid content mass in the target resist composition were substituted into the multiple regression equation to calculate a pattern size of the target resist composition.

The obtained pattern size of the target resist composition was compared with the target pattern size (25 nm), and in a case where the absolute value of the difference was more than 0.5 nm, the target resist composition was selected as a target resist composition for composition adjustment.

By repeating the above-described procedure using the resins A-78 having different lot numbers, 10 kinds of target resist compositions for composition adjustment (hereinafter, also simply referred to as a "target resist composition X4") were prepared.

In addition, by repeating the above-described procedure, 10 kinds of target resist compositions in which the absolute value of the difference between the pattern size of the target resist composition and the target pattern size (25 nm) was 0.5 nm or less (hereinafter, also referred to as a "target resist composition Y4") were prepared.

The content of the acid diffusion control agent C-2 with respect to the total solid content mass in the target resist composition X4 was changed such that a pattern size of the prepared target resist composition X4 (target resist composition for composition adjustment) was set to the target pattern size (25 nm), thereby determining a formulating amount.

Next, a resist composition was prepared using the resin A-78 of the lot number included in the target resist composition X4 based on the determined formulating amount. Using the resist composition prepared above instead of the resist composition for a regression analysis, the treatments described in <Acquisition of pattern size for regression analysis> above was carried out to form a pattern. Thereafter, in a case where the absolute value of the difference between a line width of the pattern and the target pattern size (25 nm) was within 0.5 nm, it was regarded as "pass", and in a case of being more than 0.5 nm, it was regarded as "fail".

The above-described treatment was carried out on the 10 kinds of the target resist compositions X4 and evaluated according to the following standard.

A: 10 kinds thereof were passed.
B: 8 or 9 kinds thereof were passed.
C: 6 or 7 kinds thereof were passed.
D: 4 or 5 kinds thereof were passed.
E: 2 or 3 kinds thereof were passed.
F: 1 or less kind thereof was passed.

In addition, using the target resist composition Y4 instead of the resist composition for a regression analysis, the treatments described in <Acquisition of pattern size for regression analysis> above was carried out to form a pattern. Thereafter, in a case where the absolute value of the difference between a line width of the pattern and the target pattern size (25 nm) was within 0.5 nm, it was regarded as "pass", and in a case of being more than 0.5 nm, it was regarded as "fail".

The above-described treatment was carried out on the 10 kinds of the target resist compositions Y4 and evaluated according to the following standard.

A: 10 kinds thereof were passed.
B: 8 or 9 kinds thereof were passed.
C: 6 or 7 kinds thereof were passed.
D: 4 or 5 kinds thereof were passed.
E: 2 or 3 kinds thereof were passed.
F: 1 or less kind thereof was passed.

<Example 24>

The evaluation was performed according to the same procedure as in Example 23, except that, as the explanatory variables for performing the multiple regression analysis, the content of each repeating unit included in the acid-decomposable resin with respect to all repeating units, the content of the acid diffusion control agent with respect to the total solid content mass in the resist composition, and the weight-average molecular weight of the acid-decomposable resin were selected, and the content of each repeating unit included in the resin A-78 used for the target resist composition with respect to all repeating units, the content of the acid diffusion control agent C-2 with respect to the total solid content mass in the target resist composition, and the weight-average molecular weight of the resin A-78 were substituted into the multiple regression equation to calculate the pattern size of the target resist composition.

<Example 25>

The evaluation was performed according to the same procedure as in Example 24, except that the number of times of integration of the NMR measurement in a case of measuring the content of each repeating unit included in the resin A-78 with respect to all repeating units was changed from 5000 times to 10000 times.

<Example 26>

The evaluation was performed according to the same procedure as in Example 24, except that the number of times of integration of the NMR measurement in a case of measuring the content of each repeating unit included in the

resin A-78 with respect to all repeating units was changed from 5000 times to 20000 times.

<Example 27>

The evaluation was performed according to the same procedure as in Example 23, except that, as the explanatory variables for performing the multiple regression analysis, the content of each repeating unit included in the acid-decomposable resin with respect to all repeating units, the content of the acid diffusion control agent with respect to the total solid content mass in the resist composition, the weight-average molecular weight of the acid-decomposable resin, and the content of the acid-decomposable resin with respect to the total solid content mass in the resist composition were selected, and the content of each repeating unit included in the resin A-78 used for the target resist composition with respect to all repeating units, the content of the acid diffusion control agent C-2 with respect to the total solid content mass in the target resist composition, the weight-average molecular weight of the resin A-78, and the content of the resin A-78 with respect to the total solid content mass in the target resist composition were substituted into the multiple regression equation to calculate the pattern size of the target resist composition.

<Example 28>

The evaluation was performed according to the same procedure as in Example 23, except that, as the explanatory variables for performing the multiple regression analysis, the content of each repeating unit included in the acid-decomposable resin with respect to all repeating units, the content of the acid diffusion control agent with respect to the total solid content mass in the resist composition, the weight-average molecular weight of the acid-decomposable resin, the content of the acid-decomposable resin with respect to the total solid content mass in the resist composition, and the refractive index of the acid-decomposable resin were selected, and the content of each repeating unit included in the resin A-78 used for the target resist composition with respect to all repeating units, the content of the acid diffusion control agent C-2 with respect to the total solid content mass in the target resist composition, the weight-average molecular weight of the resin A-78, the content of the resin A-78 with respect to the total solid content mass in the target resist composition, and the refractive index of the resin A-78 were substituted into the multiple regression equation to calculate the pattern size of the target resist composition.

<Example 29>

The evaluation was performed according to the same procedure as in Example 23, except that, as the explanatory variables for performing the multiple regression analysis, the content of each repeating unit included in the acid-decomposable resin with respect to all repeating units, the content of the acid diffusion control agent with respect to the total solid content mass in the resist composition, the weight-average molecular weight of the acid-decomposable resin, the content of the acid-decomposable resin with respect to the total solid content mass in the resist composition, the refractive index of the acid-decomposable resin, and the content of the photoacid generator with respect to the total solid content mass in the resist composition were selected, and the content of each repeating unit included in the resin A-78 used for the target resist composition with respect to all repeating units, the content of the acid diffusion control agent C-2 with respect to the total solid content mass in the target resist composition, the weight-average molecular weight of the resin A-78, the content of the resin A-78 with respect to the total solid content mass in the target resist composition, the refractive index of the resin A-78, and the content of the photoacid generator B-4 with respect to the total solid content mass in the target resist composition were substituted into the multiple regression equation to calculate the pattern size of the target resist composition.

<Example 30>

The evaluation was performed according to the same procedure as in Example 29, except that the number of times of integration of the NMR measurement in a case of measuring the content of each repeating unit included in the resin A-78 with respect to all repeating units was changed from 5000 times to 20000 times.

<Comparative Example 4>

The evaluation was performed according to the same procedure as in Example 23, except that, as the explanatory variables for performing the multiple regression analysis, the only content of each repeating unit included in the acid-decomposable resin with respect to all repeating units was selected, the content of each repeating unit included in the resin A-78 used for the target resist composition with respect to all repeating units was substituted into the multiple regression equation to calculate the pattern size of the target resist composition, a ratio of the pattern size to the target

pattern size (pattern size/target pattern size) (for example, 1.1) was obtained, and the amount of the acid diffusion control agent C-2 was adjusted so as to be a value obtained by multiplying the content of the acid diffusion control agent in the target resist composition by the ratio.

The refractive index of the acid-decomposable resin was measured by <Measurement of refractive index of acid-decomposable resin> described above.

The "content of the acid-decomposable resin with respect to the total solid content mass in the resist composition", "content of the acid diffusion control agent with respect to the total solid content mass in the resist composition", and "content of the photoacid generator with respect to the total solid content mass in the resist composition", which are described in Examples, were obtained from the amount charged in each resist composition.

The results of Examples 23 to 30 and Comparative Example 4 are summarized in Table 4-4.

In Table 4-4, "Resin compositional ratio" means the "content of each repeating unit included in the acid-decomposable resin with respect to all repeating units", "Amount of acid diffusion control agent" means the "content of the acid diffusion control agent with respect to the total solid content mass in the resist composition", "Resin Mw" means the "weight-average molecular weight of the acid-decomposable resin", "Amount of resin" means the "content of the acid-decomposable resin with respect to the total solid content mass in the resist composition", "Refractive index of resin" means the "refractive index of the acid-decomposable resin", and "PAG amount" means the "content of the photoacid generator with respect to the total solid content mass in the resist composition".

In each parameter, one used for the multiple regression analysis is indicated as "Implementation".

In Table 4-4, "Evaluation X" is the evaluation result in a case where the 10 kinds of target resist compositions X4 were used, and "Evaluation Y" is the evaluation result in a case where the 10 kinds of target resist compositions Y4 were used.

[Table 17]

| Table 4-4 | Resist composition | Parameter | | | | | | Number of times of integration in NMR measurement | Evaluation X | Evaluation Y |
|---|---|---|---|---|---|---|---|---|---|---|
| | | Resin compositional ratio | Amount of acid diffusion control agent | Resin Mw | Amount of resin | Refractive index of resin | PAG amount | | | |
| Example 23 | Re-76 | Implementation | Implementation | - | - | - | - | 5000 | E | E |
| Example 24 | Re-76 | Implementation | Implementation | Implementation | - | - | - | 5000 | D | D |
| Example 25 | Re-76 | Implementation | Implementation | Implementation | - | - | - | 10000 | C | C |
| Example 26 | Re-76 | Implementation | Implementation | Implementation | - | - | - | 20000 | A | A |
| Example 27 | Re-76 | Implementation | Implementation | Implementation | Implementation | - | - | 5000 | C | C |
| Example 28 | Re-76 | Implementation | Implementation | Implementation | Implementation | Implementation | - | 5000 | B | B |
| Example 29 | Re-76 | Implementation | Implementation | Implementation | Implementation | Implementation | Implementation | 5000 | B | B |
| Example 30 | Re-76 | Implementation | Implementation | Implementation | Implementation | Implementation | Implementation | 20000 | A | A |
| Comparative Example 4 | Re-76 | Implementation | - | - | - | - | - | 5000 | F | F |

As shown in Table 4-4, it was confirmed that the desired effect can be obtained by the method for producing a resist composition according to the embodiment of the present invention.

<Example 31>

First, with regard to the pattern size for a regression analysis obtained in <Acquisition of pattern size for regression analysis> using the resist compositions Re-79 to Re-93 which were the resist compositions for a regression analysis, a multiple regression analysis in which the content of the respective repeating units included in the acid-decomposable resin with respect to all repeating units and the content of the photoacid generator with respect to the total solid content mass in the resist composition were used as explanatory variables and a target pattern size (25 nm) was used as an objective variable was carried out.

Next, under production conditions planned to produce an acid-decomposable resin in which the respective repeating units shown in the following chemical formulae were included, the contents of the respective repeating units were 25% by mole, 45% by mole, and 30% by mole in order from the left, the weight-average molecular weight was 7600, and the molecular weight distribution (Pd (Mw/Mn)) was 1.8, the acid-decomposable resins was produced a plurality of times, and a plurality of resins A-94 having different lot numbers were prepared.

In the obtained resins A-94 having different lot numbers, due to an error in the actual production conditions, the contents of the respective repeating units, the weight-average molecular weight, the molecular weight distribution, and the like differed from the above-described target values (contents for the respective repeating units: 25% by mole, 45% by mole, and 30% by mole, weight-average molecular weight: 7600, molecular weight distribution: 1.8). That is, the contents of the respective repeating units, the weight-average molecular weight, the molecular weight distribution, and the like in the resin A-94 of each lot number deviated from the target values.

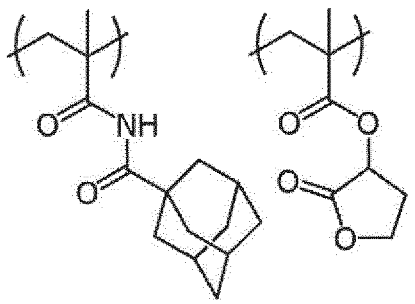
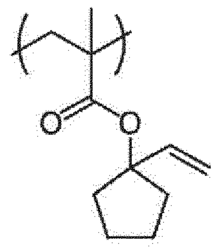

Next, one of the resins A-94 having different lot numbers was selected, and a composition including a predetermined amount of the following components (resist composition Re-94) was used as a target resist composition for determining a formulating amount. The concentration of solid contents of the target resist composition is 2% by mass, the content (% by mass) of each component other than the solvent means a content with respect to the total solid content, and "Solvent F-1/solvent F-2" represents a mixing ratio (mass ratio) of the solvent F-1 and the solvent F-2.

Resin A-94: 76.6% by mass
Photoacid generator B-5: 18.8% by mass
Acid diffusion control agent C-3: 4.6% by mass
Solvent F-1/solvent F-2: 20/80

Next, a content of each repeating unit included in the resin A-94 used for the target resist composition with respect to all repeating units was measured with a measuring method described in <NMR measurement> described later and the number of times of integration of 5000 times, and the content of each repeating unit included in the acid-decomposable resin with respect to all repeating units was calculated.

Next, the content of each repeating unit included in the resin A-94 used for the target resist composition with respect to all repeating units, which was calculated by <NMR measurement> described above, and the content of the photoacid generator B-5 with respect to the total solid content mass in the target resist composition were substituted into the multiple regression equation to calculate a pattern size of the target resist composition.

The obtained pattern size of the target resist composition was compared with the target pattern size (25 nm), and in a case where the absolute value of the difference was more than 0.5 nm, the target resist composition was selected as a target resist composition for composition adjustment.

By repeating the above-described procedure using the resins A-94 having different lot numbers, 10 kinds of target resist compositions for composition adjustment (hereinafter, also simply referred to as a "target resist composition

X5") were prepared.

In addition, by repeating the above-described procedure, 10 kinds of target resist compositions in which the absolute value of the difference between the pattern size of the target resist composition and the target pattern size (25 nm) was 0.5 nm or less (hereinafter, also referred to as a "target resist composition Y5") were prepared.

The content of the photoacid generator B-5 with respect to the total solid content mass in the target resist composition X5 was changed such that a pattern size of the prepared target resist composition X5 (target resist composition for composition adjustment) was set to the target pattern size (25 nm), thereby determining a formulating amount.

Next, a resist composition was prepared using the resin A-94 of the lot number included in the target resist composition X5 based on the determined formulating amount. Using the resist composition prepared above instead of the resist composition for a regression analysis, the treatments described in <Acquisition of pattern size for regression analysis> above was carried out to form a pattern. Thereafter, in a case where the absolute value of the difference between a line width of the pattern and the target pattern size (25 nm) was within 0.5 nm, it was regarded as "pass", and in a case of being more than 0.5 nm, it was regarded as "fail".

The above-described treatment was carried out on the 10 kinds of the target resist compositions X5 and evaluated according to the following standard.

A: 10 kinds thereof were passed.
B: 8 or 9 kinds thereof were passed.
C: 6 or 7 kinds thereof were passed.
D: 4 or 5 kinds thereof were passed.
E: 2 or 3 kinds thereof were passed.
F: 1 or less kind thereof was passed.

In addition, using the target resist composition Y5 instead of the resist composition for a regression analysis, the treatments described in <Acquisition of pattern size for regression analysis> above was carried out to form a pattern. Thereafter, in a case where the absolute value of the difference between a line width of the pattern and the target pattern size (25 nm) was within 0.5 nm, it was regarded as "pass", and in a case of being more than 0.5 nm, it was regarded as "fail".

The above-described treatment was carried out on the 10 kinds of the target resist compositions Y5 and evaluated according to the following standard.

A: 10 kinds thereof were passed.
B: 8 or 9 kinds thereof were passed.
C: 6 or 7 kinds thereof were passed.
D: 4 or 5 kinds thereof were passed.
E: 2 or 3 kinds thereof were passed.
F: 1 or less kind thereof was passed.

<Example 32>

The evaluation was performed according to the same procedure as in Example 31, except that, as the explanatory variables for performing the multiple regression analysis, the content of each repeating unit included in the acid-decomposable resin with respect to all repeating units, the content of the photoacid generator with respect to the total solid content mass in the resist composition, and the weight-average molecular weight of the acid-decomposable resin were selected, and the content of each repeating unit included in the resin A-94 used for the target resist composition with respect to all repeating units, the content of the photoacid generator B-5 with respect to the total solid content mass in the target resist composition, and the weight-average molecular weight of the resin A-94 were substituted into the multiple regression equation to calculate the pattern size of the target resist composition.

<Example 33>

The evaluation was performed according to the same procedure as in Example 32, except that the number of times of integration of the NMR measurement in a case of measuring the content of each repeating unit included in the resin A-94 with respect to all repeating units was changed from 5000 times to 10000 times.

<Example 34>

The evaluation was performed according to the same procedure as in Example 32, except that the number of times of integration of the NMR measurement in a case of measuring the content of each repeating unit included in the

resin A-94 with respect to all repeating units was changed from 5000 times to 20000 times.

<Example 35>

The evaluation was performed according to the same procedure as in Example 31, except that, as the explanatory variables for performing the multiple regression analysis, the content of each repeating unit included in the acid-decomposable resin with respect to all repeating units, the content of the photoacid generator with respect to the total solid content mass in the resist composition, the weight-average molecular weight of the acid-decomposable resin, and the content of the acid-decomposable resin with respect to the total solid content mass in the resist composition were selected, and the content of each repeating unit included in the resin A-94 used for the target resist composition with respect to all repeating units, the content of the photoacid generator B-5 with respect to the total solid content mass in the target resist composition, the weight-average molecular weight of the resin A-94, and the content of the resin A-94 with respect to the total solid content mass in the target resist composition were substituted into the multiple regression equation to calculate the pattern size of the target resist composition.

<Example 36>

The evaluation was performed according to the same procedure as in Example 31, except that, as the explanatory variables for performing the multiple regression analysis, the content of each repeating unit included in the acid-decomposable resin with respect to all repeating units, the content of the photoacid generator with respect to the total solid content mass in the resist composition, the weight-average molecular weight of the acid-decomposable resin, the content of the acid-decomposable resin with respect to the total solid content mass in the resist composition, and the refractive index of the acid-decomposable resin were selected, and the content of each repeating unit included in the resin A-94 used for the target resist composition with respect to all repeating units, the content of the photoacid generator B-5 with respect to the total solid content mass in the target resist composition, the weight-average molecular weight of the resin A-94, the content of the resin A-94 with respect to the total solid content mass in the target resist composition, and the refractive index of the resin A-94 were substituted into the multiple regression equation to calculate the pattern size of the target resist composition.

<Example 37>

The evaluation was performed according to the same procedure as in Example 31, except that, as the explanatory variables for performing the multiple regression analysis, the content of each repeating unit included in the acid-decomposable resin with respect to all repeating units, the content of the photoacid generator with respect to the total solid content mass in the resist composition, the weight-average molecular weight of the acid-decomposable resin, the content of the acid-decomposable resin with respect to the total solid content mass in the resist composition, the refractive index of the acid-decomposable resin, and the content of the acid diffusion control agent with respect to the total solid content mass in the resist composition were selected, and the content of each repeating unit included in the resin A-94 used for the target resist composition with respect to all repeating units, the content of the photoacid generator B-5 with respect to the total solid content mass in the target resist composition, the weight-average molecular weight of the resin A-94, the content of the resin A-94 with respect to the total solid content mass in the target resist composition, the refractive index of the resin A-94, and the content of the acid diffusion control agent C-3 with respect to the total solid content mass in the target resist composition were substituted into the multiple regression equation to calculate the pattern size of the target resist composition.

<Example 38>

The evaluation was performed according to the same procedure as in Example 37, except that the number of times of integration of the NMR measurement in a case of measuring the content of each repeating unit included in the resin A-94 with respect to all repeating units was changed from 5000 times to 20000 times.

<Comparative Example 5>

The evaluation was performed according to the same procedure as in Example 31, except that, as the explanatory variables for performing the multiple regression analysis, the only content of each repeating unit included in the acid-decomposable resin with respect to all repeating units was selected, the content of each repeating unit included in the resin A-94 used for the target resist composition with respect to all repeating units was substituted into the multiple regression equation to calculate the pattern size of the target resist composition, a ratio of the pattern size to the target

pattern size (pattern size/target pattern size) (for example, 1.1) was obtained, and the amount of the photoacid generator B-5 was adjusted so as to be a value obtained by multiplying the content of the photoacid generator in the target resist composition by the ratio.

The refractive index of the acid-decomposable resin was measured by <Measurement of refractive index of acid-decomposable resin> described above.

The "content of the acid-decomposable resin with respect to the total solid content mass in the resist composition", "content of the acid diffusion control agent with respect to the total solid content mass in the resist composition", and "content of the photoacid generator with respect to the total solid content mass in the resist composition", which are described in Examples, were obtained from the amount charged in each resist composition.

The results of Examples 31 to 38 and Comparative Example 5 are summarized in Table 4-5.

In Table 4-5, "Resin compositional ratio" means the "content of each repeating unit included in the acid-decomposable resin with respect to all repeating units", "PAG amount" means the "content of the photoacid generator with respect to the total solid content mass in the resist composition", "Resin Mw" means the "weight-average molecular weight of the acid-decomposable resin", "Amount of resin" means the "content of the acid-decomposable resin with respect to the total solid content mass in the resist composition", "Refractive index of resin" means the "refractive index of the acid-decomposable resin", and "Amount of acid diffusion control agent" means the "content of the acid diffusion control agent with respect to the total solid content mass in the resist composition".

In each parameter, one used for the multiple regression analysis is indicated as "Implementation".

In Table 4-5, "Evaluation X" is the evaluation result in a case where the 10 kinds of target resist compositions X5 were used, and "Evaluation Y" is the evaluation result in a case where the 10 kinds of target resist compositions Y5 were used.

[Table 18]

| Table 4-5 | Resist composition | Parameter | | | | | | Number of times of integration in NMR measurement | Evaluation X | Evaluation Y |
|---|---|---|---|---|---|---|---|---|---|---|
| | | Resin compositional ratio | PAG amount | Resin Mw | Amount of resin | Refractive index of resin | Amount of acid diffusion control agent | | | |
| Example 31 | Re-94 | Implementation | Implementation | - | - | - | - | 5000 | E | E |
| Example 32 | Re-94 | Implementation | Implementation | Implementation | - | - | - | 5000 | D | D |
| Example 33 | Re-94 | Implementation | Implementation | Implementation | - | - | - | 10000 | C | C |
| Example 34 | Re-94 | Implementation | Implementation | Implementation | - | - | - | 20000 | A | A |
| Example 35 | Re-94 | Implementation | Implementation | Implementation | Implementation | - | - | 5000 | C | C |
| Example 36 | Re-94 | Implementation | Implementation | Implementation | Implementation | Implementation | - | 5000 | B | B |
| Example 37 | Re-94 | Implementation | Implementation | Implementation | Implementation | Implementation | Implementation | 5000 | B | B |
| Example 38 | Re-94 | Implementation | Implementation | Implementation | Implementation | Implementation | Implementation | 20000 | A | A |
| Comparative Example 5 | Re-94 | Implementation | - | - | - | - | - | 5000 | F | F |

As shown in Table 4-5, it was confirmed that the desired effect can be obtained by the method for producing a resist composition according to the embodiment of the present invention.

<Example 39>

First, with regard to the pattern size for a regression analysis obtained in <Acquisition of pattern size for regression analysis> using the resist compositions Re-95 to Re-119 which were the resist compositions for a regression analysis, a multiple regression analysis in which the content of the respective repeating units included in the acid-decomposable resin with respect to all repeating units and the content of the acid diffusion control agent with respect to the total solid content mass in the resist composition were used as explanatory variables and a target pattern size (25 nm) was used as an objective variable was carried out.

Next, under production conditions planned to produce an acid-decomposable resin in which the respective repeating units shown in the following chemical formulae were included, the contents of the respective repeating units were 35% by mole, 24% by mole, 35% by mole, 3% by mole, and 3% by mole in order from the left, the weight-average molecular weight was 4600, and the molecular weight distribution (Pd (Mw/Mn)) was 1.54, the acid-decomposable resins was produced a plurality of times, and a plurality of resins A-120 having different lot numbers were prepared.

In the obtained resins A-120 having different lot numbers, due to an error in the actual production conditions, the contents of the respective repeating units, the weight-average molecular weight, the molecular weight distribution, and the like differed from the above-described target values (contents for the respective repeating units: 35% by mole, 24% by mole, 35% by mole, 3% by mole, and 3% by mole, weight-average molecular weight: 4600, molecular weight distribution: 1.54). That is, the contents of the respective repeating units, the weight-average molecular weight, the molecular weight distribution, and the like in the resin A-120 of each lot number deviated from the target values.

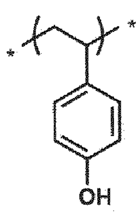 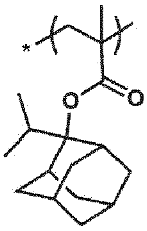 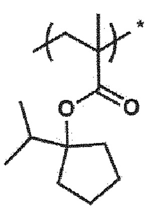 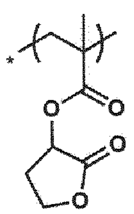 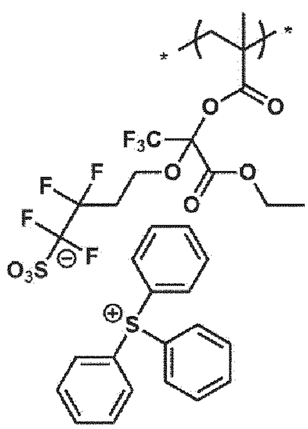

Next, one of the resins A-120 having different lot numbers was selected, and a composition including a predetermined amount of the following components (resist composition Re-120) was used as a target resist composition for determining a formulating amount. The concentration of solid contents of the target resist composition is 2% by mass, the content (% by mass) of each component other than the solvent means a content with respect to the total solid content, and "Solvent F-1/solvent F-2/solvent F-6/solvent F-3" represents a mixing ratio (mass ratio) of the solvent F-1, the solvent F-2, the solvent F-6, and the solvent F-3.

Resin A-120: 77.8% by mass
Photoacid generator B-6: 19.4% by mass
Acid diffusion control agent C-4: 2.8% by mass
Solvent F-1/solvent F-2/solvent F-6/solvent F-3: 85/7/7/1

Next, a content of each repeating unit included in the resin A-120 used for the target resist composition with respect to all repeating units was measured with a measuring method described in <NMR measurement> described later and the number of times of integration of 5000 times, and the content of each repeating unit included in the acid-decomposable resin with respect to all repeating units was calculated.

Next, the content of each repeating unit included in the resin A-120 used for the target resist composition with respect to all repeating units, which was calculated by <NMR measurement> described above, and the content of the acid diffusion control agent C-4 with respect to the total solid content mass in the target resist composition were substituted into the multiple regression equation to calculate a pattern size of the target resist composition.

The obtained pattern size of the target resist composition was compared with the target pattern size (25 nm), and in a case where the absolute value of the difference was more than 0.5 nm, the target resist composition was selected as a target resist composition for composition adjustment.

By repeating the above-described procedure using the resins A-120 having different lot numbers, 10 kinds of target resist compositions for composition adjustment (hereinafter, also simply referred to as a "target resist composition X6") were prepared.

In addition, by repeating the above-described procedure, 10 kinds of target resist compositions in which the absolute value of the difference between the pattern size of the target resist composition and the target pattern size (25 nm) was 0.5 nm or less (hereinafter, also referred to as a "target resist composition Y6") were prepared.

The content of the acid diffusion control agent C-4 with respect to the total solid content mass in the target resist composition X6 was changed such that a pattern size of the prepared target resist composition X6 (target resist composition for composition adjustment) was set to the target pattern size (25 nm), thereby determining a formulating amount.

Next, a resist composition was prepared using the resin A-120 of the lot number included in the target resist composition X6 based on the determined formulating amount. Using the resist composition prepared above instead of the resist composition for a regression analysis, the treatments described in <Acquisition of pattern size for regression analysis> above was carried out to form a pattern. Thereafter, in a case where the absolute value of the difference between a line width of the pattern and the target pattern size (25 nm) was within 0.5 nm, it was regarded as "pass", and in a case of being more than 0.5 nm, it was regarded as "fail".

The above-described treatment was carried out on the 10 kinds of the target resist compositions X6 and evaluated according to the following standard.

A: 10 kinds thereof were passed.
B: 8 or 9 kinds thereof were passed.
C: 6 or 7 kinds thereof were passed.
D: 4 or 5 kinds thereof were passed.
E: 2 or 3 kinds thereof were passed.
F: 1 or less kind thereof was passed.

In addition, using the target resist composition Y6 instead of the resist composition for a regression analysis, the treatments described in <Acquisition of pattern size for regression analysis> above was carried out to form a pattern. Thereafter, in a case where the absolute value of the difference between a line width of the pattern and the target pattern size (25 nm) was within 0.5 nm, it was regarded as "pass", and in a case of being more than 0.5 nm, it was regarded as "fail".

The above-described treatment was carried out on the 10 kinds of the target resist compositions Y6 and evaluated according to the following standard.

A: 10 kinds thereof were passed.
B: 8 or 9 kinds thereof were passed.
C: 6 or 7 kinds thereof were passed.
D: 4 or 5 kinds thereof were passed.
E: 2 or 3 kinds thereof were passed.
F: 1 or less kind thereof was passed.

<Example 40>

The evaluation was performed according to the same procedure as in Example 39, except that, as the explanatory variables for performing the multiple regression analysis, the content of each repeating unit included in the acid-decomposable resin with respect to all repeating units, the content of the acid diffusion control agent with respect to the total solid content mass in the resist composition, and the weight-average molecular weight of the acid-decomposable resin were selected, and the content of each repeating unit included in the resin A-120 used for the target resist composition with respect to all repeating units, the content of the acid diffusion control agent C-4 with respect to the total solid content mass in the target resist composition, and the weight-average molecular weight of the resin A-120 were substituted into the multiple regression equation to calculate the pattern size of the target resist composition.

<Example 41>

The evaluation was performed according to the same procedure as in Example 40, except that the number of times of integration of the NMR measurement in a case of measuring the content of each repeating unit included in the

resin A-120 with respect to all repeating units was changed from 5000 times to 10000 times.

<Example 42>

The evaluation was performed according to the same procedure as in Example 40, except that the number of times of integration of the NMR measurement in a case of measuring the content of each repeating unit included in the resin A-120 with respect to all repeating units was changed from 5000 times to 20000 times.

<Example 43>

The evaluation was performed according to the same procedure as in Example 39, except that, as the explanatory variables for performing the multiple regression analysis, the content of each repeating unit included in the acid-decomposable resin with respect to all repeating units, the content of the acid diffusion control agent with respect to the total solid content mass in the resist composition, the weight-average molecular weight of the acid-decomposable resin, and the content of the acid-decomposable resin with respect to the total solid content mass in the resist composition were selected, and the content of each repeating unit included in the resin A-120 used for the target resist composition with respect to all repeating units, the content of the acid diffusion control agent C-4 with respect to the total solid content mass in the target resist composition, the weight-average molecular weight of the resin A-120, and the content of the resin A-120 with respect to the total solid content mass in the target resist composition were substituted into the multiple regression equation to calculate the pattern size of the target resist composition.

<Example 44>

The evaluation was performed according to the same procedure as in Example 39, except that, as the explanatory variables for performing the multiple regression analysis, the content of each repeating unit included in the acid-decomposable resin with respect to all repeating units, the content of the acid diffusion control agent with respect to the total solid content mass in the resist composition, the weight-average molecular weight of the acid-decomposable resin, the content of the acid-decomposable resin with respect to the total solid content mass in the resist composition, and the refractive index of the acid-decomposable resin were selected, and the content of each repeating unit included in the resin A-120 used for the target resist composition with respect to all repeating units, the content of the acid diffusion control agent C-4 with respect to the total solid content mass in the target resist composition, the weight-average molecular weight of the resin A-120, the content of the resin A-120 with respect to the total solid content mass in the target resist composition, and the refractive index of the resin A-120 were substituted into the multiple regression equation to calculate the pattern size of the target resist composition.

<Example 45>

The evaluation was performed according to the same procedure as in Example 39, except that, as the explanatory variables for performing the multiple regression analysis, the content of each repeating unit included in the acid-decomposable resin with respect to all repeating units, the content of the acid diffusion control agent with respect to the total solid content mass in the resist composition, the weight-average molecular weight of the acid-decomposable resin, the content of the acid-decomposable resin with respect to the total solid content mass in the resist composition, the refractive index of the acid-decomposable resin, and the content of the photoacid generator with respect to the total solid content mass in the resist composition were selected, and the content of each repeating unit included in the resin A-120 used for the target resist composition with respect to all repeating units, the content of the acid diffusion control agent C-4 with respect to the total solid content mass in the target resist composition, the weight-average molecular weight of the resin A-120, the content of the resin A-120 with respect to the total solid content mass in the target resist composition, the refractive index of the resin A-120, and the content of the photoacid generator B-6 with respect to the total solid content mass in the target resist composition were substituted into the multiple regression equation to calculate the pattern size of the target resist composition.

<Example 46>

The evaluation was performed according to the same procedure as in Example 45, except that the number of times of integration of the NMR measurement in a case of measuring the content of each repeating unit included in the resin A-120 with respect to all repeating units was changed from 5000 times to 20000 times.

<Comparative Example 6>

The evaluation was performed according to the same procedure as in Example 39, except that, as the explanatory variables for performing the multiple regression analysis, the only content of each repeating unit included in the acid-decomposable resin with respect to all repeating units was selected, the content of each repeating unit included in the resin A-120 used for the target resist composition with respect to all repeating units was substituted into the multiple regression equation to calculate the pattern size of the target resist composition, a ratio of the pattern size to the target pattern size (pattern size/target pattern size) (for example, 1.1) was obtained, and the amount of the acid diffusion control agent C-4 was adjusted so as to be a value obtained by multiplying the content of the acid diffusion control agent in the target resist composition by the ratio.

The refractive index of the acid-decomposable resin was measured by <Measurement of refractive index of acid-decomposable resin> described above.

The "content of the acid-decomposable resin with respect to the total solid content mass in the resist composition", "content of the acid diffusion control agent with respect to the total solid content mass in the resist composition", and "content of the photoacid generator with respect to the total solid content mass in the resist composition", which are described in Examples, were obtained from the amount charged in each resist composition.

The results of Examples 39 to 46 and Comparative Example 6 are summarized in Table 4-6.

In Table 4-6, "Resin compositional ratio" means the "content of each repeating unit included in the acid-decomposable resin with respect to all repeating units", "Amount of acid diffusion control agent" means the "content of the acid diffusion control agent with respect to the total solid content mass in the resist composition", "Resin Mw" means the "weight-average molecular weight of the acid-decomposable resin", "Amount of resin" means the "content of the acid-decomposable resin with respect to the total solid content mass in the resist composition", "Refractive index of resin" means the "refractive index of the acid-decomposable resin", and "PAG amount" means the "content of the photoacid generator with respect to the total solid content mass in the resist composition".

In each parameter, one used for the multiple regression analysis is indicated as "Implementation".

In Table 4-6, "Evaluation X" is the evaluation result in a case where the 10 kinds of target resist compositions X6 were used, and "Evaluation Y" is the evaluation result in a case where the 10 kinds of target resist compositions Y6 were used.

[Table 19]

| Table 4-6 | Resist composition | Parameter | | | | | | Number of times of integration in NMR measurement | Evaluation X | Evaluation Y |
|---|---|---|---|---|---|---|---|---|---|---|
| | | Resin compositional ratio | Amount of acid diffusion control agent | Resin Mw | Amount of resin | Refractive index of resin | PAG amount | | | |
| Example 39 | Re-120 | Implementation | Implementation | - | - | - | - | 5000 | E | E |
| Example 40 | Re-120 | Implementation | Implementation | Implementation | - | - | - | 5000 | D | D |
| Example 41 | Rc-120 | Implementation | Implementation | Implementation | - | - | - | 10000 | C | C |
| Example 42 | Re-120 | Implementation | Implementation | Implementation | - | - | - | 20000 | A | A |
| Example 43 | Re-120 | Implementation | Implementation | Implementation | Implementation | - | - | 5000 | C | C |
| Example 44 | Re-120 | Implementation | Implementation | Implementation | Implementation | Implementation | - | 5000 | B | B |
| Example 45 | Re-120 | Implementation | Implementation | Implementation | Implementation | Implementation | Implementation | 5000 | B | B |
| Example 46 | Rc-120 | Implementation | Implementation | Implementation | Implementation | Implementation | Implementation | 20000 | A | A |
| Comparative Example 6 | Re-120 | Implementation | - | - | - | - | - | 5000 | F | F |

As shown in Table 4-6, it was confirmed that the desired effect can be obtained by the method for producing a resist composition according to the embodiment of the present invention.

Explanation of References

10: processing apparatus

12: processing unit

14: input unit

16: display unit

18: producing unit

20: setting unit

21: acquisition unit

22: analysis unit

23: calculation unit

24: decision unit

25: change unit

26: determination unit

27: display control unit

28: memory

29: control unit

S10, S12, S14, S16, S18, S20, S22, S24: step

## Claims

**1.** A method for producing a resist composition, the resist composition including an acid-decomposable resin which has a group decomposed by an action of acid to generate a polar group and a photoacid generator, the method *comprising:*

a setting step of setting each of a content of a repeating unit included in the acid-decomposable resin with respect to all repeating units and a physical quantity including at least a content of components in the resist composition as parameters;
an acquisition step of producing a plurality of resist compositions for a regression analysis, which include at least the acid-decomposable resin and the photoacid generator, with at least one of the parameters as a variable, and acquiring a pattern size for a regression analysis of each of the produced resist compositions for a regression analysis;
an analysis step of performing a regression analysis on the pattern size for a regression analysis, which is obtained by the acquisition step, using the parameter as the variable as an explanatory variable and using a target pattern size as an objective variable;
a calculation step of measuring a content of a repeating unit included in the acid-decomposable resin which is a component in a target resist composition including the same types of components as components in the resist

composition for a regression analysis with respect to all repeating units by a nuclear magnetic resonance spectroscopy, and calculating, based on the regression analysis in the analysis step, a pattern size of the target resist composition using the obtained content of the repeating unit included in the acid-decomposable resin with respect to all repeating units and the physical quantity of the explanatory variables of the target resist composition;
a comparison step of comparing the pattern size of the target resist composition, which is obtained by the calculation step, with the target pattern size;
a determination step of determining a formulating amount of the target resist composition based on the regression analysis of the analysis step in a case where, in the comparison step, a difference between the pattern size of the target resist composition and the target pattern size is within an allowable range; and
a producing step of producing a resist composition based on the formulating amount determined in the determination step,
wherein, in the comparison step, in a case where the difference between the pattern size of the target resist composition and the target pattern size is out of the allowable range, the method further includes a change step of changing the formulating amount of the target resist composition such that the difference between the pattern size of the target resist composition and the target pattern size is within the allowable range.

**2.** The method for producing a resist composition according to claim 1, wherein the number of times of integration in the nuclear magnetic resonance spectroscopy is 5000 or more.

**3.** The method for producing a resist composition according to claim 1 or 2, wherein the number of times of integration in the nuclear magnetic resonance spectroscopy is 10000 or more.

**4.** The method for producing a resist composition according to any one of claims 1 to 3, wherein the number of times of integration in the nuclear magnetic resonance spectroscopy is 20000 or more.

**5.** The method for producing a resist composition according to any one of claims 1 to 4, wherein the physical quantity is a content of the acid-decomposable resin with respect to a total solid content mass in the resist composition.

**6.** The method for producing a resist composition according to any one of claims 1 to 5, wherein the physical quantity is a content of the photoacid generator with respect to a total solid content mass in the resist composition.

**7.** The method for producing a resist composition according to any one of claims 1 to 6, wherein the physical quantity is a weight-average molecular weight of the acid-decomposable resin.

**8.** The method for producing a resist composition according to any one of claims 1 to 7, wherein the regression analysis is a multivariate analysis.

**9.** The method for producing a resist composition according to any one of claims 1 to 8, wherein the resist composition produced in the producing step is used for exposure with extreme ultraviolet rays.

**10.** A pattern forming method comprising:

a step of forming a resist film using the resist composition produced by the production method according to any one of claims 1 to 9;
a step of exposing the resist film; and
a step of developing the exposed resist film using a developer to form a pattern.

FIG. 1

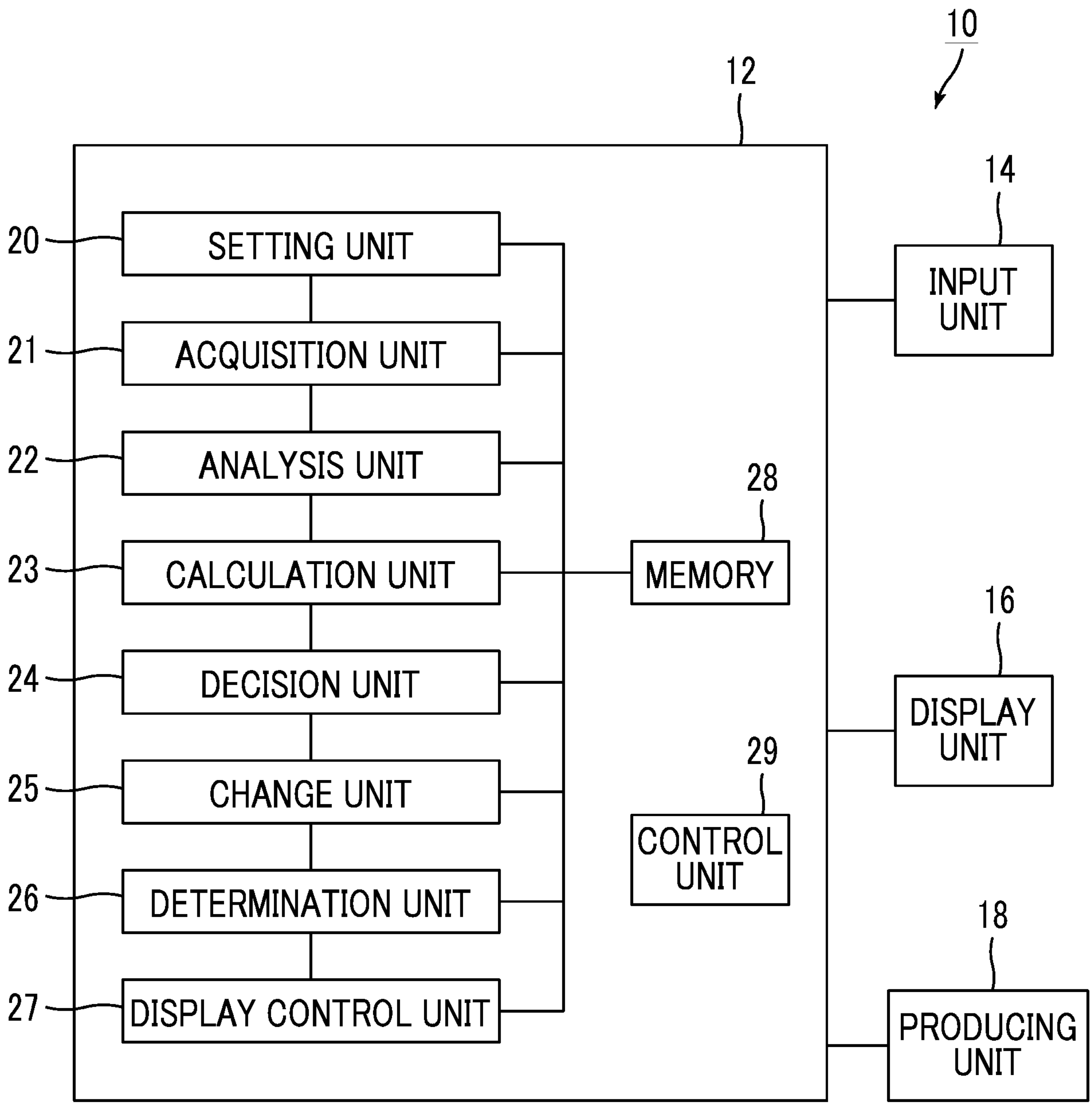
10
12
20
SETTING UNIT
21
ACQUISITION UNIT
22
ANALYSIS UNIT
23
CALCULATION UNIT
24
DECISION UNIT
25
CHANGE UNIT
26
DETERMINATION UNIT
27
DISPLAY CONTROL UNIT
28
MEMORY
29
CONTROL UNIT
14
INPUT UNIT
16
DISPLAY UNIT
18
PRODUCING UNIT

FIG. 2

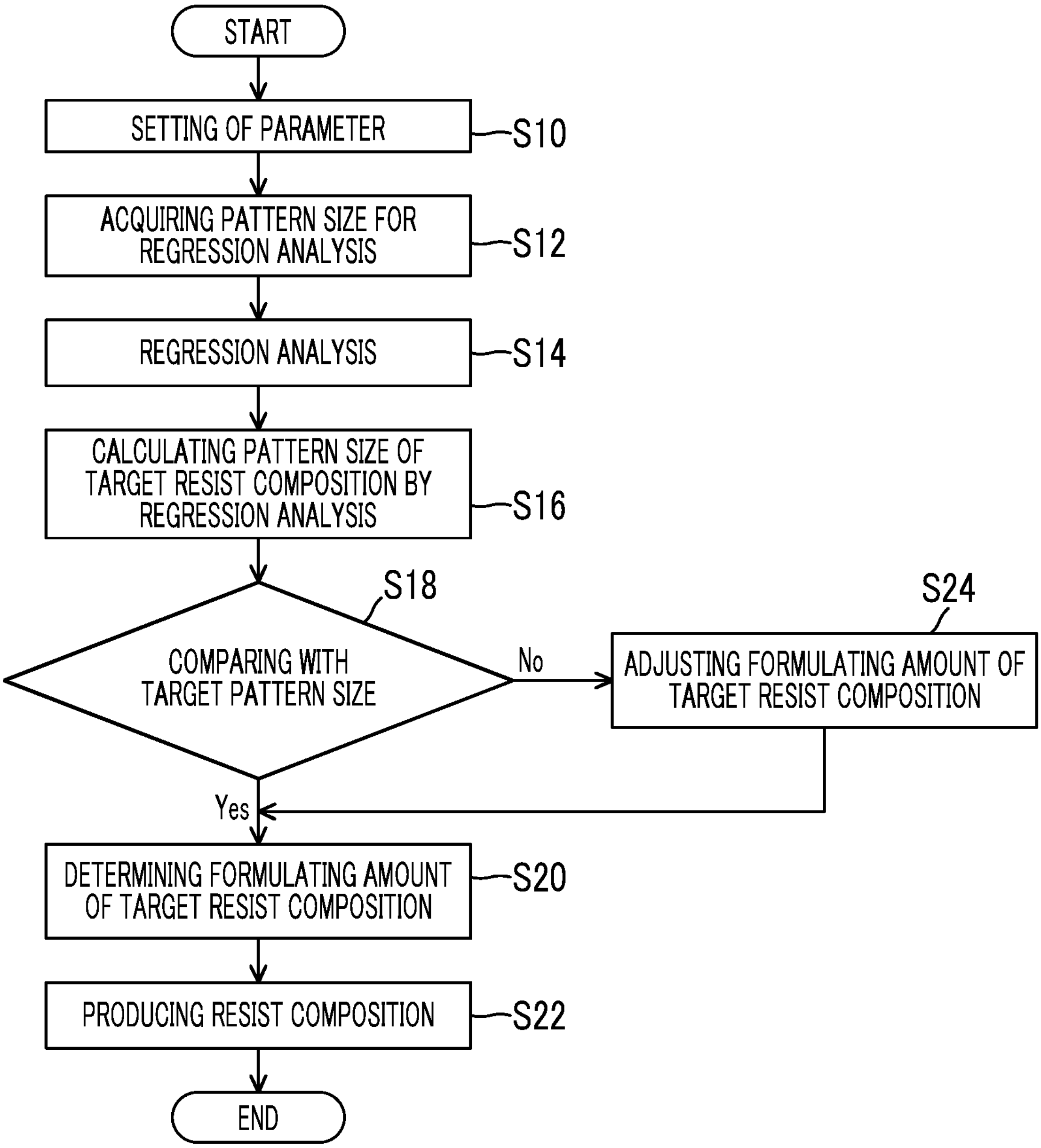
START
SETTING OF PARAMETER
S10
ACQUIRING PATTERN SIZE FOR REGRESSION ANALYSIS
S12
REGRESSION ANALYSIS
S14
CALCULATING PATTERN SIZE OF TARGET RESIST COMPOSITION BY REGRESSION ANALYSIS
S16
S18
COMPARING WITH TARGET PATTERN SIZE
No
S24
ADJUSTING FORMULATING AMOUNT OF TARGET RESIST COMPOSITION
Yes
DETERMINING FORMULATING AMOUNT OF TARGET RESIST COMPOSITION
S20
PRODUCING RESIST COMPOSITION
S22
END

## INTERNATIONAL SEARCH REPORT

International application No. PCT/JP2021/009032

A. CLASSIFICATION OF SUBJECT MATTER
Int.Cl. G03F7/039(2006.01)i, G03F7/20(2006.01)i
FI: G03F7/039601, G03F7/20503, G03F7/20521

According to International Patent Classification (IPC) or to both national classification and IPC

B. FIELDS SEARCHED

Minimum documentation searched (classification system followed by classification symbols)
Int.Cl. G03F7/039, G03F7/20

Documentation searched other than minimum documentation to the extent that such documents are included in the fields searched

| | |
|---|---|
| Published examined utility model applications of Japan | 1922-1996 |
| Published unexamined utility model applications of Japan | 1971-2021 |
| Registered utility model specifications of Japan | 1996-2021 |
| Published registered utility model applications of Japan | 1994-2021 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 2015-227468 A (MITSUBISHI RAYON CO., LTD.) 17 December 2015 (2015-12-17), claims | 1-10 |
| A | JP 9-219355 A (MATSUSHITA ELECTRIC INDUSTRIAL CO., LTD.) 19 August 1997 (1997-08-19), claims | 1-10 |
| A | WO 2012/053434 A1 (MITSUBISHI RAYON CO., LTD.) 26 April 2012 (2012-04-26), claims | 1-10 |

☐ Further documents are listed in the continuation of Box C.   ☒ See patent family annex.

* Special categories of cited documents:
“A” document defining the general state of the art which is not considered to be of particular relevance
“E” earlier application or patent but published on or after the international filing date
“L” document which may throw doubts on priority claim(s) or which is cited to establish the publication date of another citation or other special reason (as specified)
“O” document referring to an oral disclosure, use, exhibition or other means
“P” document published prior to the international filing date but later than the priority date claimed
“T” later document published after the international filing date or priority date and not in conflict with the application but cited to understand the principle or theory underlying the invention
“X” document of particular relevance; the claimed invention cannot be considered novel or cannot be considered to involve an inventive step when the document is taken alone
“Y” document of particular relevance; the claimed invention cannot be considered to involve an inventive step when the document is combined with one or more other such documents, such combination being obvious to a person skilled in the art
“&” document member of the same patent family

| Date of the actual completion of the international search | Date of mailing of the international search report |
|---|---|
| 10 May 2021 | 01 June 2021 |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

**INTERNATIONAL SEARCH REPORT**
Information on patent family members

International application No.
PCT/JP2021/009032

| | | |
|---|---|---|
| JP 2015-227468 A | 17 December 2015 | US 2012/0111099 A1<br>claims<br>TW 201109865 A<br>CN 102471387 A<br>KR 10-2012-0027462 A |
| JP 9-219355 A | 19 August 1997 | US 5756262 A<br>claims<br>KR 10-1996-0035770 A |
| WO 2012/053434 A1 | 26 April 2012 | US 2013/0224654 A1<br>claims<br>CN 103154042 A<br>KR 10-2013-0122942 A<br>TW 201222146 A |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2019211531 A
- JP 2009267112 A
- WO 2014002808 A
- JP 2004235468 A
- US 20100020297 A
- JP 2008083384 A
- JP 3270227 A
- JP H3270227 A
- JP 2013164509 A
- JP 2014041327 A
- JP 2014041328 A
- JP 2013228681 A
- US 2015004533 A
- JP 2014219664 A
- JP 2014134686 A
- JP 2013011833 A
- US 20120251948 A1
- JP 2014010245 A
- JP 2011248019 A
- JP 2010175859 A
- JP 2012032544 A
- US 20080248425 A
- JP 2002090991 A


### Non-patent literature cited in the description


- *Journal of The International Society for Optical Engineering (Proc. of SPIE),* 2008, vol. 6924, 692420
- Etching. Semiconductor Process Text Book. SEMI Japan, 2007
- EUV Resist Curing Technique for LWR Reduction and Etch Selectivity Enhancement. *Proc. of SPIE,* vol. 8328, 83280N-1
- *ACS Nano,* vol. 4 (8), 4815-4823
- *Materials Letters,* 2008, vol. 62, 3152
- Prediction of polymer properties. Marcel Dekker Inc, 1993